Europäisches Patentamt

(19) European Patent Office

Office européen des brevets

(11) **EP 0 749 162 B1**

(12) **EUROPEAN PATENT SPECIFICATION**

(45) Date of publication and mention
of the grant of the patent:
**03.09.2003 Bulletin 2003/36**

(51) Int Cl.[7]: **H01L 29/10**, H01L 29/78,
H01L 21/8238, H01L 27/11,
H01L 29/786

(21) Application number: **96870075.7**

(22) Date of filing: **17.06.1996**

(54) **Vertical MISFET devices, CMOS process integration, RAM applications**

Vertikale MISFET-Bauelemente, CMOS-Prozessintegration, RAM-Anwendungen

Dispositifs de MISFET verticals, intégration de technologie CMOS, applications RAM

(84) Designated Contracting States:
**AT BE DE ES FR GB IT NL SE**

(30) Priority: **16.06.1995 EP 95870071**
**23.01.1996 US 10479**
**23.01.1996 US 10476**
**23.01.1996 US 10478**

(43) Date of publication of application:
**18.12.1996 Bulletin 1996/51**

(73) Proprietor: **INTERUNIVERSITAIR**
**MICRO-ELEKTRONICA CENTRUM VZW**
**3001 Heverlee (BE)**

(72) Inventors:
• **Augusto, Carlos Jorge Ramiro Proenca**
**3000 Leuven (BE)**
• **The other inventor has agreed to waive his**
**entitlement to designation.**

(74) Representative: **Van Malderen, Joelle et al**
**Office Van Malderen,**
**Place Reine Fabiola 6/1**
**1083 Bruxelles (BE)**

(56) References cited:
**US-A- 4 236 166**        **US-A- 4 550 489**
**US-A- 4 740 826**

• **KEARNEY M J: "THE PHYSICS AND DEVICE APPLICATIONS OF EPITAXIALLY GROWN SI AND SI1-XGEX HETEROSTRUCTURES" GEC JOURNAL OF RESEARCH (INCORPORATING MARCONI.REVIEW.) (FOR THE WHOLE COLLECTION USE BOCA..LI MAX), vol. 10, no. 3, 1 January 1993, pages 158-165, XP000377841**
• **HWANG J D ET AL: "A VERTICAL SUBMICRON SIC THIN FILM TRANSISTOR" SOLID STATE ELECTRONICS, vol. 38, no. 2, February 1995, pages 275-278, XP000486574**
• **PATENT ABSTRACTS OF JAPAN vol. 018, no. 603 (E-1632), 16 November 1994 & JP 06 232448 A (HITACHI LTD), 19 August 1994,**
• **PATENT ABSTRACTS OF JAPAN vol. 012, no. 403 (E-674), 26 October 1988 & JP 63 143877 A (HITACHI LTD), 16 June 1988,**
• **TUCKER J R ET AL: "NANOSCALES FETS AND STM LITHOGRAPHY" PROCEEDINGS OF THE IEEE/CORNELL CONFERENCE ON ADVANCED CONCEPTS IN HIGH SPEED SEMICONDUCTOR DEVICES AND CIRCUITS, ITHACA, NEW YORK, AUG. 7 - 9, 1995, 7 August 1995, INSTITUTE OF ELECTRICAL AND ELECTRONICS ENGINEERS, pages 425-434, XP000626630**

EP 0 749 162 B1

**Description**

### General technical background and problem definition

The microelectronics industry, owes its success to the relentless technological progress of the micro-fabrication processes. These fabrication processes have allowed the critical dimensions of electronic devices be decreased to the deep submicrometer levels. In this size range, the MISFET (Metal-Insulator-Semiconductor-Field Effect Transistor) and preferably the MOSFET (Metal-Oxide Semiconductor-Field-Effect-Transistor) device is the preferred type of. device, because it offers the best compromise between speed, size, power dissipation, and production cost.

Lithography has been the technology driver of all other processing steps. In fact, it has been the limitation for making smaller transistors, because the other process steps could easily be scaled to smaller dimensions.

The advantages of patterning smaller features are twofold: smaller design rules, for a given area, mean more devices, and smaller devices are faster and dissipate less power.

Up to now, very small planar transistors are fabricated with experimental techniques which are not suitable for production. It is not yet clear if they will ever be. There are also device physics problems for their operation at room temperature. Because the issues being faced now are of unprecedented difficulty, the evolutionary approach (or incremental engineering) seems unable to deliver solutions for at least some of the problems. These problems are of different natures: device physics, new fabrication techniques demanding new types of processing equipment, and economics.

Making Si MISFET devices with short gates (e.g. less than 0.12μm), presents (in 1995) two very obvious problems: device physics and fabrication technology.

The first problem is known as Drain Induced Barrier Lowering (DIBL), which, for very short channels exists even without drain bias. This effect, results in undesirable high off-sate currents, which will have a major contribution to serious power dissipation problems. It also degrades the switching properties (sub threshold current slope) of the devices.

Concerning fabrication technology, lithography and shallow junction formation are the most prominent ones. Although, from the technical point of view, several proposed solutions seem to work, they imply different fabrication techniques, using new types of equipment. For some of these techniques, it is not yet clear if they will ever be economically feasible. This is clearly the case with lithography technologies for dimensions below 0.12μm.

To solve the technological problems, Vertical MISFET devices have been proposed. In this way, the lithographic steps define the cross section of the transistor, and the gate/channel length will be defined by epitaxial techniques (at low temperatures).

More particularly, Planar Delta Doped. Vertical MISFET devices having a homojunction are known.

However, the DIBL effect remains for these devices, thereby imposing a minimum channel length. This results from the fact that potential barriers built by doping suffer from charge redistribution when a bias is applied, and their maximum value is limited by the band-gap of Si. Also, very short distances between source/drain and the delta doped barrier results in a strong field, enhancing band to band tunnelling beyond acceptable levels.

Document US-A-4 740 826 describes a Vertical CMOS inverter consisting in a layer P-type material formed on the surface of an N+-type substrate followed by formation of an N+ layer, a P+ layer, an N- layer and a P+ layer and wherein a trench is then etched along one side of the stack thus formed and a connector is formed to the middle P+ and N+ layers and wherein another trench is formed where a gate insulator and a- gate are formed. There is only homojunction between the several layers.

Transistors having a heterojunction are also well known from the document "Fabrication of Three-terminal Resonant Tunnelling Devices in Silicon-based Material" of A. Zaslavsky, K.R. Milkove, Y.H. Lee, K.K. Chan, F. Stern, D.A. Grützmacher, S.A. Rishton, C. Stanis, and T.O. Sedgwick: Appl. Phys. Lett. 64 (13), 28 March 1994.

This reference describes the fabrication of a silicon-based device having a double SiGe barrier for which the physical principle of operation is resonant tunnelling.

Document US-A-4 550 489 describes a Vertical Field Effect Transistor wherein the layer structure is formed epitaxially and wherein the gate is formed by a Schottky junction between a metal electrode and the channel semiconductor material. The current control mechanism is barrier thinning to enhance tunnelling across the channel material.

Document US-A-4236166 describes a Vertical Field Effect Transistor which includes a relatively wide bandgap, lowly doped active layer epitaxially grown on, and substantially lattice matched to, an underlying semiconductor body portion. A mesa of lower bandgap material is epitaxially grown on and substantially lattice matched to the active layer. A source electrode is formed on a bottom major surface of the semiconductor body portion, a drain electrode is formed on the top of the mesa, and a pair of gate electrode stipes are formed on the active layer adjacent both sides of the mesa.

This transistor is normally on and needs the application of a gate voltage to become off. This turn-off mechanism works through the depletion of channel material to stop current which imposes, in the present case, constraints on the lateral to vertical dimension ratio.

The "GEC Journal of Research, 10 (1993) no. 3, pp. 645, Chelmsford, Essex, GB, describes very well known technique used for epitaxially grown Si and $Si_{1-x}Ge_x$ heterostructure.

There is no mention of vertical MISFET transistor in this document.

Concerning the CMOS process integration using Vertical MISFETs, such as the one suggested in the state of the art, one is faced with four main problems:

1° multiple epitaxial runs to make complementary transistors. In process architectures where complementary transistors are made sequentially, at least two epi-runs (SEGs even), have to be performed. This implies process complexity, low temperature cleans and cures, very selective etches, etc.

2° parasitic capacitances coming from extensive gate overlap of highly doped regions. The gate fully overlaps the source and drain (which is something that doesn't happen with planar transistors). This capacitance can be significative since "thick" source and drain layers should be provided for minimisation of the series resistance.

3° when gate electrode definition is made by lithography and dry etch, there are even more extensive regions overlapped by the gate electrode: on top of the transistor itself, and on the highly doped layer where the vertical transistor was defined. The last point is unavoidable if the contact to that layer is made outside the perimeter defined by the gate.

4° low integration density resulting from the necessity of separately contacting layers on different levels. In the age of self-aligned planar MOSFETs, one patterning step results in the contacts for all the terminals of the transistors. With vertical transistors where contacts have to be made with 2 or 3 patterning steps, area has to be provided for the inaccuracy of the alignments from on layer to the other. These built-in tolerances can cause a large area penalty (lithography tools have a non-zero alignment accuracy).

Historically, DRAM has been the product driving the advances in micro-fabrication.

DRAMS have got more bits per die, due to the combined effects of ever smaller lateral features, and to ever larger dies. Even these two factors are by no means certain to work in the future. What kind of lithography equipment will provide resolution below 0.1 μm, is very uncertain. Since die size is dependent on the lithography tool used, the answer to the first question will also provide the answer to the second.

In any case, it seems that the factors of progress which worked so well in the past, will fail to do so for the Gigabit age. New approaches are needed to continue the accelerated pace of the past, into one future.

A Random Access Memory (RAM) cell, needs at least one transistor and one charge storage capacitor. Therefore, it is dependent on how small the transistor (usually a MOSFET) can be made. The planar MOSFET, when reducing the lateral dimensions, needs to have very shallow junctions, with low leakage currents. This is a difficult problem, as the 0.12 μm generation is approached. This is very important, because the charge retention in the capacitor is dependent on the leakage current of the transistor. The larger the leakage, the higher the refreshment rate the capacitor needs to be, in order to preserve the stored information .

Aslo to care about, is the capacitor itself. As the lateral dimensions of the capacitor are reduced, so does the total capacitance. Also, operating voltages need to be reduced, but there is a minimum of charge that must be stored, because noise is determined by KT, which is a fixed value. Therefore, the solution for this problem has been to increase the capacitance per area. Such has been achieved by thinning the silicon dioxide between the capacitor plates, and by fabricating three dimensional capacitor structures. The silicon dioxide cannot be scaled beyond the value at which leakage current becomes prohibitive. Three dimensional capacitor structures can increase the effective capacitor area, without increasing the footprint of the cell, but introduce important process complexities, which in turn, tend to decrease the yield. It seems that the future of capacitors lies with planar structures using dielectric materials with large permeability values.

If SOI substrates were used, MISFET leakage current would be strongly reduces. The problem with SOI still resides in the too high cost of substrate.

The document 'A Vertical Submicron SiC Thin Film Transistor', Hwang et al., Solid State Electronics, vol. 38, no. 2, February 1995, pages 275-278, XP000486574 discloses a vertical P-channel depletion mode device applying the MIS effect to modulate the effective barrier seen by holes travelling from the source towards the drain. A heterojunction is created between the channel and the source region by using SiC as channel material. At the source side of the channel-source interface no lowly doped region is present that would allow band bending in the source.

The document 'The Physics and Device Applications of Epitaxially Grown Si and $Si_{1-x}Ge_x$ Heterostructures', M.J. Kearney, GEC Journal of Research, vol. 10, no. 3, 1 January 1993, pages 158-165, XP000377841 discusses the application of epitaxially grown Si and $Si_{1-x}Ge_x$ in semiconductor devices. It is shown that for the Si - $Si_{1-x}Ge_x$ heterojunction almost all the band offset appears within the valence band, while the conductance band offset is very small. Hence a hole-specific barrier can be created. This effect is used for bipolar devices. According to Kearney; Si - $Si_{1-x}Ge_x$ will only find application for p-type Field Effect Transistors in which a hole confinement layer can be created with increased hole mobility.

The present invention aims to suggest as a first object a new device which will be a Vertical MISFET device, preferably with very short channel lengths, preferably short enough to allow ballistic operation and which will simultaneously solve the DIBL problem.

More particularly, the present invention aims to propose PMOS and NMOS transistors having these advantages.

As a second object, the present invention aims to suggest a manufacturable Vertical CMOS process integration capable of replacing the planar CMOS process integration. By manufacturable, is meant that the individual process steps, their complexity, their number and sequence, must be such that a high fabrication yield is obtainable.

A third aim of the present invention is to propose new DRAM cells and/or circuits having memory cells based on silicon Vertical MISFET devices and having a very high integration density.

Many other advantages of the devices and the process integration thereof will be described hereunder.

## Main characteristics of the present invention

The present invention is related to a silicon-germanium based or silicon-carbide based Vertical MISFET device which comprises a stack of several layers including at least a source layer, a channel layer and a drain layer, wherein:

- the channel layer is undoped or lowly doped,
- a heterojunction is formed between the source and the channel,
- a gate is overlapping at least partially with any of the source, the channel and the drain layers with an insulate layer between said gate and said stack of several layers, and

characterized in that

- said gate is overlapping, at an essentially right angle to the stacking direction, said source, channel and drain layers,
- an undoped or lowly doped region is present in the source adjacent to the source/channel interface.

In the case of a PMOS device, the drain is made of a highly p-type doped material preferably the same material as the channel material, the channel is an undoped material, the source comprised at least a double layer consisting in an undoped or lowly p-type doped region and a highly p-type doped region both made of a second material which has a valence band edge with a lower potential energy than the valence band edge of the channel material. Preferably, the device of the PMOS type is characterized by the fact that:

- the drain comprises a highly doped p++ layer preferably Si layer,
- the channel is an undoped layer preferably Si layer, and
- the source comprises at least a double layer consisting in an undoped or lowly doped $Si_{1-x}Ge_x$ layer and a highly doped p++ possibly graded SiGe layer.

In the case of an NMOS device, the drain is made of a highly n-doped material preferably the same material as the channel material, the channel is an undoped material, and the source comprises at least a double layer, consisting in an undoped or lowly n-type doped region and a highly n-type doped region both made of a second material which has a conduction band edge with a lower potential energy than the conduction band edge of the channel material.

According to a first preferred embodiment, the device of the NMOS type is characterized by the fact that:

- the drain comprises a highly doped n++ layer preferably Si layer,
- the channel is an undoped layer preferably Si layer,
- the source comprises at least a double layer consisting in an undoped or lowly doped $Si_{1-x-y}Ge_xC_y$ or $Si_{1-y}C_y$ layer and a highly doped n++ possibly graded $Si_{1-x-y}Ge_xC_y$ or $Si_{1-y}C_y$ layer.

According to another preferred embodiment, the device of the NMOS type can be characterized by the fact that:

- the drain comprises a highly doped n++ layer preferably Ge layer,
- the channel is an undoped layer preferably Ge layer,
- the source comprises at least a double layer consisting in an undoped or lowly doped $Si_{1-y}Ge_y$ layer and a highly doped n++ possibly graded SiGe layer.

**EP 0 749 162 B1**

Several preferred embodiments of PMOS and NMOS devices will be described more in detail hereunder in connection with the description of the drawings.

Using silicon epitaxial compatible materials, the PMOS device has the following configuration: the drain consists of a p++ silicon layer, the channel in an undoped silicon layer and the source in an undoped silicon-germanium layer and a p++ silicon-germanium layer.

Using the same material, the NMOS device is less straightforward due to the small conduction band off-set of SiGe layers drained to Si wafer. Such can be circumvented by the use of a $Si_{0.5}Ge_{0.5}$ virtual substrate. In this case, the NMOS has the following configuration: the drain consists of an n++ Ge layer, the channel in undoped Ge layer, and the source in an undoped or lightly n-type doped SiGe layer and an n++ SiGe layer.

The material configurations are by no means unique. Several variations on this material system are possible in order to achieve the particular band structure desired for each device. For example, the use of $Si_{1-y}C_y$ random alloys strained to Si wafer may yield useful conduction band off-sets which might render unnecessary the use of a SiGe virtual substrate. These devices can also be made in other materials systems like GaAs and related alloys.

For economic production reasons, the silicon-based material will be used in the description of the invention.

Since SiGe is by far the best developed technology to make band-gap engineering using the production facilities of conventional IC manufacturing, the several devices of the present invention will be presented as to be manufactured on $Si_{1-x}Ge_x$ virtual substrate.

The present invention is also related to complementary devices wherein, devices of the PMOS or of the NMOS type are grown on the top of the devices of the NMOS type or of the PMOS type. The three possible configurations for complimentary devices are the CMOS inverter, the PMOS pass transistor, and the NMOS pass transistor.

According to a preferred embodiment, stacks having either PMOS/NMOS/PMOS devices stacked one upon the other or NMOS/PMOS/NMOS devices stacked one upon the other are also possible.

In the case of a CMOS inverter, the PMOS source is grounded, NMOS source is at -VSS, Input signal is put at the common gate contact, and Output signal is taken at the common drain contact.

For pass transistors, a Control signal is put at the gate of a single MOS, to allow or forbid the access of the drain to the signal at the source. Quite often the control signal is a clock. So, for pass transistors, the terminal of the PMOS must be fully independent of the terminals of the NMOS and vice-versa.

According to the present invention, a surrounding gate is provided common to the whole stack of the several devices and preferably such stack of devices has also a drain contact common to all the stacked devices preferably made inside the perimeter of the stack of device.

The source contact can either be only provided to the bottom or to the top device, preferably made inside the perimeter of the stacked devices or be common to all the devices made on the whole substrate or wafer wherein the several stacks of devices are defined through a unpatterned wafer backside.

The present invention is also related to a process integration for Vertical MISFET devices of the invention, each of the MISFET devices comprising a stack of several layers including at least a source layer, a channel layer and a drain layer, a heterojunction being present between said source layer and said channel layer, and having a surrounding gate and insulator overlapping at least partially the several layers of the MISFET device, and further having an undoped or lowly doped region in the source adjacent to the source/channel interface, said gate and insulator being at a right angle to the stacking direction of said several layers, said process being characterized in that :

- one epitaxial deposition sequence on a silicon substrate is used for defining the several layers of each Vertical MISFET device possibly stacked,
- a patterning step consisting in a lithographic/etch step is used to create the surrounding gate around the possibly stacked device or devices, and
- other patterning steps are used to make contact to the source and to the drain of each Vertical MISFET device possibly stacked.

Preferably, the patterning step used in order to make the contact to the drain of the devices- is performed in order to have said drain common to several stacked devices preferably made inside the perimeter of the stacked device or devices.

Preferably, the stacked devices are also defined by a single uninterrupted epitaxial deposition in order to create stacks of NMOS/PMOS or PMOS/NMOS or NMOS/PMOS/NMOS or PMOS/NMOS/PMOS devices.

Preferably, the epitaxial deposition sequence uses a virtual $Si_{1-x}Ge_x$ substrate in order to create a heterojunction in each of the PMOS or NMOS device or devices.

Heterojunction can also be done by incorporating group IV elements and appropriate dopants in order to create significant energy barriers.

According to a preferred embodiment, the present invention suggests a CMOS process integration for Vertical Heterojunctin MISFET devices comprising at least the following steps:

- Epitaxy of Several Layers of a Vertical MISFET device;
- Deposition of the Insulator or Insulators;
- Mask 1: Definition of Configuration units (MESAS) each corresponding to one stack;
- Formation of Gate Electrode on Mesas Sidewalls;
- Gate Electrode Etchback (Spacer-like Electrode);
- Planarization: Filling of Spaces Between Mesas;
- Mask 2: Formation of Gate Contact Pad;
- Mask 3: (Common) Drain Contact Holes
- Formation of Spacers at least Partially on the Internal Side Walls of the Top/Bottom Device;
- Contact Hole Filling with Silicide & Metal;
- Mask 4: Contact Hole to Source of Top Device;
- Contact Hole Filling with Silicide & Metal;
- Metallization

The present invention is also related to RAM circuits comprising memory cells and a logic circuitry. According to a first preferred embodiment, each of the memory cells comprises at least one Vertical MISFET device of the invention, having itself a stack of several layers including at least a source layer, a channel layer and a drain layer and comprising a capacitor on the top of the stack of several layers of the Vertical MISFET device.

According to a second preferred embodiment, each of the memory cells comprises at least two Vertical MISFET devices of the invention, on the top of each other and having a capacitor there between.

Preferably, the Vertical MISFET devices are monocrystalline Vertical MISFET devices.

According to a preferred embodiment, the Vertical MISFET devices are Vertical Heterojunction MISFET devices comprising at least:

- a channel layer which is undoped or lowly doped;
- a heterojunction which is formed between the source and the channel with a presence of an undoped or lowly doped region in the source near the source/channel interface, and
- a gate which is overlapping, preferably essentially at right angle, at least partially the source, the channel, and the drain layers with an insulate layer there between.

The on-chip logic circuitry in these RAM circuits can be realized either with planar transistor or transistors or with Vertical MISFET device or devices and preferably, Vertical Heterojunction MISFET device or devices.

## Description of the drawings

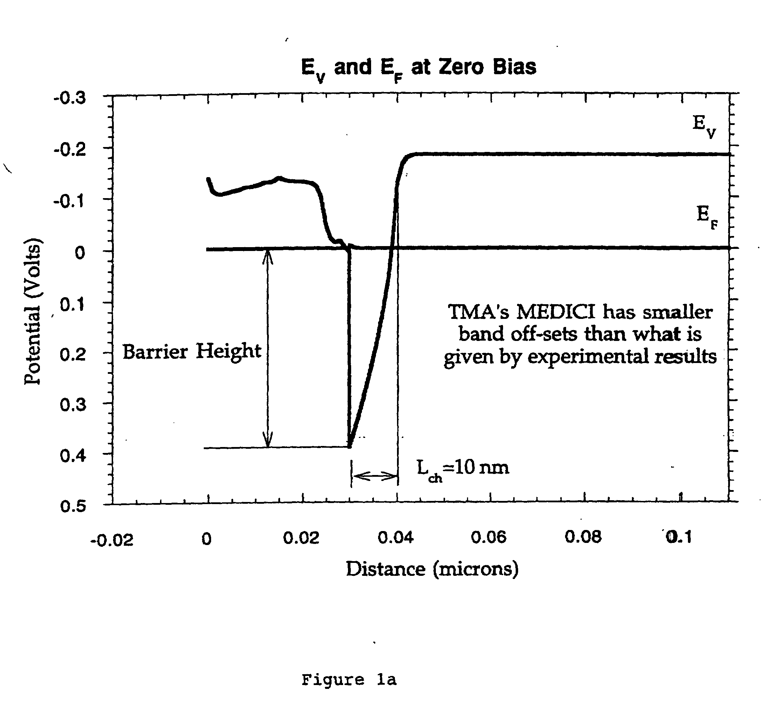

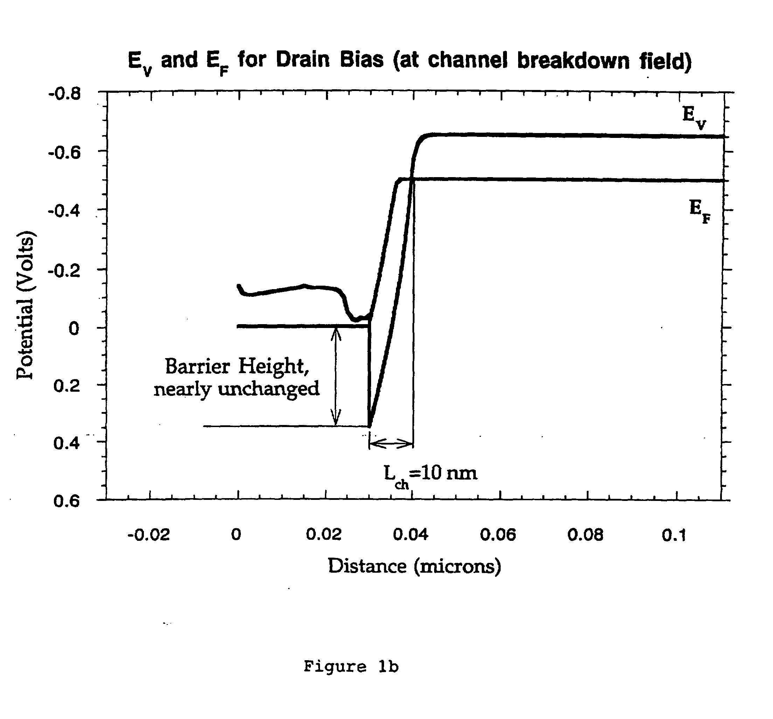

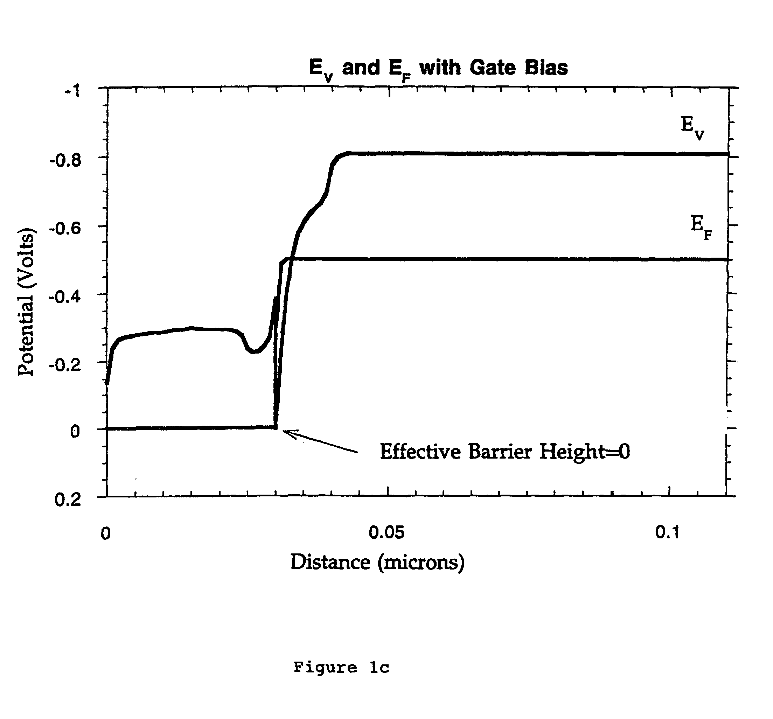

Fig. 1 represents the band structure and the electrochemical potential in function of the distance (from the source to the drain) for a PMOS device according to the present invention under the three following bias conditions:

no bias (fig. 1a),
drain bias (fig. 1b),
drain and gate bias (fig. 1c).

Figs. 2 represent schematic view of a PMOS device (fig. 2a) and a NMOS device (fig. 2b) respectively according to a first preferred embodiment of the present invention, wherein these devices are strained to a Si wafer.

Figs. 3 represent schematic view of a PMOS device (fig. 3a) and a NMOS device (fig. 3b) respectively according to a second preferred embodiment of the present invention, wherein these devices are strained to a $Si_{0.5}Ge_{0.5}$ wafer.

Figs. 4 represent schematic view of a PMOS device (fig. 4a) and a NMOS device (fig. 4b) respectively according to a third preferred embodiment of the present invention, wherein the devices are more symmetrical.

Fig. 5 represents a schematic view of a Vertical CMOS inverter which is manufactured according to the CMOS process integration of the present invention.

Fig. 6 represents schematically the band structure in the case of no bias applied for a CMOS inverter as described in fig. 5.

Figures 7 and 8 represent a schematic view of a Vertical NMOS and PMOS transistors respectively.

Fig. 9 represents schematically a general process flow for manufacturing a CMOS inverter according to the present invention.

Figs. 10, 11, 12, 13 represent several embodiments of process flow used as CMOS process integration.

Figs. 14 and 15 represent schematically general process flows for manufacturing RAM circuits according to two preferred embodiments of the present invention.

Fig. 16 represents a schematic view of a RAM cell according to the second preferred embodiment of the present invention.

Figs. 17, 18, 19, 20 and 21 represent several embodiments of process flow intended for manufacturing RAM cells or circuits according to several preferred embodiments of the present invention.

## Detailed description of the several embodiments of the present invention

A first object of the present invention is related to a silicon-based vertical MISFET and preferably MOSFET device having a heterojunction which does not suffer from DIBL problem and for which it is possible to allow the transfer across the heterojunction.

Fig. 1 represents the band structure and the electrochemical potential as functions of distance (from source to drain) for PMOS device, wherein the plots are obtained with a commercial device simulator (TMA's Medici with heterojunction module).

More particularly, Figs. 1a, 1b, 1c show three possible bias conditions: no bias, drain bias only, drain and gate bias respectively.

If one looks at the Source, as a thermalized carrier reservoir, the fraction of those carriers with energies higher than the barrier height, is given by the Fermi-Dirac Distribution. Already for around 10 KT barrier height, the distribution is very close to zero. For devices with channel lengths smaller than the carriers mean free path, the current is solely determined by the barrier height, and independent of the channel length. In this case the off-state current is given by the thermionic emission over the barrier. That is, provided tunnelling is suppressed (see fig. 1a).

The devices according to the present invention are the first one to make possible the lowering of an heterobarrier by an insulated-gate action. These devices indicate that with the appropriate source engineering, drift-diffusion or ballistic transport (depending on temperature and channel length) can also take place across heterojunctions.

The band discontinuities (difference between two band edges) among two different materials, depend on if they are pseudomorphic and how much strain there is. But once a layer configuration is in place, the band off-sets cannot be changed, because they result from the interfacing of the two different materials or alloys.

The effective barrier height seen by a carrier in the lower potential energy material (source), depends on its energetic position inside the band, that is, the distance between its energy level, and the band edge. For a thermalized carrier, this difference depends on the availability of the lower energy states. If the carrier can occupy an energy state at the edge of the band, then the barrier height is equal to the band discontinuity.

When the Electrochemical Potential is inside the band (it can then be called Fermi-Level) of the Source material, the states between the edge of the band and the Fermi-Level are occupied, and therefore are no longer available for an incoming particle.

If indeed, the lowest energy states available to an incoming particle are only those at the Fermi-Level, the Effective Energy Barrier that the particle will "see", will no longer be the difference between the Band Edges of Source and Channel, but the difference between the Band Edge of the Channel and the Fermi-Level of the Source.

For semiconductors with low doping levels, the relative position between electrochemical potential, and band edge can be significantly modulated (in this device is accumulation) by field effect in a MIS structure.

By modulating the relative position (to the Source Fermi-Level) of the Source Band Edge, the barrier height "seen" by a particle travelling from Source to Drain, can then be modulated. In this particular case one is interested in doing this modulation through the field effect of a Gate.

When the Gate is "off" (fig. 1b), one wishes to have the minimum (thermionic) current possible flowing from Source to Drain (even with drain bias already applied). Therefore the barrier height should be maximum, that is, the full amount of band discontinuity should be seen by all carriers at the source. Thus the Electrochemical Potential (at the Source) should be in the gap, or at least at the band edge.

As it can be seen in the plots, tunnelling will not take place, because the width of the barrier, at the concerned energy levels, is just too large.

In the off-state, with applied drain bias, the potential drop between the highly doped regions of source and drain, is distributed (unevenly) over the channel, and the undoped region of the source. In order to minimise DIBL, the potential drop (band bending) in the undoped part of the source, should also be minimised. Such is possible by making that region the smallest possible. Simulations show that 5 or 10 nm are enough for the mechanism of barrier lowering to work. In the off-state, only thermionic current flows from source to drain.

When the Gate is "on" (fig. 1b), one wants to have a zero barrier height (< 1KT). This means that in the Source, all energy states up to the level of the Channel Band Edge, are occupied, that is to say, the Fermi-Level (in the Source) should match the Band Edge Level of the Channel (actually to the level of the first bound state of the quantum well in the channel).

To achieve this behaviour, it is necessary to be able to bend the band at the Source just before the Channel, that is, just before the heterojunction. There lies the reason for the lowly doped region in the Source near the Channel interface. This is also the reason why a metallic or degenerately doped semiconductor Source can not work. This turn-on mechanism and the asymmetric structure, make a clear the distinction between this device and others suggesting the use of heterojunctions in Field Effect Transistors.

The channel is defined as the region where the potential drop occurs in the on-state.

The undoped region just before the heterojunction is considered a part of the source (and not of the channel) because in the on-state, there is no potential drop in that region. In the on-state, the Fermi Level is well inside the band throughout entire source region until the heterojunction.

Drain is defined as the region after the channel, where the Fermi level is inside the band (the semiconductor is degenerate), and there is no potential drop.

It has to be kept in mind that, this barrier lowering occurs by the action of a MIS structure overlapping source and drain. Therefore it is obvious that devices based on the Schottky gate concept cannot reproduce this effect, and are governed by a completely different mechanism (barrier thinning to enable tunnelling).

It has been indicated how to produce large barrier heights for the off-state, of MISFETs with channel lengths less than 20 nm. It has also been established a new mechanism to make the barrier become zero, for the on-state. With such short channel lengths, ballistic operation can be expected, at room temperature.

A recent publication "Ballistic Metal-Oxide-Semiconductor Field Effect Transistors" of Kenji Natori, J. Appl. Phys. 76(8), 15 October 1994, and concerning the modelling of ballistic homojunction MISFETs can be applied to the present devices. Since this device has a MOS gate-induced barrier lowering, it is irrelevant if the barrier is made with homojunctions or heterojunctions. What is important is the ability to modulate its height with a MOS gate.

The devices according to the present invention can be implemented in any materials system, provided that a heterojunction and a MIS structure are possible. Due to the dominant position of the silicon technology in the microelectronics industry, the silicon based materials are the most attractive one for the implementation of this device concept.

In order to make the PMOS devices, valence band off-sets are needed, and to make the NMOS devices, conduction band discontinuities are necessary.

The simplest way two obtain valence band off-sets, is to have coherently grown $Si_{1-x}Ge_x$ films on Si wafers. It is known that in SiGe layers, the valence band goes up, without any significant effect on the conduction band.

Conduction band off-sets are less straightforward to obtain. For the moment, two alternatives seem possible. The first is to grow pseudomorphic $Si_{1-y}C_y$ or $Si_{1-x-y}Ge_xC_y$ alloys on Si wafers. There is strong indication that the incorporation of carbon in the films, causes a lowering of the conduction band. In this case, complementary devices can be grown directly on a silicon wafer.

The second is to arrange a SiGe substrate, and grow strained SiGe films with a Ge content different from that of the substrate (higher Ge contents make a barrier for electrons). In this last case, the PMOS could also be made by growing SiGe films with Si content different from that of the substrate (with higher Si contents make a barrier for holes).

The actual composition of the PMOS and NMOS layers in terms of Ge and/ or C percentages, depend on the band off-sets sought, which in turn are a function of the off-state current one wishes to have.

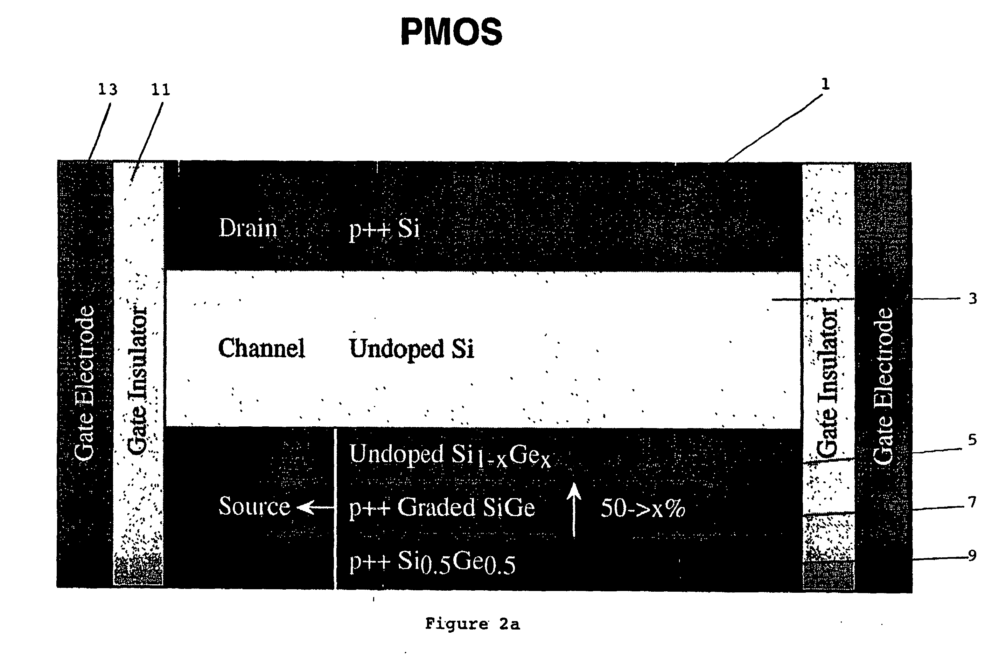

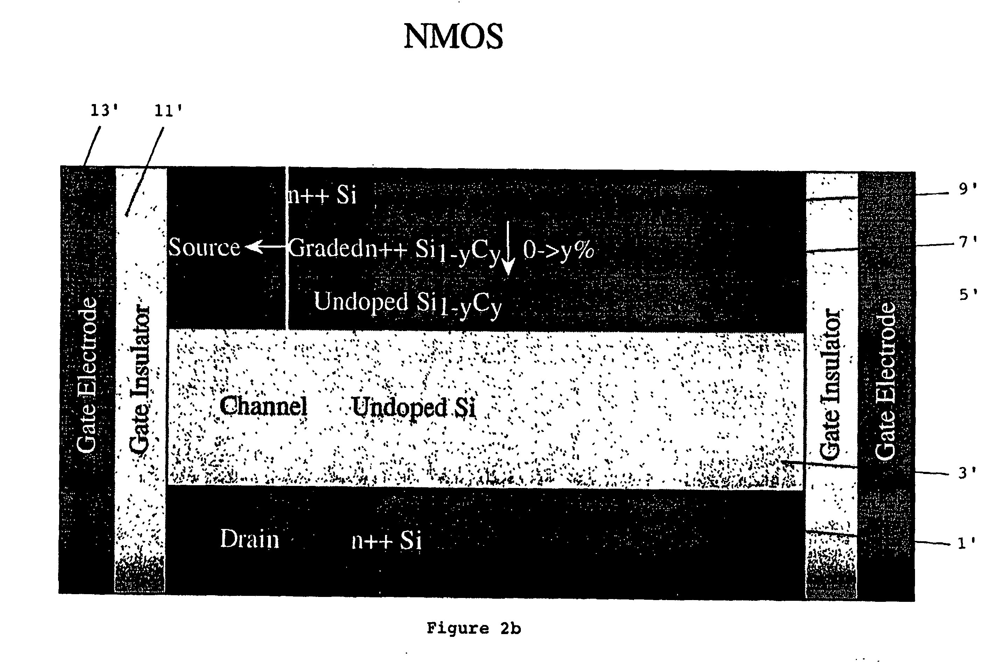

Figs. 2, 3, 4 represent several embodiments of PMOS and NMOS devices which are Vertical Heterojunction MISFET (VHMISFET) according to the present invention.

More particularly, Figs. 2a and 2b represent a PMOS and an NMOS device respectively which are strained to a Si substrate and which are manufactured with conventional epitaxial growth techniques.

Fig. 2a is representing the PMOS device- wherein the drain (1) comprises at least a very highly doped p++ Si layer, the channel (3) comprises an undoped or lowly doped Si layer and the source comprises at least a double layer comprising an undoped or lowly doped $Si_{1-x}Ge_x$ layer (5) and a very highly doped p++ graded SiGe layer (7). The source of the PMOS device is strained to a highly doped p++ Si wafer (9).

Fig. 2b represents more particularly an NMOS device wherein the drain (1') comprises at least a very highly doped n++ Si layer, the channel (3') comprises an undoped or lowly doped Si layer, and the source comprises at least a double layer comprising an undoped or lowly doped $\_Si_{1-y}C_y$ (5') and a very highly doped n++ graded $\_Si_{1-y}C_y$ layer (7'). The source of the NMOS device is strained to a highly doped n++ Si wafer (9').

In both devices represented in figs. 2a and 2b, the gate dielectrics (11 or 11') and the gate electrodes (13 or 13') are overlapping essentially vertically at least partially the source, the channel and the drain layers. Both devices have three terminals and are completely surrounded by the gate.

From the fabrication point of view, it is preferable to have all layers strained to a Si wafer, instead of buffer layers.

There are also device physics reasons to prefer this approach: for both transistors the channel is made of the same material, pure silicon, which has a higher breakdown voltage than Ge-rich alloys, alloying a higher $V_{DS}$ (and therefore $V_{GS}$) value for the CMOS circuit. Also, Ge-rich alloys have a considerably smaller band-gap, which increases thermal generation of carriers, which in turn might hinder high temperature operation.

In any case, both configurations are possible for. room temperature. Low temperature operation, solves all sorts of objections for the use of Ge-rich alloys as the channel material.

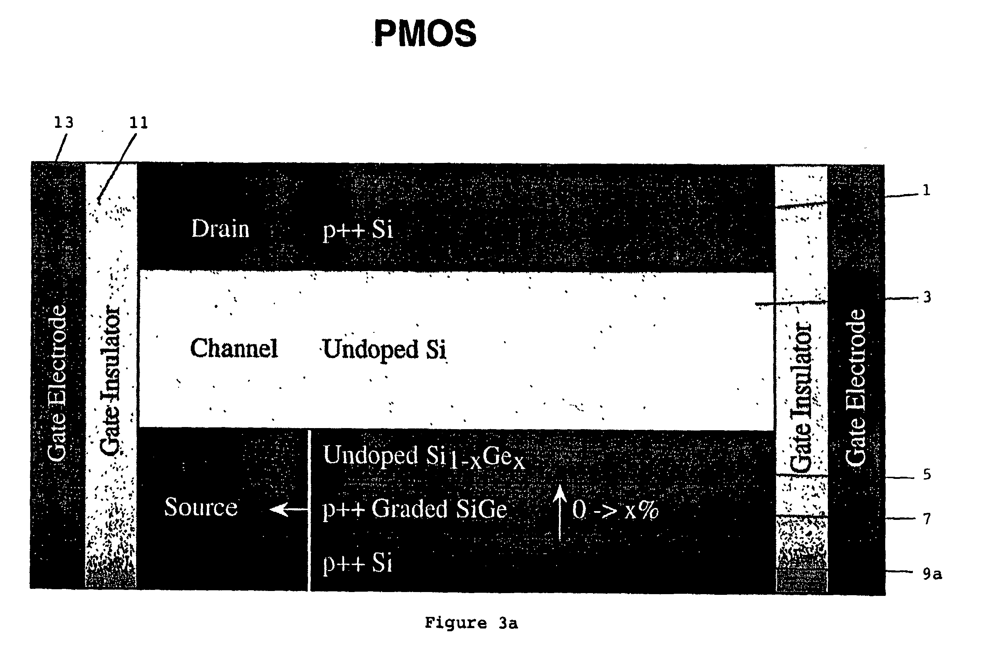

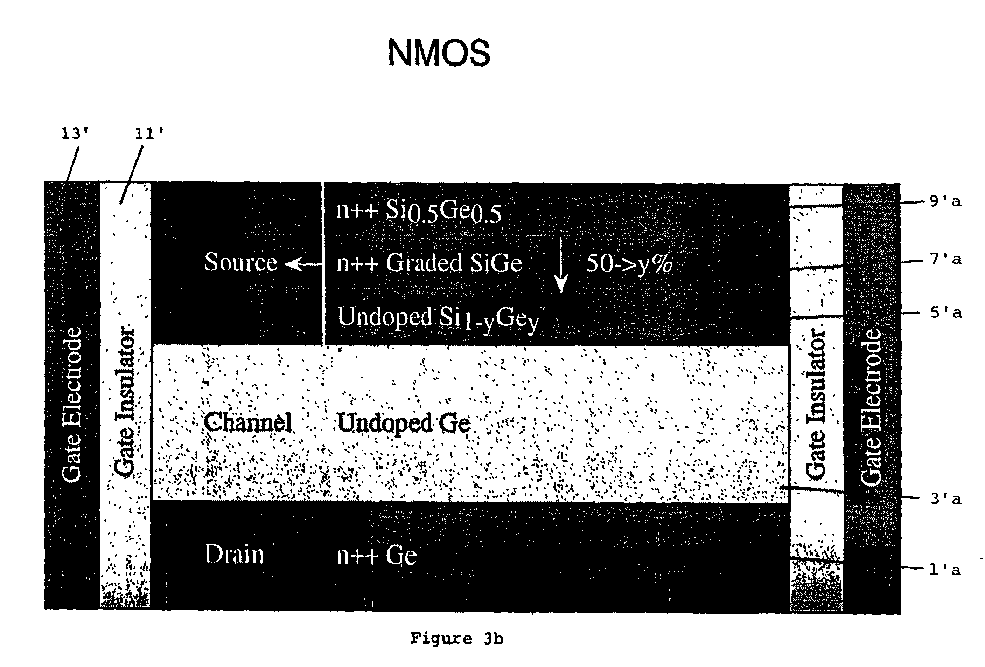

If a SiGe substrate is preferred to the epitaxy of $Si_{1-x-y}Ge_xC_{y \ or} \ Si_{1-y}C_y$ alloys on Si substrates, then the device structures are those shown on Figs. 3a and 3b which represents a PMOS and NMOS device respectively strained to a SiGe substrate.

In the case of the PMOS device represented in fig. 3a, the source is strained to a highly doped p++ $Si_{0.5}Ge_{0.5}$ layer (9a).

In the case of an NMOS device represented in fig. 3b, the source is strained to a highly doped n++ $Si_{0.5}Ge_{0.5}$ layer (9a').

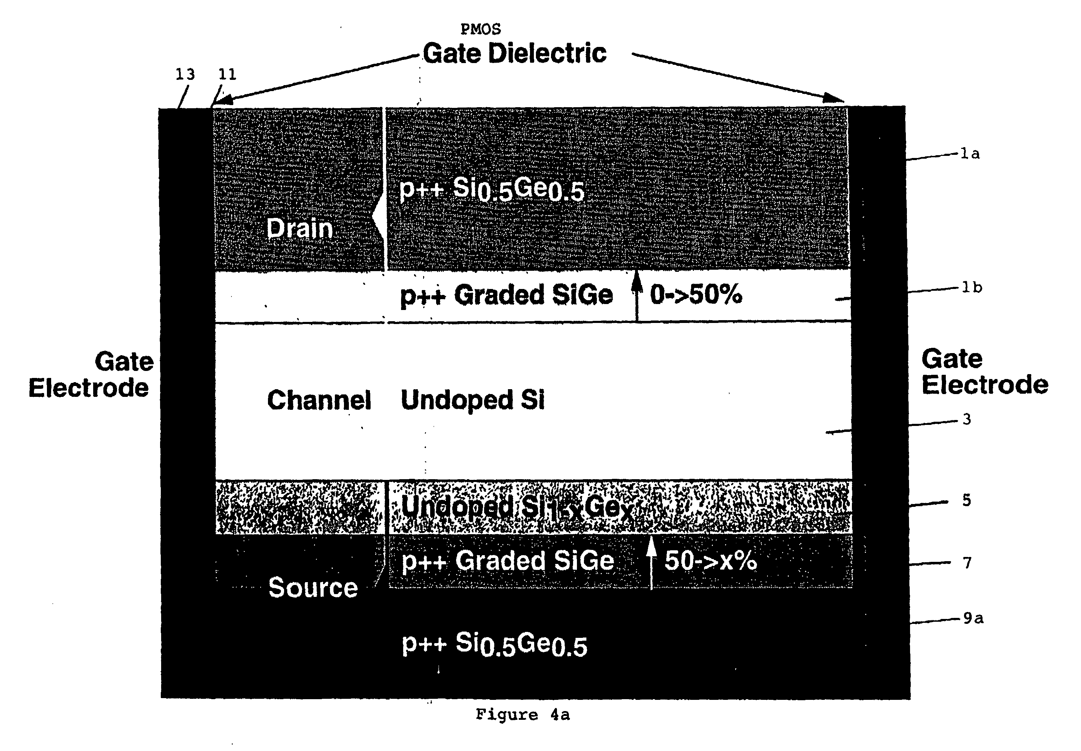

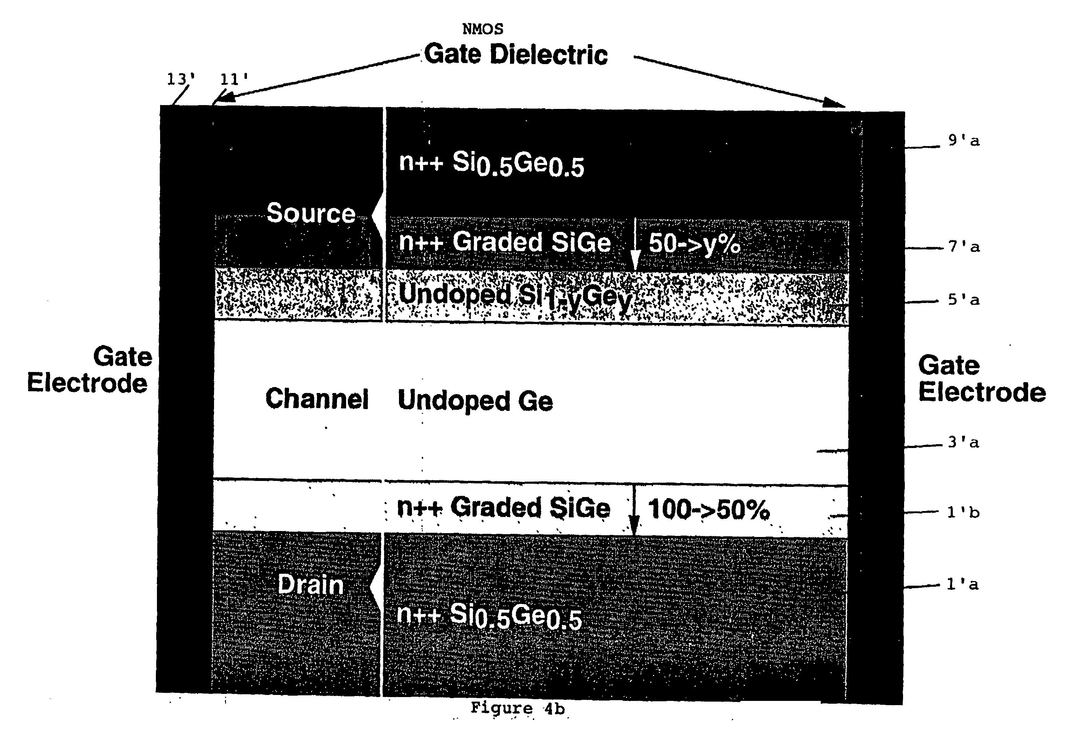

Due to strain considerations, the drain layer structure of figures 3a and 3b can also be changed into the layer structure of figures 4a and 4b, respectively.

In the case of a PMOS device represented in fig. 4a, the drain comprises at least a highly doped p++ graded SiGe layer (1a) and a highly doped p++ $Si_{0.5}Ge_{0.5}$ layer (1b).

In the case of an NMOS device represented in fig. 4b, the drain comprises at least a highly doped n++ (graded) SiGe layer (1a') and a highly doped n++ $Si_{0.5}Ge_{0.5}$ layer (1b').

In the case of SiGe substrate, using pure Si and pure Ge for the channels materials is preferable because it avoids alloy scattering. But, because strain imposes a limit on the film thickness, this will only be possible for very thin films (very short channels).

The progress in the epitaxy of group IV elements and low temperature processing, may one day allow the use of carbon, silicon, germanium and tin heterostructures grown on silicon wafers or buffer layers, and provide more possibilities for the band edge engineering. With the possibility of using all those elements, some of the layer compositions here proposed, might be somewhat different.

There are three possible configurations for complementary devices: CMOS inverter, PMOS pass transistor, and NMOS pass transistor. In a CMOS inverter, PMOS source is grounded, NMOS source is at -VSS, Input signal is put at the common gate contact, and Output signal is taken at the common drain contact. For pass transistors, a Control signal is put at the gate of a single MOS, to allow or forbid the access of the drain to the signal at the source. Quite often the control signal is a clock. So, for pass transistors, the terminal of the PMOS must be fully independent of the terminals of the NMOS and vice-versa.

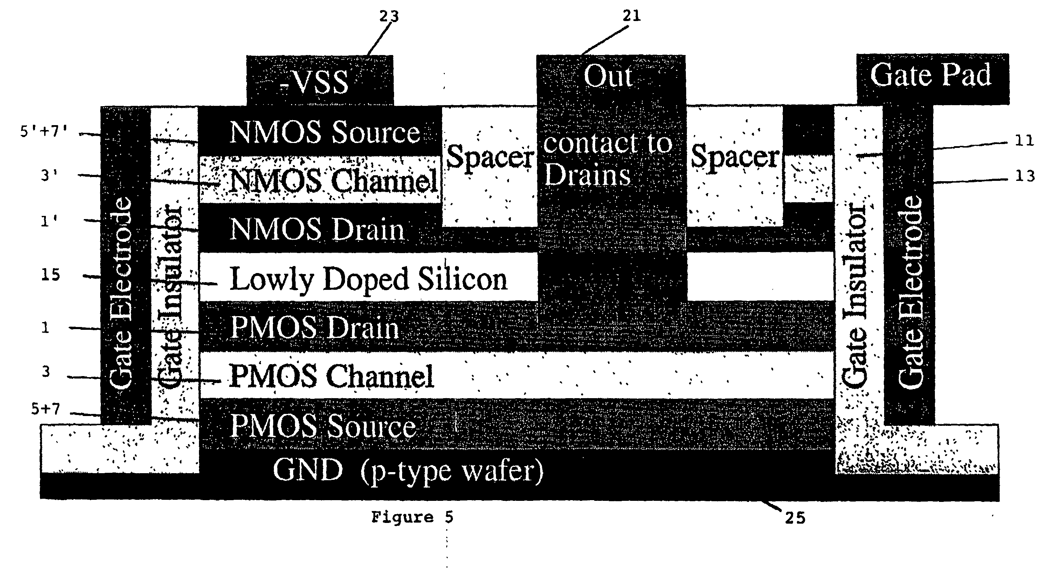

Fig. 5 represents a preferred embodiment CMOS inverter according to the present invention made with Vertical Heterojunction MISFET wherein an NMOS transistor is grown on the top of the PMOS transistor and having their drains, n++ and p++ layers (1' and 1) facing each other. Both drains of the PMOS and the NMOS transistors are separated by a drain barrier (15) which should comprise a barrier layer for electron for the NMOS transistor and a barrier layer for holes of the PMOS transistor.

To make the CMOS inverter an ohmic contact (21) to both drains (1 and 1') is necessary while an ohmic contact (23) to the source (5') of the NMOS transistor and an ohmic contact (25) to the source (5) of the PMOS transistor are made separately one on the front surface and the other back surface of the CMOS inverter.

Of course, the opposite, a PMOS transistor grown on the top of an NMOS transistor is another possible alternative to built a CMOS inverter.

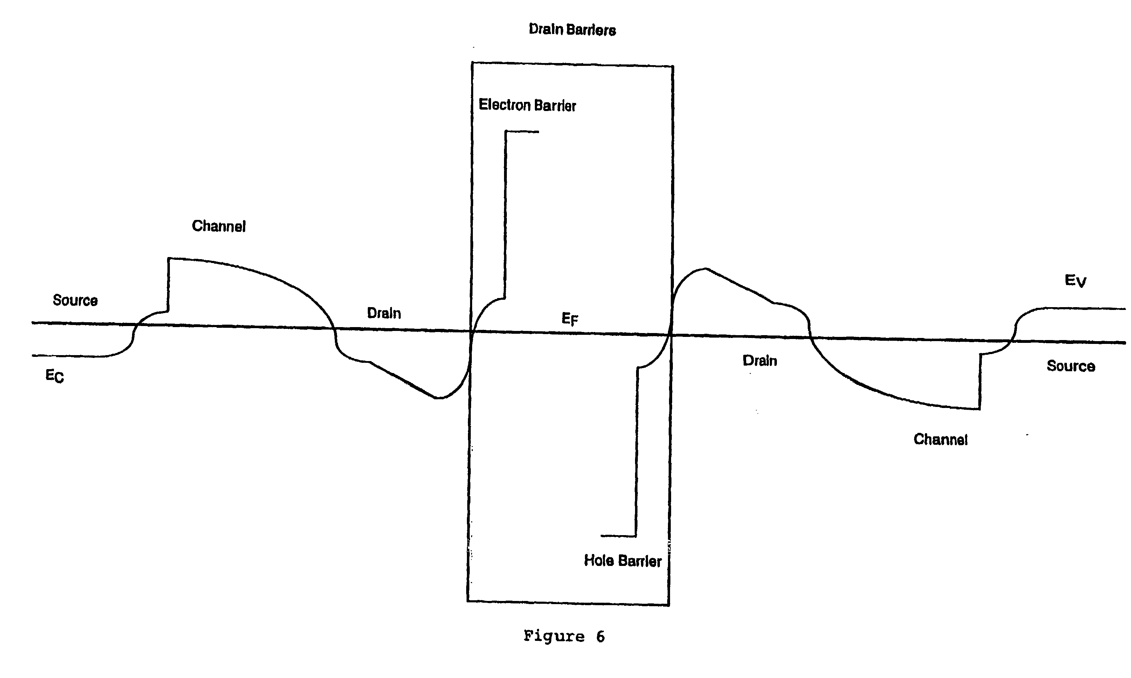

Figure 6 shows schematically the band structure in case of no bias applied for a CMOS inverter as described in fig. 5. The barriers made with semiconductor heterojunctions, are smoothly integrated in the middle of the epitaxial stack to be grown. And this is also true for transistors making use of homojunctions only. These heterobarriers are useful in the sense that they can minimise the inverter area.

If the heterobarriers were not possible to include, then the bottom sources could not have a common contact through the backside of the wafer, and would need individual contacts through the front side. In this way, a contact shunting the PMOS source and drain, biased to the supply voltage of the top transistors would eliminate the PIN diode action. The only advantage of having front side individual contacts to the sources of the bottom transistors is that, it is straightforward to make pass-transistors also of the bottom kind. But the extra contact from the front-side, would mean more area per CMOS stack.

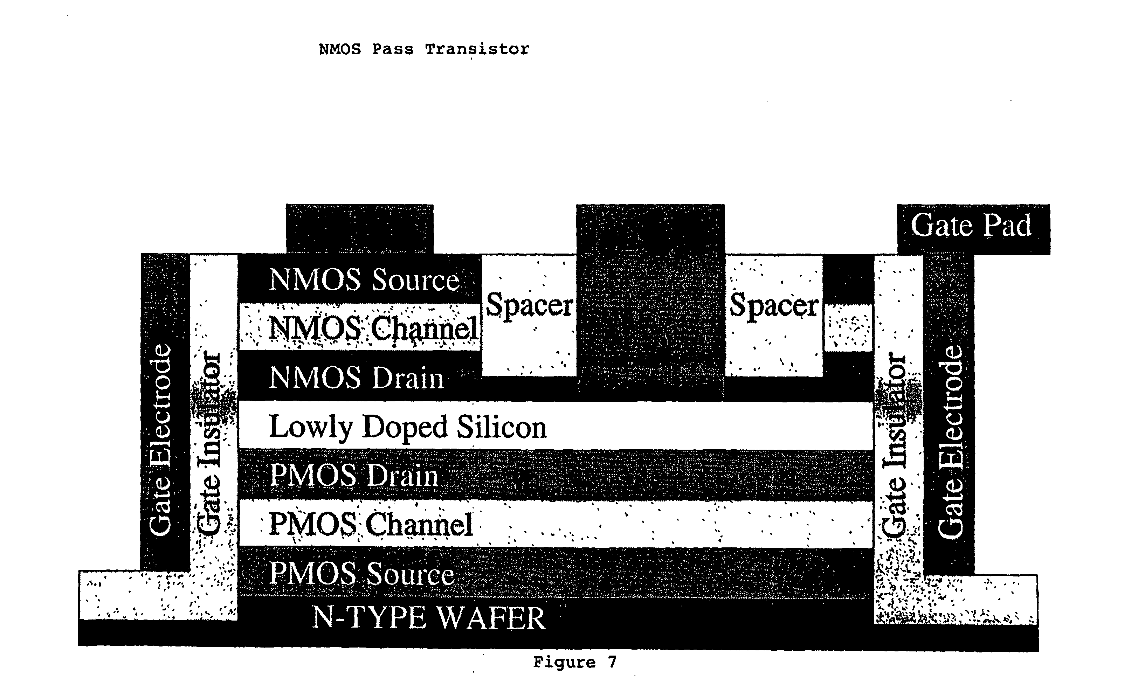

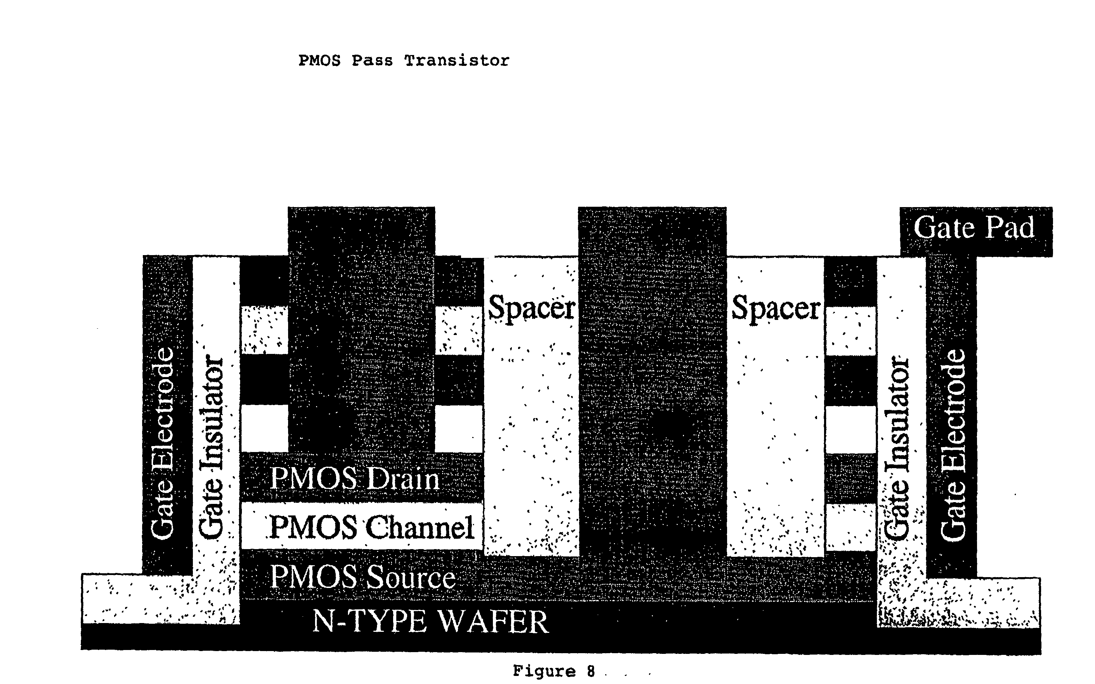

Figures 7 and 8 are representing NMOS and PMOS pass transistors respectively made with Vertical Heterojunction MISFET devices according to the present invention.

Assuming that insulating or semi-insulating barriers can be included in the epitaxial stack, there is another architecture, where CMOS, NMOS and PMOS pass transistors can co-exist without area penalty compared with the simple CMOS. In this architecture, three transistor layers are formed, where the layers of the bottom transistor are repeated on top of what was the top transistor, which now becomes the middle one. In this new stack, PMOS/ NMOS/ PMOS, the bottom PMOS will have all sources connected together to the ground. These PMOS and NMOS will be used for the CMOS inverter. Whenever a PMOS pass transistor is needed, the top PMOS will be used. The NMOS can be used as a pass transistor or as a part of the CMOS. In this case there will be no area penalty, and not processing complexity, other than forming for a second time the PMOS layers.

A second object of the present invention is to suggest a new type of integration architecture for Vertical MISFET devices which will solve the four main items mentioned hereabove which can occur in CMOS process integration using conventional vertical devices as known in the state of the art.

1° A single epitaxial growth step on an unpatterned wafer, where the layers of one type of transistor (say NMOS) are grown sequentially on top of the layers of the other type of transistor (say PMOS), at the beginning of the fabrication process. This solves the first problem.

2° Reducing the gate to drain capacitance comes at a price, which is either higher series resistance, or process complexity, and more critical steps: a "thick" oxide can be grown on the drain areas which are more distant from the channel, while only a thin dielectric is formed on the source, channel and immediate regions of drains. This should solve the second problem. Naturally, a higher process complexity, is the drawback of such scheme.

3° A solution for the third problem is the formation of the gate electrode, which if deposited as a fairly thin film, and etched-back (spacer-like) provides a very low overlap on the bottom and top layers (sources of PMOS and NMOS).

4° The fourth problem will be addressed through a very high degree of self alignment, which results in only 3 or 4 masks (plus the marker layers), to make the entire front end of the CMOS circuit. Such is achieved by the careful arrangement of materials, thereby obtaining high etch selectivities, which in turn make possible the high degree of self-alignment.

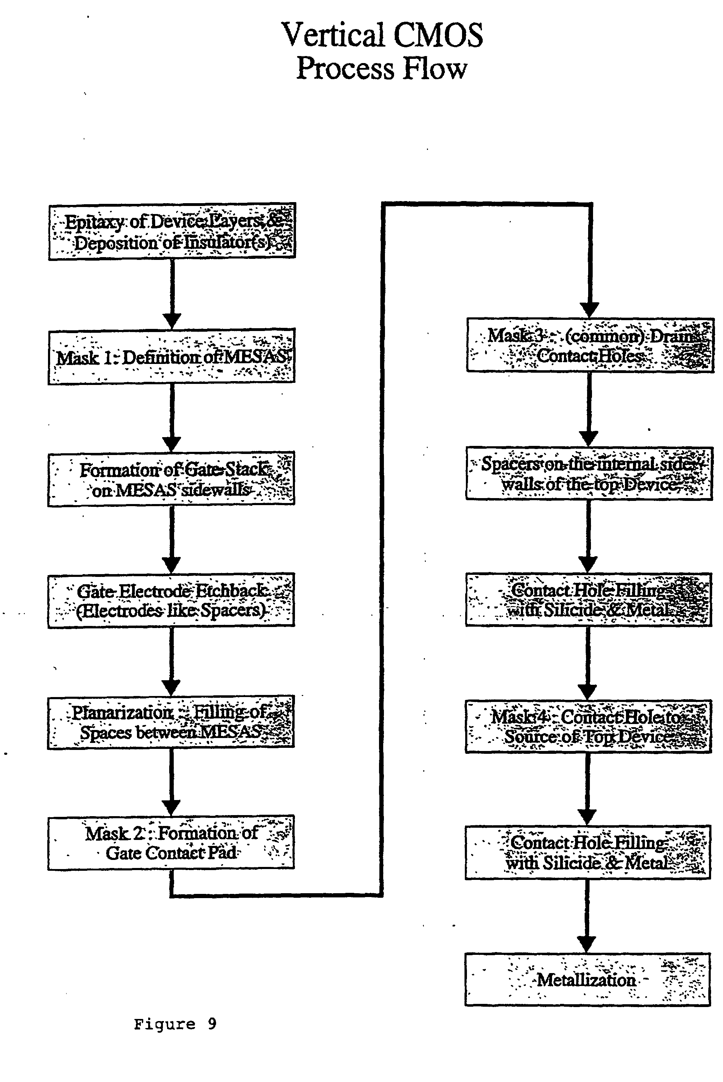

More particularly, fig. 9 is describing a general process flow for a vertical CMOS process integration which comprises at least the following steps:

- Epitaxy of Device Layers,
- Deposition of Insulator(s);
- Mask 1: Definition of Mesas(which corresponds to the configuration units);
- Formation of Gate Stack on Mesas Sidewalls;
- Gate Electrode Etchback (Spacers-like Electrode);
- Planarization: Filling of Spaces Between Mesas;
- Mask 2: Formation of Gate Contact Pad;
- Mask 3: (Common) Drain Contact Holes
- Formation of Spacers at least Partially on the Internal Side Walls of the Top/Bottom Device;
- Contact Hole Filling with Silicide & Metal;
- Mask 4: Contact Hole to Source of Top Device;
- Contact Hole Filling with Silicide & Metal;
- Metallization

For process simplicity, except for contacts, all the rest of processing should be the same for any kind of configuration. With this scheme, very compact CMOS inverters can be made. For NMOS pass transistors (not represented), individual contacts to the NMOS source and drain have to be made. But this is not enough, because the gate is also overlapping the PMOS layers. Every time the gate switches there is a forward biased PIN diode (with the same cross section of the devices), thereby making the circuit leaky.

Ideally, an insulator should exist between the PMOS and NMOS drains. Considering that the epitaxy of semiconductor/ insulator/ semiconductor, is not developed at the level of the epitaxy of semiconductors only, large semiconductor heterobarriers can provide a semi-insulation and keep the processing compatibility.

So, a very large heterobarrier for electrons should be placed under the NMOS drain, and one for holes on top of the PMOS drain. This way, injection of holes beyond the PMOS drain and injection of electrons beyond the NMOS drain are blocked. Throughout the cross section of the devices, these drain barriers need not to be larger than the transistor's barrier. But because at the gate interface, the barriers are lowered, the only way to completely block the current there, is to have barriers with roughly two times the height of the transistor's barriers. Unfortunately, the barrier heights obtainable with heteroepitaxy of SiGe on Si may not be enough. There is hope that other group IV elements may provide the desired magnitude of band discontinuities.

To cover the several possible architectures, a few process flows are describe hereunder more in detail:

For the process flows that follow, several advanced process steps are included. Some of these steps could also be done with less advanced techniques, but that increases the number of steps and some times their criticality. Although some of included steps are not yet commonly used by the microelectronics industry, they might soon be. Others are based on the scientific demonstration of a given process for which there was no obvious application by the industry at large scale. In any case every step which is included in these process flows has been already clearly demonstrated, and is used here for the construction of a completely new CMOS process integration.

Relevant to the fabrication of vertical transistors, are for example, the vertical sidewall formation, by dry etch.

The low temperature arrangement of the gate dielectric and electrode on that surface.

Regarding heterojunction vertical transistors, the existence of different materials, has also to be taken into account, in cases like the ohmic contacts, where the deposition (selective if possible) of a silicide is preferable because it does not depend on the substrate composition. Highly selective dry etch of PSG over an undoped oxide helps in the self-alignment of some fabrication steps.

For practical reasons, some choices had to be made on what to depict in the drawings. These choices however do not damage the generality of what is being proposed. For example the ordering of which transistor is on the bottom or on the top. For all purposes those positions can be interchanged. Another example is the arrangement of ohmic contacts through selective deposition of silicides and metals. These could, of course, be made in a more conventional way, by deposition and etchback. Even the silicides could be replaced by germanides for example. Again, the specification of materials or of particular ways to achieve a certain result, are given as a real examples, not as unique ways of doing performing them.

Also optional, is the removal of the wafer bulk in some flows. The contact to all PMOS sources can be made with or without removing the wafer bulk. This removal can be useful for very high frequency circuits, where the wafer bulk could introduce parasitic interferences in the circuits. In some of the flows this optional removal is shown.

**Process Flow**

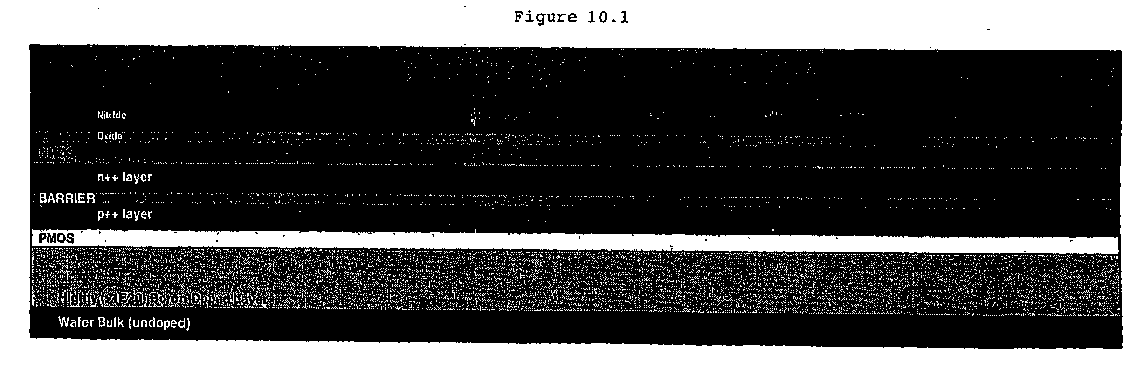

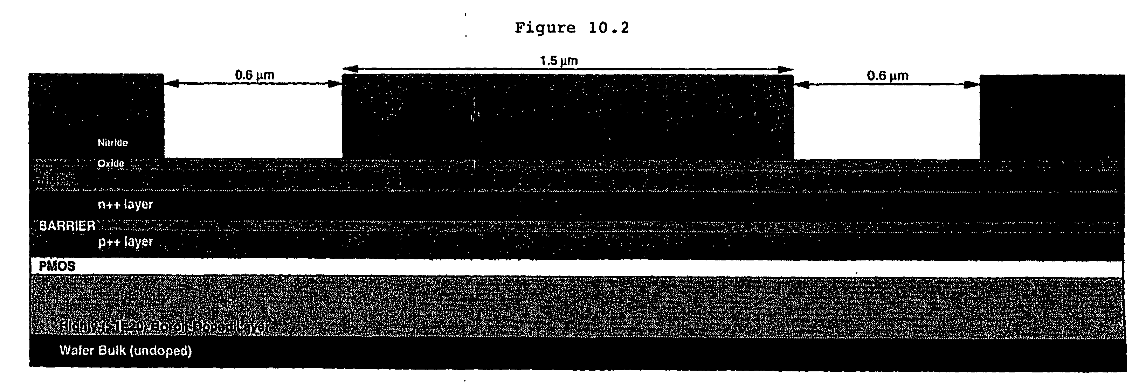

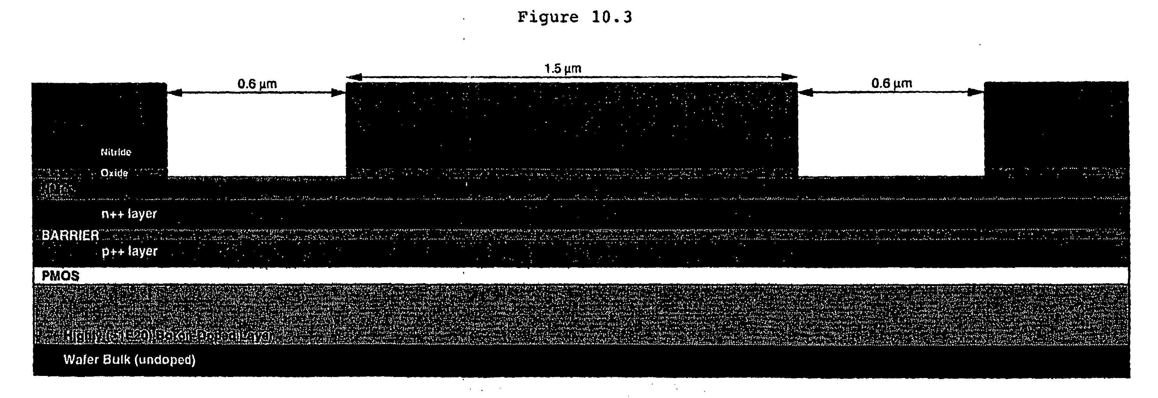

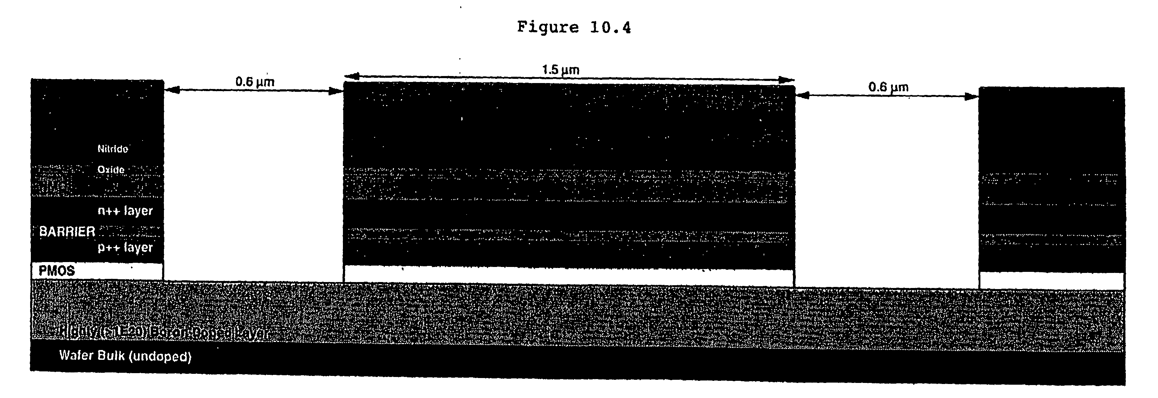

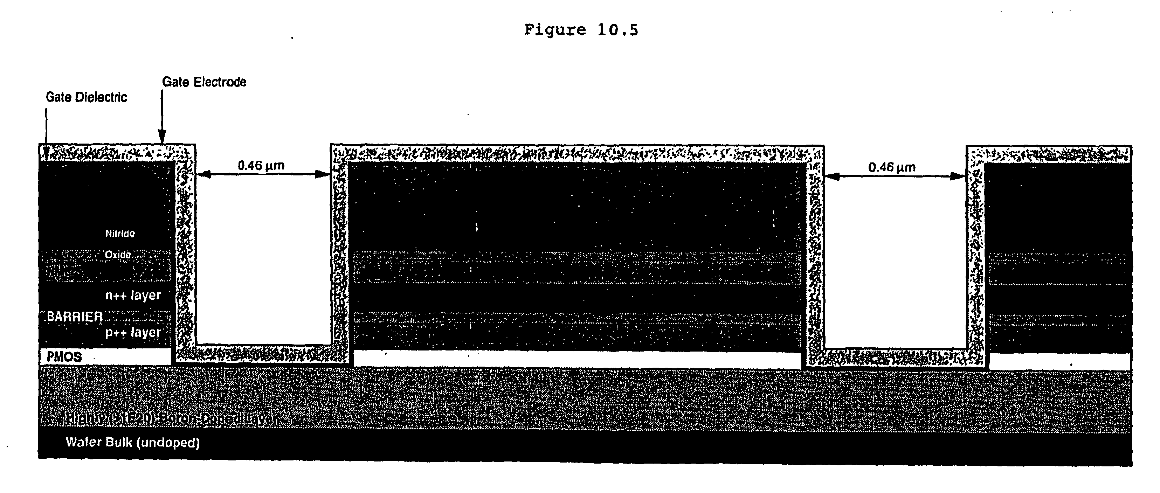

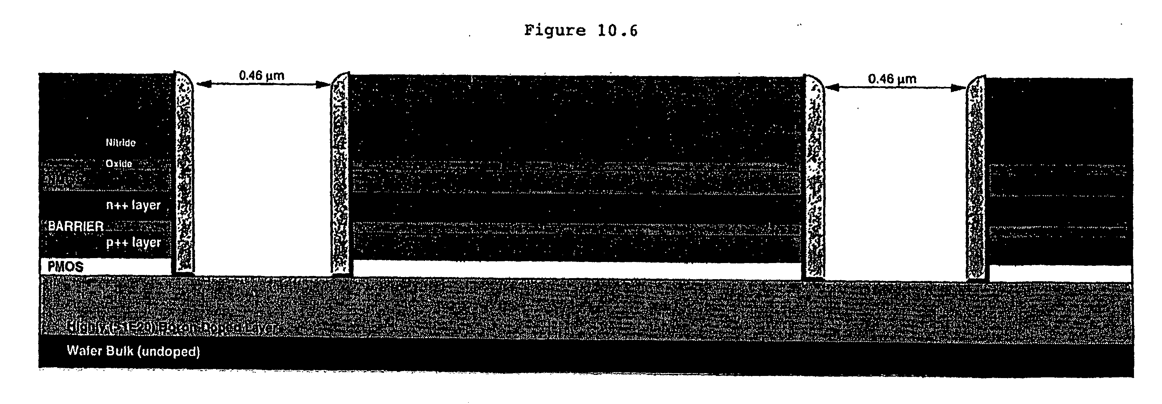

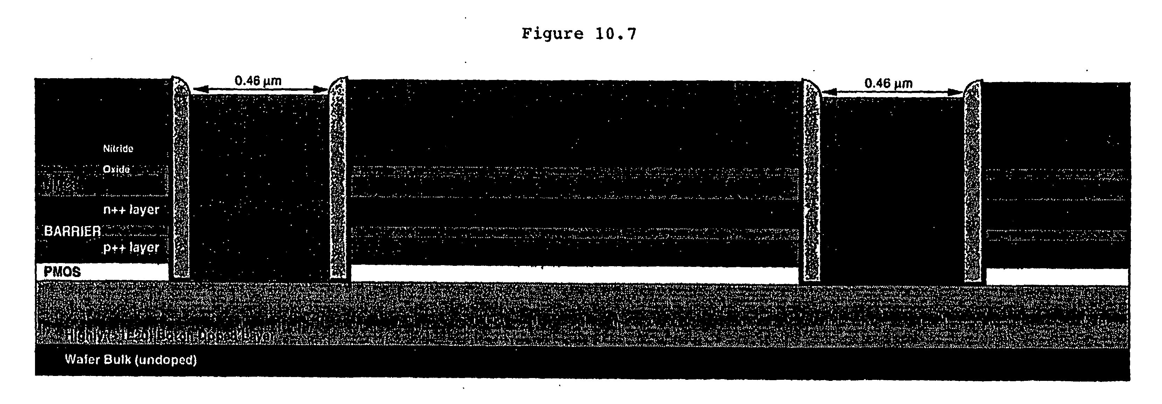

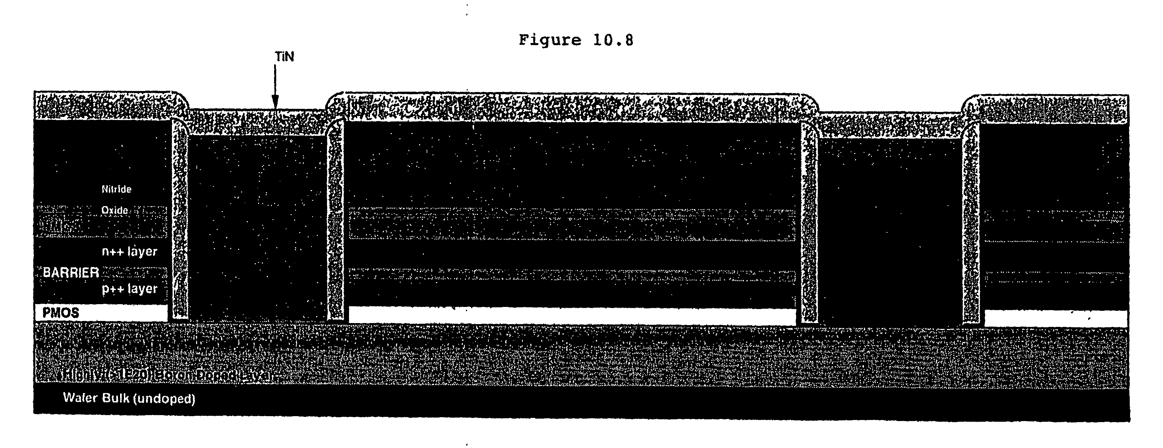

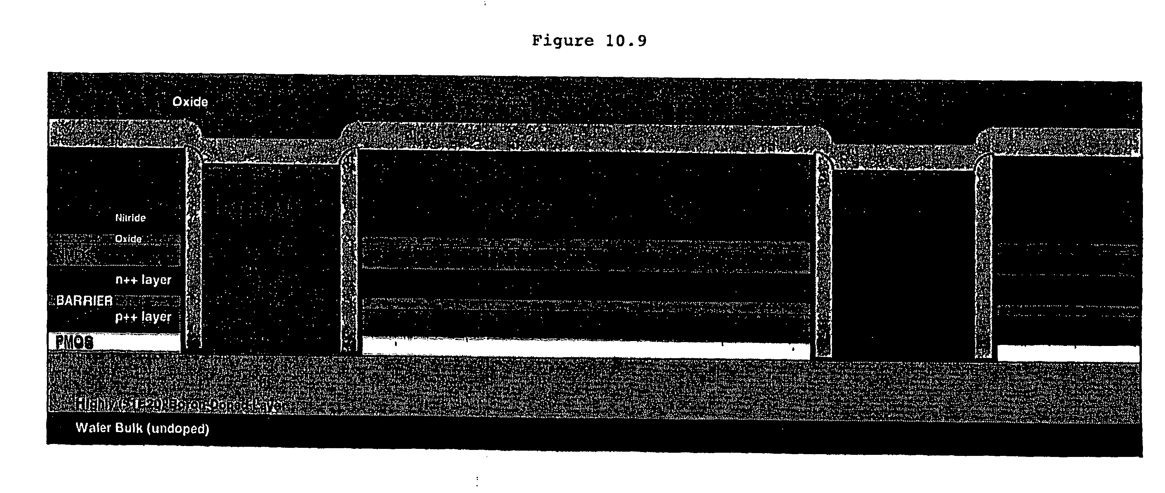

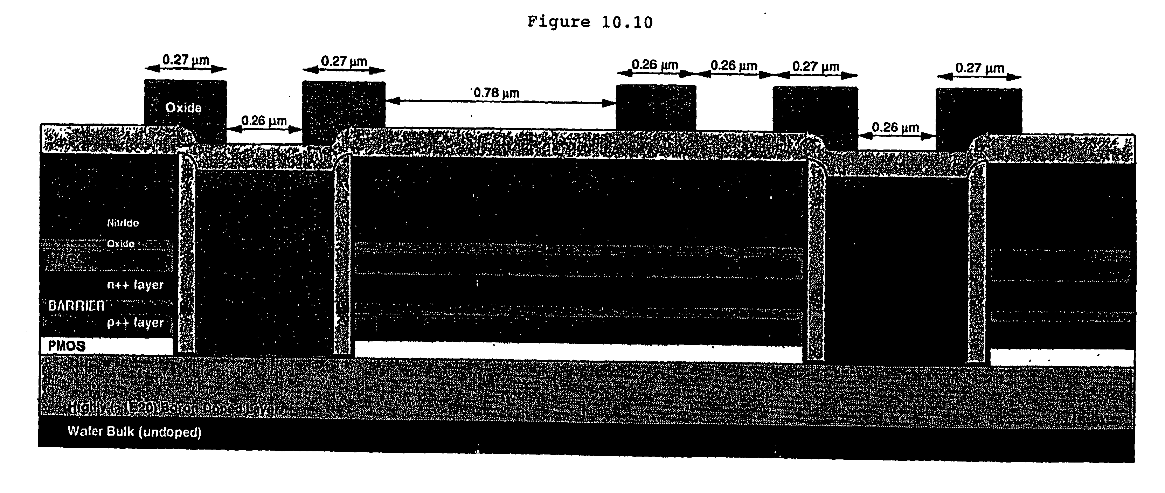

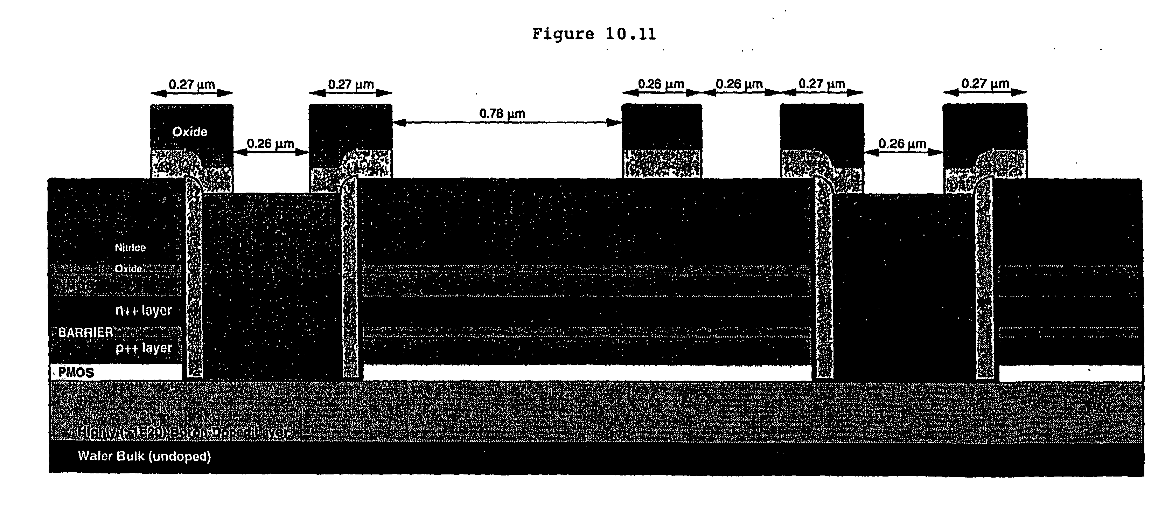

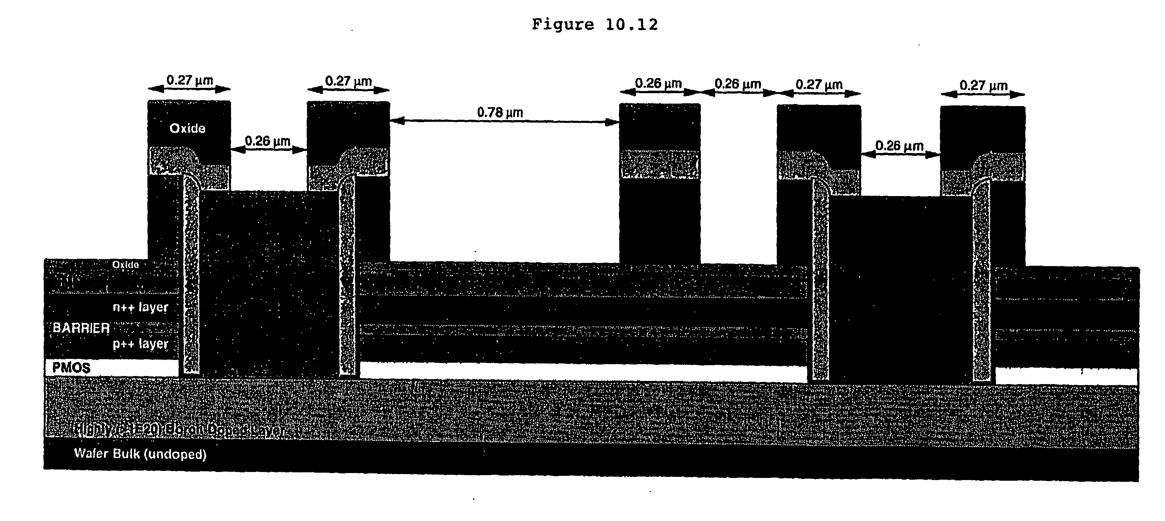

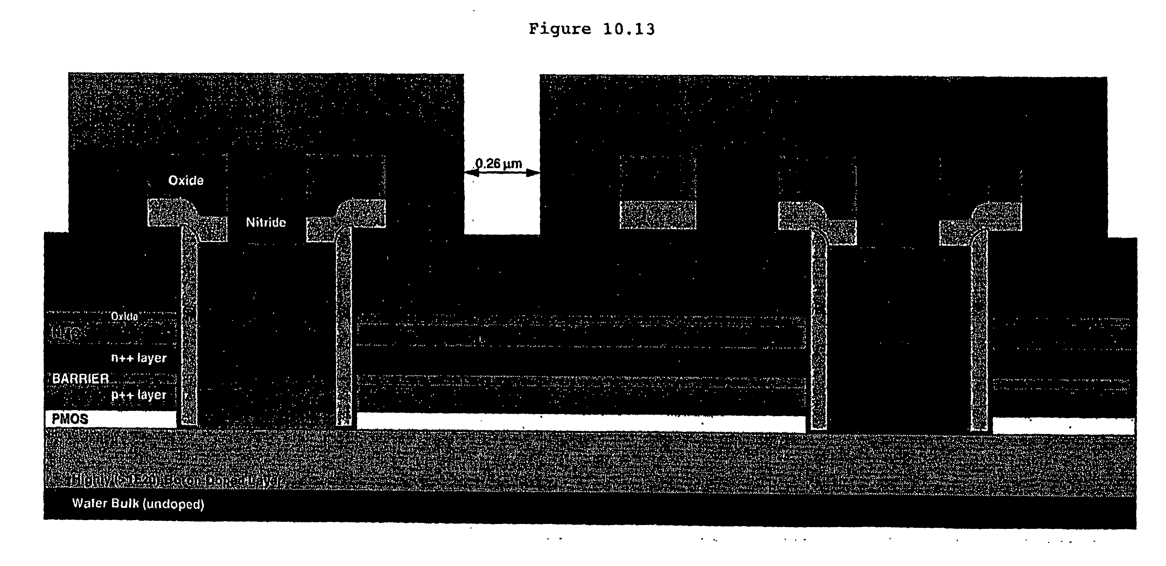

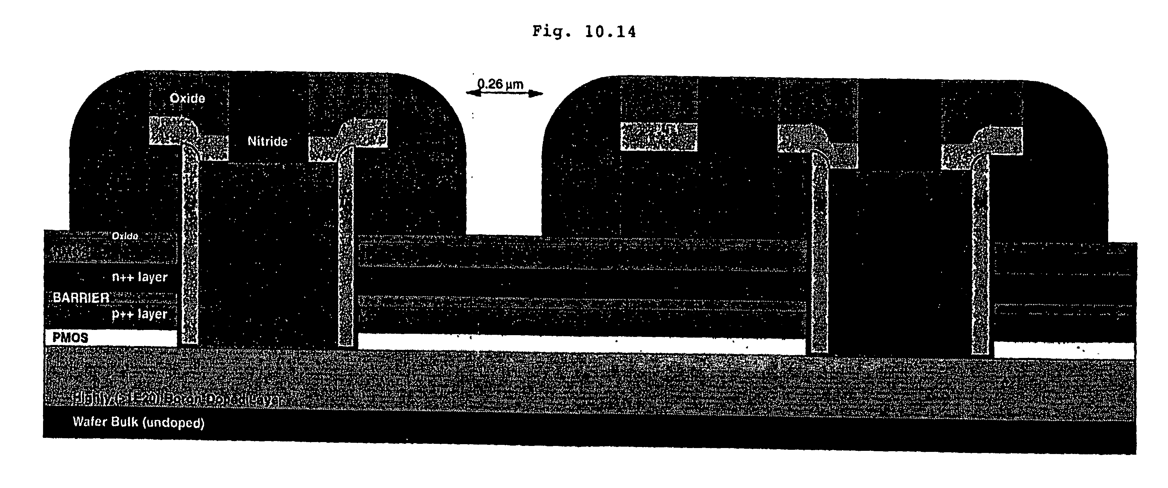

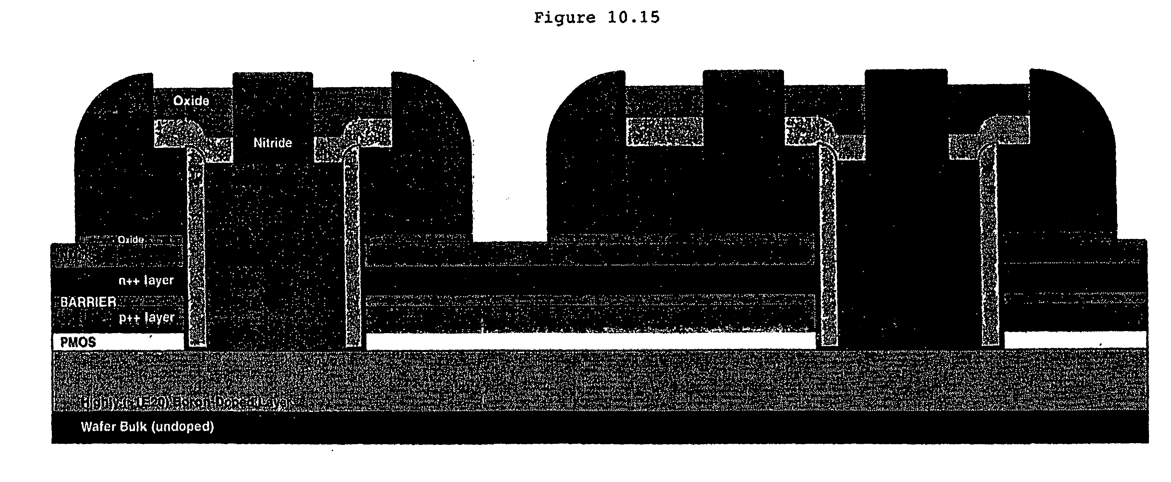

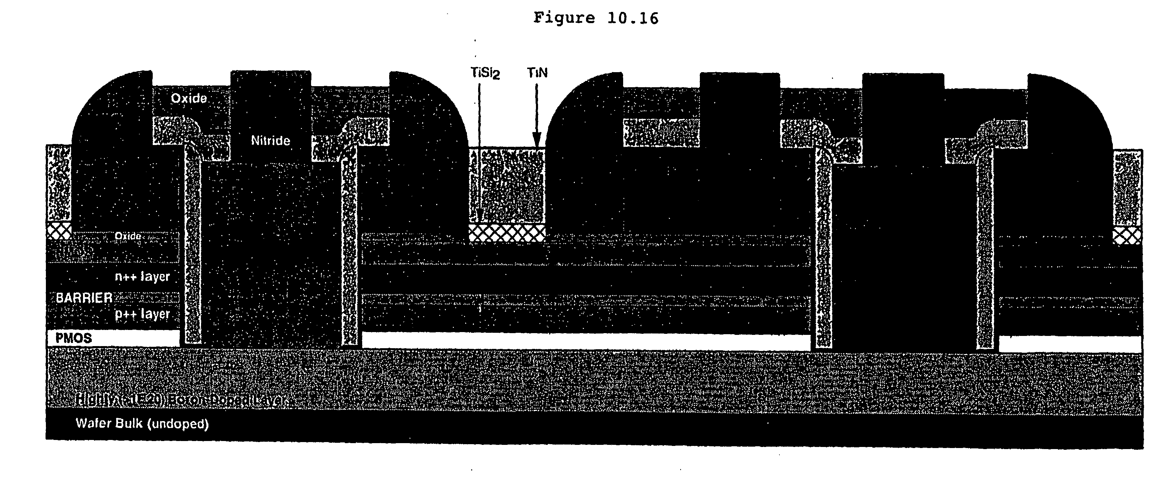

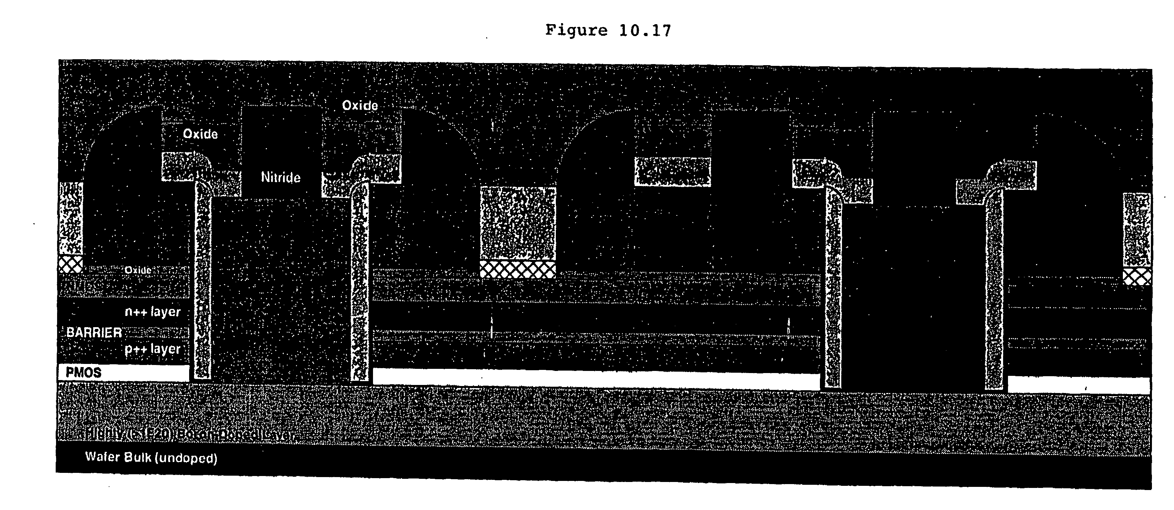

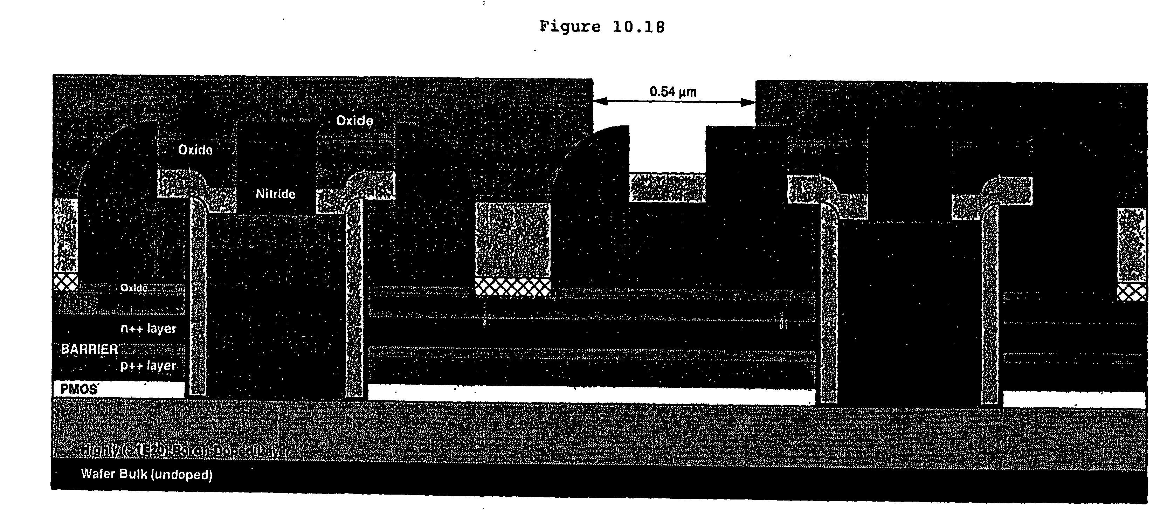

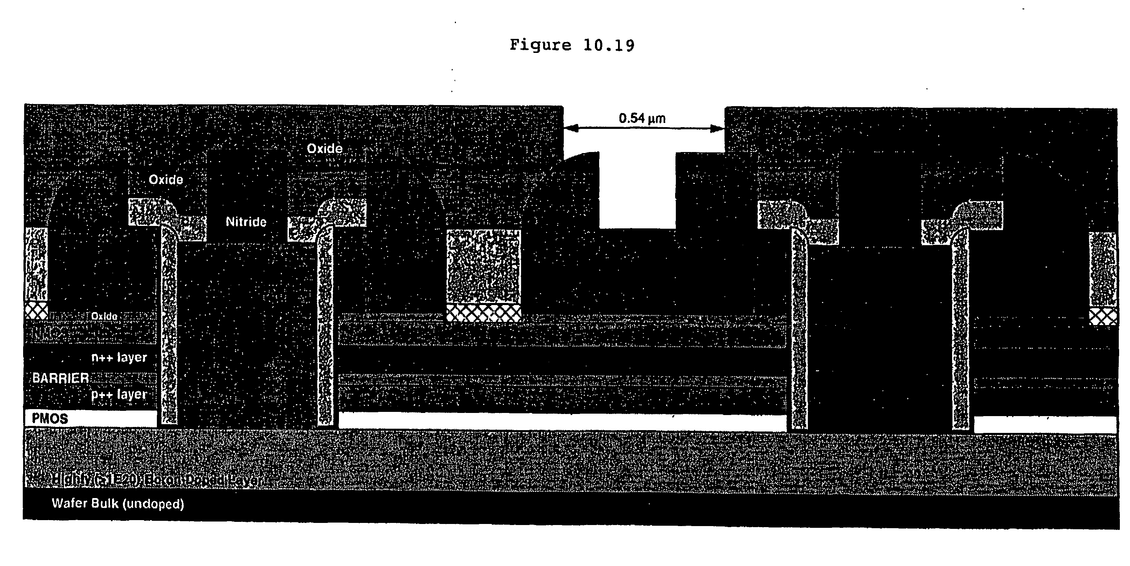

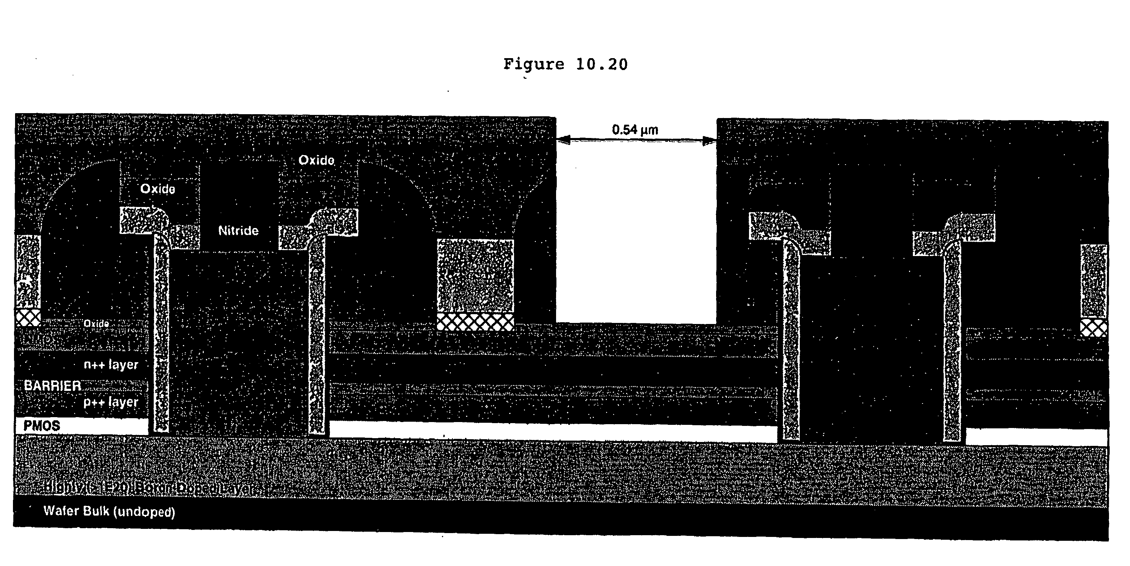

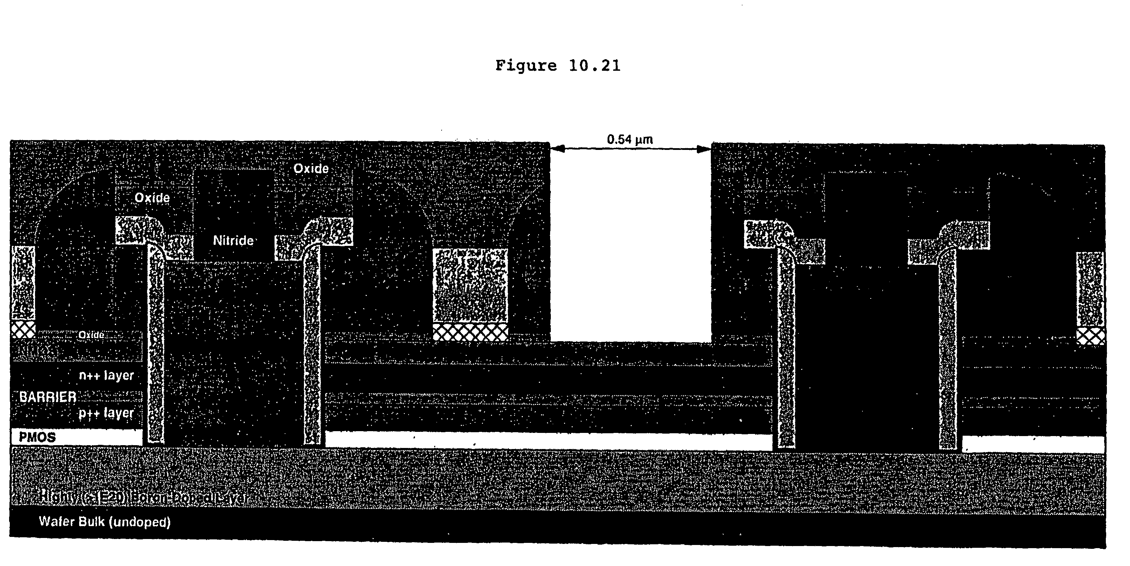

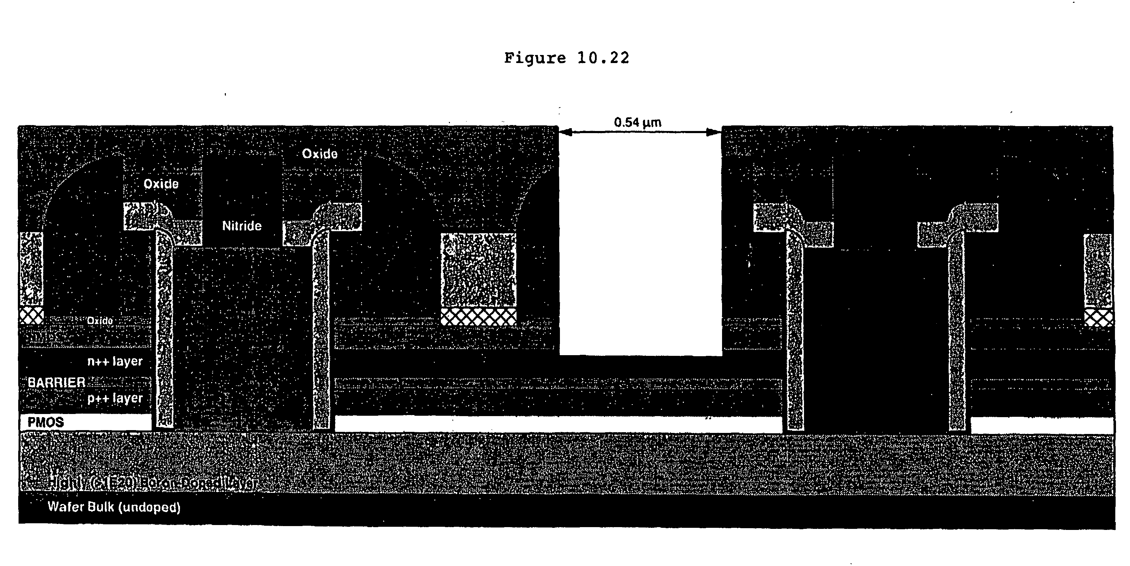

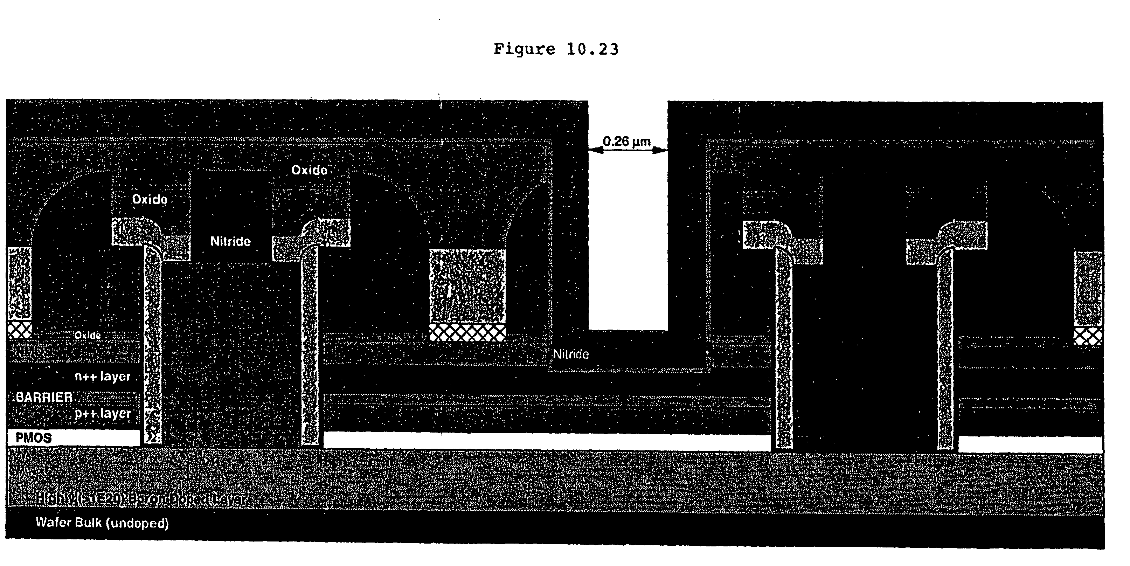

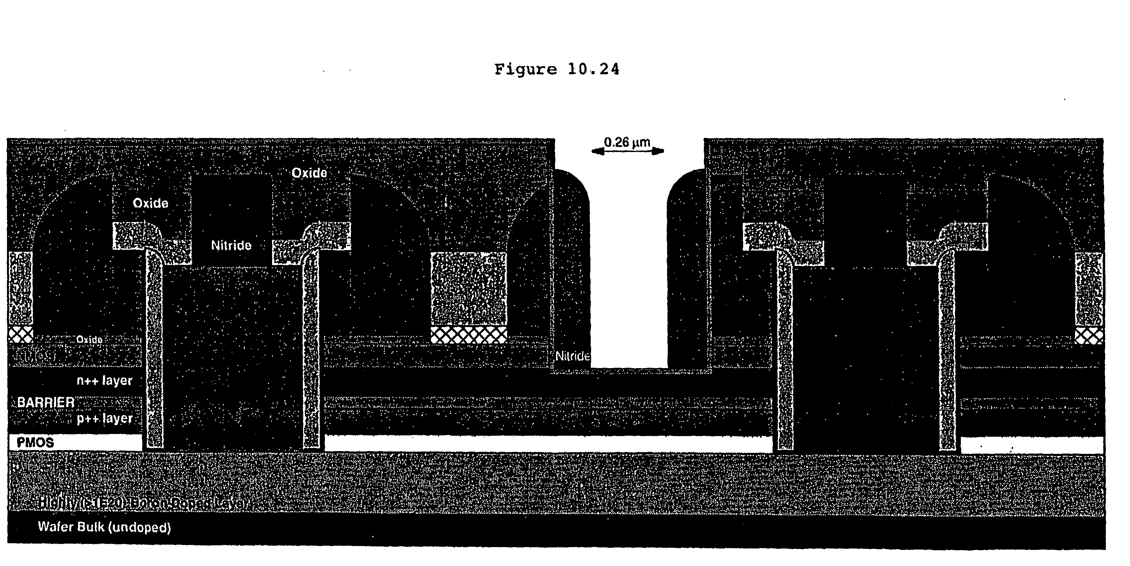

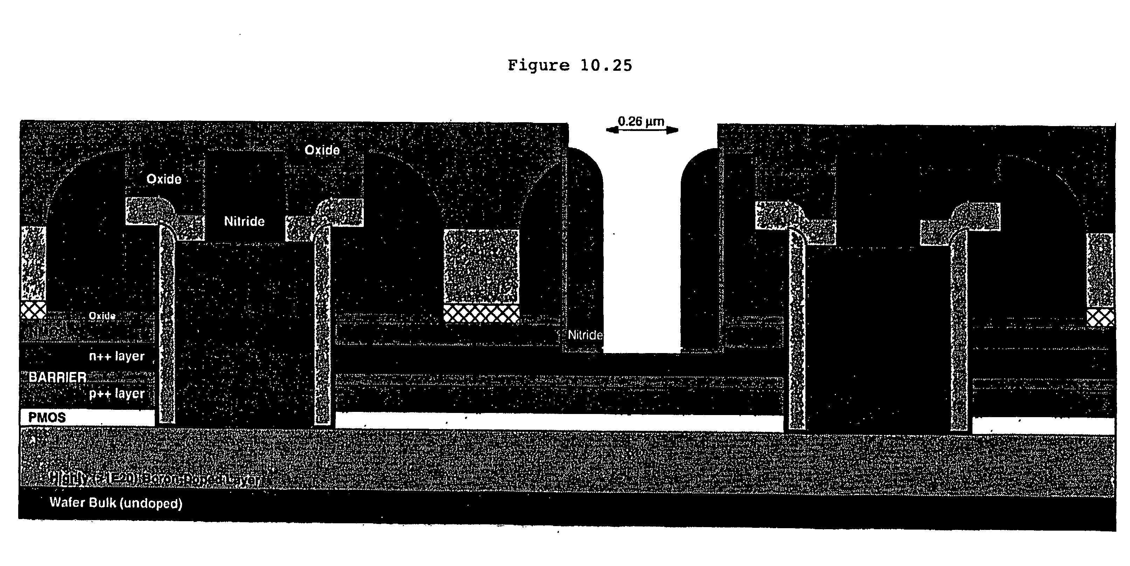

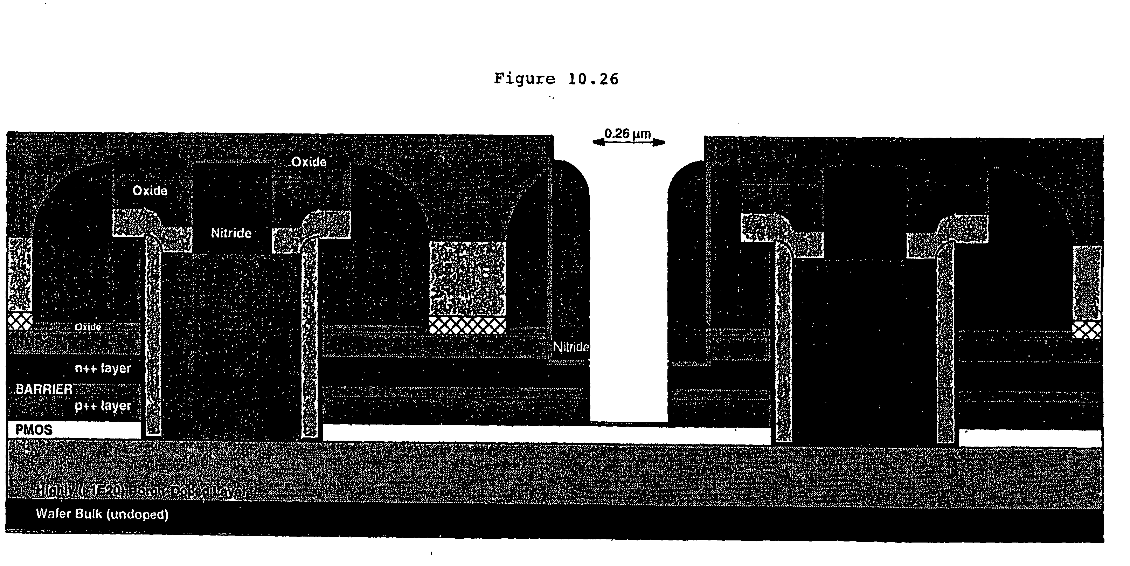

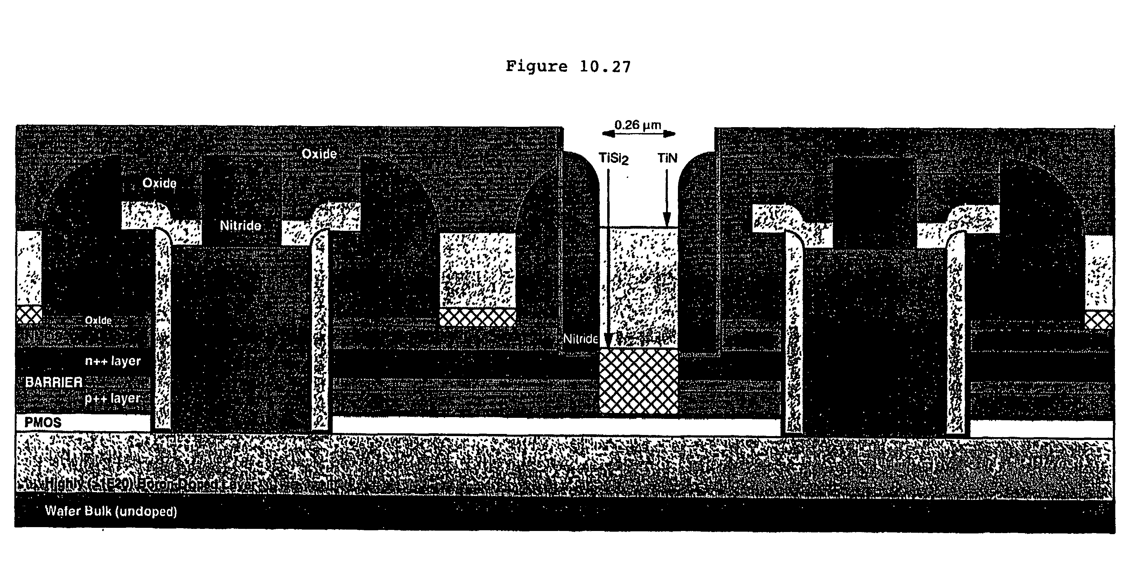

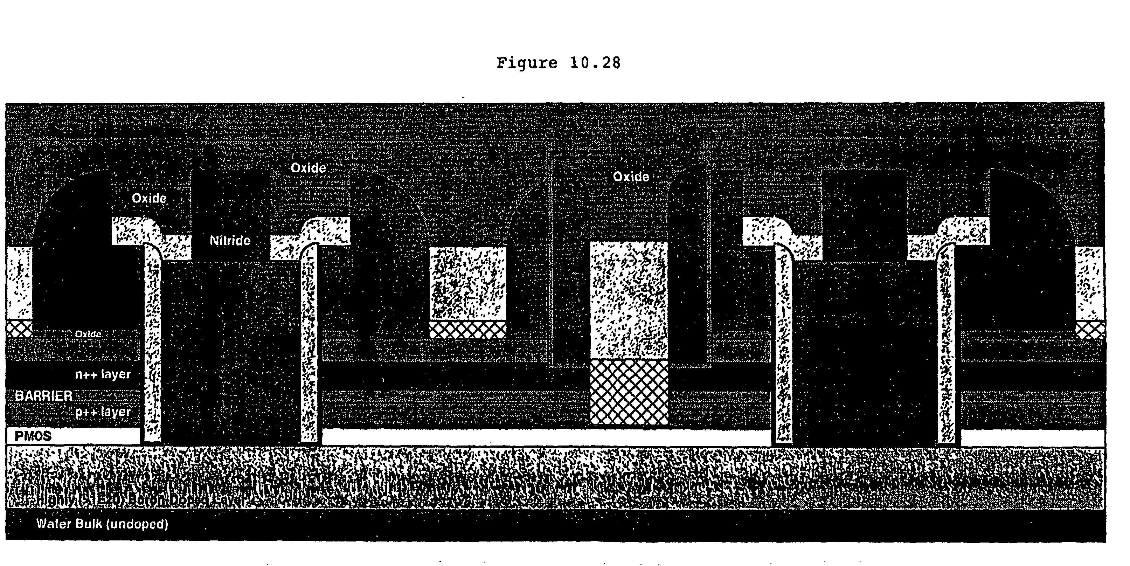

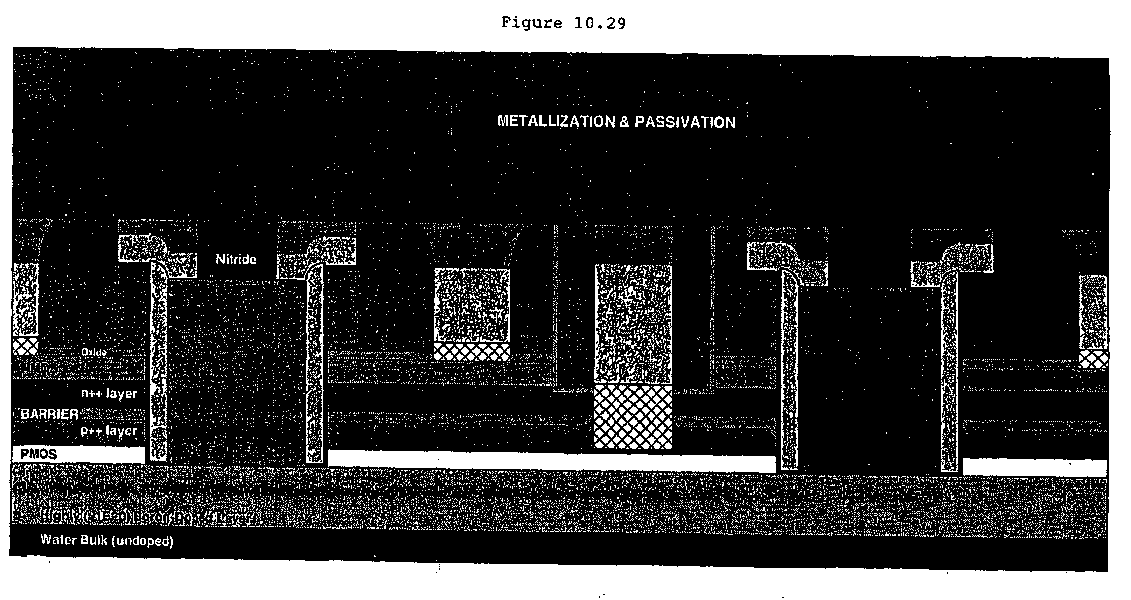

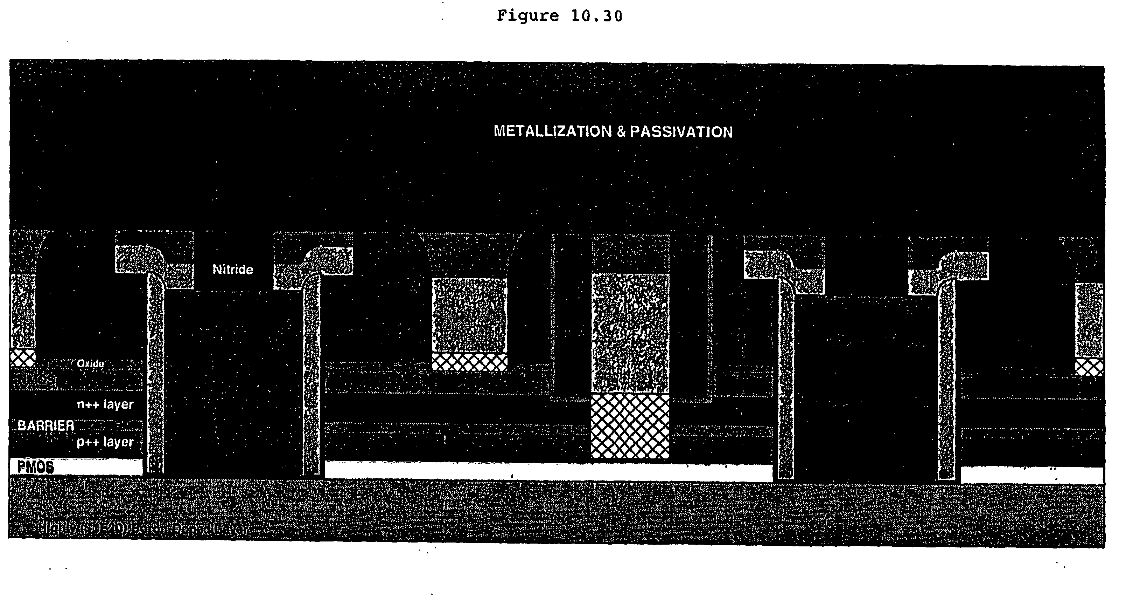

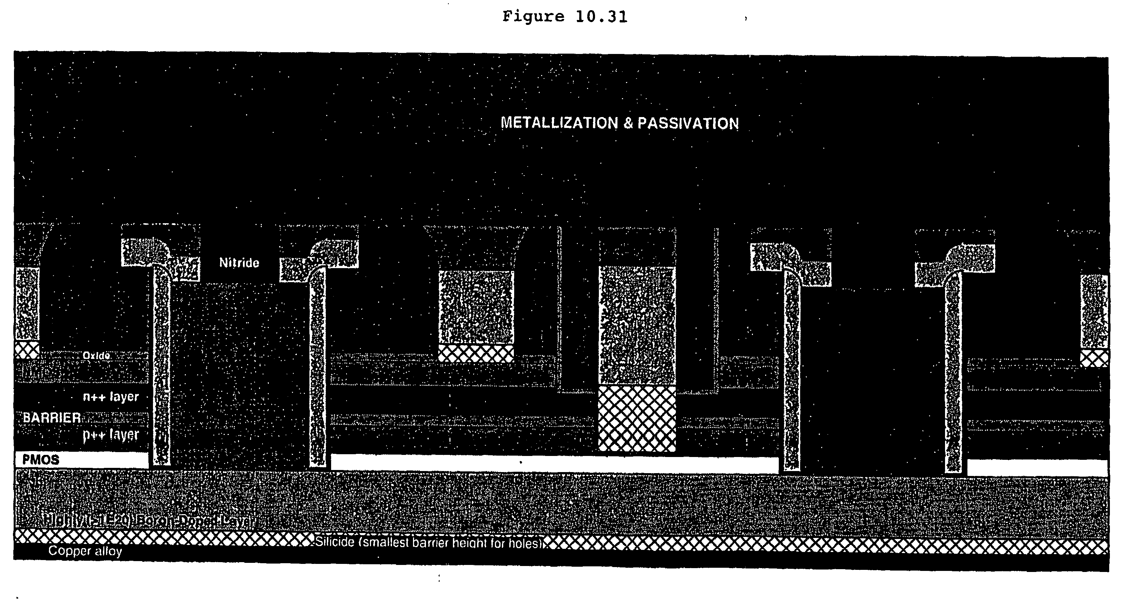

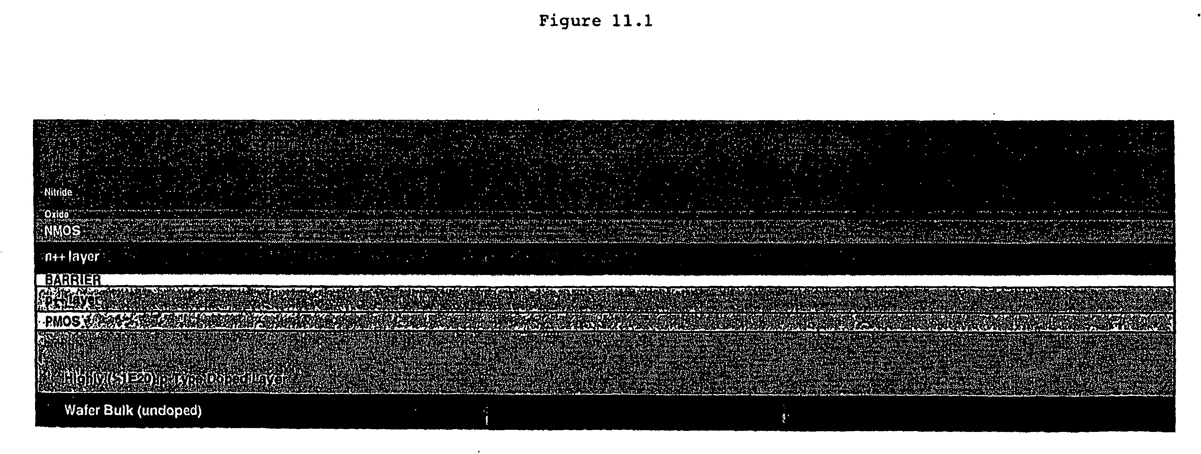

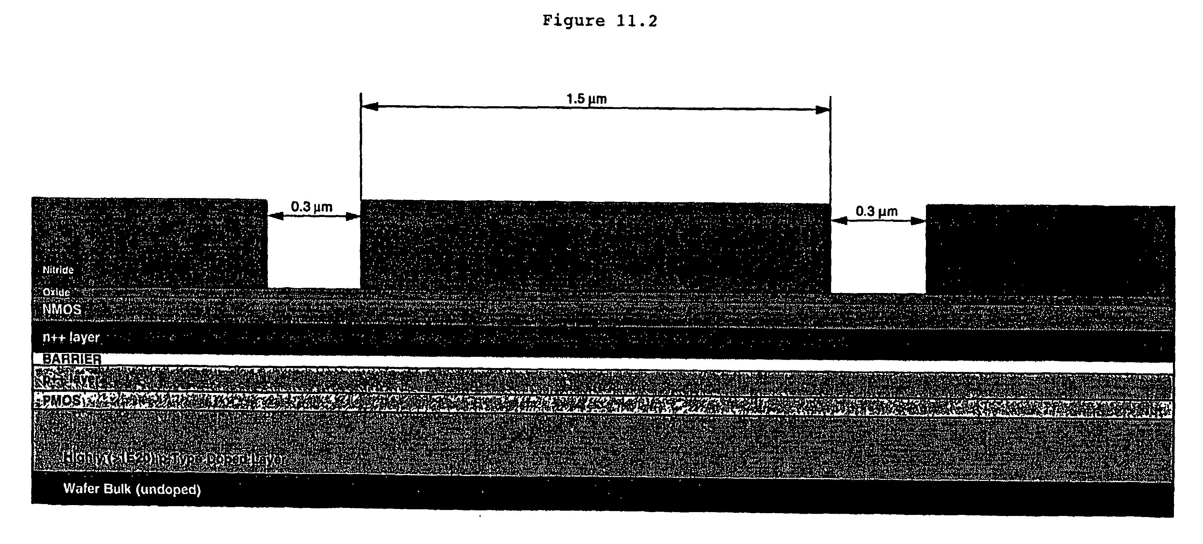

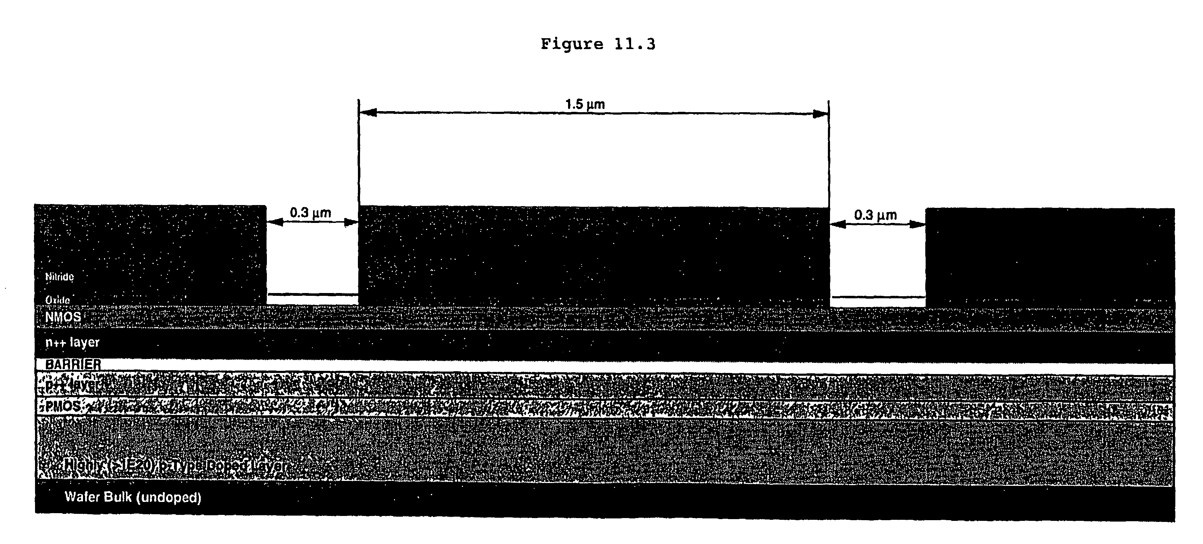

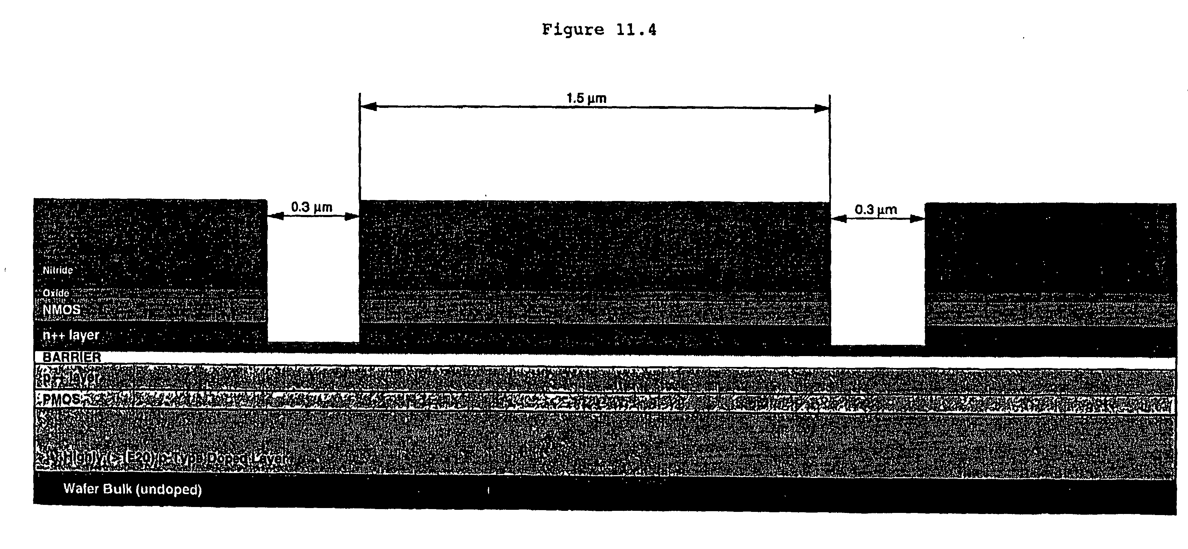

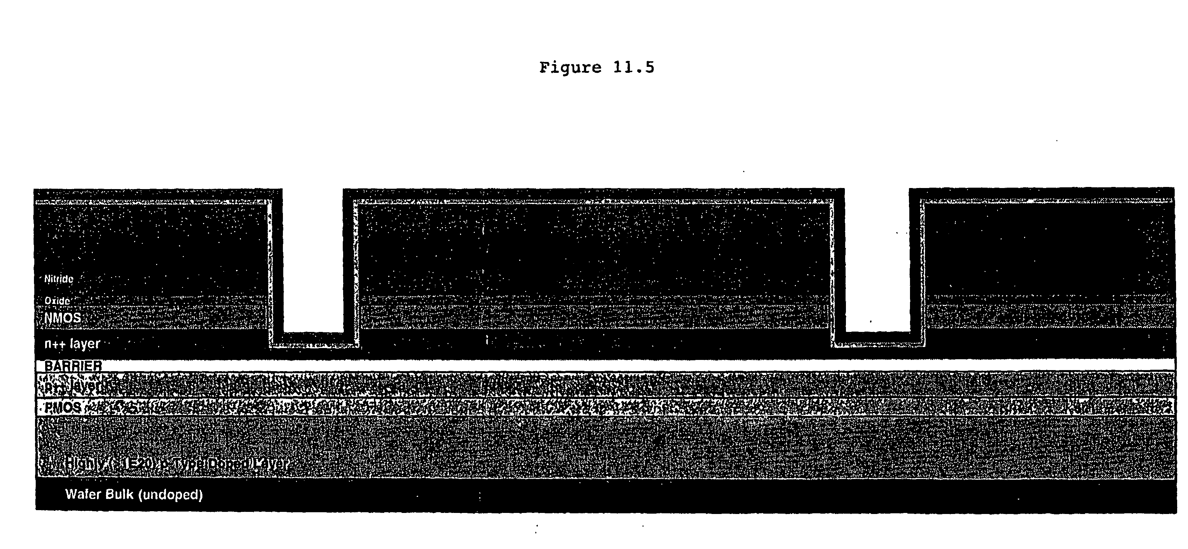

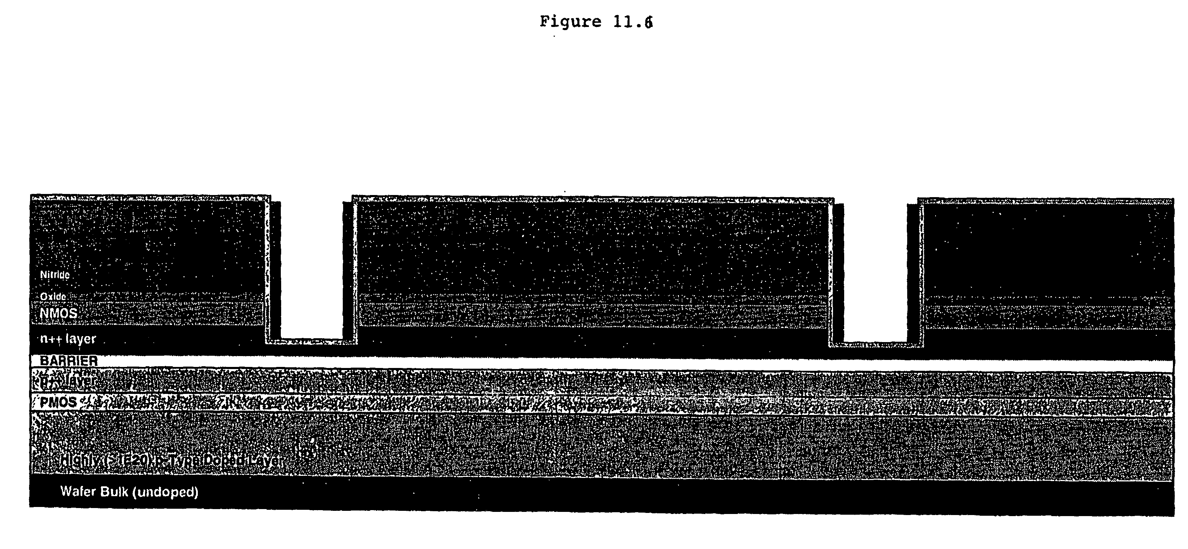

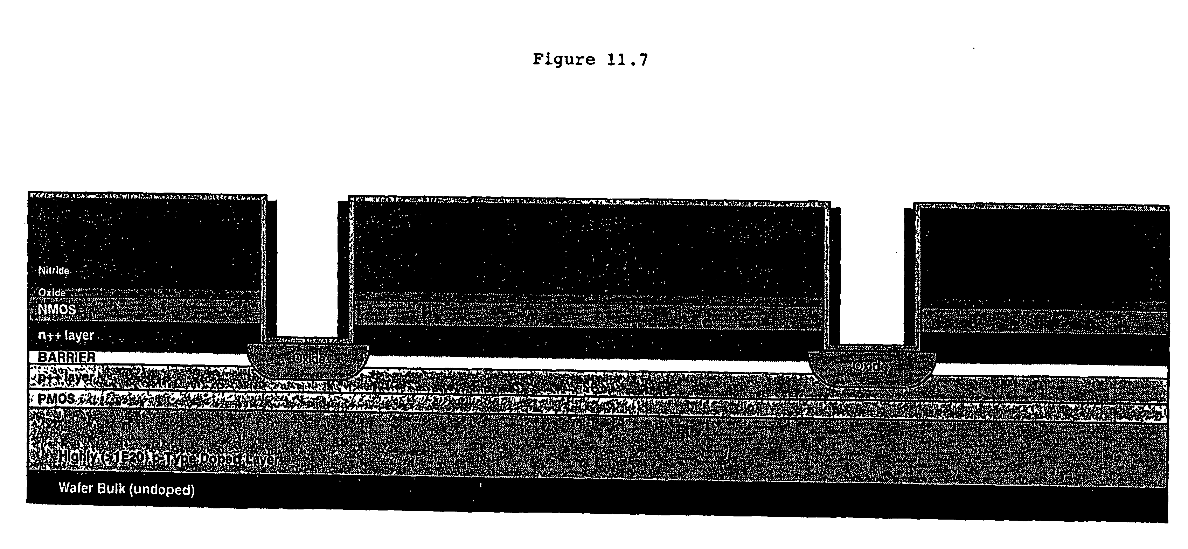

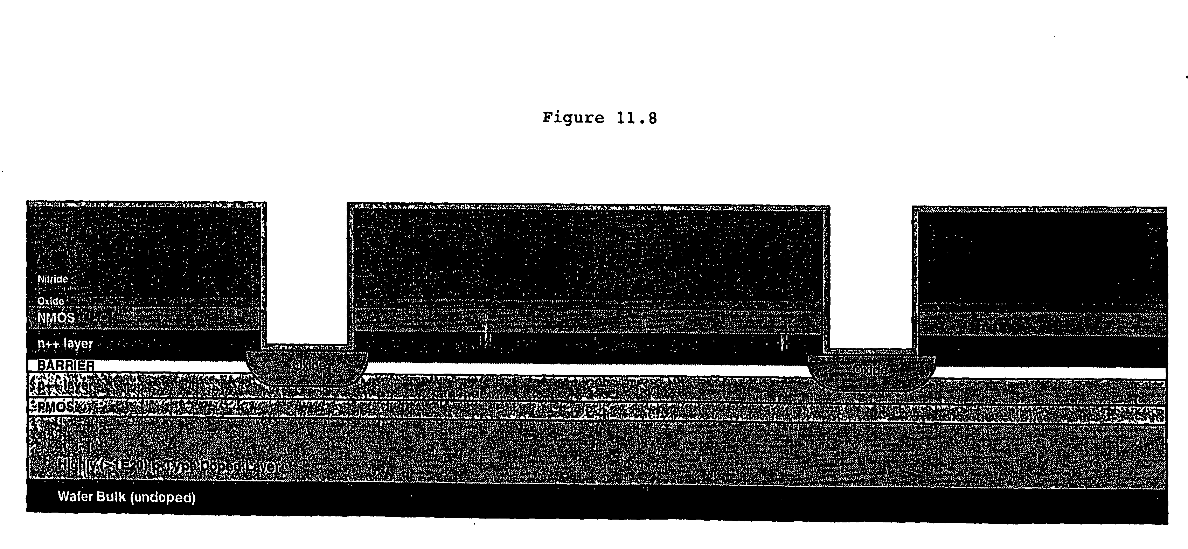

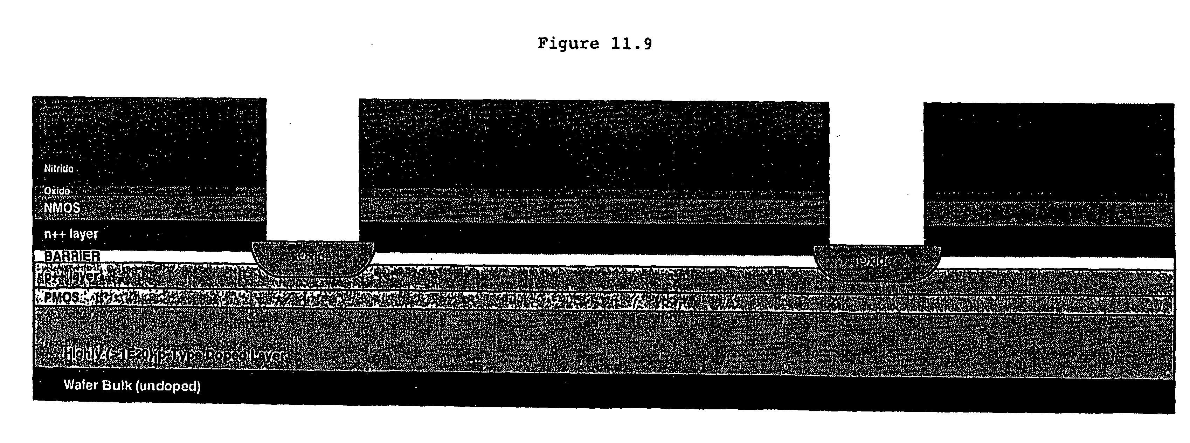

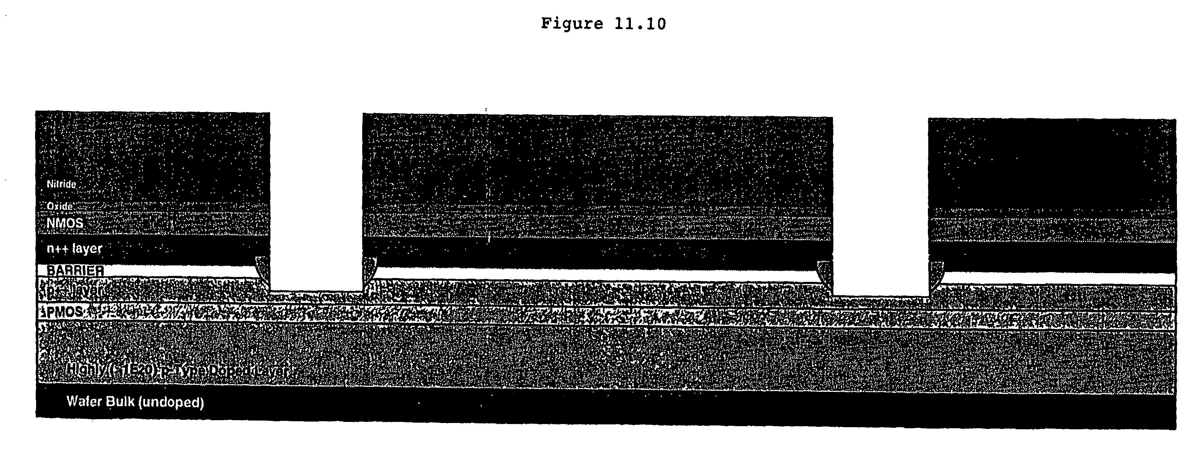

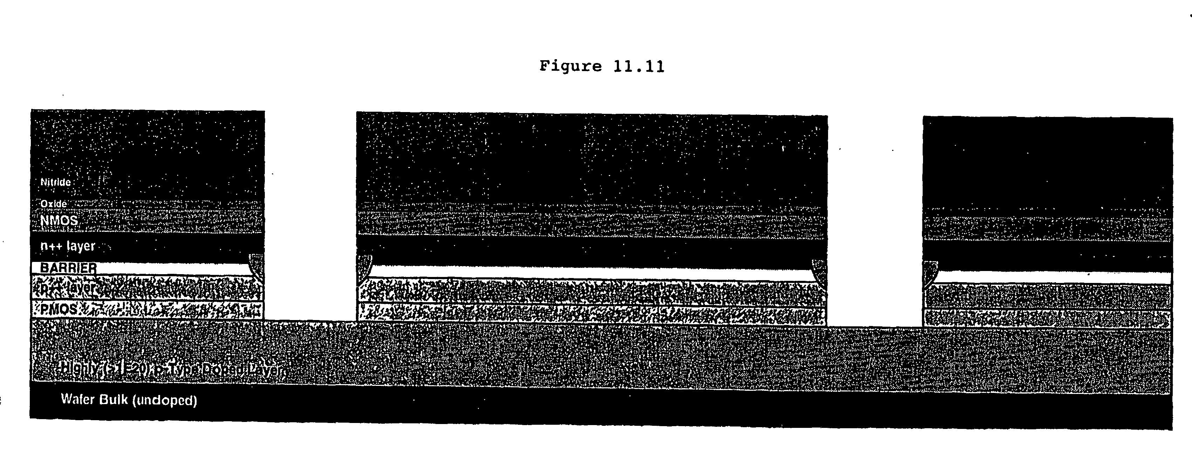

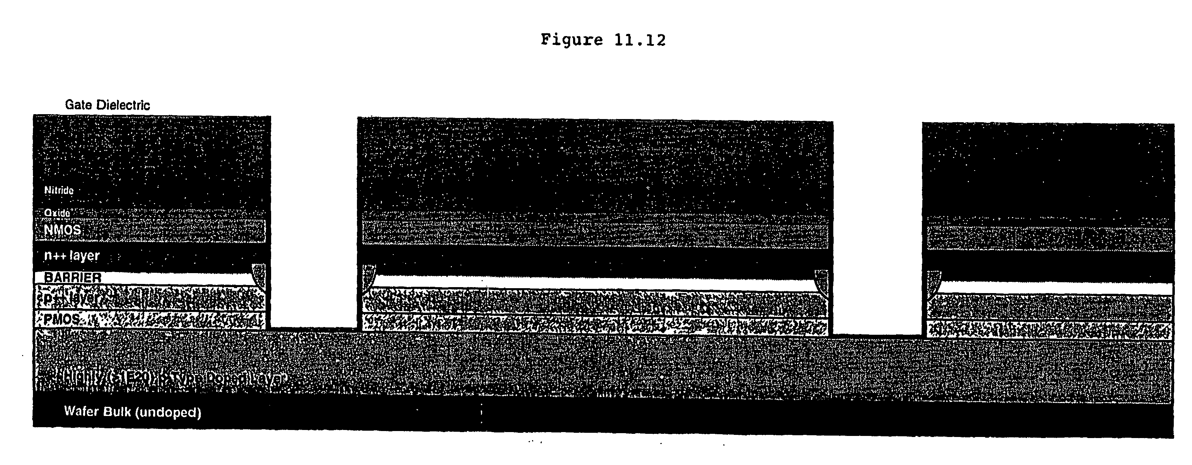

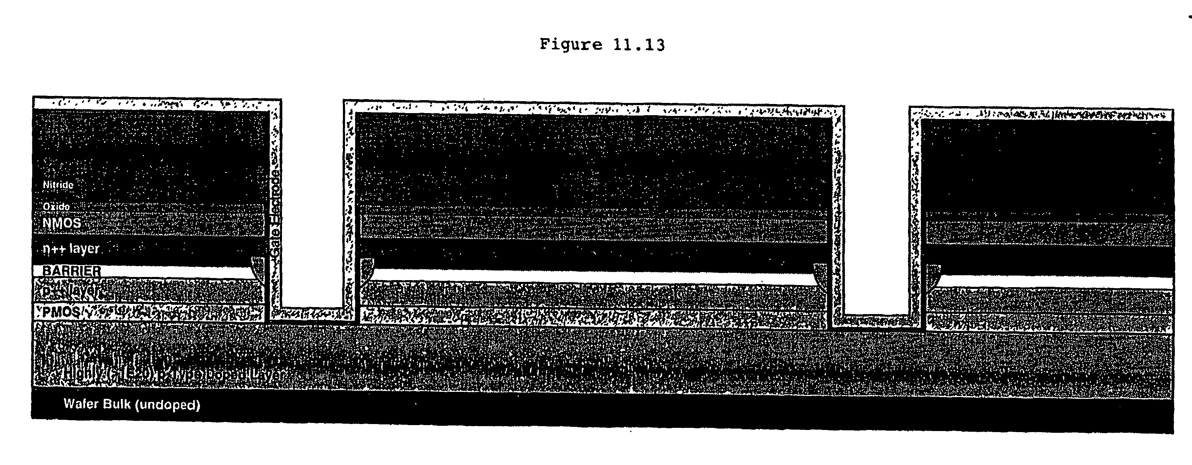

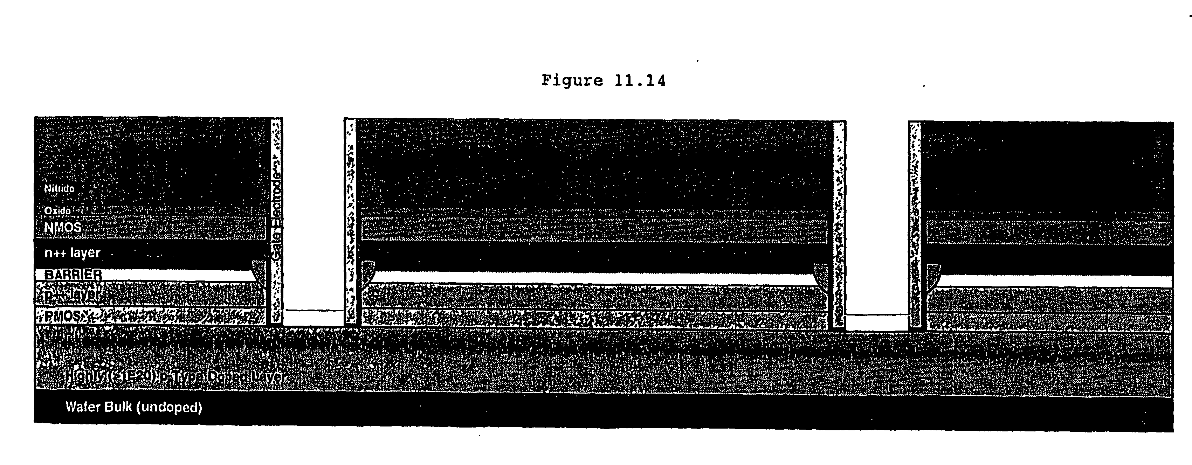

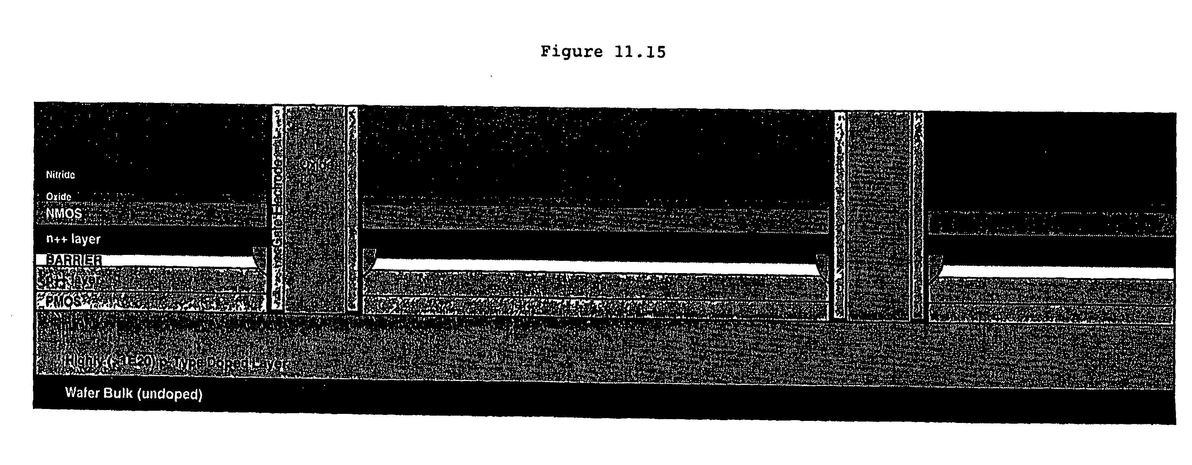

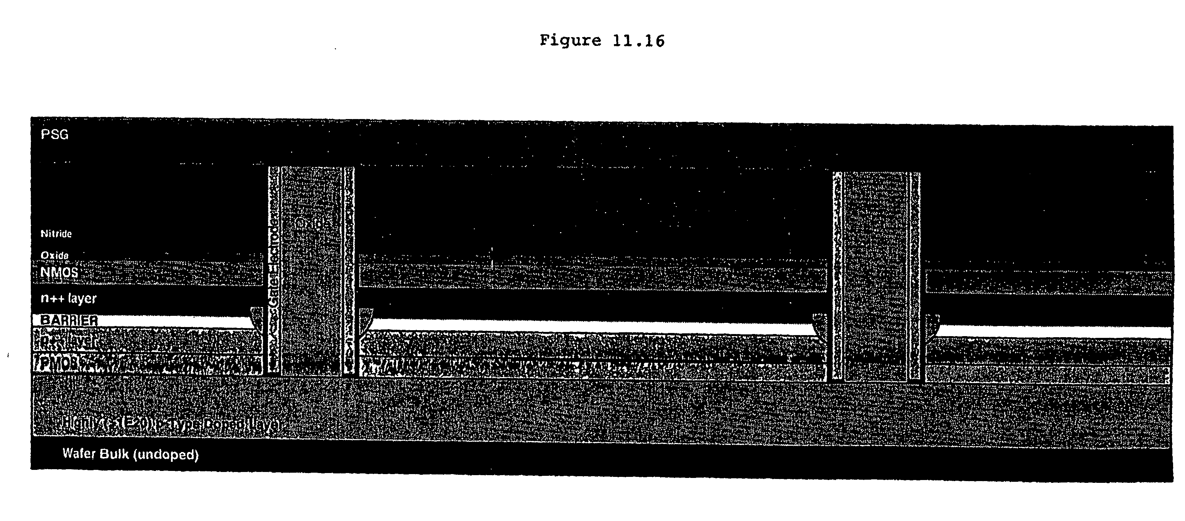

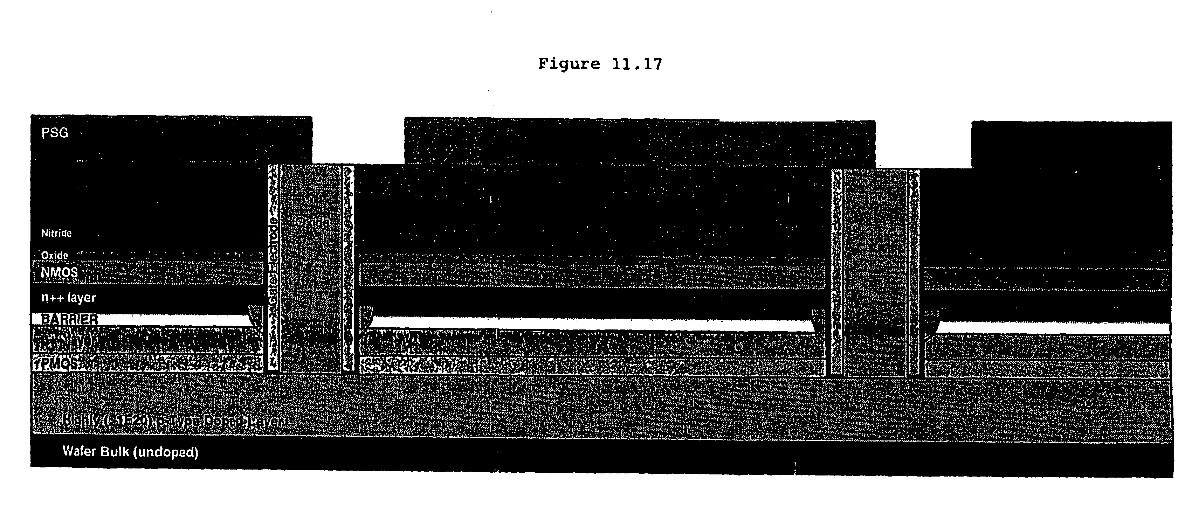

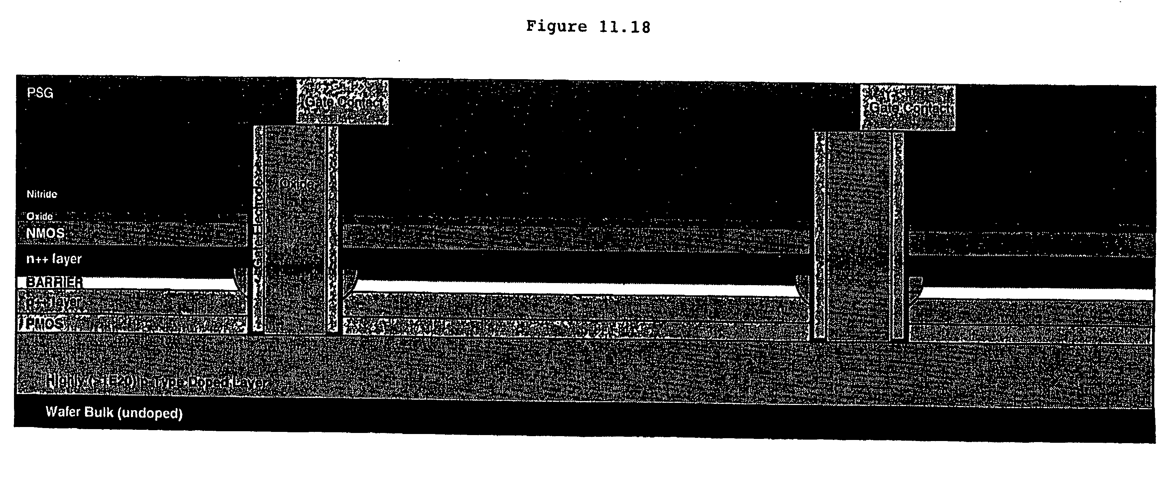

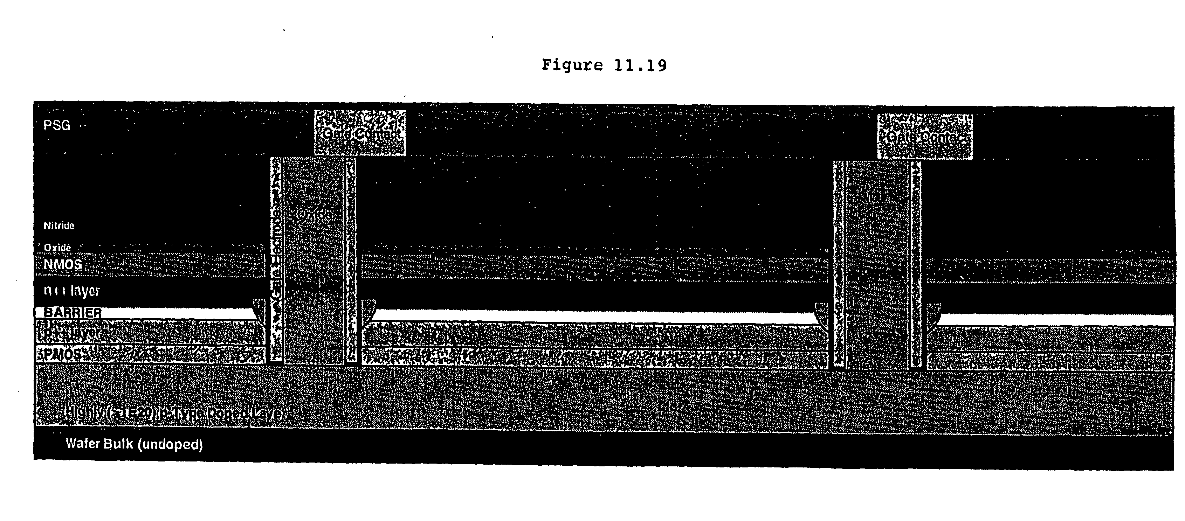

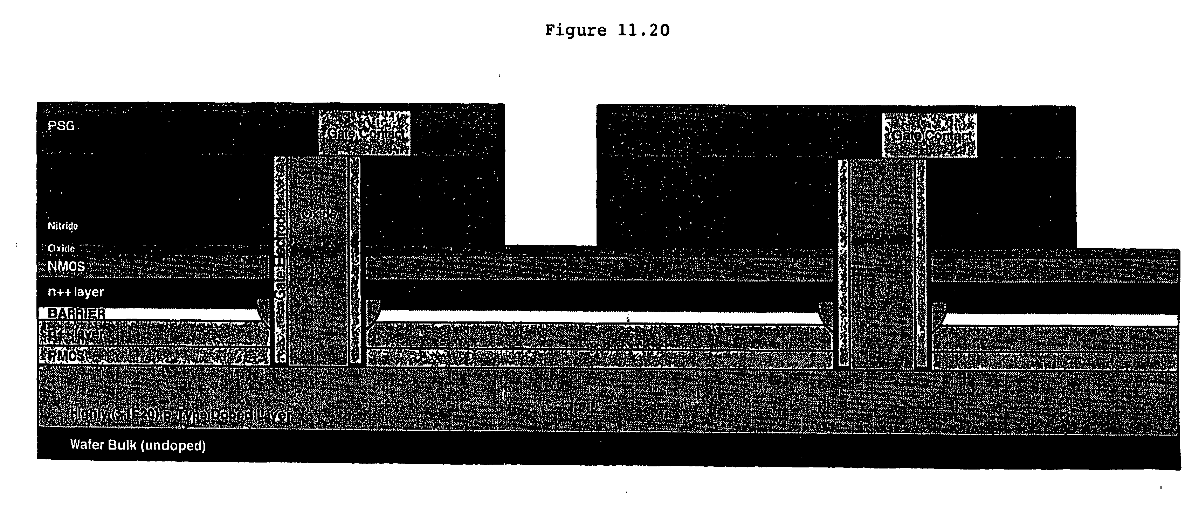

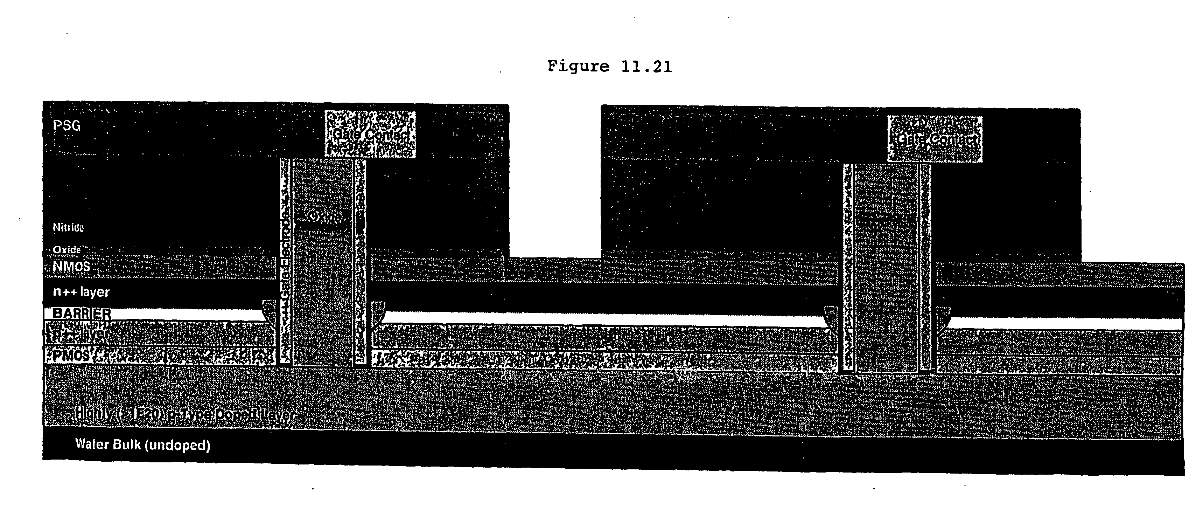

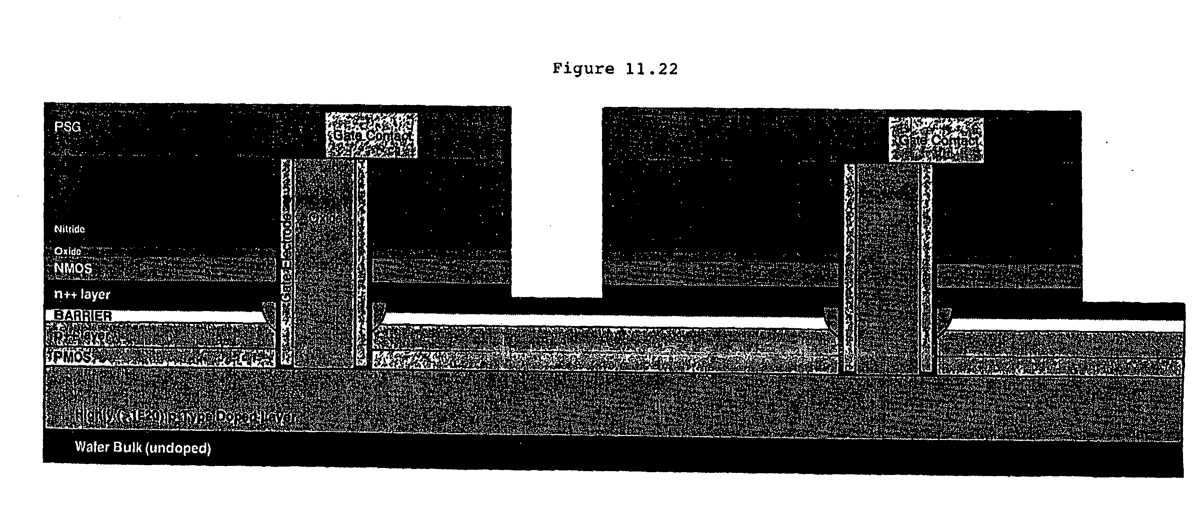

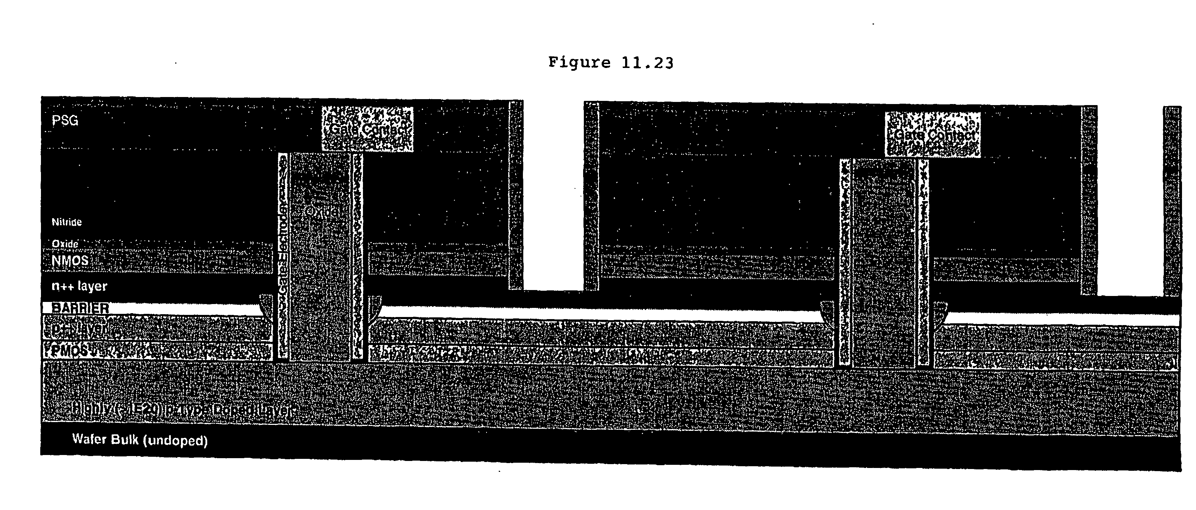

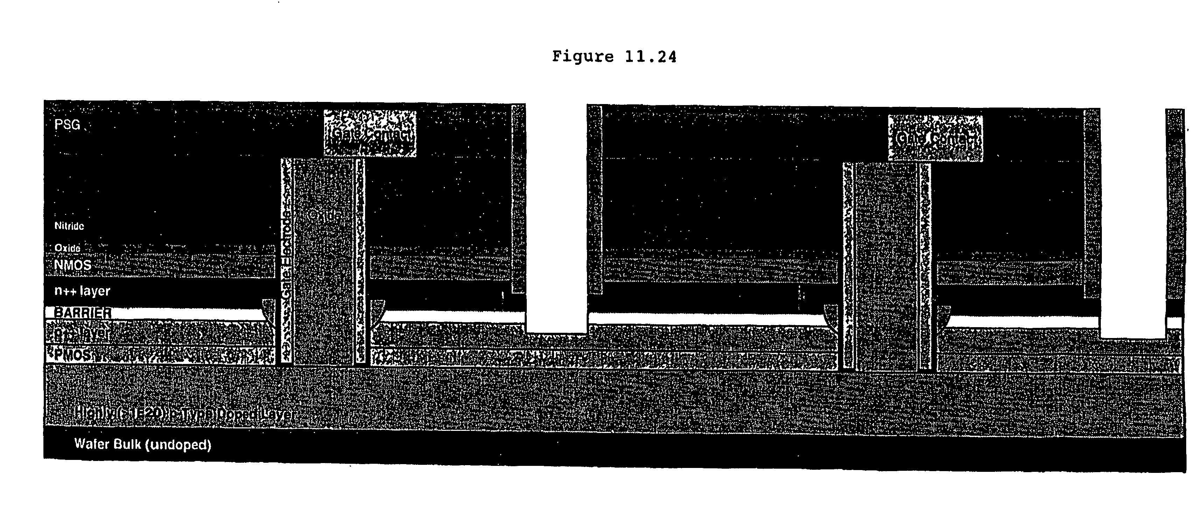

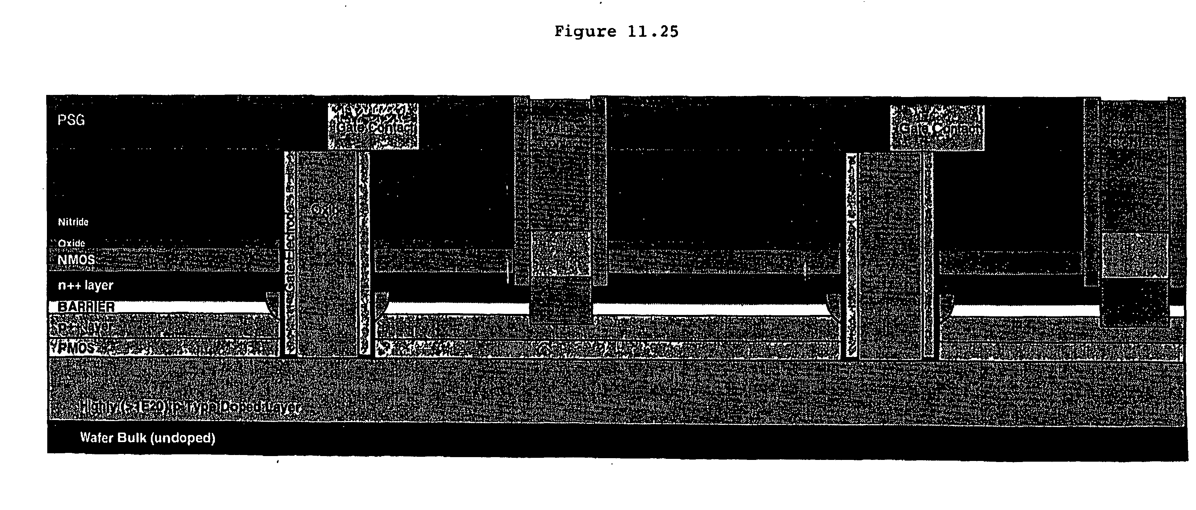

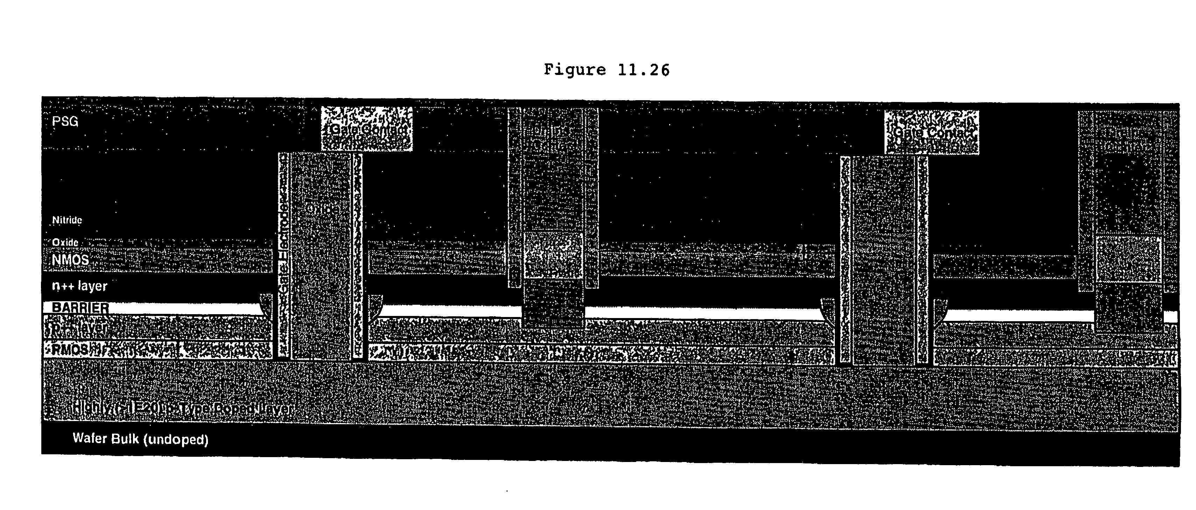

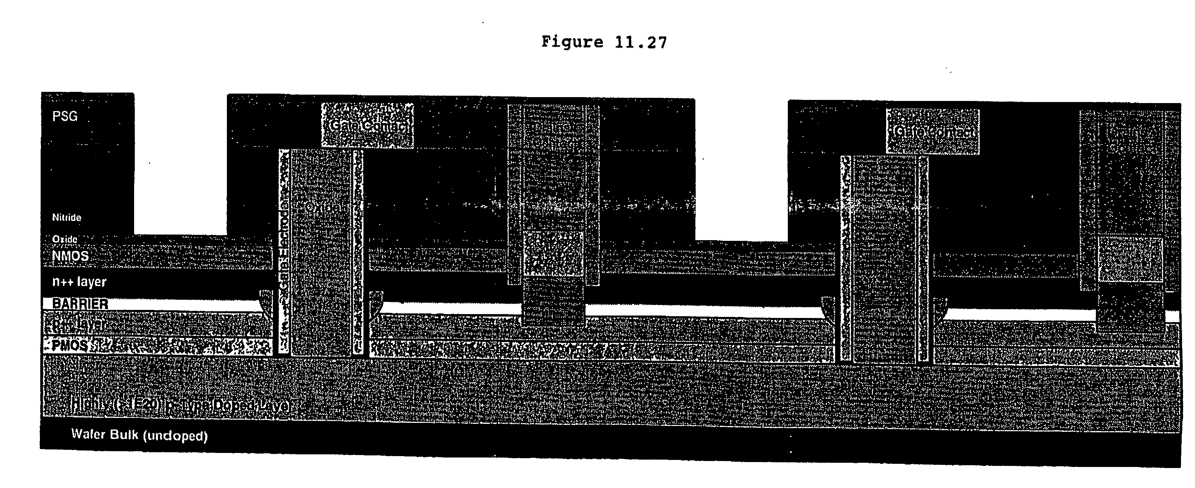

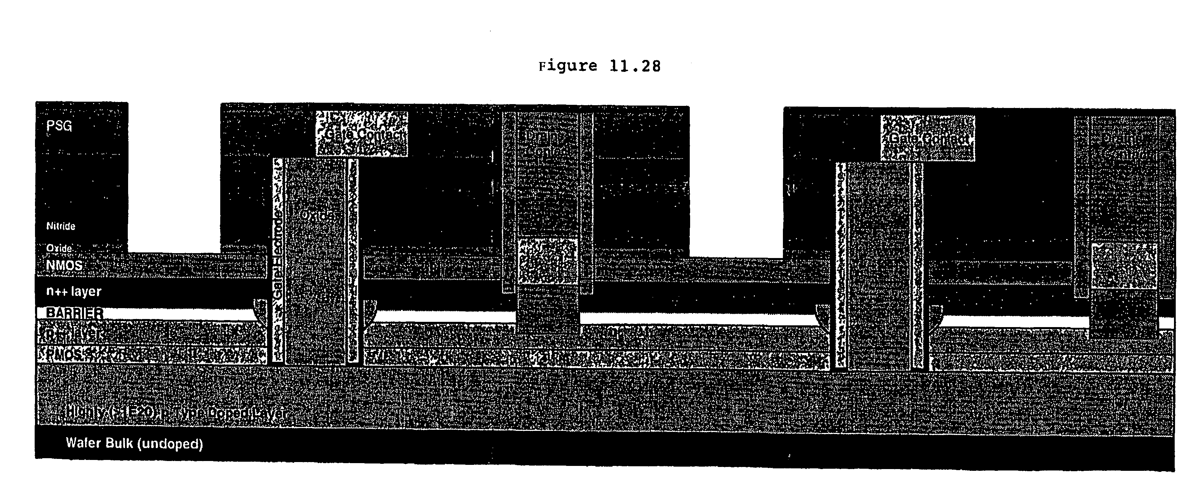

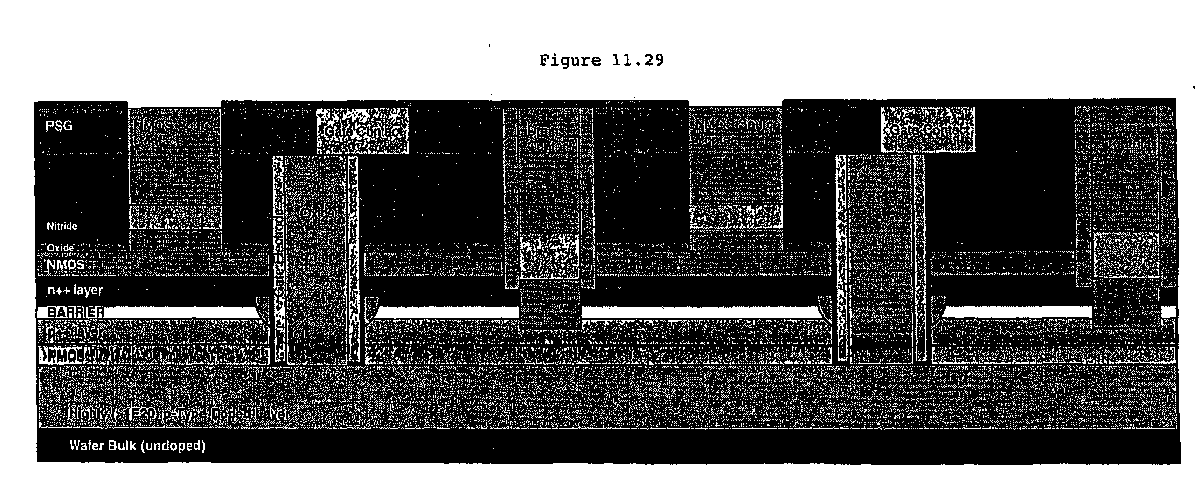

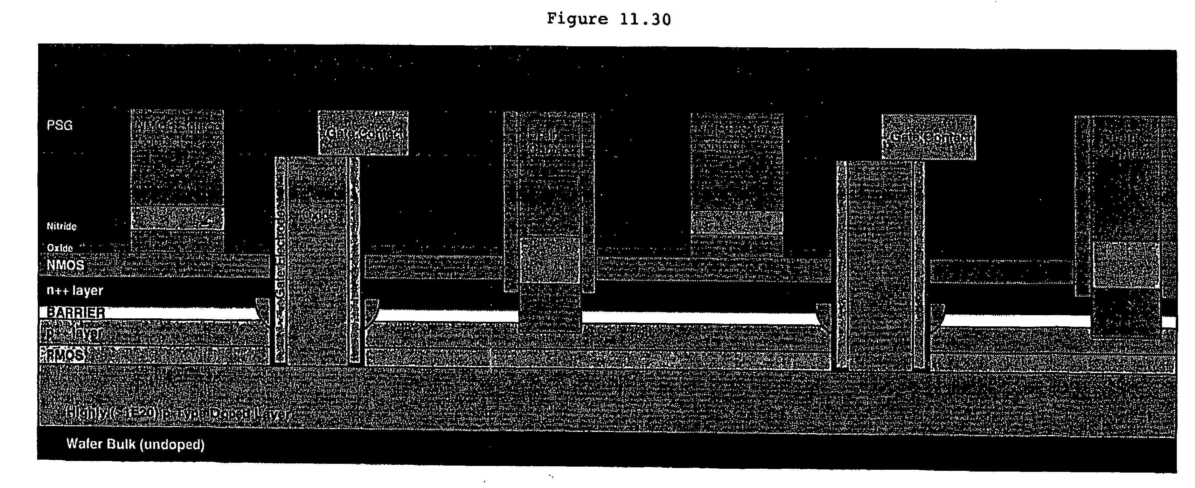

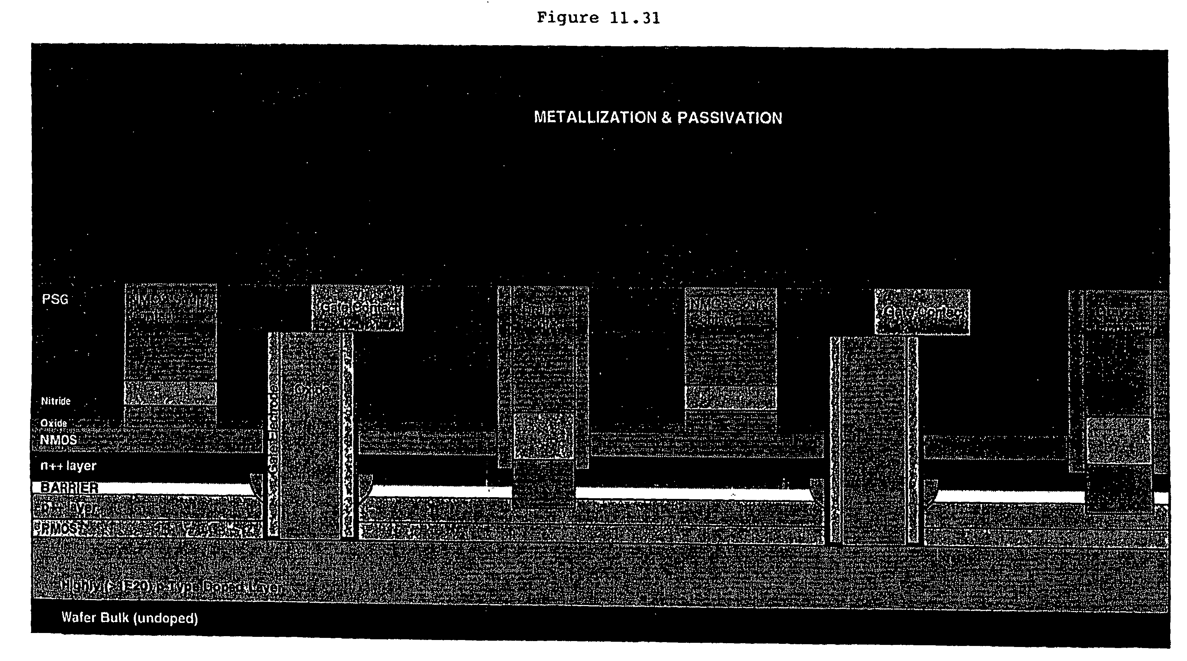

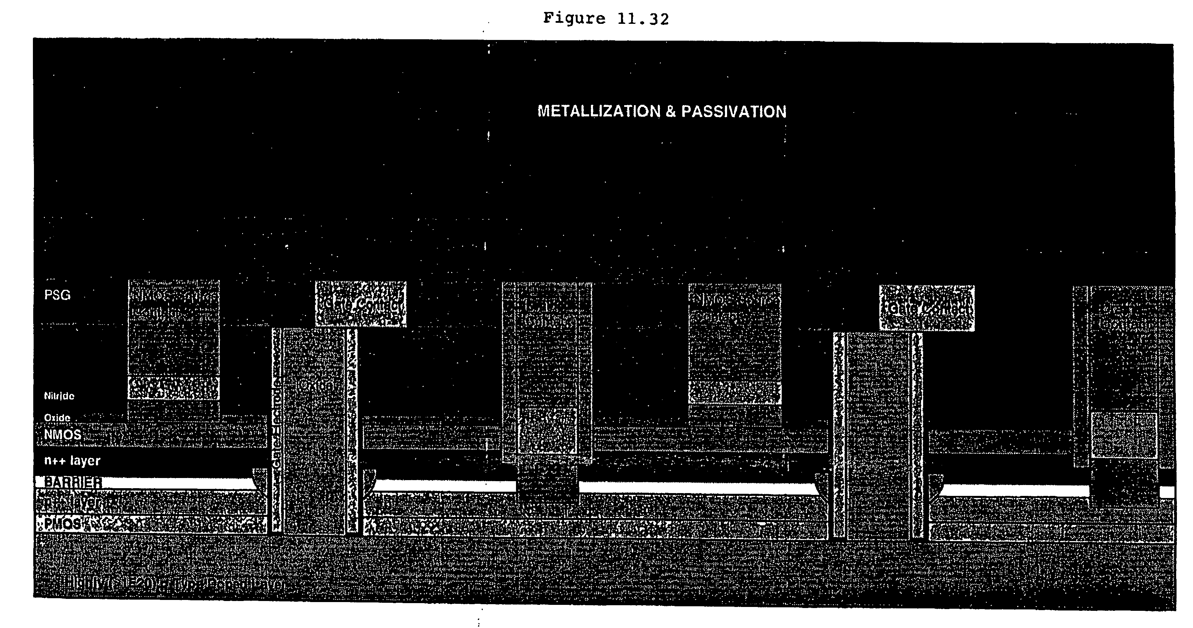

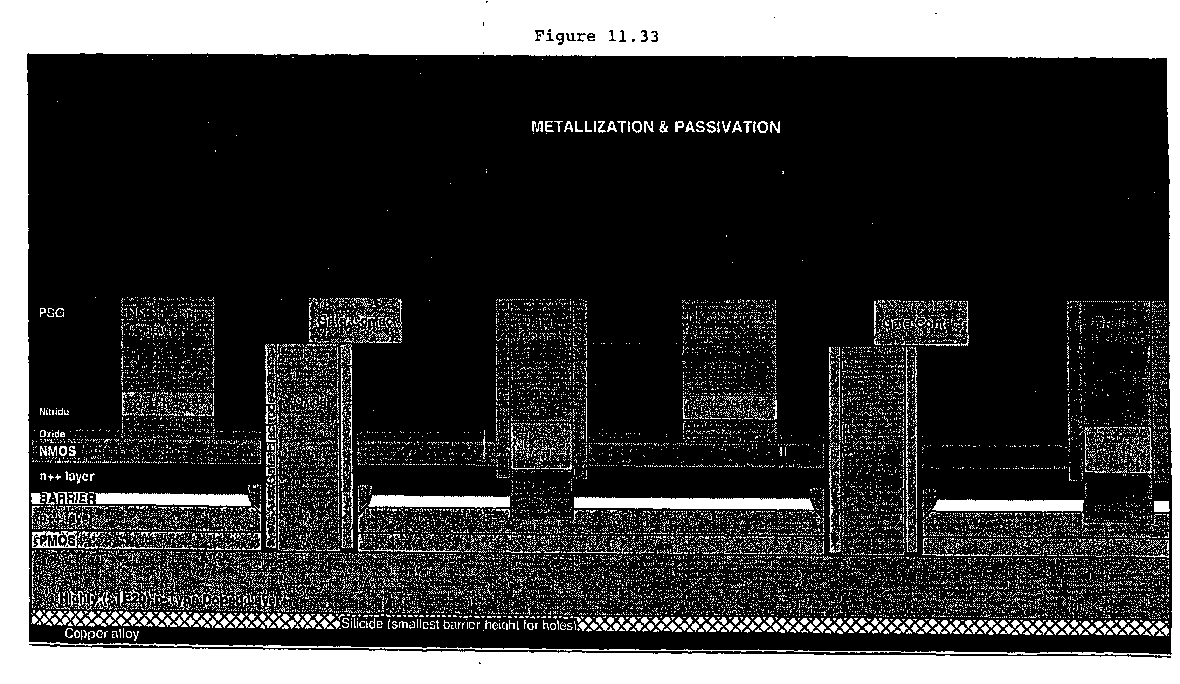

Flows 1 and 2 present different processing possibilities to implement CMOS architectures where NMOS pass transistors are possible provided that drain barriers can be implemented, or provided that the leakage current, in the absence of drain barriers, is tolerable. More particularly, flow 2 shows a process sequence slightly different from flow 1 at the moment of the formation of the gate contact pad and thereafter. This alternative way seems to provide less critical processing steps. As an example, figures 10 and 11 represent the manufacturing of a CMOS inverter according to these process flows 1 and 2.

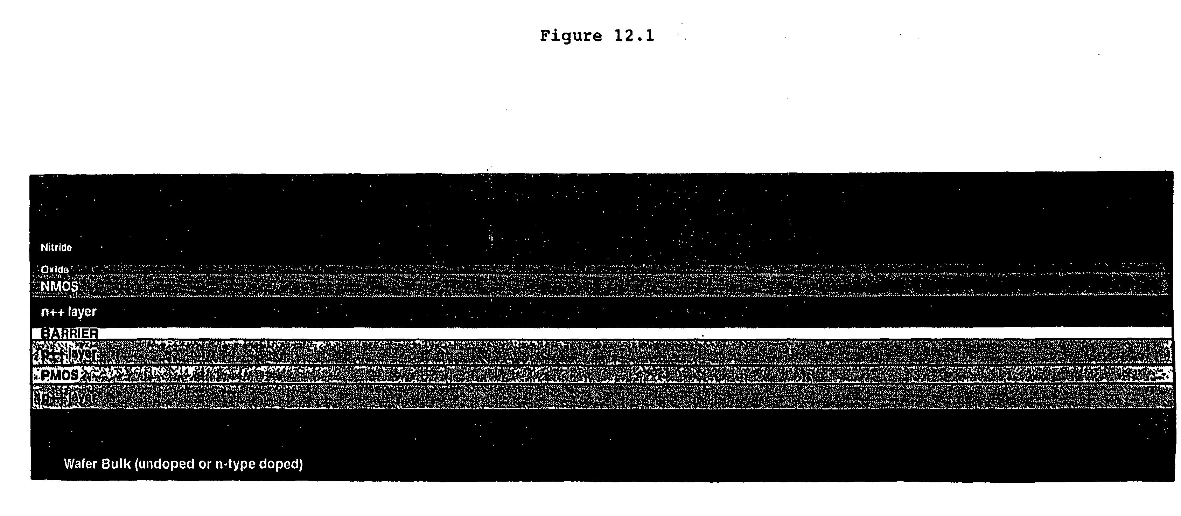

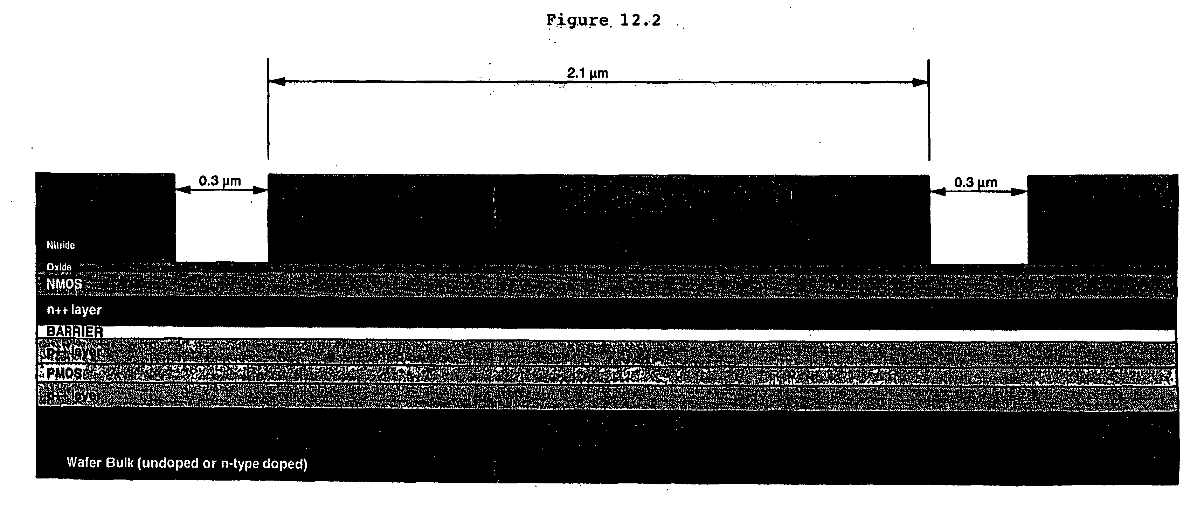

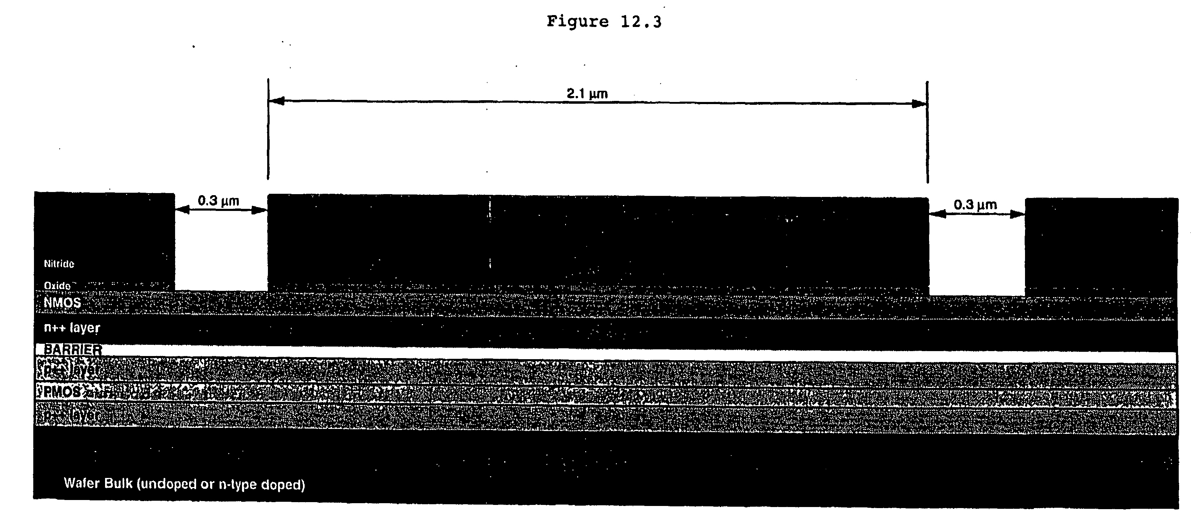

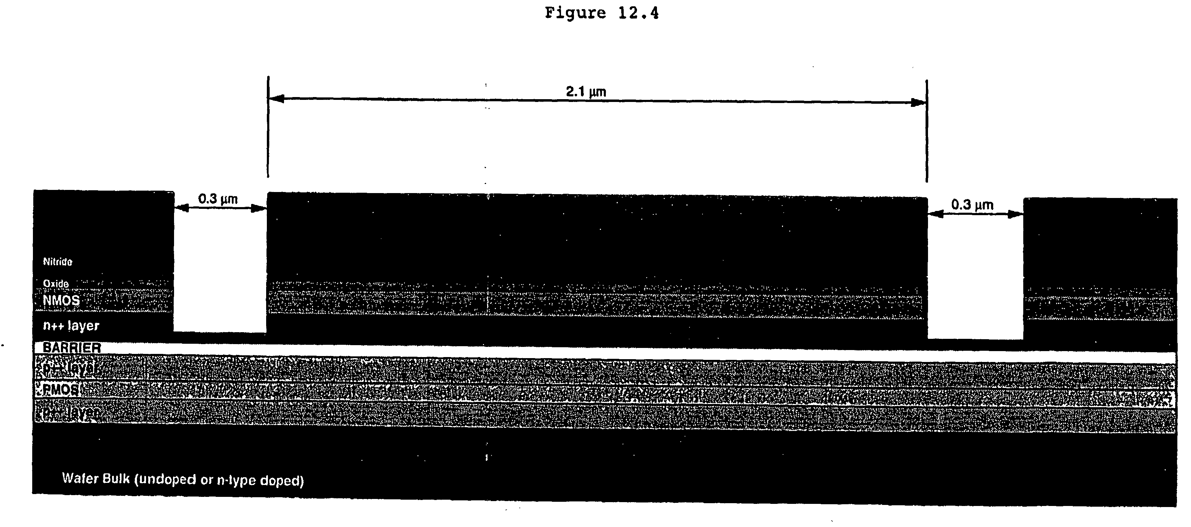

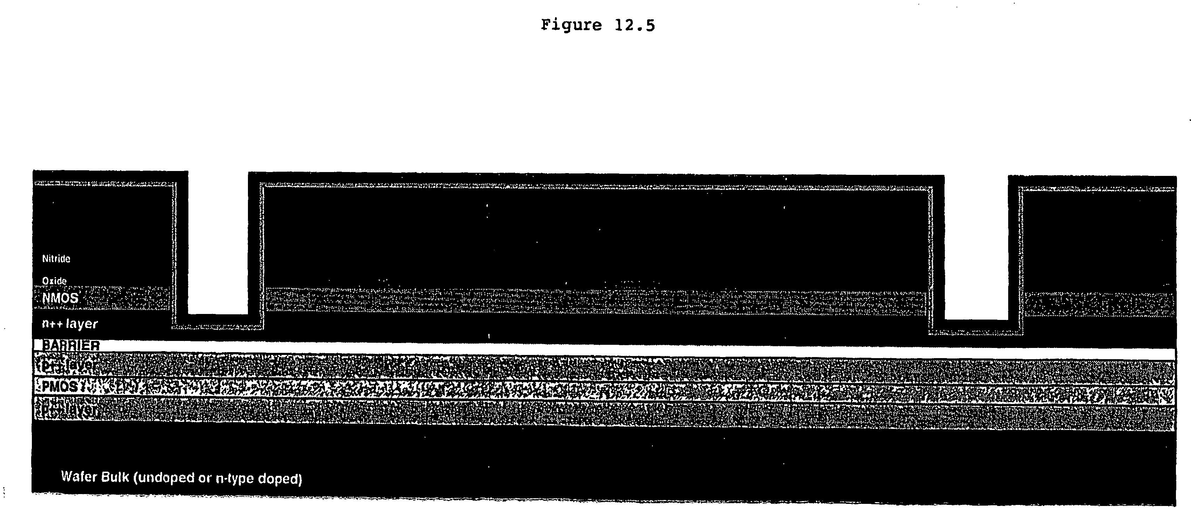

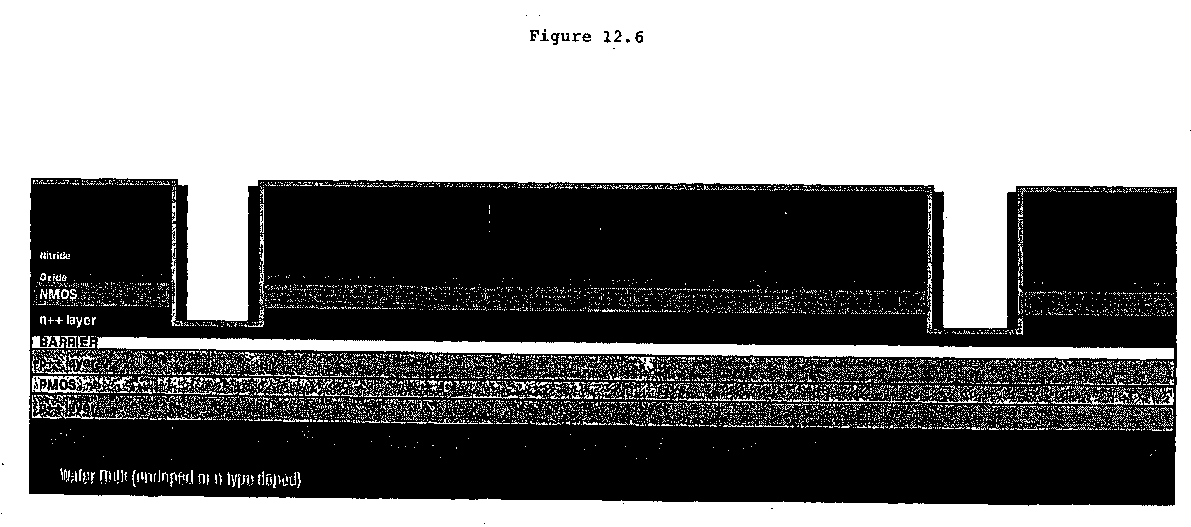

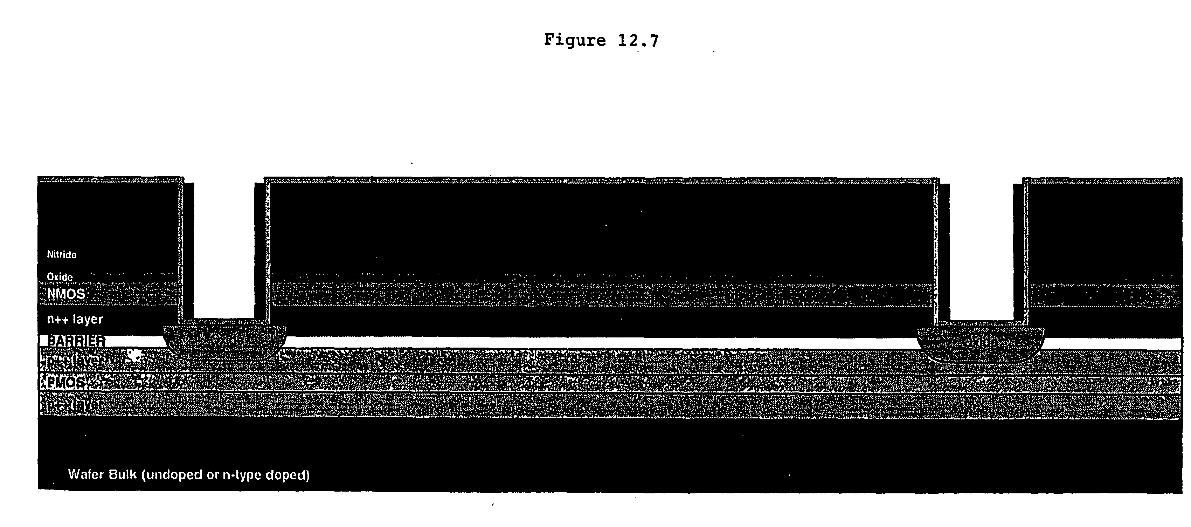

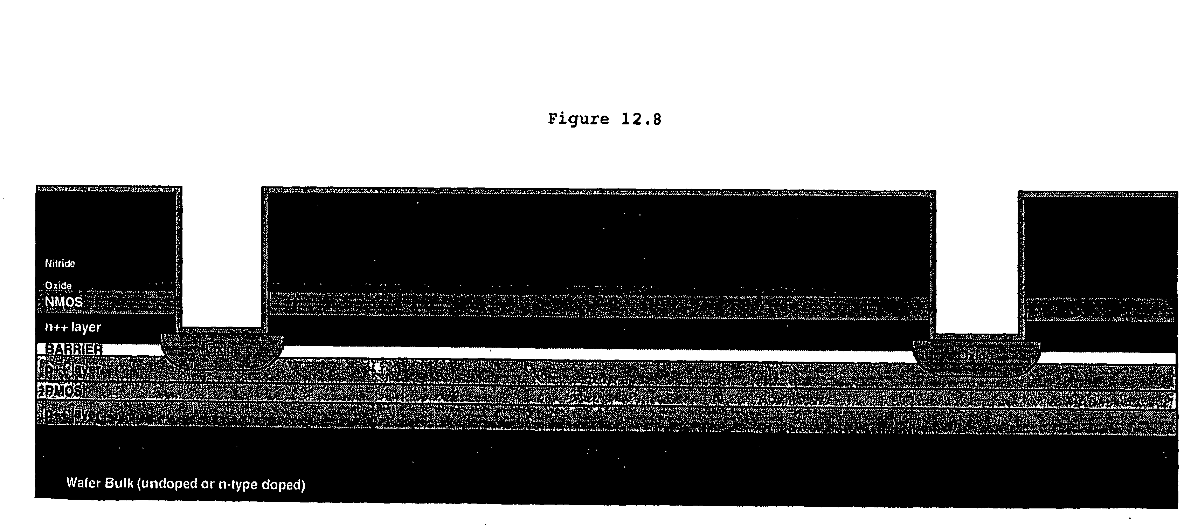

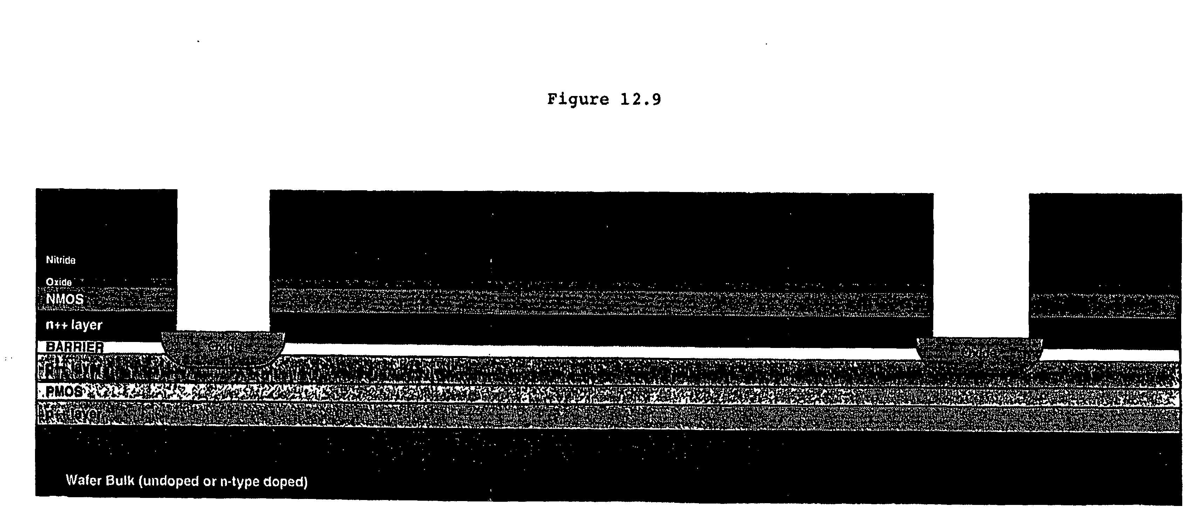

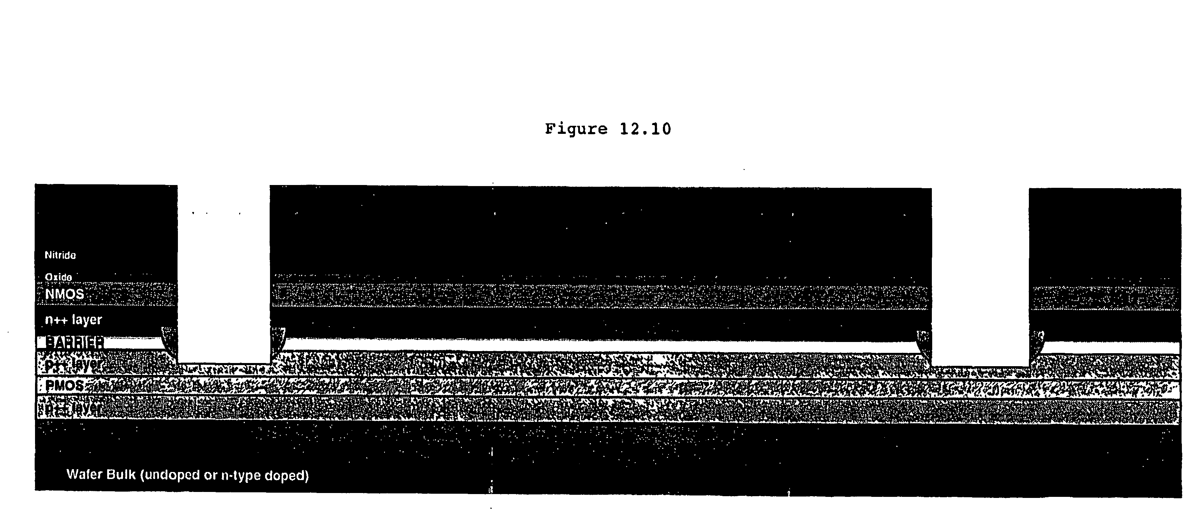

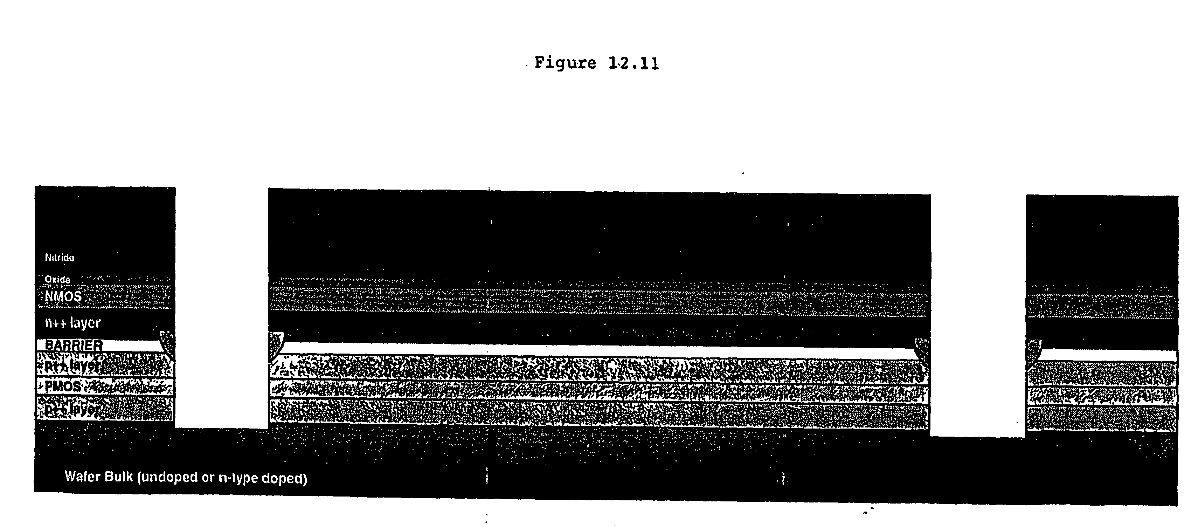

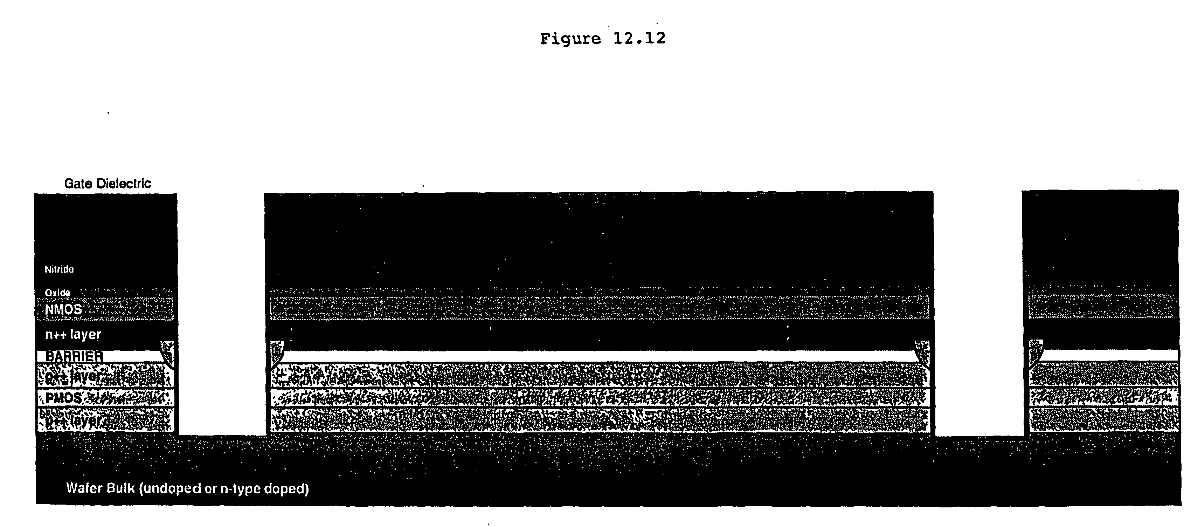

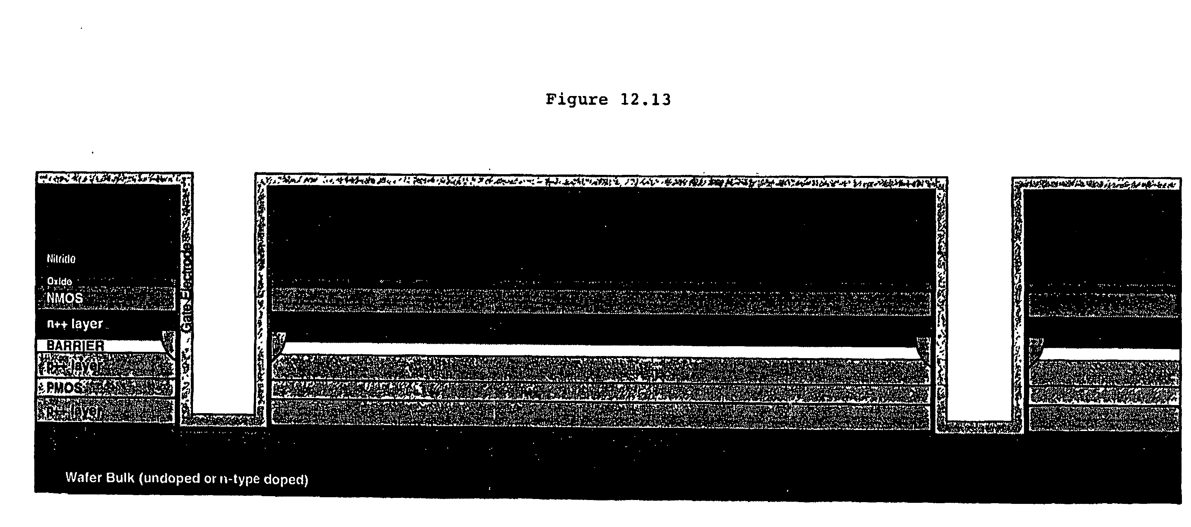

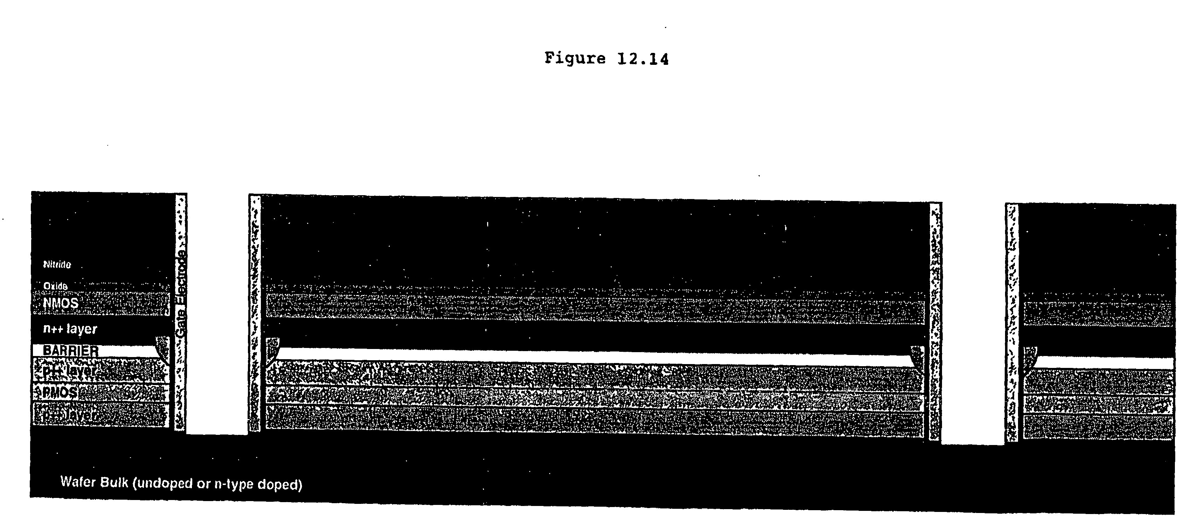

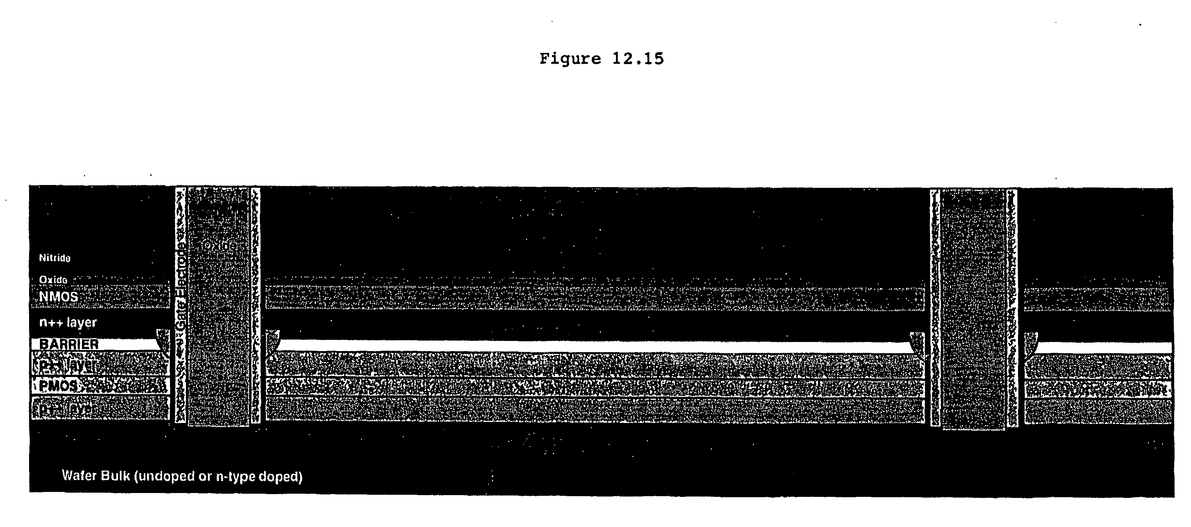

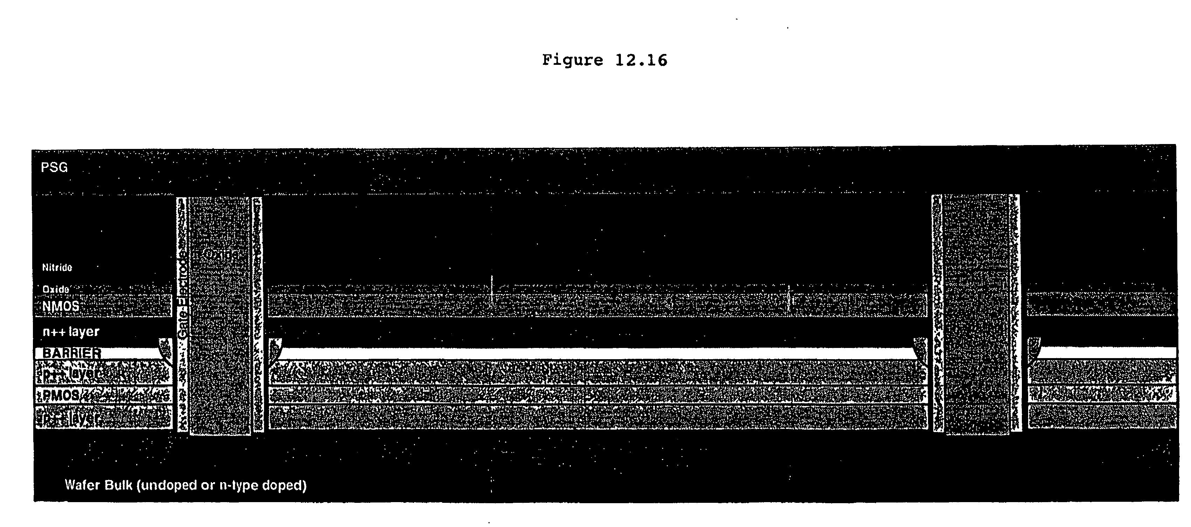

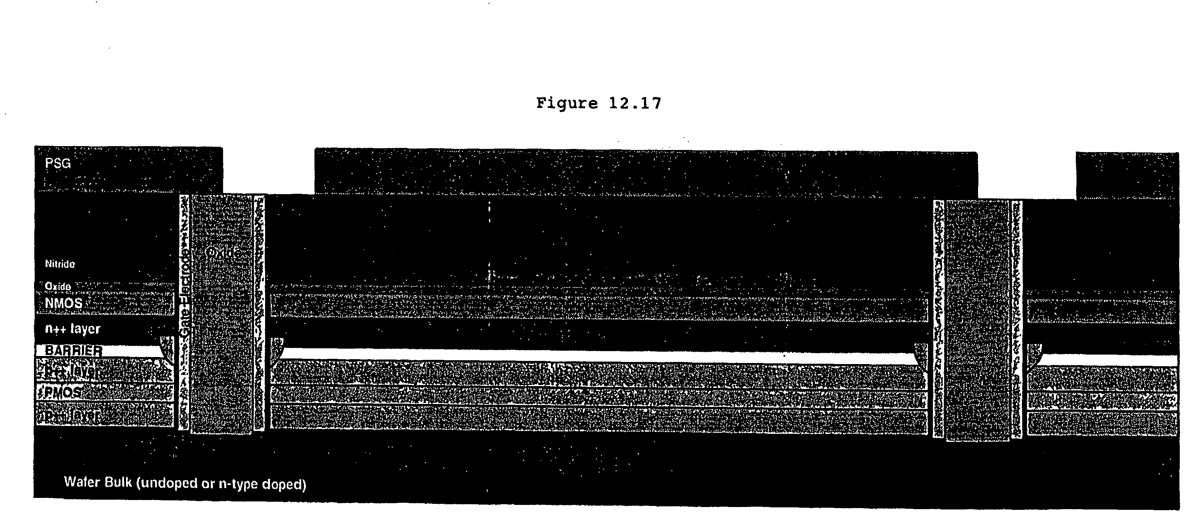

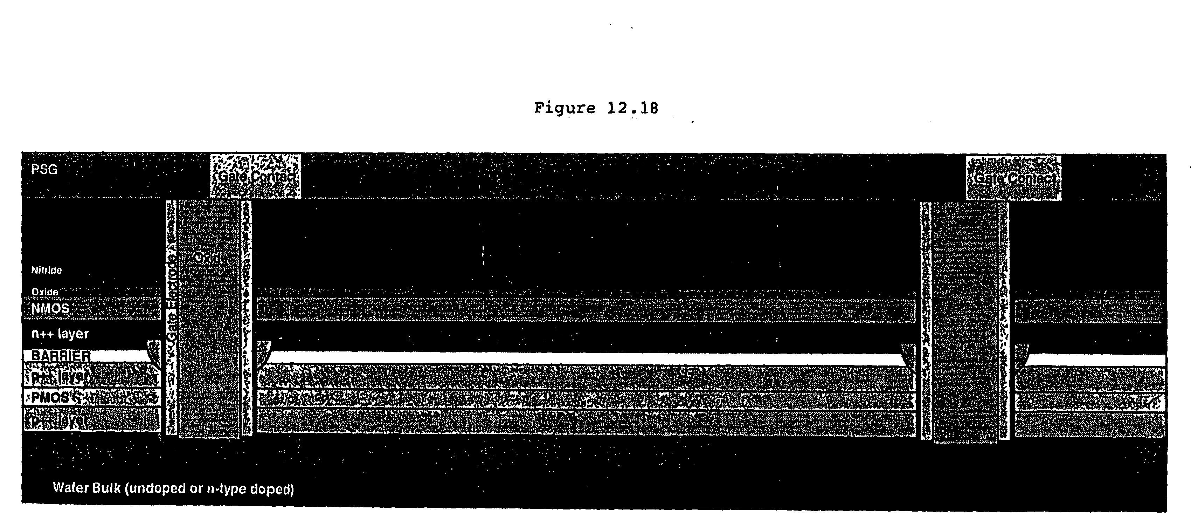

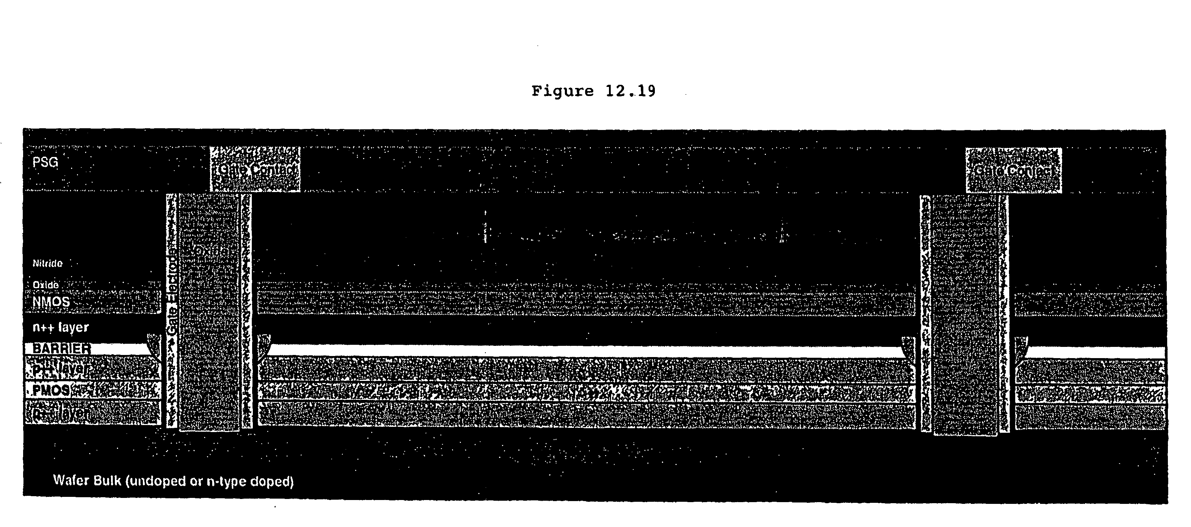

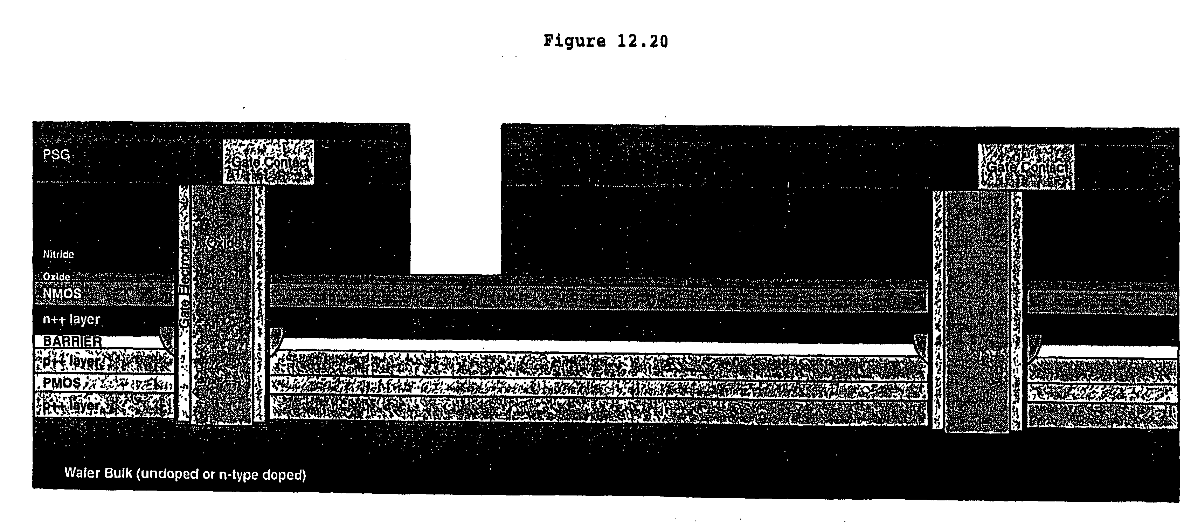

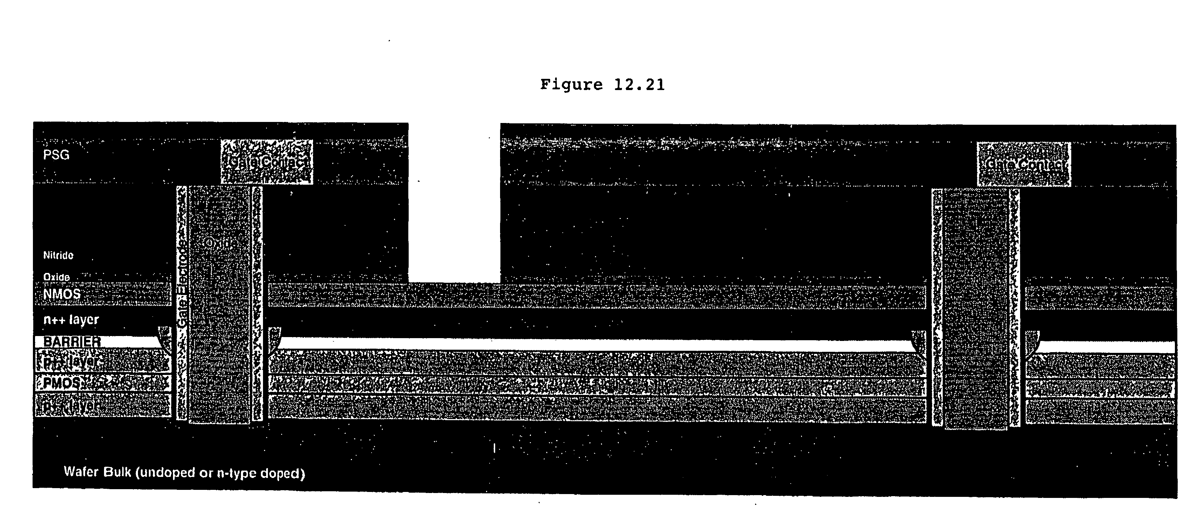

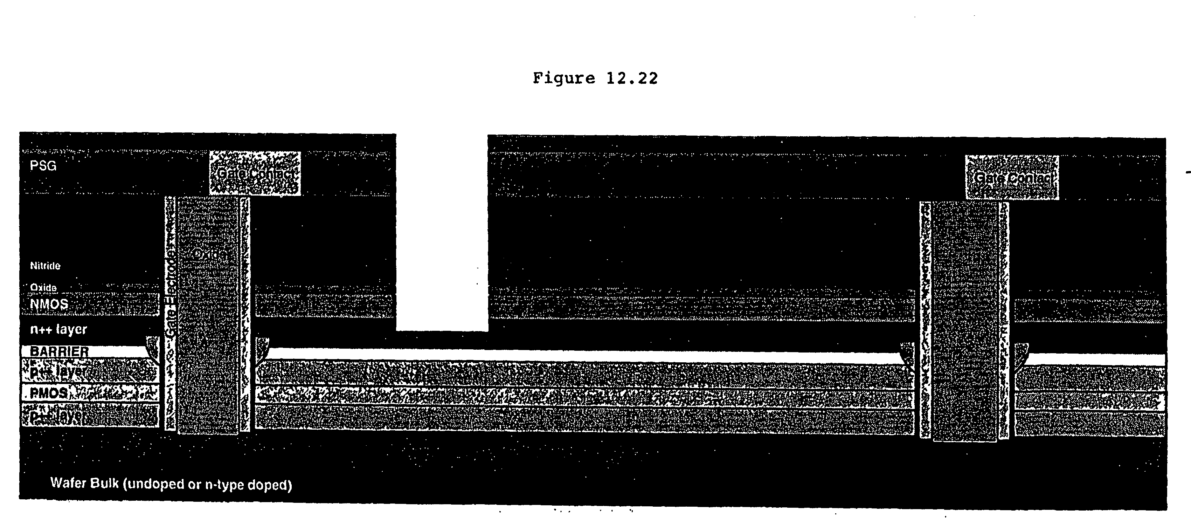

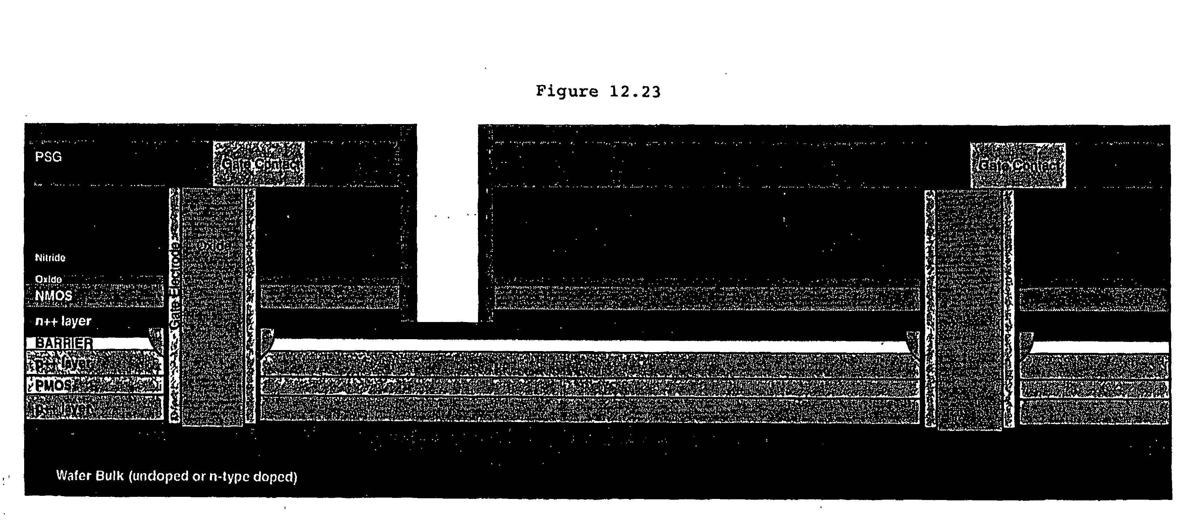

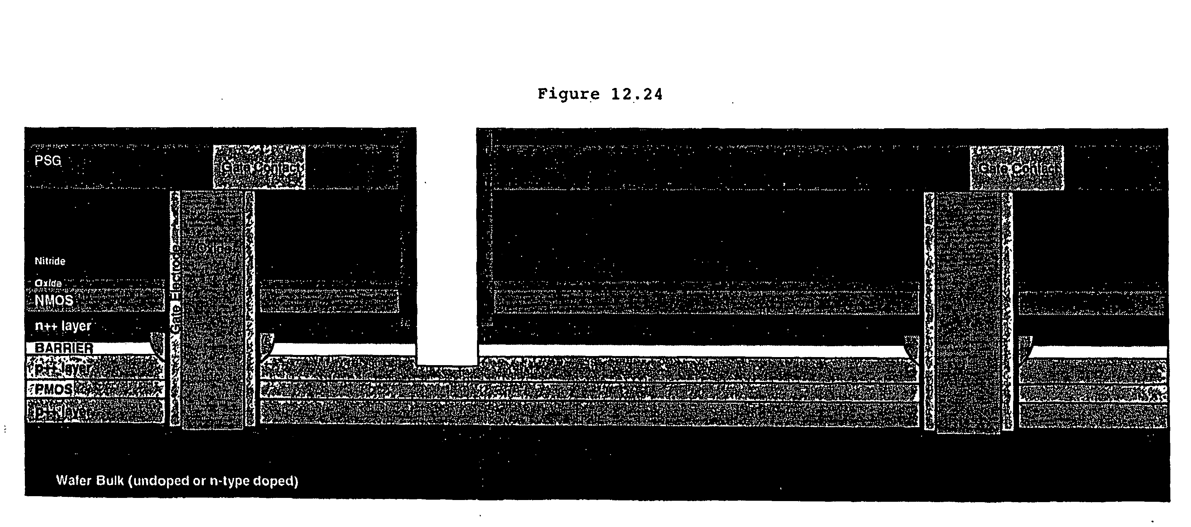

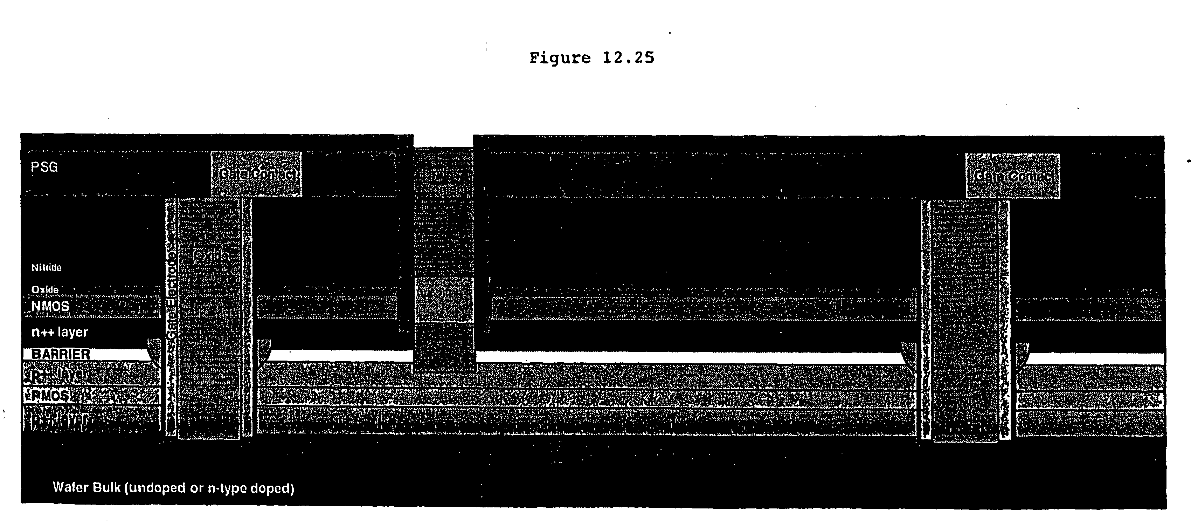

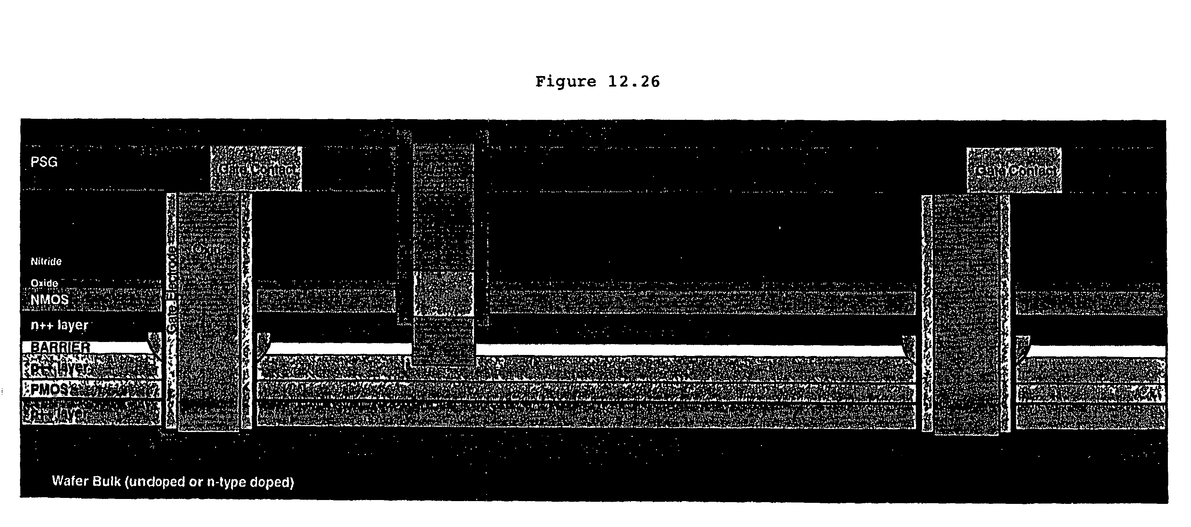

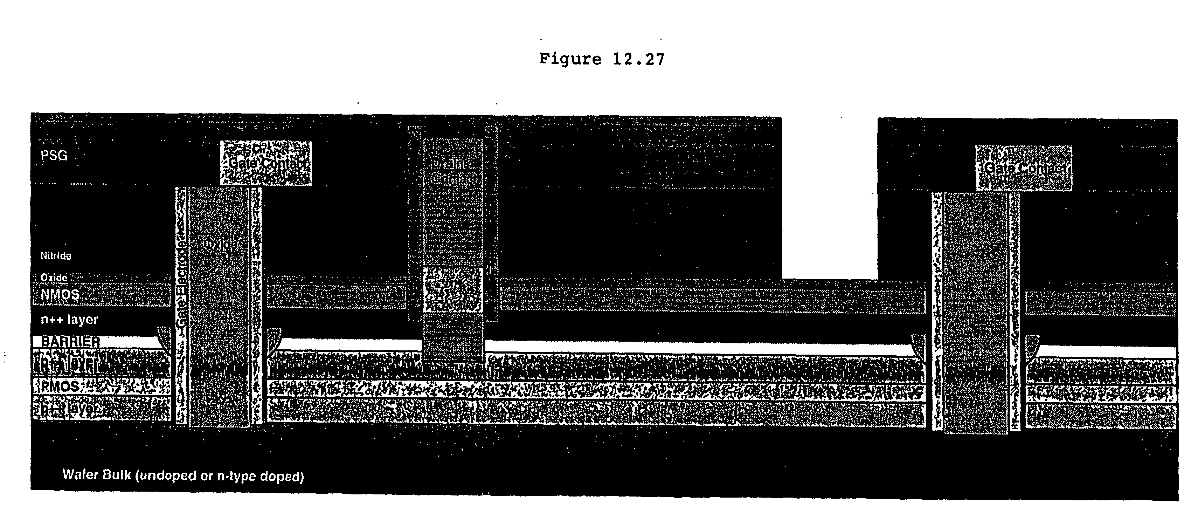

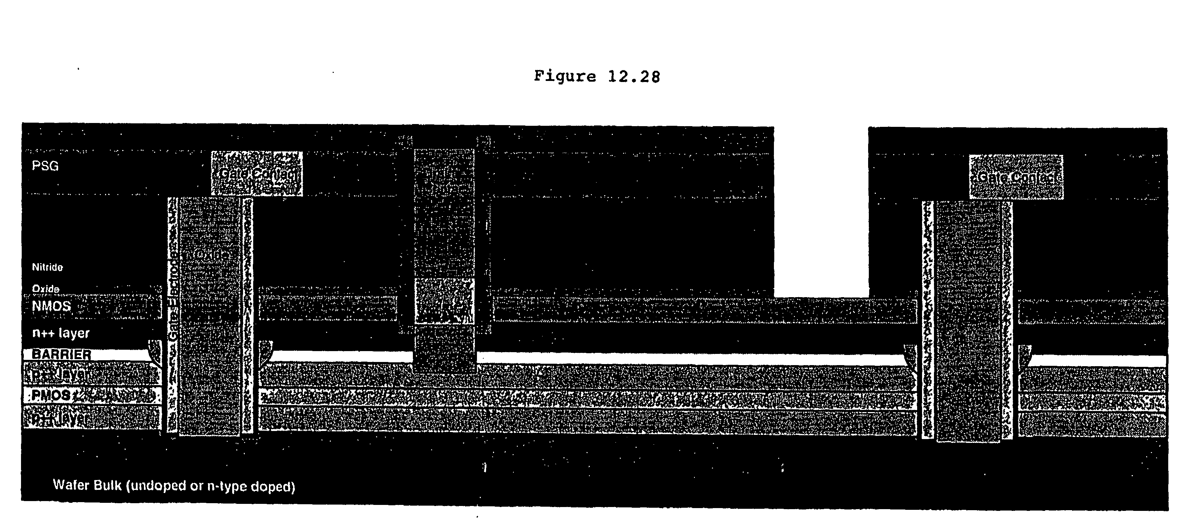

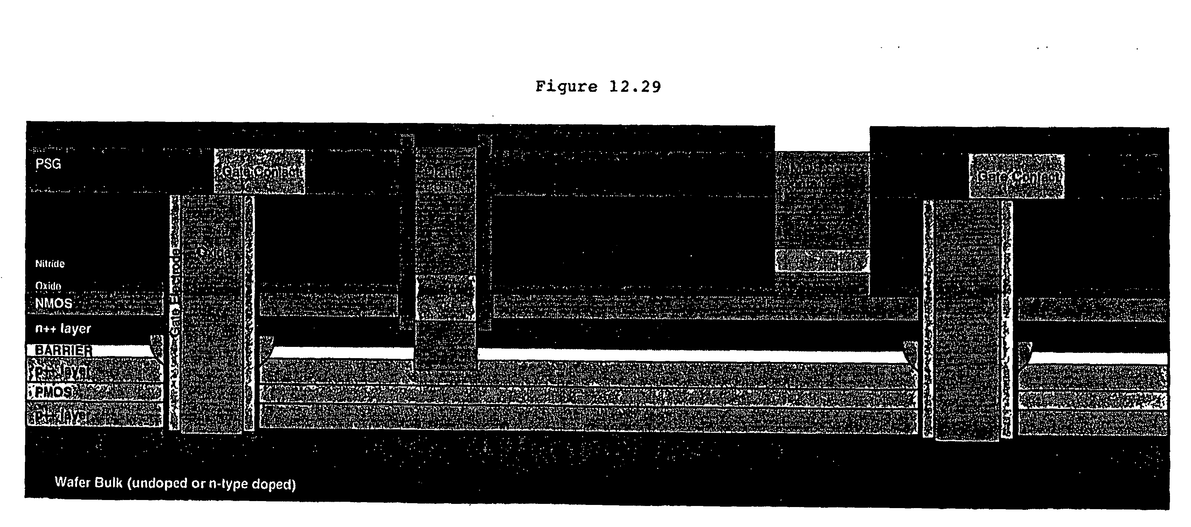

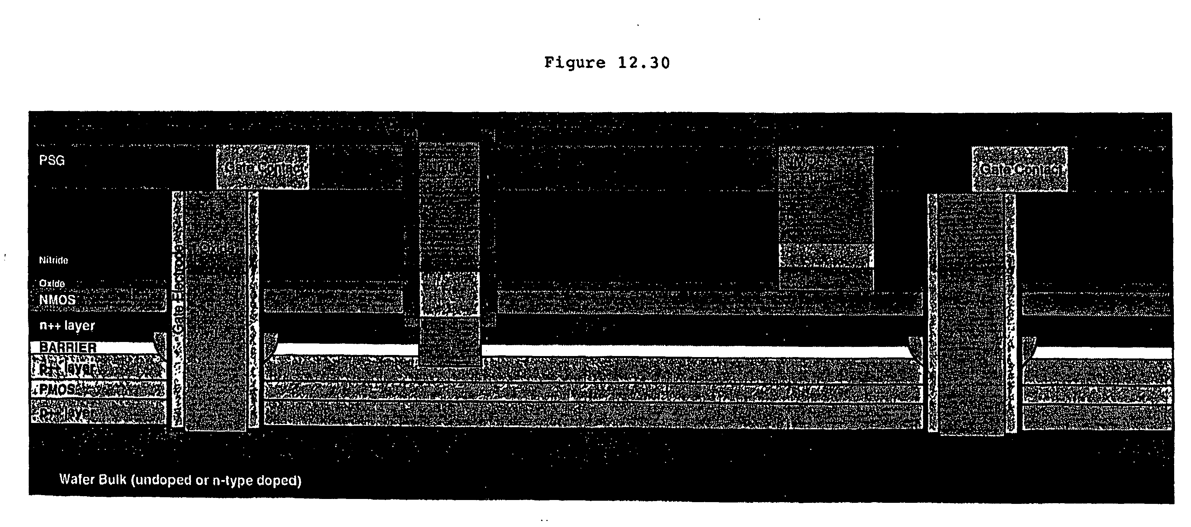

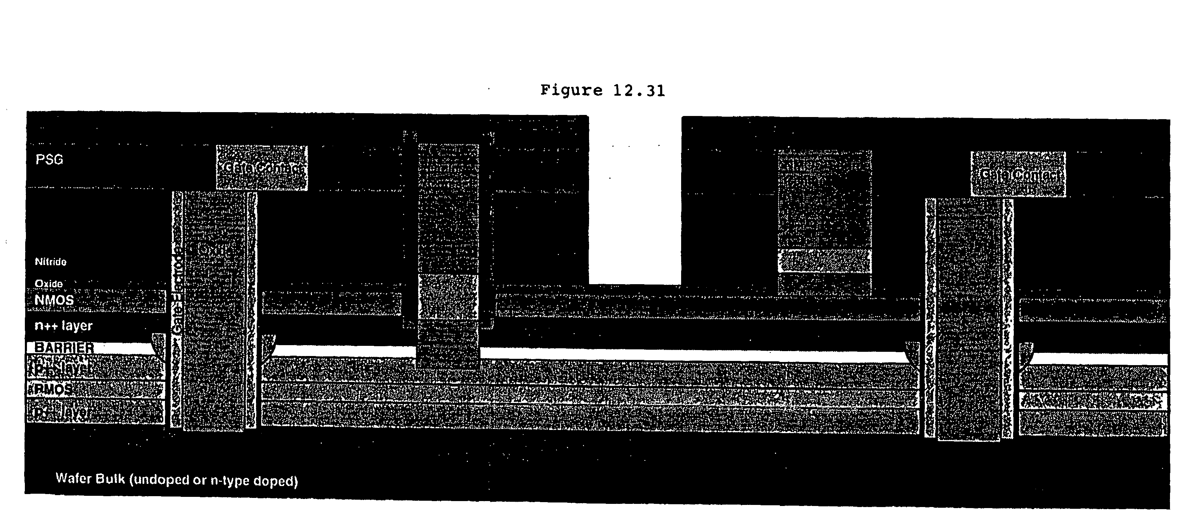

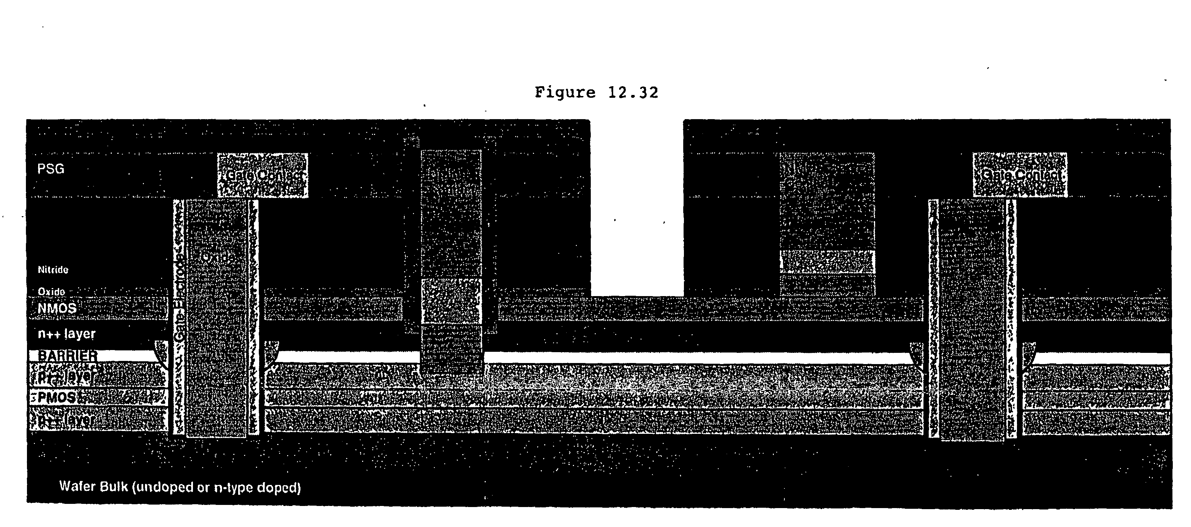

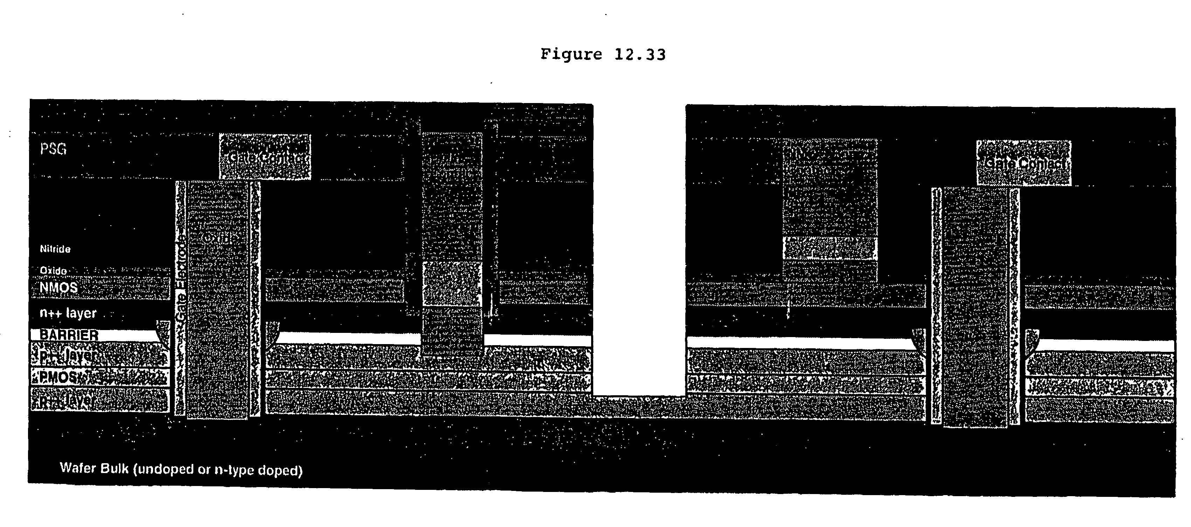

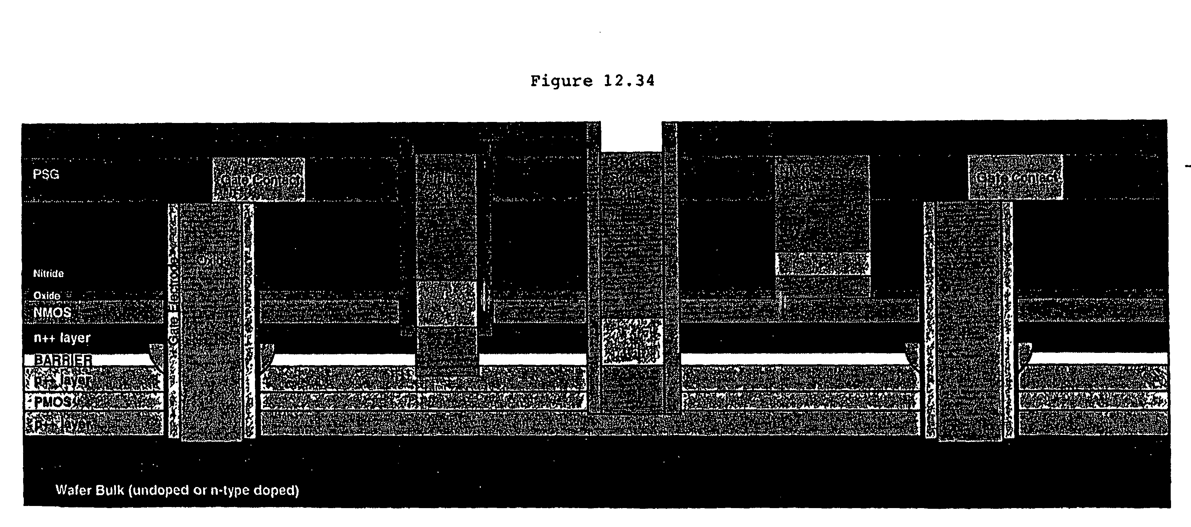

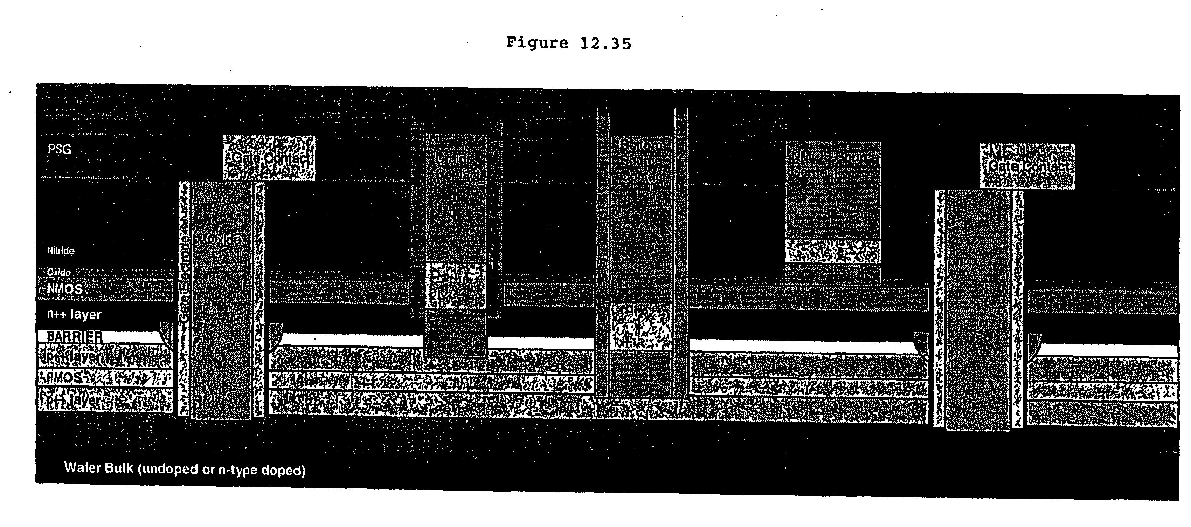

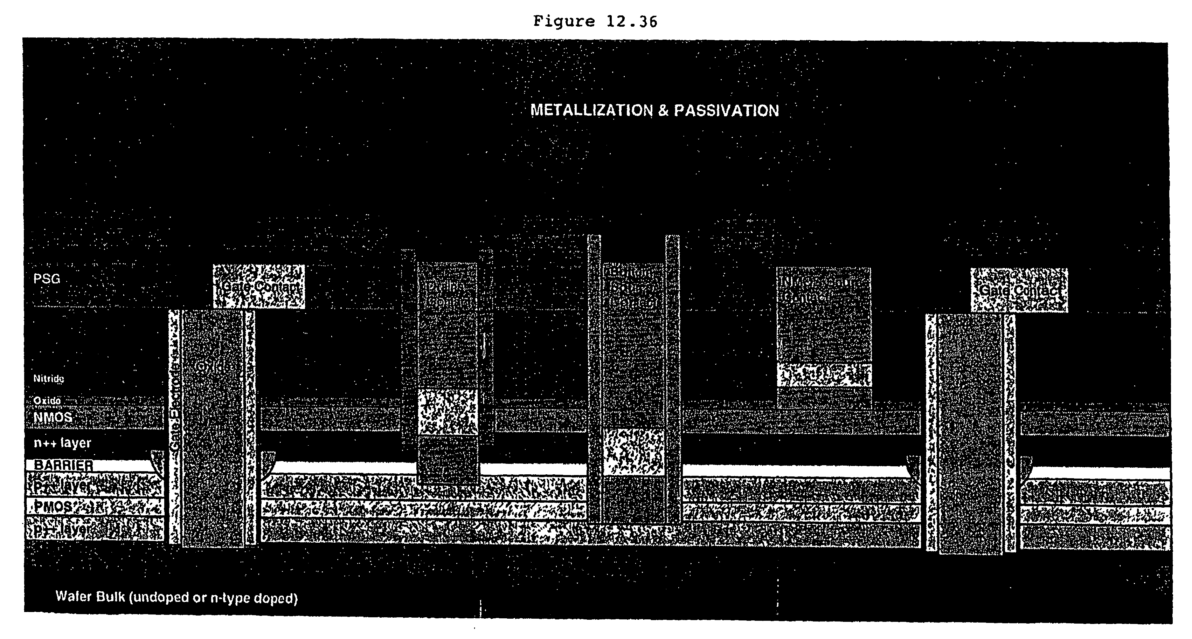

Flow 3, shows one possible architecture for the fabrication of complementary pass-transistors. This is achieved by not having all the bottom transistor sources connected together. There is some area penalty (compared to flows 1 and 2) to make inverters due to the need of providing contact to the bottom source for every single bottom transistor. As an example, a CMOS process flow is shown in figs. 12.

In Flow 4, another integration architecture is shown that makes complementary pass-transistors possible, without area penalty. In this flow, the layers of the bottom transistor are again deposited on top, thereby arranging a triple transistor stack. All the sources of the bottom transistors are connected together for the CMOS inverters, and the same kind of transistor can also be used as a pass-transistor by using the third layer stack on top. This scheme seems to offer all the advantages of flows 1, 2 and 3 without the drawbacks of flow 3 (in terms of integration integrity), and allow all possible circuit designs (impossible with flows 1 and 2). As an example, a NMOS (middle transistor layers) pass-transistor process is shown in the flow.

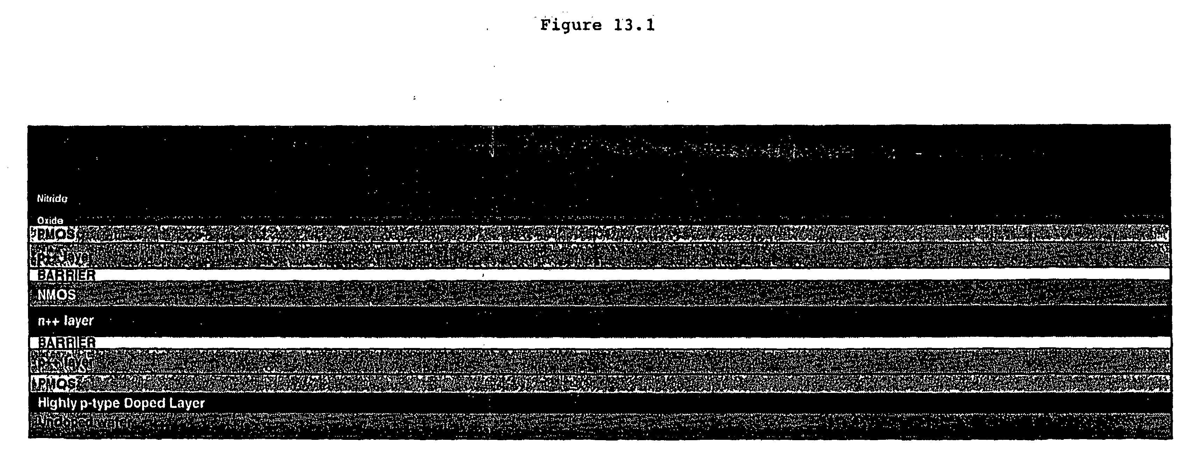

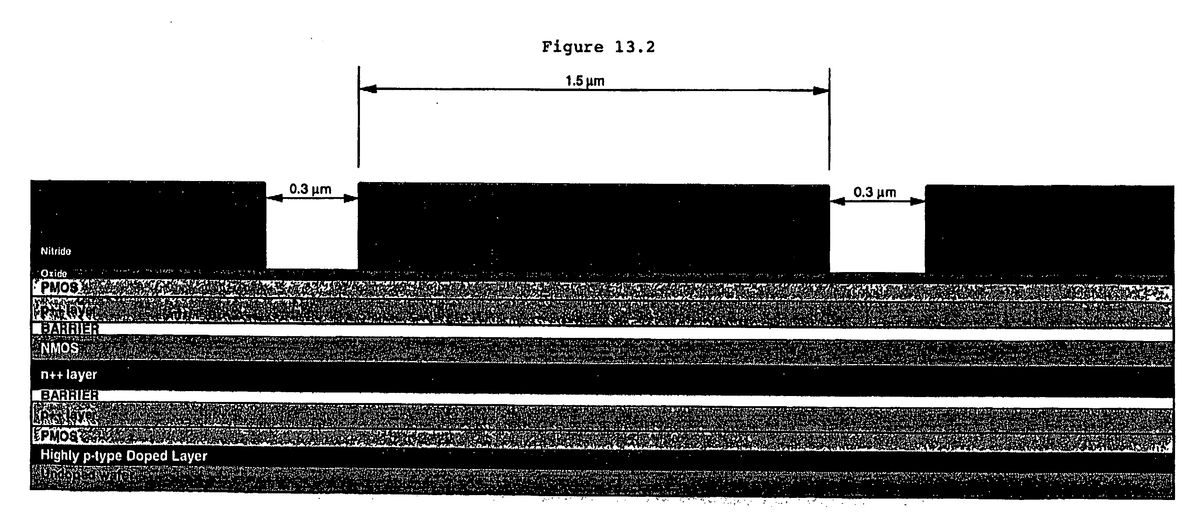

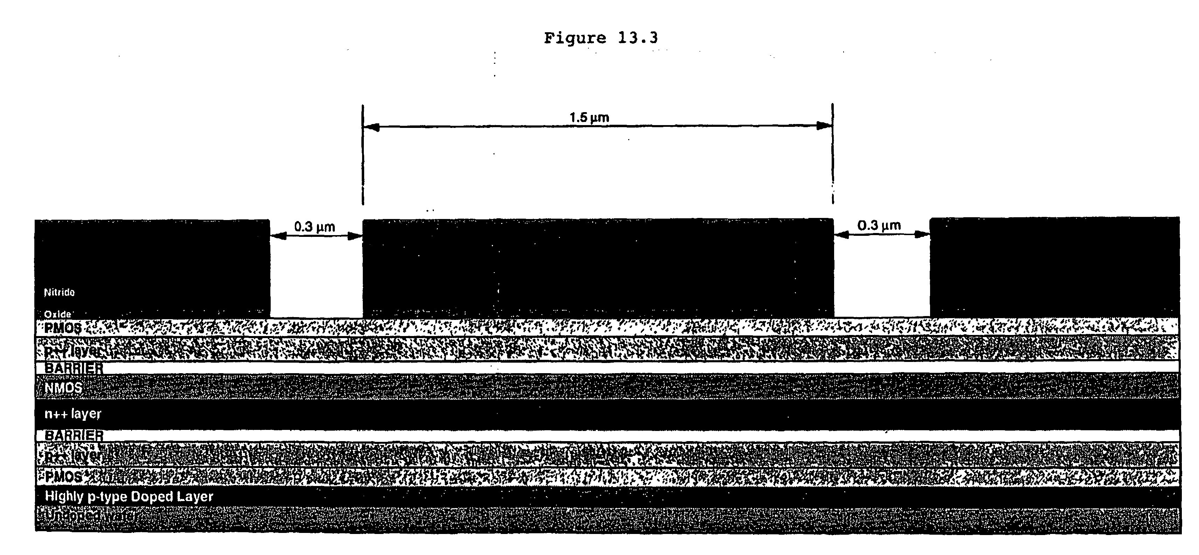

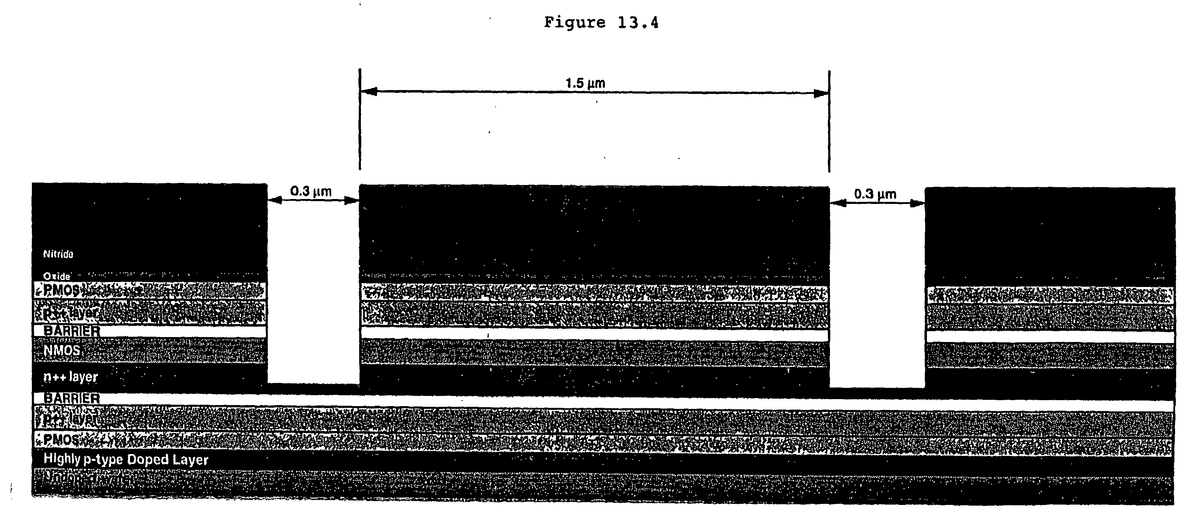

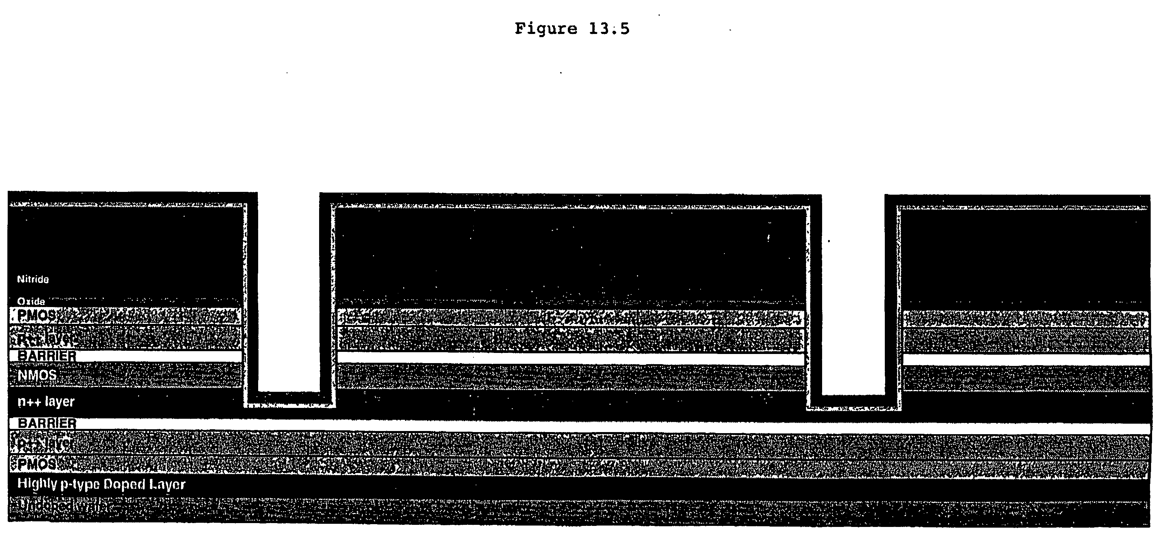

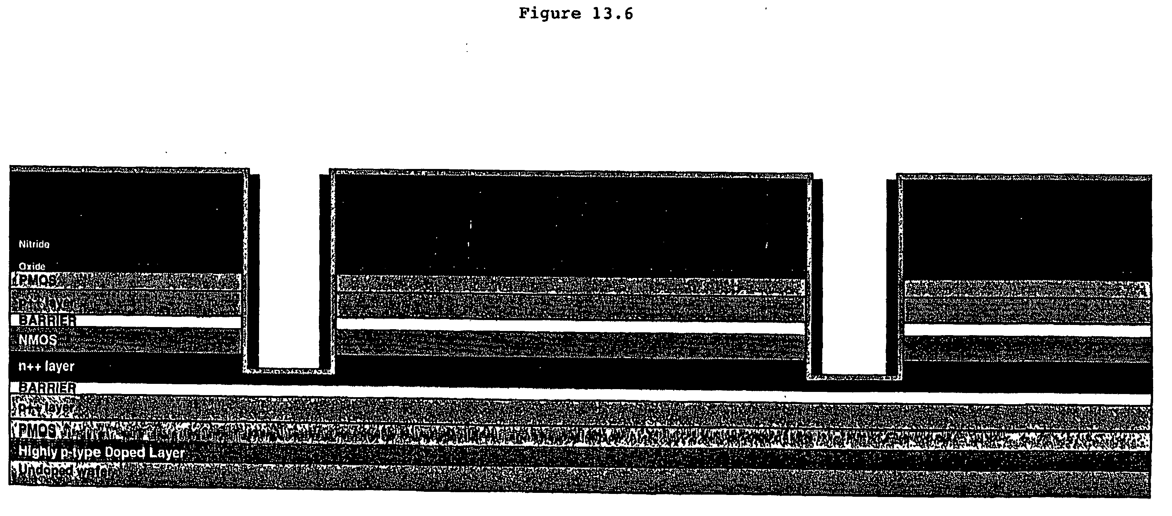

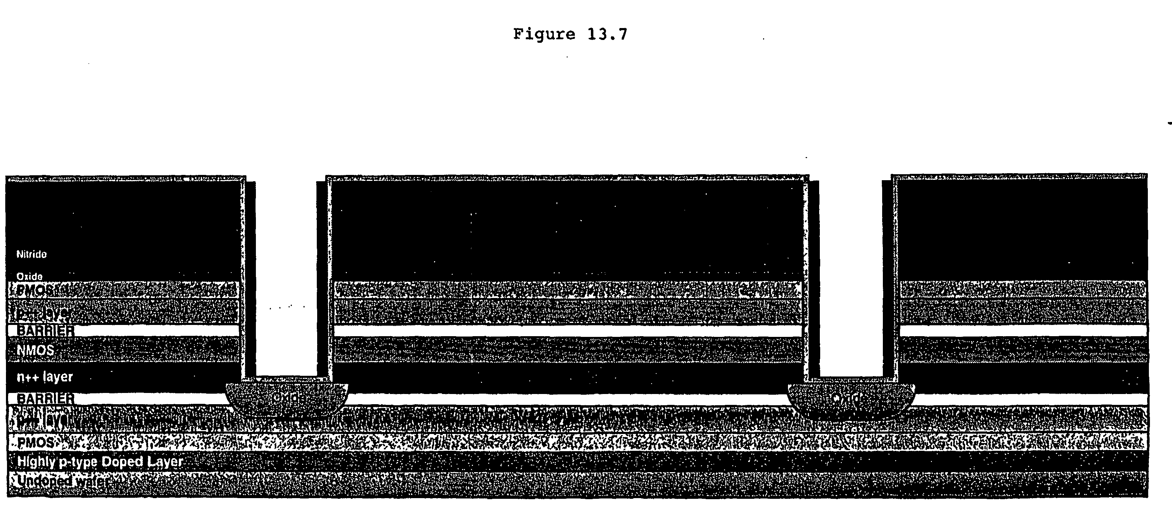

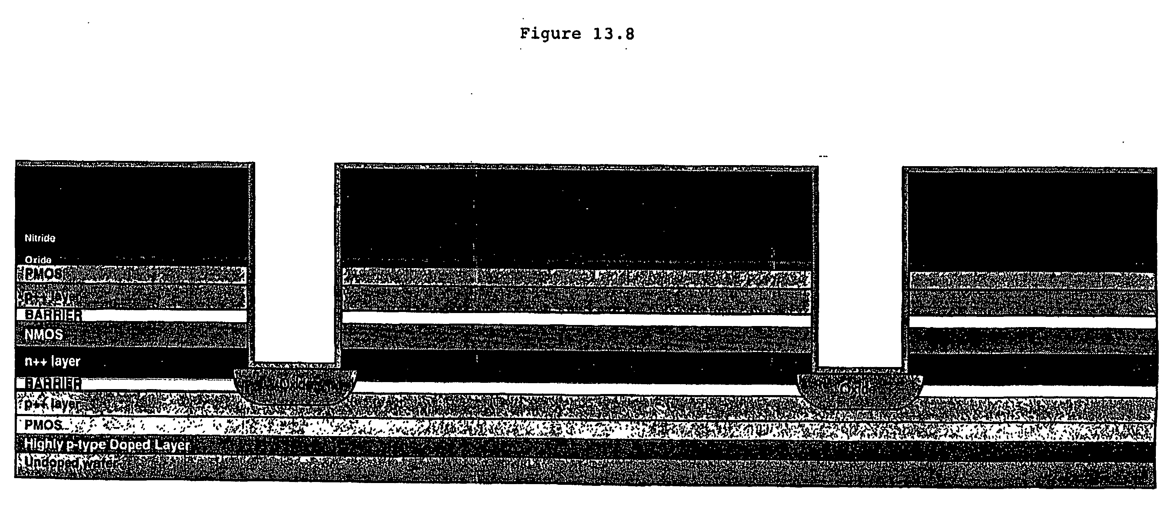

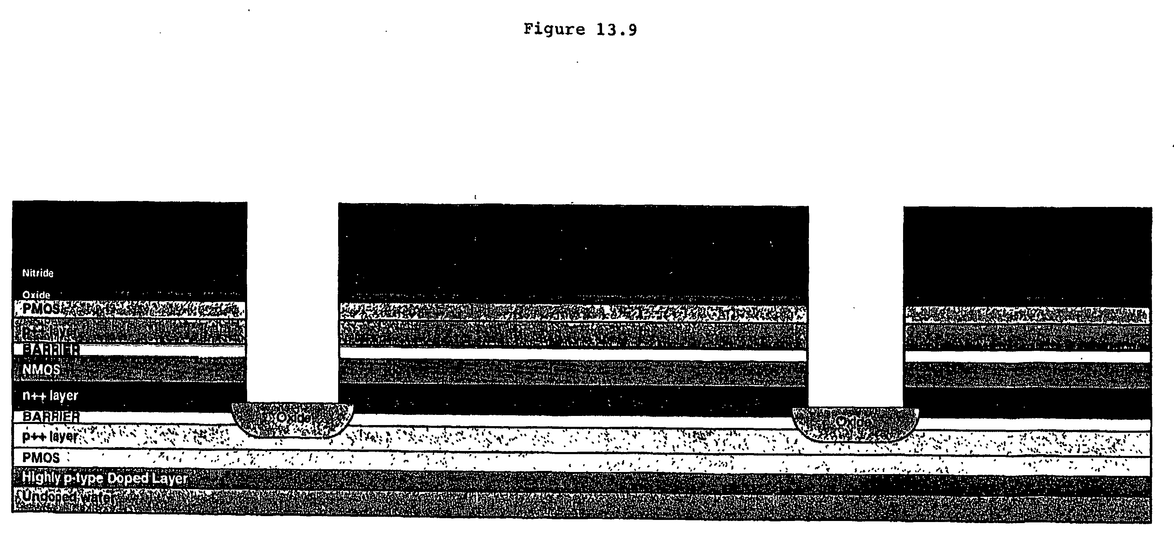

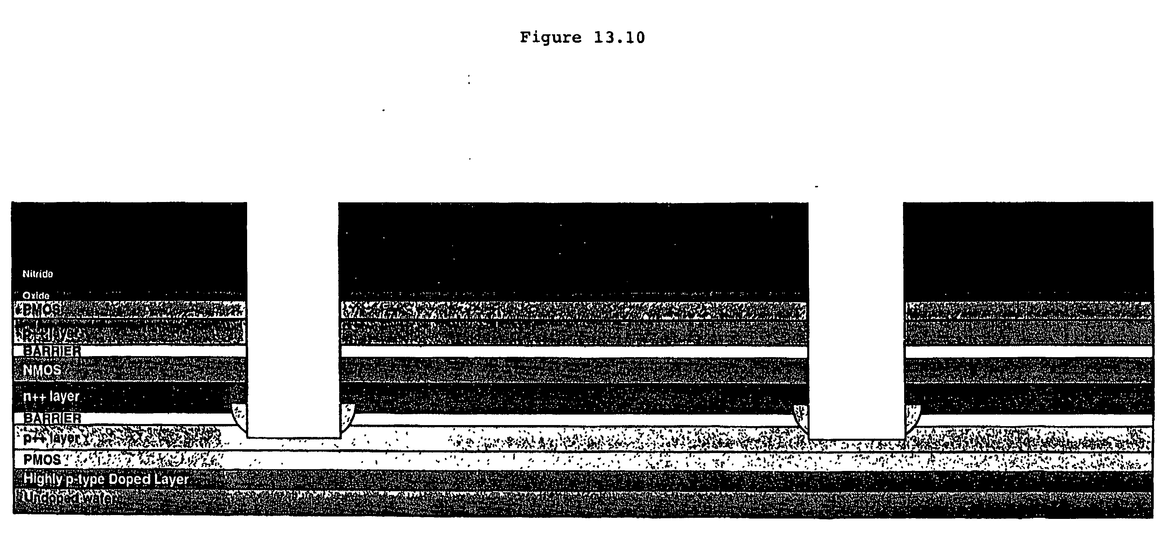

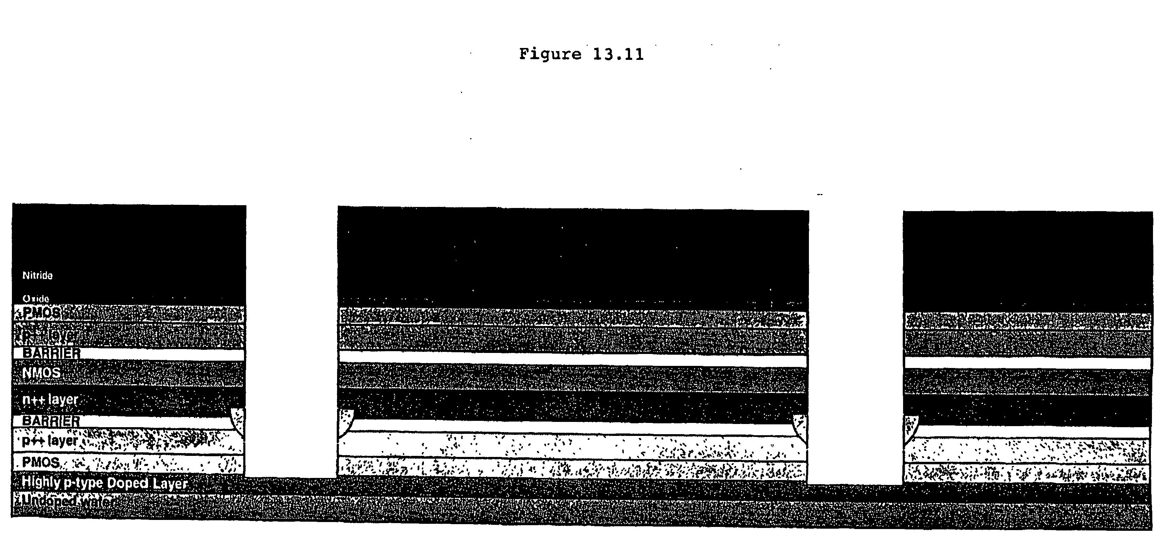

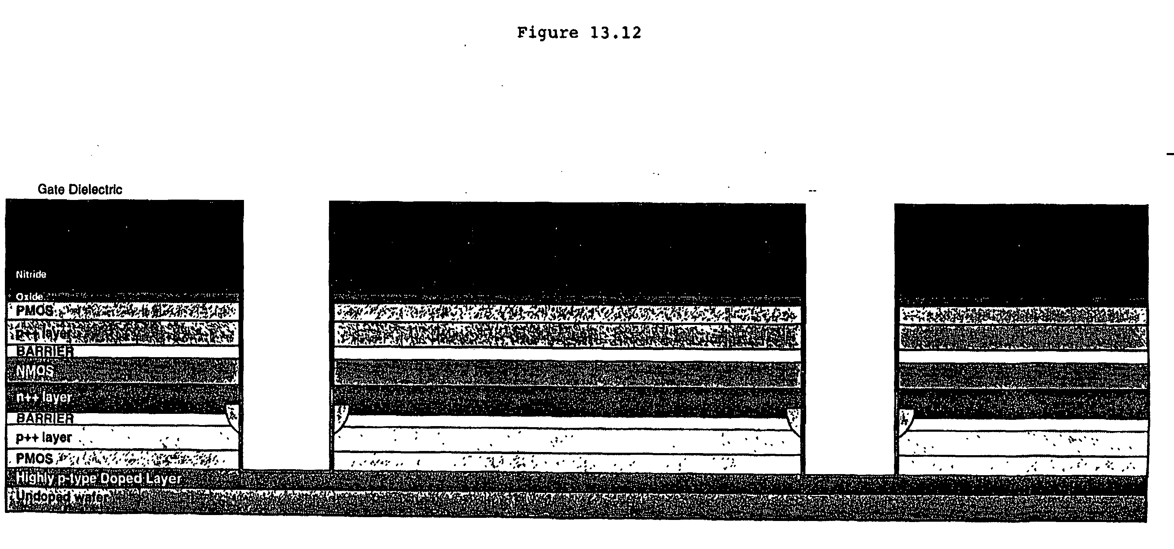

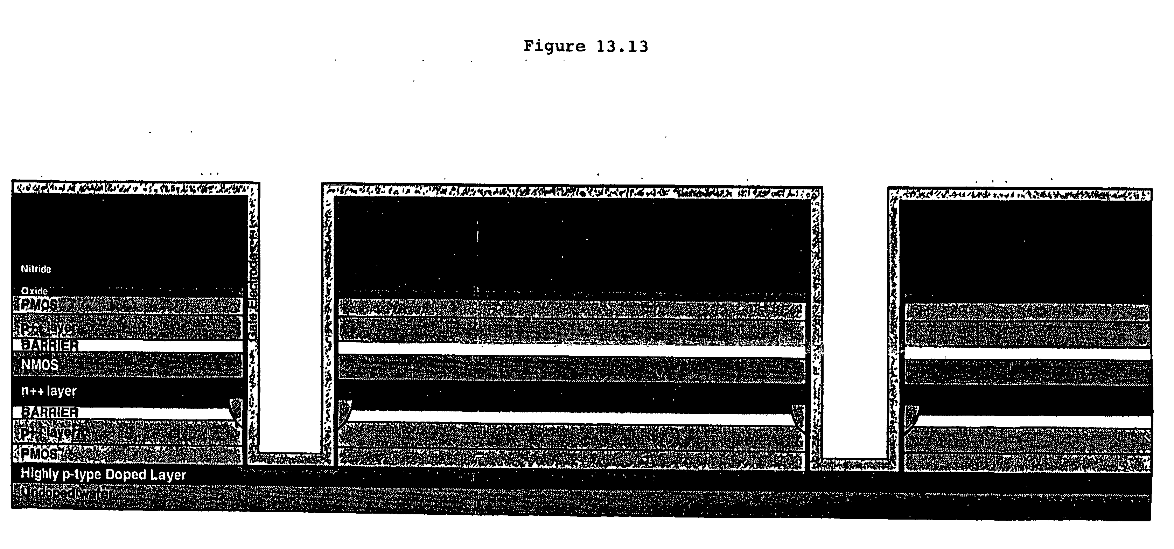

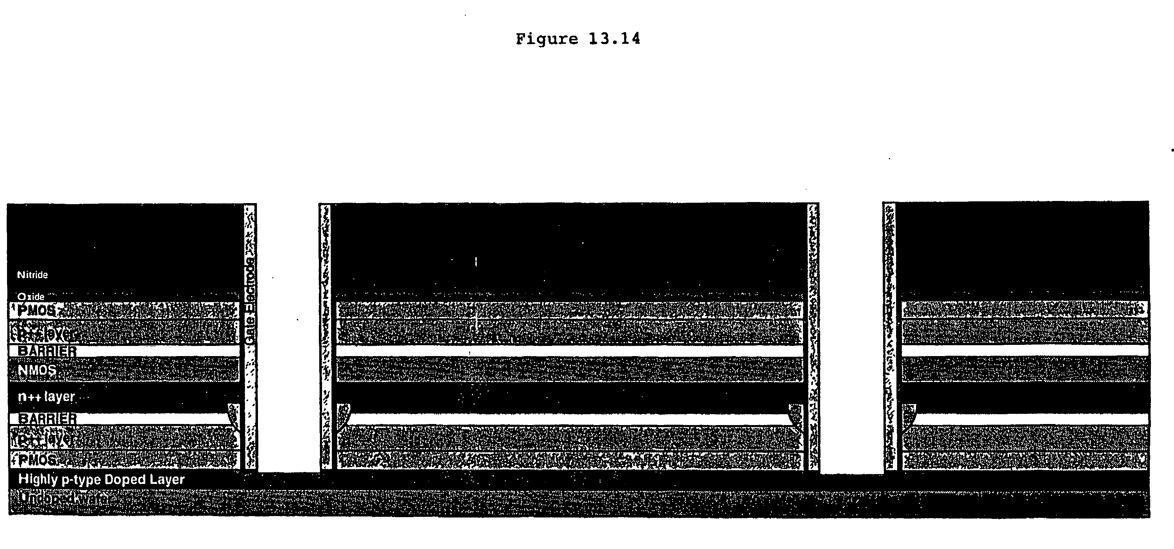

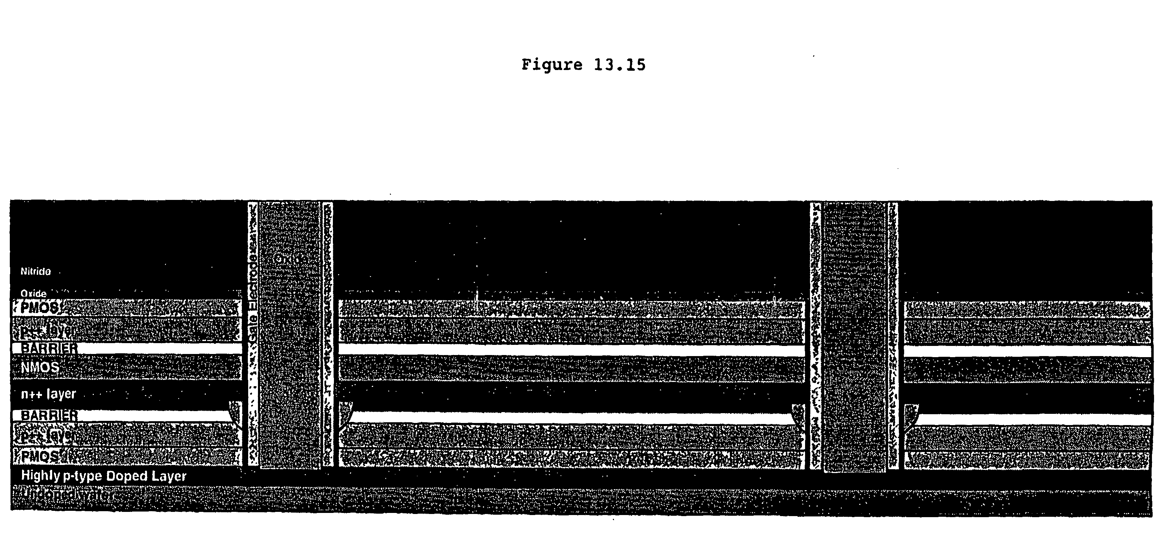

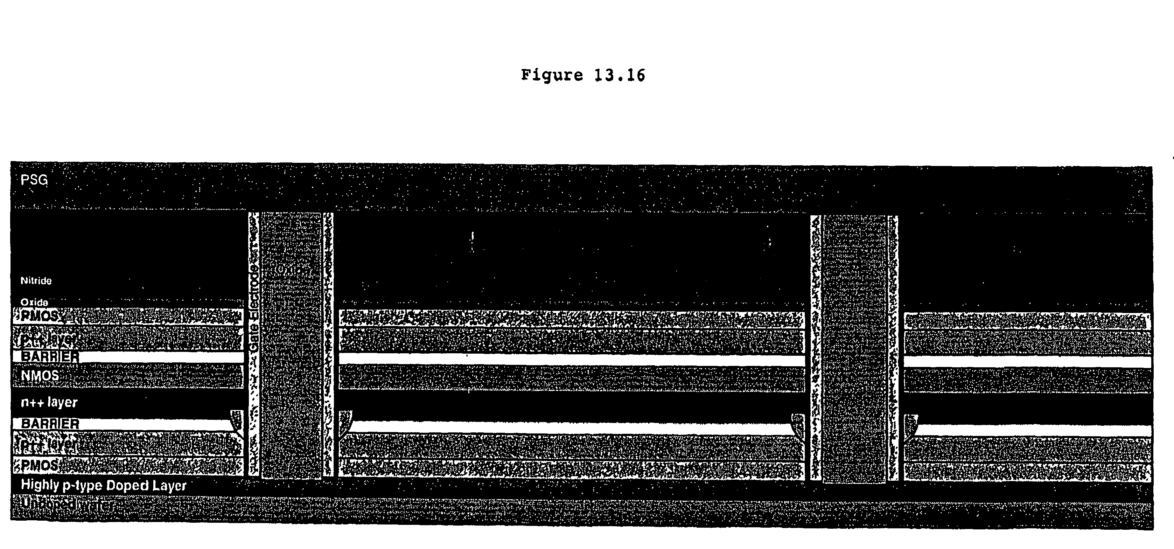

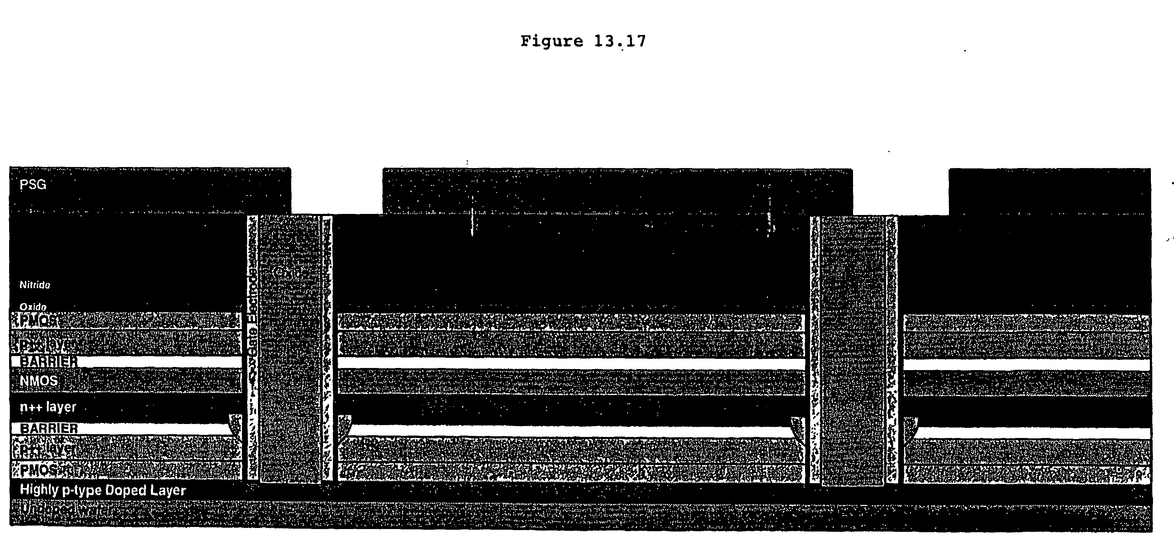

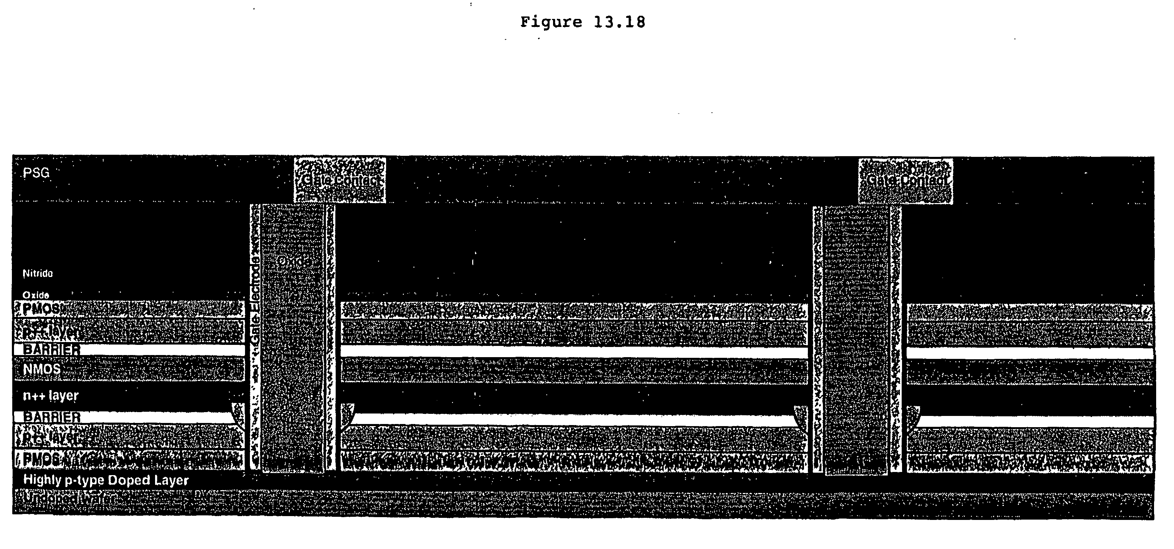

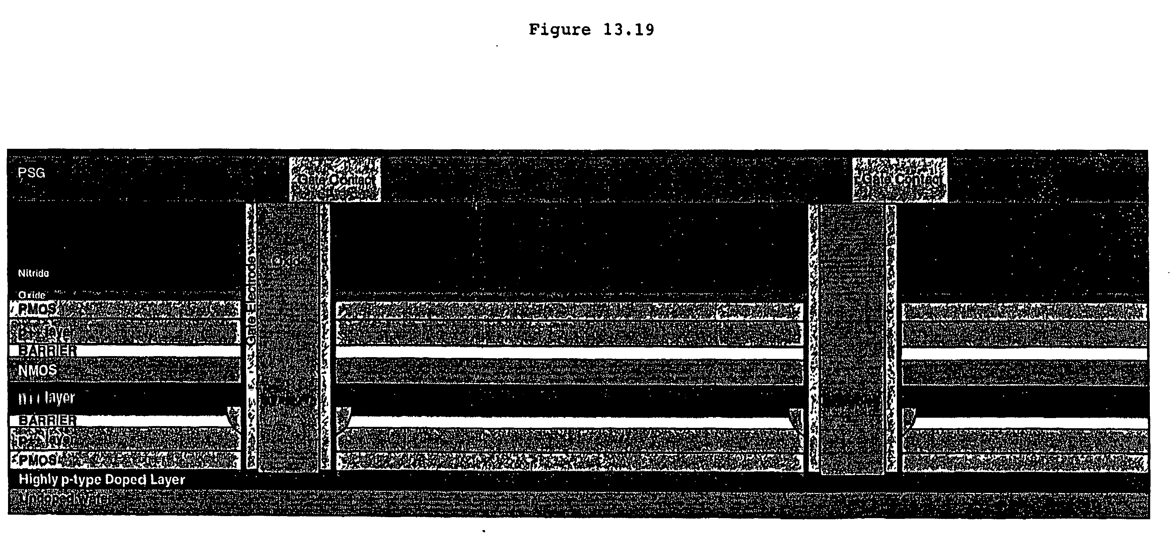

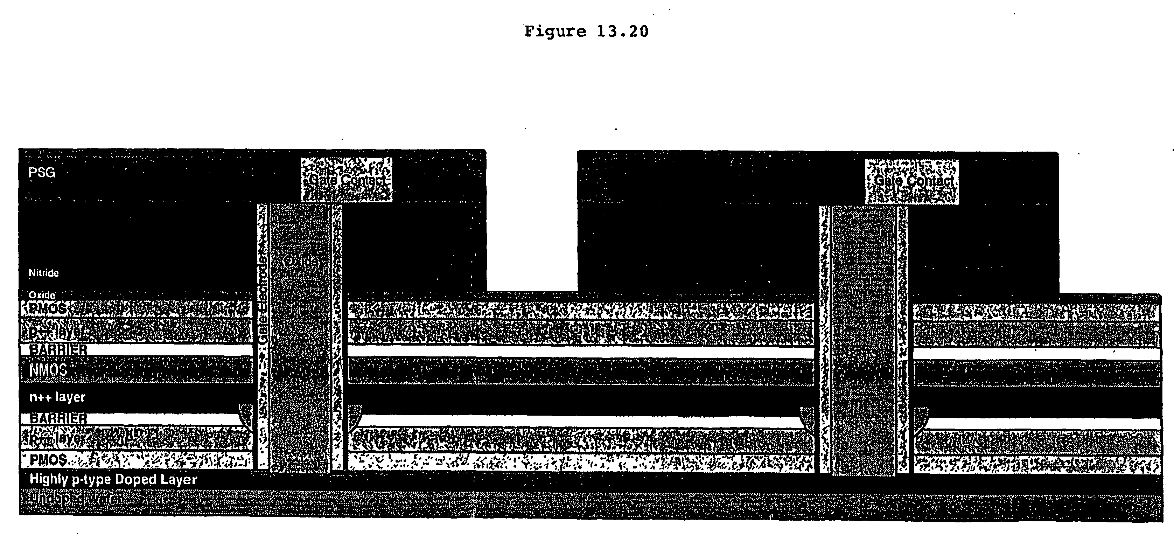

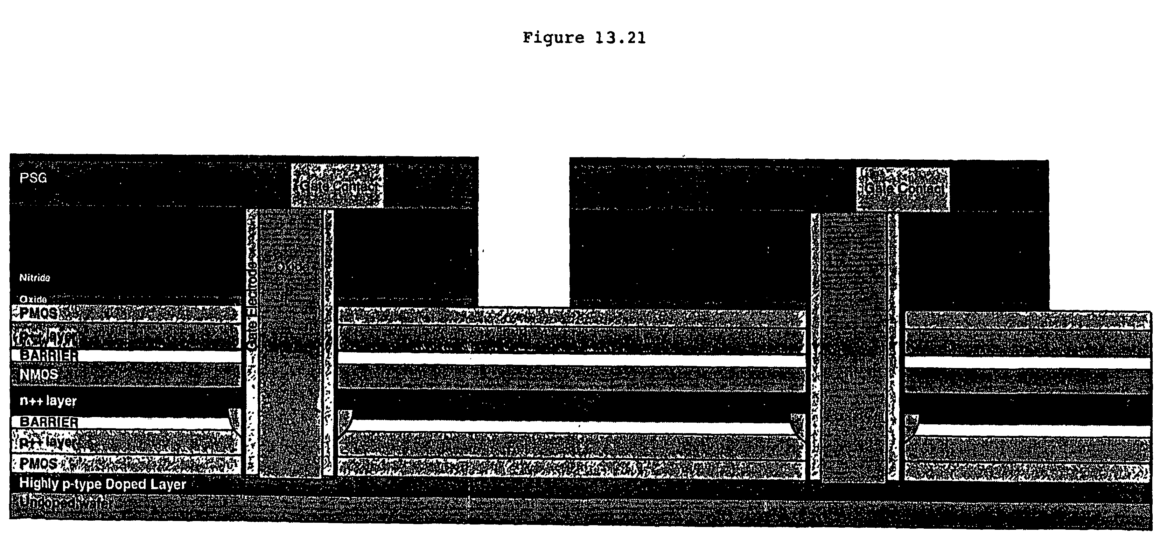

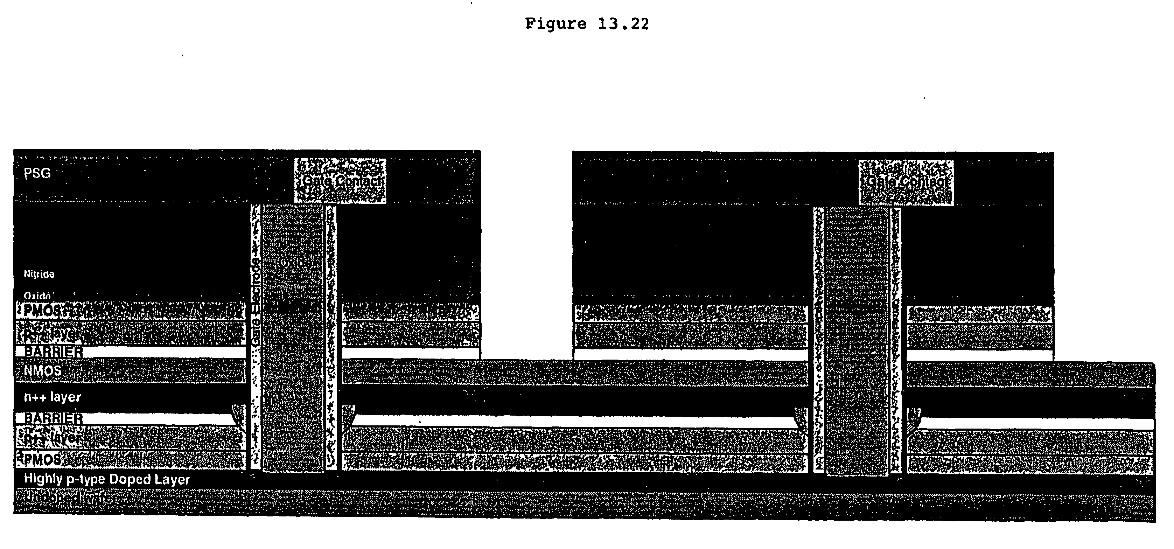

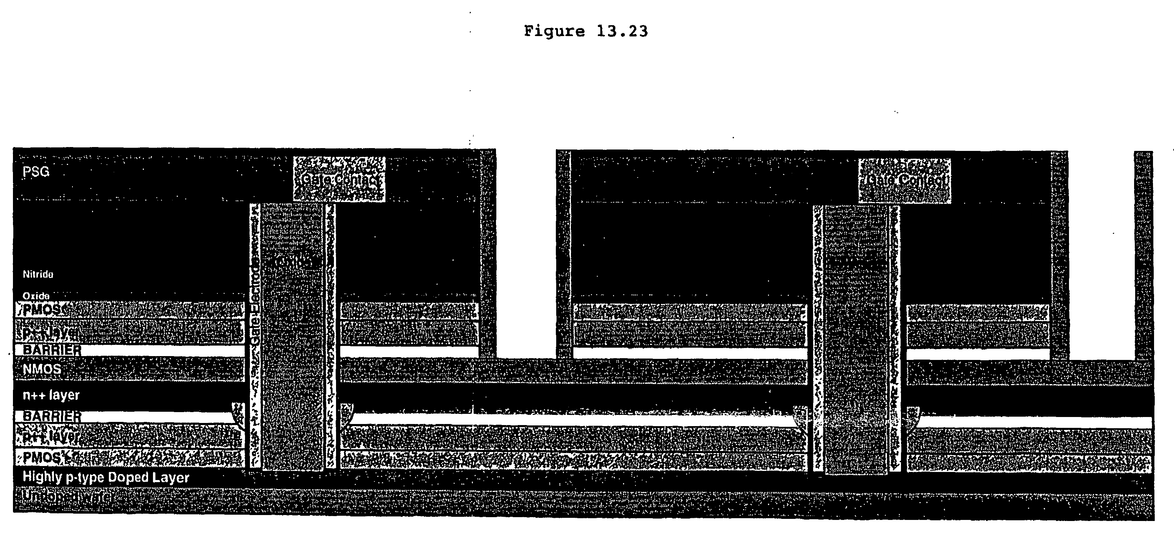

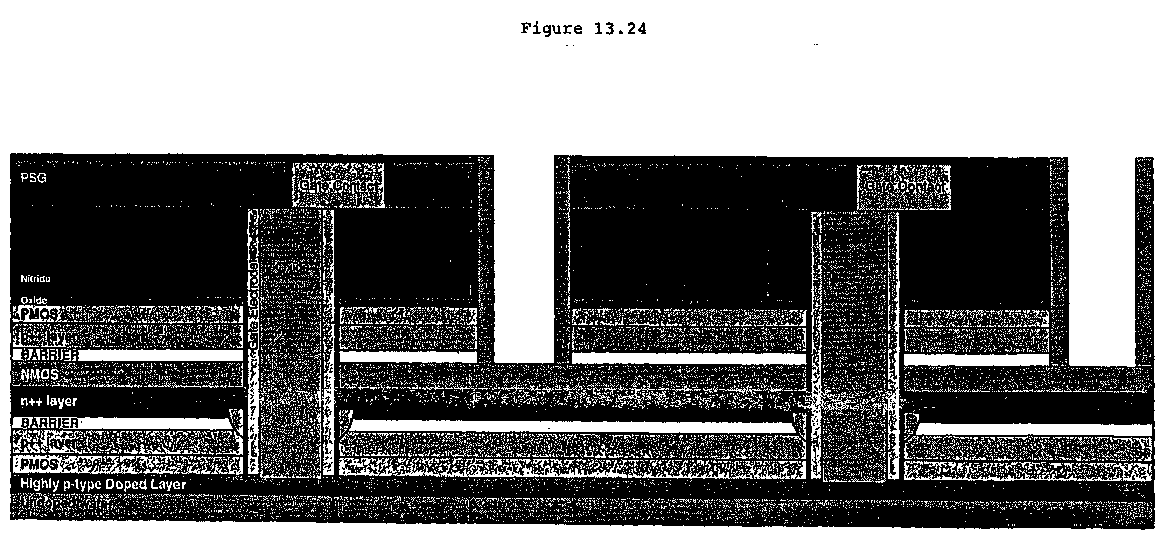

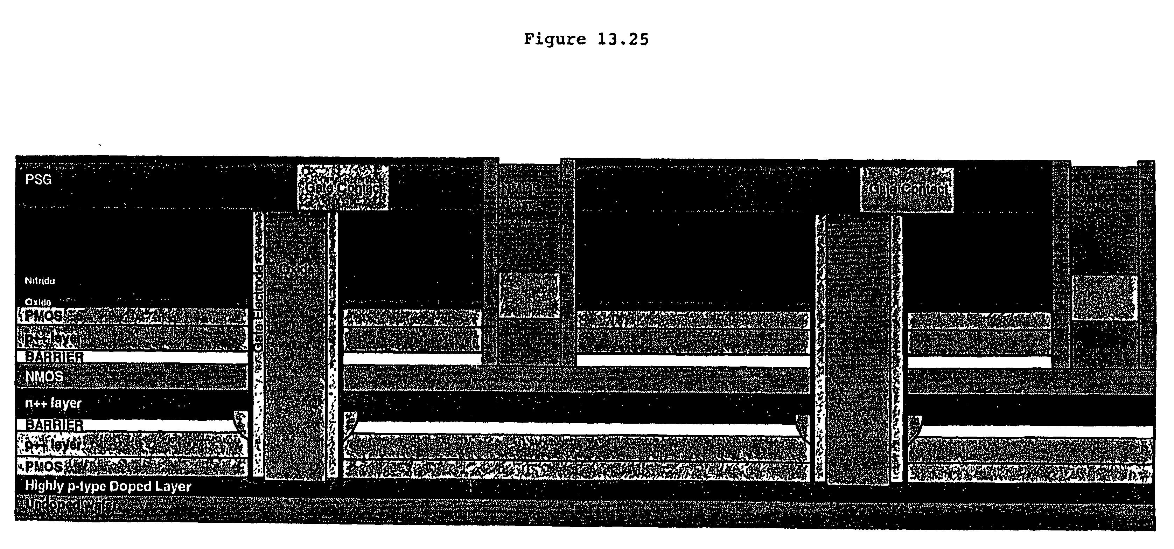

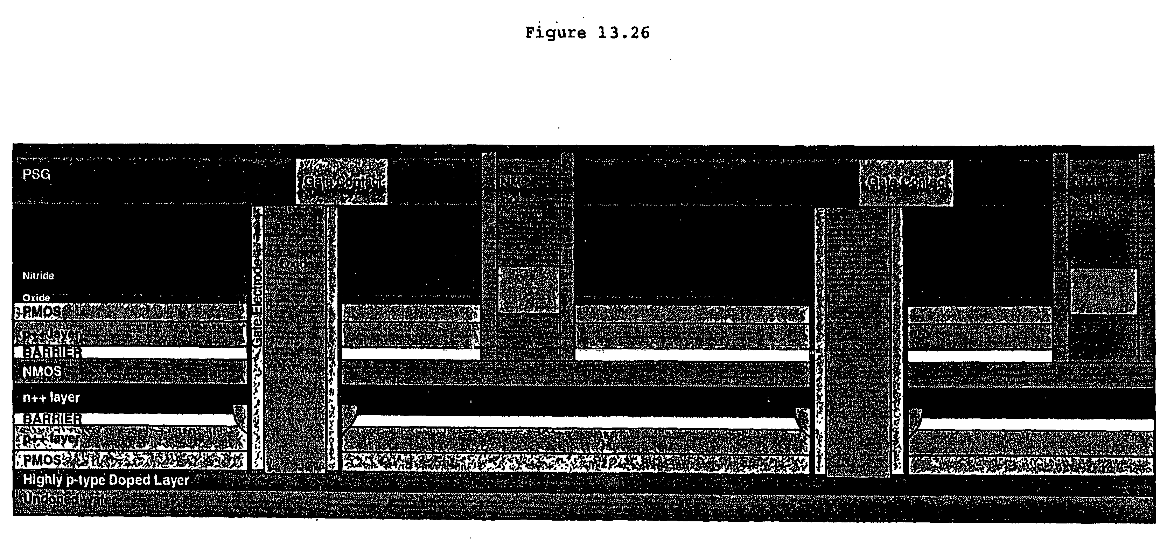

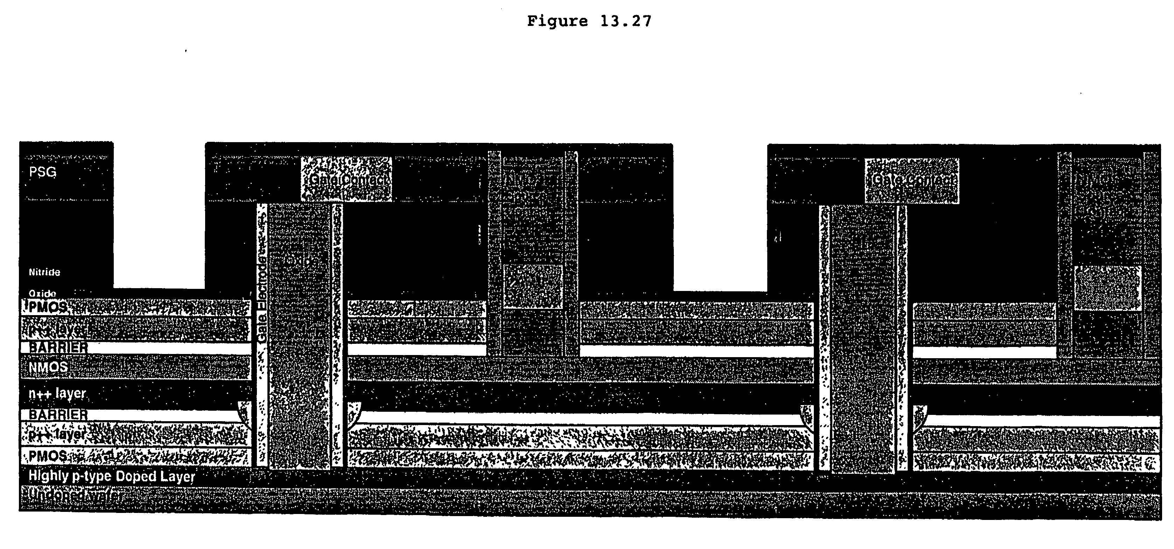

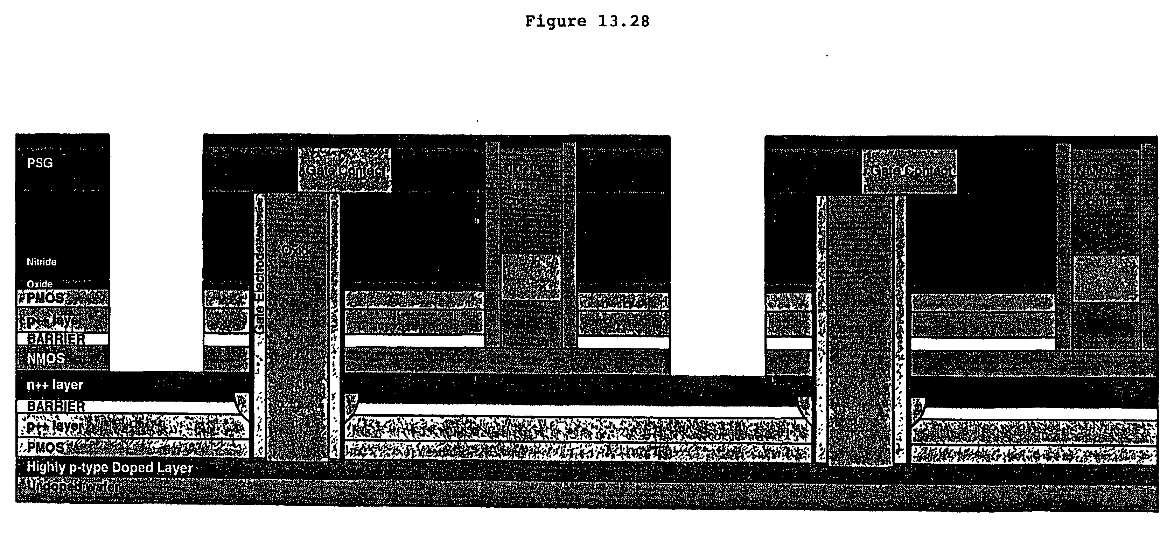

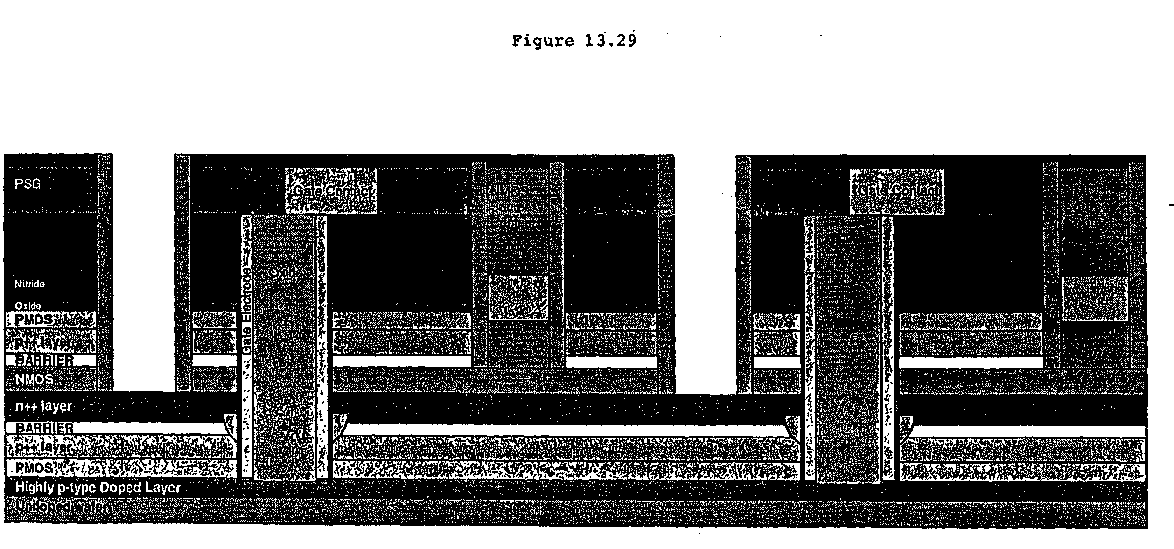

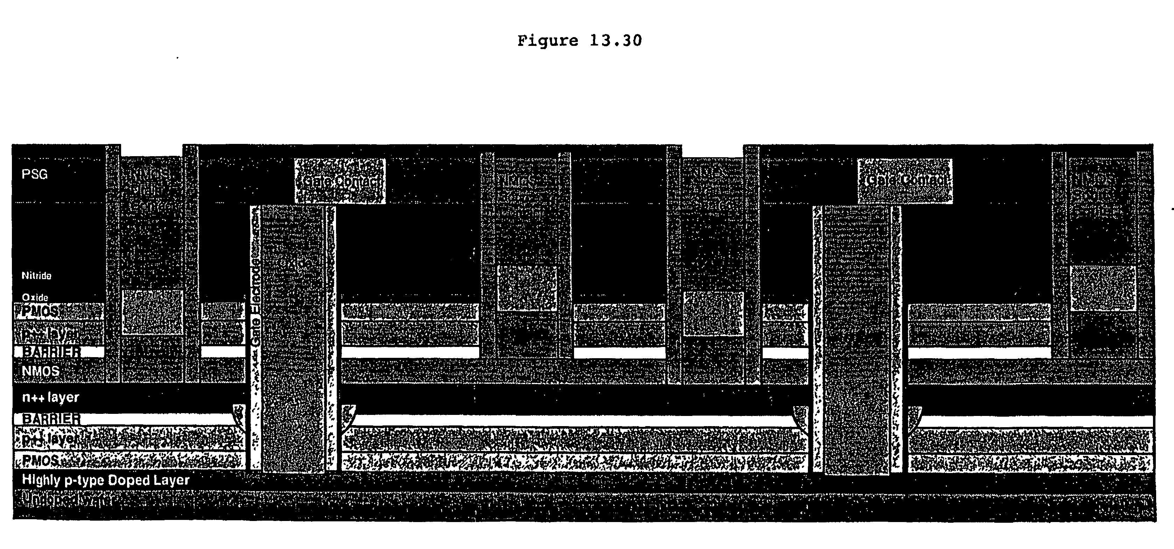

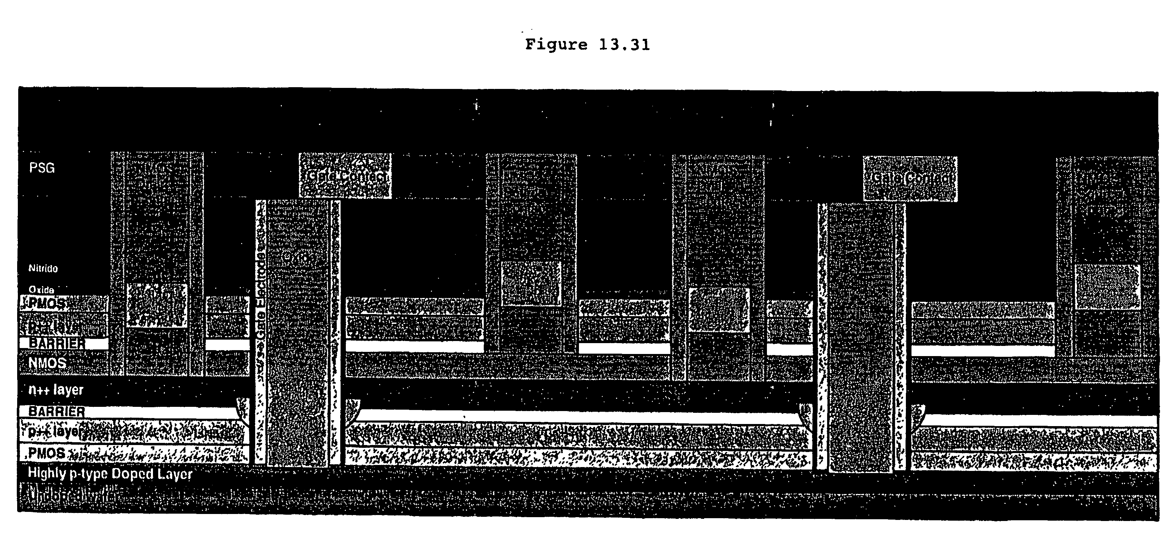

One circuit application of flow 4, is the 6-transistor (6T) Static Random Access Memory (SCRAM) Cell. That cell is made of 2 pass-transistors and 2 CMOS inverters. With the present invention, the area of the 6T Cell can be reduced by at least 30% compared to the standard implementation with planar technologies. That is achieved because of the reduced area taken by the CMOS inverter, when NMOS and PMOS are stacked upon each other instead of side by side. An example is shown on figures 13.

In all flows, drain barriers are shown in the drawings. In case they are not possible to make because of insufficient band-offsets, or because they are just not wanted, they can be omitted, without lack of generality of the ideas being presented here. Ideally, those barriers would be made of an insulator, epitaxially compatible with silicon. Quite a few of these materials exist and are applied in Silicon on Insulator (SOI) planar technologies. A short list of those materials reads like this:

1) $Al_2O_3$ (Saffire = Aluminium Oxide)
2) CaF (Calcium Fluoride)
3) $CeO_2$ (Cerium Dioxide)
4) AlN (Aluminium Nitride)
5) SrO (Strontium Oxide)
6) $SrTiO_3$ (Strontium Titanate)
7) $BaTiO_3$ (Barrium Titanate)
8) $SrVO_3$ (Strontium Vanadium Oxide)

Wafer bonding between silicon wafer with VH-PMOS, and Ge wafer with VH-NMOS. Naturally, there is an oxide between them, and therefore there is no need for extra barriers.

**Flow 1**

The starting material is an undoped <100> Si Cz wafer.

Zero markers can be made before or after the epitaxial growth. For simplicity, it is assumed that they are made before the epitaxial growth is performed.

1) Pre-epitaxy clean
2) Epitaxial deposition of transistor layers
3) Deposition (RT-CVD for example) of silicon-dioxide
4) Deposition (RT-CVD for example) of silicon-nitride
**FIG 10.1**
5) Lithography: Mask 1 (definition of gates)
6) Dry etch nitride, stopping on oxide (resist is not shown)
**FIG 10.2**
7) Resist strip (and possibly a clean)
8) Removal of oxide (HF vapor or dip, for example)
**FIG 10.3**
9) Damageless etch (dry or wet) of epi stack, into the Si wafer
**FIG 10.4**
10) Formation (growth or deposition) of gate dielectric
11) Deposition (RT-CVD for example) of gate electrode
**FIG 10.5**
12) Etchback of gate electrode (this might also remove partially or totally the gate dielectric)
**FIG 10.6**
13) Deposition (PE-CVD for example) of oxide
14) Etchback of oxide, to planarize, and slightly recess the oxide
**FIG 10.7**
15) Deposition (RT or PE-CVD for example) of TiN
**FIG 10.8**
16) Deposition (PE-CVD for example) of oxide
**FIG 10.9**
17) Lithography - Mask 2: Gate Isolation & Top Contact
18) Dry etch of oxide (resist is not shown)
**FIG 10.10**
19) Dry etch of TiN
**FIG 10.11**
20) Dry etch of nitride (selective against oxide)
**FIG 10.12**
21) Resist-strip and possibly a clean
22) Deposition (RT-CVD for example) of nitride
**FIG 10.13**
23) Etchback (spacers) of nitride (selective against oxide)
**FIG 10.14**
24) Oxide removal (HF dip or vapor for example)
**FIG 10.15**
25) Selective CVD of TiSi$_2$
26) Selective CVD of TiN
**FIG 10.16**
27) Deposition (CVD for example) of oxide
**FIG 10.17**
28) Lithography: Mask 3: Output Contact
29) Dry etch of oxide, stopping on nitride and TiN (resist is not shown)
**FIG 10.18**
30) Etch, wet or dry, (can be isotropic) of TiN selective against nitride
**FIG 10.19**
31) Resist strip and possibly a clean
32) Dry etch of nitride (selective against oxide)
**FIG 10.20**

33) Oxide removal (HF dip or vapor for example)

**FIG 10.21**

34) Damageless dry etch of Si, stopping on top drain

**FIG 10.22**

35) Deposition (RT-CVD for example) of oxide

36) Deposition (RT-CVD for example) of nitride

**FIG 10.23**

37) Etchback of nitride (spacers), stopping on oxide

**FIG 10.24**

38) Oxide removal (HF dip or vapor for example)

**FIG 10.25**

39) Damageless dry etch of Si, stopping on the top bottom drain

**FIG 10.26**

40) Selective CVD of $TiSi_2$

41) Selective CVD of TiN

**FIG 10.27**

42) Deposition (CVD for example) of oxide (gap-filling--planarizing)

**FIG 10.28**

Metalization & Passivation (BACK-END) FIG 29

**FIG 10.29**

KOH etch of the undoped wafer's backside, stopping on the highly boron doped buffer

**FIG 10.30**

Deposition of thick metal layer onto the backside of the wafer.

**FIG 10.31**

Dicing and Packaging.


### Flow 2


Wafer in - The starting material is an undoped <100> Si Cz wafer.

Zero markers can be made before or after the epitaxial growth. For simplicity, it is assumed that they are made before the epitaxial growth is performed.


1) Pre-epitaxy clean

2) Epitaxial deposition of the transistor layers.

3) Deposition (CVD for example) of silicon-dioxide

4) Deposition (CVD for example) of silicon-nitride

**FIG 11.1**

5) Lithography: Mask 1 (definition of gates)

6) Dry etch nitride, stopping on oxide (resist is not shown)

**FIG 11.2**

7) Resist strip and possibly a clean

8) Removal of oxide (HF vapor or dip, for example)

**FIG 11.3**


In a simpler process flow, the next step, damageless etch of the epitaxial layers, would be done through the entire stack at once. The process would proceed by an immediate formation of the gate dielectric.

These extra steps are a possible route for the minimisation of parasitic capacitances caused by the gate to source and drain overlapping. With these steps, a thick oxide is formed between the gate electrode and the extended regions of source and drain.


9) Damageless etch (dry or wet) of epi stack, stopping in the drain layer of the top transistor

**FIG 11.4**

10) Deposition (RT-CVD for example) of thin oxide (20nm for example)

11) Deposition (RT-CVD for example) of thin nitride (30nm for example)

**FIG 11.5**

12) Nitride etchback, stopping on oxide

**FIG 11.6**

13) Low temperature oxidation

**FIG 11.7**

14) Isotropic etch of nitride, selective against oxide

**FIG 11.8**

15) Removal of the spacer oxide (HF vapor for example)

**FIG 11.9**

16) Anisotropic etch of oxide, stopping on epi layer

**FIG 11.10**

17) Damageless etch of the remaining of the epi stack, into the Si wafer

**FIG 11.11**

18) Formation (growth or deposition) of gate dielectric

**FIG 11.12**

19) Deposition (RT-CVD for example) of gate electrode

**FIG 11.13**

20) Etchback of gate electrode

**FIG 11.14**

21) Deposition of oxide

22) Etchback of oxide, to planarize

**FIG 11.15**

23) Deposition (RT-CVD for example) of PSG.

**FIG 11.16**

24) Lithography: Mask 2 (contact to the gate electrode)

25) Selective dry etch of PSG. PSG can be dry etched with large selectivities against oxide, nitride end TiN

26) Resist strip

**FIG 11.17**

27) Selective deposition (CVD for example) of metal (TiN for example), in order to make the gate contact pads. It could also be done through a more conventional technique, like CVD and etchback.

**FIG 11.18**

28) Deposition of a thin nitride layer.

**FIG 11.19**

29) Lithography: Mask 3 (contact to the drains)

30) Dry etch of nitride, PSG, nitride, stopping on oxide

31) Resist strip.

**FIG 11.20**

32) Oxide removal (HF dip or vapor for example).

**FIG 11.21**

33) Damageless etch (wet or dry) of epitaxial layers until the drain of the top transistor is reached.

**FIG 11.22**

34) Spacer formation by CVD and etchback of oxide (or oxide / nitride combination).

**FIG 11.23**

35) Damageless etch (wet or dry) of epitaxial layers until the bottom drain is reached.

**FIG 11.24**

36) Selective deposition (CVD for example) of Ti-silicide.

37) Selective deposition (CVD for example) of TiN, and possibly a more conductive metal (copper for example).

**FIG 11.25**

38) Deposition (CVD for example) of a thin nitride layer.

**FIG 11.26**

39) Lithography: Mask 3 (contact to the drains).

40) Dry etch of nitride, PSG, nitride, stopping on oxide.

41) Resist strip.

**FIG 11.27**

42) Oxide removal (HF vapor or dip for example)

**FIG 11.28**

43) Selective deposition (CVD for example) of Titanium-disilicide

44) Selective deposition (CVD for example) of TiN, and possibly a more conductive metal (copper for example).

**FIG 11.29**

45) Deposition (RT-CVD for example) of nitride

**FIG 11.30**

Metallization & Passivation (BACK-END)

**FIG 11.31**

KOH etch of the undoped wafer's backside, stopping on the highly p-type (boron for example) doped layer.

**FIG 11.32**

Deposition of silicide and metal (copper alloy for example) onto the backside of the wafer.

**FIG 11.33**

Dicing and Packaging.


**Flow 3**


Wafer in - The starting material is an undoped <100> Si Cz wafer.

Zero markers can be made before or after the epitaxial growth. For simplicity, it is assumed that they are made before the epitaxial growth is performed.


1) Pre-epitaxy clean

2) Epitaxial deposition of the transistor layers (possibly a n-type layer prior to the PMOS, or a p-type layer if the NMOS was put under the PMOS)

3) Deposition (CVD for example) of silicon-dioxide

4) Deposition (CVD for example) of silicon-nitride

**FIG 12.1**

5) Lithography: Mask 1 (definition of gates)

6) Dry etch nitride, stopping on oxide

7) Resist strip and possibly a clean

**FIG 12.2**

8) Removal of oxide (HF vapor or dip, for example)

**FIG 12.3**

In a simpler process flow, the next step, damageless etch of the epitaxial

layers, would be done through the entire stack at once. The process would proceed by an immediate formation of the gate dielectric.

These extra steps are a possible route for the minimisation of parasitic capacitances caused by the gate to source and drain overlapping. With these steps, a thick oxide is formed between the gate electrode and the extended regions of source and drain.


9) Damageless etch (dry or wet) of epi stack, stopping in the drain layer of the top transistor

**FIG 12.4**

10) Deposition (RT-CVD for example) of thin oxide (20nm for example)

11) Deposition (RT-CVD for example) of thin nitride (30nm for example)

**FIG 12.5**

12) Nitride etchback, stopping on oxide

**FIG 12.6**

13) Low temperature oxidation

**FIG 12.7**

14) Isotropic etch of nitride, selective against oxide

**FIG 12.8**

15) Removal of the spacer oxide (HF vapor for example;

**FIG 12.9**

16) Anisotropic etch of oxide, stopping on epi layer

**FIG 12.10**

17) Damageless etch (wet or dry) of the remaining of the epi stack, into the Si wafer

**FIG 12.11**

18) Formation (growth or deposition) of gate dielectric

**FIG 12.12**

19) Deposition (RT-CVD for example) of gate electrode

**FIG 12.13**

20) Etchback of gate electrode

**FIG 12.14**

21) Deposition of oxide

22) Etchback of oxide, to planarize
**FIG 12.15**
23) Deposition (RT-CVD for example) of PSG.
**FIG 12.16**
24) Lithography: Mask 2 (contact to the gate electrode)
25) Selective dry etch of PSG. PSG can be dry etched with large selectivities against oxide, nitride and TiN.
26) Resist strip
**FIG 12.17**
27) Selective deposition (CVD for example) of metal (TiN for example), in order to make the gate contact pads. It could also be done through a more conventional technique, like CVD and etchback.
**FIG 12.18**
28) Deposition of a thin nitride layer.
**FIG 12.19**
29) Lithography: Mask 3 (contact to the drains)
30) Dry etch of nitride, PSG, nitride, stopping on oxide
31) Resist strip.
**FIG 12.20**
32) Oxide removal (HF dip or vapor for example).
**FIG 12.21**
33) Damageless etch (wet or dry) of epitaxial layers until the drain of the top transistor is reached. For a PMOS pass-transistor, this etch would continue down to the drain of the PMOS, followed by the spacer formation.
**FIG 12.22**
34) Spacer formation by CVD and etchback of oxide (or oxide / nitride combination).
**FIG 12.23**
35) Damageless etch (wet or dry) of epitaxial layers until the bottom drain is reached.
**FIG 12.24**
36) Selective deposition (CVD for example) of Ti-silicide
37) Selective deposition (CVD for example) of TiN, and possibly a more conductive metal (copper for example).
**FIG 12.25**
38) Deposition (CVD for example) of a thin nitride layer.
**FIG 12.26**
39) Lithography: Mask 3 (contact to the drains).
40) Dry etch of nitride, PSG, nitride, stopping on oxide.
41) Resist strip.
**FIG 12.27**
42) Oxide removal (HF vapor or dip for example)
**FIG 12.28**
43) Selective CVD of Titanium-disilicide
**FIG 12.29**
44) Selective CVD of TiN, and possibly a more conductive metal (copper for example).
**FIG 12.30**
45) Lithography: Mask 4 (contact to the drains).
46) Dry etch of nitride, PSG, nitride, stopping on oxide.
47) Resist strip.
**FIG 12.31**
48) Oxide removal (HF dip or vapor for example).
**FIG 12.32**
49) Damageless etch (wet or dry) of epitaxial layers until the source of the bottom transistor is reached.
**FIG 12.33**
50) Spacer formation by CVD and etchback of oxide (or oxide / nitride combination).
**FIG 12.34**
51) Selective deposition (CVD for example) of Titanium-disilicide
52) Selective deposition (CVD for example) of TiN, and possibly a more conductive metal (copper for example).
53) Deposition (RT-CVD for example) of nitride
**FIG 12.35**
Metallization & Passivation (BACK-END)
**FIG 12.36**
Dicing and Packaging.

**Flow 4**

Wafer in - The starting material is an undoped <100> Si Cz wafer.

Zero markers can be made before or after the epitaxial growth. For simplicity, it is assumed that they are made before the epitaxial growth is performed.

1) Pre-epitaxy clean

2) Epitaxial deposition of the transistor layers

3) Deposition (CVD for example) of silicon-dioxide

4) Deposition (CVD for example) of silicon-nitride

**FIG 13.1**

5) Lithography: Mask 1 (definition of gates)

6) Dry etch nitride, stopping on oxide

7) Resist strip and possibly a clean

**FIG 13.2**

8) Removal of oxide (HF vapor or dip, for example)

**FIG 13.3**

In a simpler process flow, the next step, damageless etch of the epitaxial layers, would be done through the entire stack at once. The process would proceed by an immediate formation of the gate dielectric.

These extra steps are a possible route for the minimisation of parasitic capacitances caused by the gate to source and drain overlapping. With these steps, a thick oxide is formed between the gate electrode and the extended regions of source and drain.

9) Damageless etch (dry or wet) of epi stack, stopping in the drain of the middle transistor

**FIG 13.4**

10) Deposition (RT-CVD for example) of thin oxide (20nm for example)

11) Deposition (RT-CVD for example) of thin nitride (30nm for example)

**FIG 13.5**

12) Nitride etchback, stopping on oxide

**FIG 13.6**

13) Low temperature oxidation

**FIG 13.7**

14) Isotropic etch of nitride, selective against oxide

**FIG 13.8**

15) Removal of the spacer oxide (HF vapor for example)

**FIG 13.9**

16) Anisotropic etch of oxide, stopping on epi layer

**FIG 13.10**

17) Damageless etch of the remaining of the epi stack, into the Si wafer

**FIG 13.11**

18) Formation (growth or deposition) of gate dielectric

**FIG 13.12**

19) Deposition (RT-CVD for example) of gate electrode

**FIG 13.13**

20) Etchback of gate electrode

**FIG 13.14**

21) Deposition of oxide

22) Etchback of oxide, to planarize

**FIG 13.15**

23) Deposition (RT-CVD for example) of PSG.

**FIG 13.16**

24) Lithography: Mask 2 (contact to the gate electrode)

25) Selective dry etch of PSG. PSG can be dry etched with large selectivities against oxide, nitride and TiN.

26) Resist strip

**FIG 13.17**

27) Selective deposition (CVD for example) of metal (TiN for example), in order to make the gate contact pads. It could also be done through a more conventional technique, like CVD and etchback.

**FIG 13.18**

28) Deposition of a thin nitride layer.

**FIG 13.19**

29) Lithography: Mask 3 (contact to the chosen drain or drains)

30) Dry etch of nitride, PSG, nitride, stopping on oxide

31) Resist strip.

**FIG 13.20**

32) Oxide removal (HF dip or vapor for example).

**FIG 13.21**

33) Damageless etch (wet or dry) of epitaxial layers until the source of the middle transistor is reached.

**FIG 13.22**

34) Spacer formation by CVD and etchback of oxide (or oxide/ nitride combination).

**FIG 13.23**

35) Damageless etch (wet or dry) of epitaxial layers until the other drain is reached.

**FIG 13.24**

36) Selective deposition (CVD for example) of Ti-silicide.

37) Selective deposition (CVD for example) of TiN, and possibly a more conductive metal (copper for example).

**FIG 13.25**

38) Deposition (CVD for example) of a thin nitride layer.

**FIG 13.26**

39) Lithography: Mask 3 (contact to the drains).

40) Dry etch of nitride, PSG, nitride, stopping on oxide.

41) Resist strip.

**FIG 13.27**

42) Oxide removal (HF vapor or dip for example)

**FIG 13.28**

43) Selective deposition (CVD for example) of Titanium-disilicide

44) Selective deposition (CVD for example) of TiN, and possibly a more conductive metal (copper for example).

**FIG 13.29**

45) Deposition (RT-CVD for example) of nitride

**FIG 13.30**

Metallization & Passivation (BACK-END)

**FIG 13.31**

KOH etch of the undoped wafer's backside, stopping on the highly p-type (boron for example) doped layer.

Deposition of silicide and metal (copper alloy for example) onto the backside of the wafer.

Dicing and Packaging.

As a third object, the present invention is related to DRAM circuits having memory cells using Vertical MISFET devices which permit to reach significant reductions in cells area compared to planar MISFETs. The area gains come solely by the fact that, in vertical transistors, the source, drain and channel are stacked upon each other, and there us no well contacts, because vertical MOSFETs have the gate dielectric all around the pillar structure.

The use of Vertical MISFETs permits significant gains in the number of stored bits per unit area (bit density) can be made by making use of another spatial direction and fabricating three dimensional structures.

New architectures and fabrication process flows of memory circuits using Vertical MISFETs have been devised and are now presented. These new architectures and processes can be tuned to the particular configuration to be implemented, like Dynamic RAM, Non Volatile RAM, Multiple Value RAM, etc.

Yet another improvement in memory fabrication technology brought by vertical transistors is the possibility of simultaneous front-end fabrication of the CMOS logic and memory cell transistors. The fabrication is simultaneous and without any duplication of process steps. Additional process steps come only when contacts to several junction layers have to be made. Because contacts in different layers need different patterning steps, different device/circuit configurations increase the number of those steps.

Several preferred embodiments for DRAM cells according to the present invention are described more in detail hereunder with reference to specific process flows.


1. One transistor and one capacitor (1T + 1C) cell


Standard DRAM cells are made of one transistor and one capacitor. The future trend seems to be for "wide bit" systems, that is several bits are written or read simultaneously. This trend is absolutely natural in view of the fact that the largest application of DRAMs is in microprocessor based systems like PCs.

In such cells, the gates of the "wide bit" all work in parallel, and therefore can share the same contact. For planar technology, this feature does not bring any particular benefit. For Vertical MOSFETs, that feature causes a dramatis improvement in integration density. The cell area is down to 2L by 2L, L being the minimal feature size (see also flows 5, 6, and 7 detailed hereunder).

The new cell takes advantage of the fact that the footprint of a vertical MOSFET (without contact) can be much smaller than the footprint of planar MOSFETs. In vertical MOSFETs, the regions of source, channel and drain are stacked upon each other, effectively having the footprint of one. This is true for as long as individual contacts to the regions of each MOSFET in the circuit is not required.

If the RAM architecture was going to ask for individual contacts to the source, drain and gate of each transistor, then there would be no area advantage of vertical over planar MOSFETs. With a "wide bit" arrangement, Wordline contact is made simultaneously to several transistors, and that is what gives the advantage to vertical MOSFETs. The "wider" the bit, the larder the advantage.

It is also very important to emphasize the fact that these are D-Gate All Around MOSFETs, which have no leakage (substrate) currents. Having extremely small leakage currents is a very important advantage over planar bulk MOSFETs.

To a certain extent, the area does not depend on the overlay accuracy of the lithography equipment. The first masking step consists of dense lines and spaces, and the second masking step consists also of dense lines and spaces, but perpendicular to mask 1. For these two steps, there are no critical alignment requirements. For the third lithography step, which consists in the separation between gates (Worldlines) of different cells, alignment is critical if area penalty is to be avoided. The tolerances for misalignments are provided by the spacers around the individual vertical MOSFETs. If the stepper's overlay (in)accuracy is less than the spacer thickness, then there is no area penalty, and the cell can be constructed with the minimum dimensions allowed by lithography.

This architecture can also be used for Multiple Value (MV) DRAM. Here again, it should have advantages over planage technology due to the fact that the vertical MOSFETs can have very short channels, and therefore much improved electrical characteristics. For example, using 0.35 $\mu$m design rules, for planar transistors this means that the shortest gate length possible to print is indeed 0.35 $\mu$m. For vertical MOSFETs, this means that the cross section of the MOSFET is 0.35 $\mu$m, while the channel length, if defined by epitaxy, can be 0.1 $\mu$m or smaller.

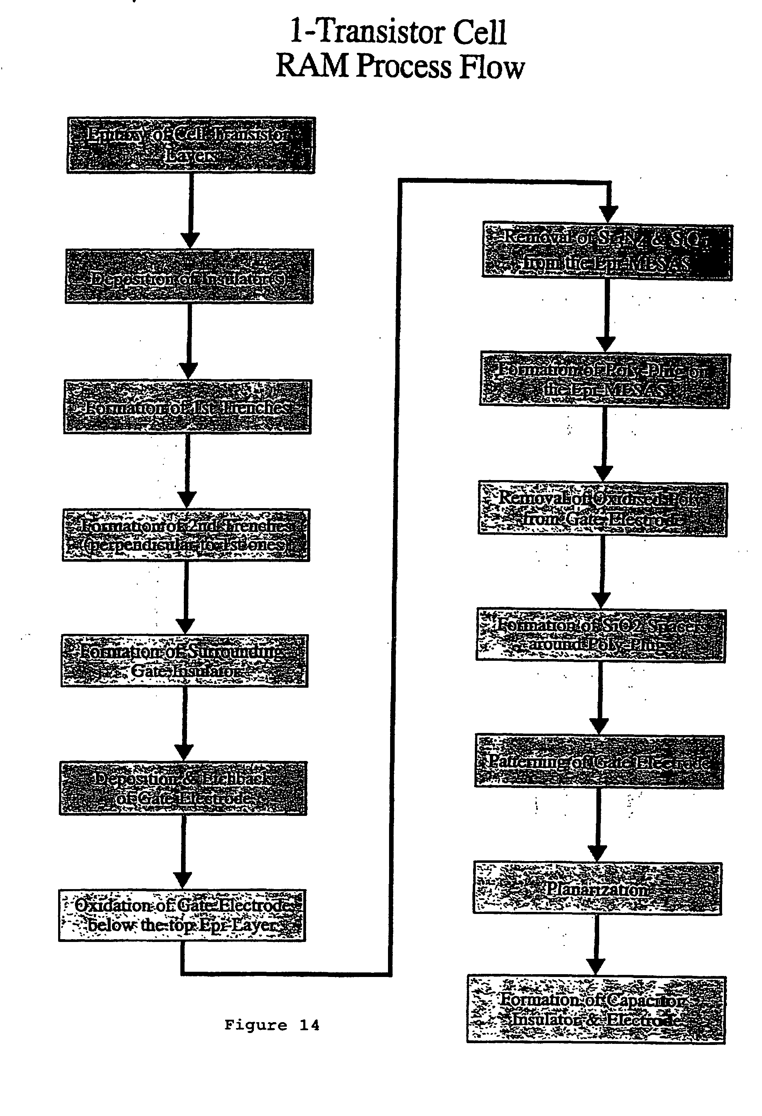

Fig. 14 is describing a general process flow for manufacturing Vertical MISFET memory cells according to this first embodiment of the present invention comprising at least the following steps:

- Epitaxy of Cell Transistor Layers;
- Deposition of Insulator(s) ;
- Formation of 1st Trenches;
- Formation of 2nd Trenches (perpendicular to 1st ones);
- Formation of Surrounding Gate Insulator;
- Deposition & Etchback of Gate Electrode;
- Oxidation of Gate Electrode below the top Epi-Layer;
- Removal of $Si_3N_4$ 1 $SiO_2$ from the EPI-MESAS;
- Formation of Poly-Plug on the Epi-MESAS;
- Removal of Oxidised Poly from the Gate Electrode;
- Formation of $SiO_2$ Spacers around Poly-Plugs;
- Patterning of Gate Electrode;
- Planarization;
- Formation of Capacitor: Consisting in Insulator & Electrode

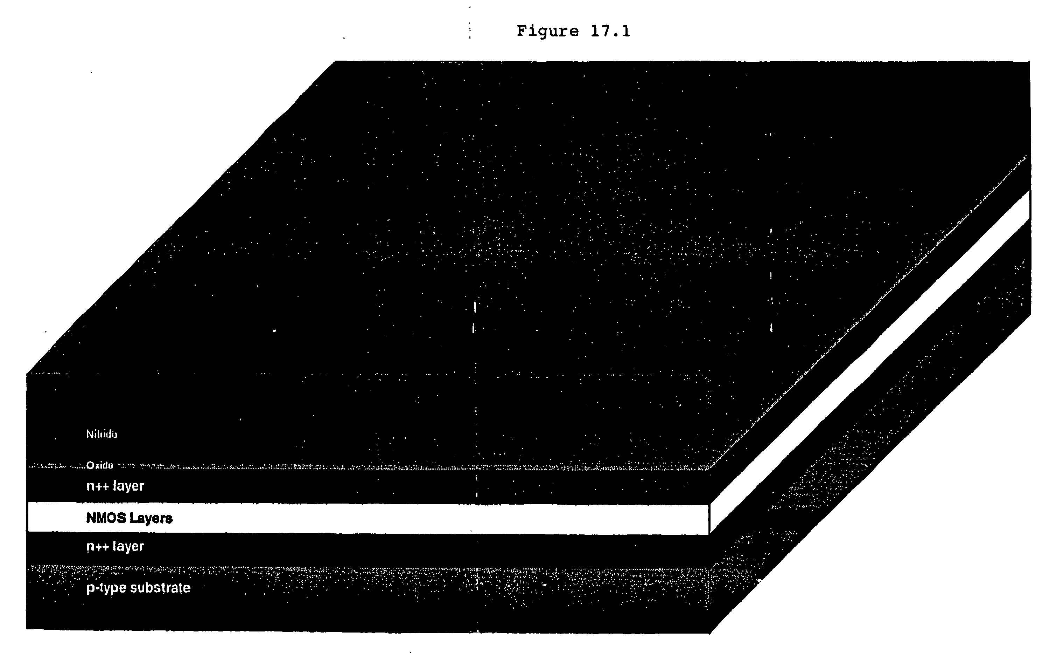

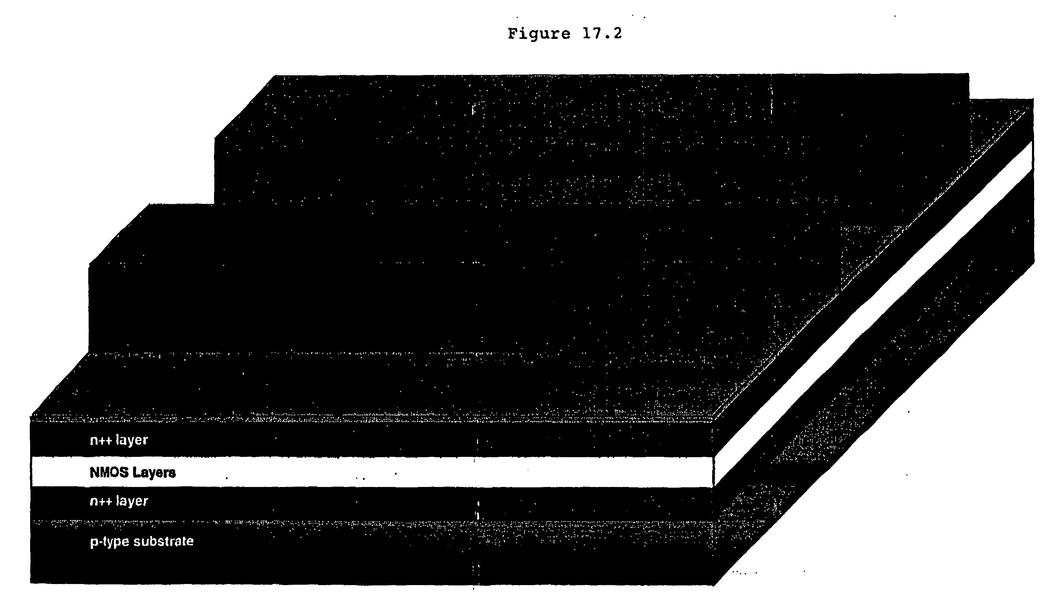

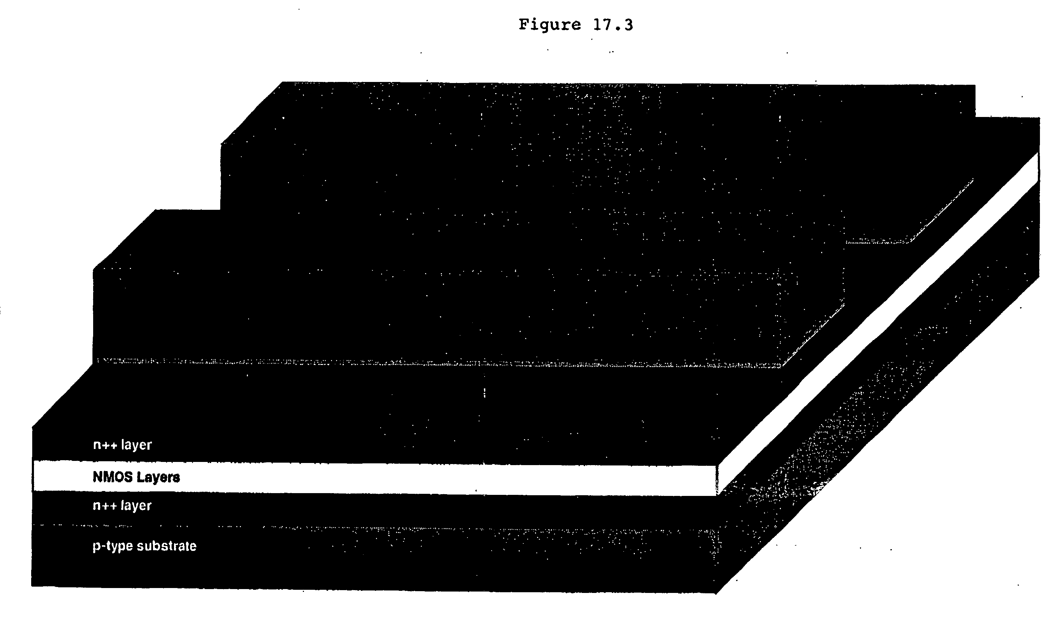

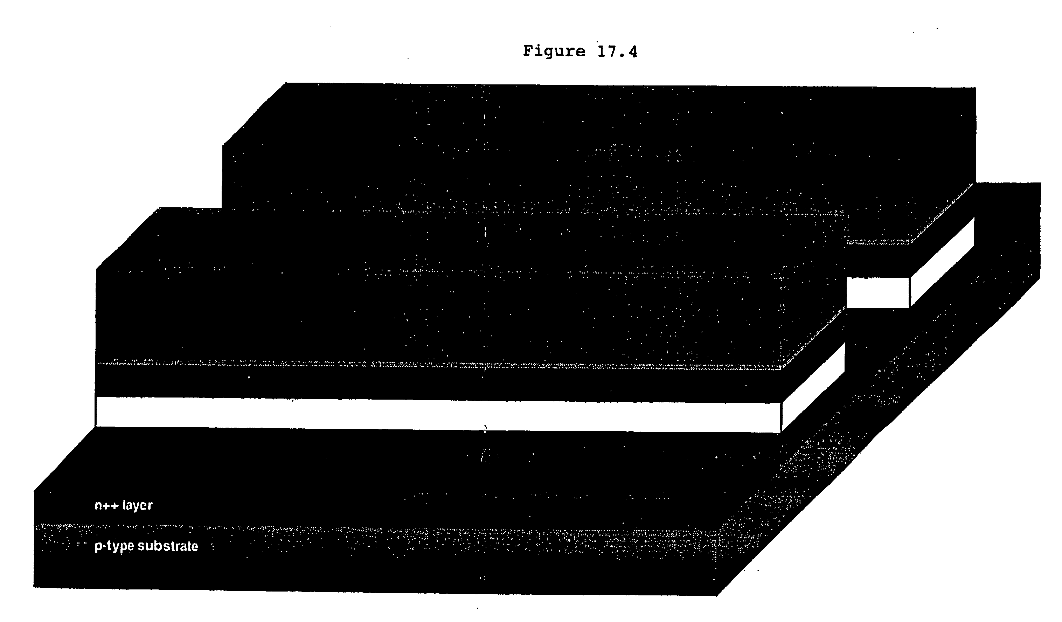

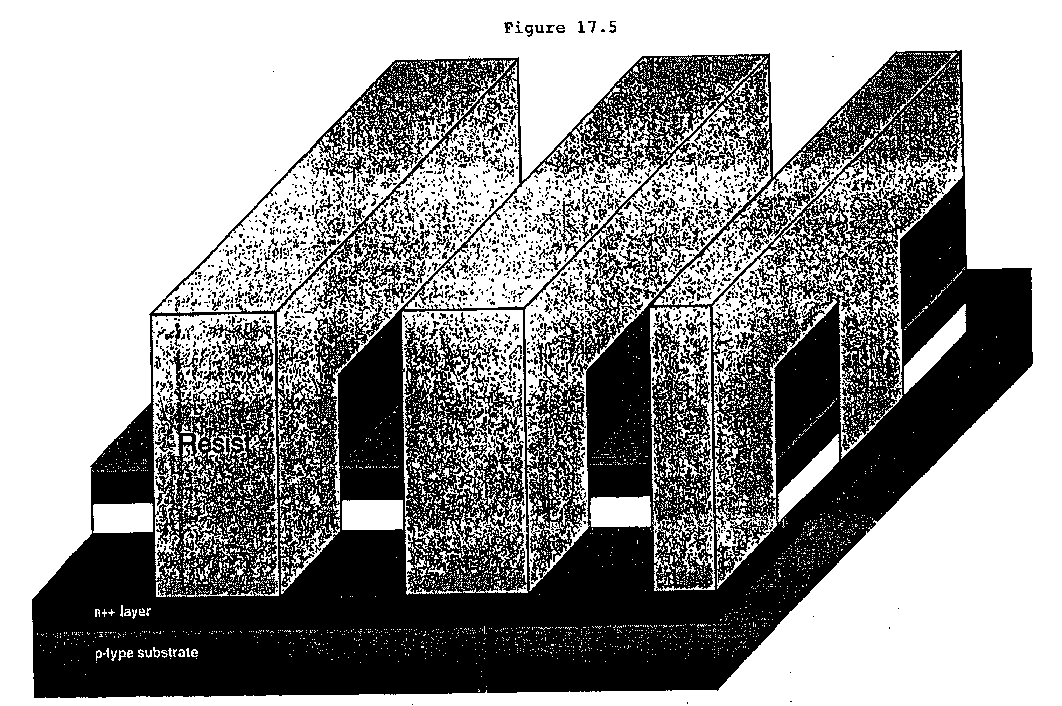

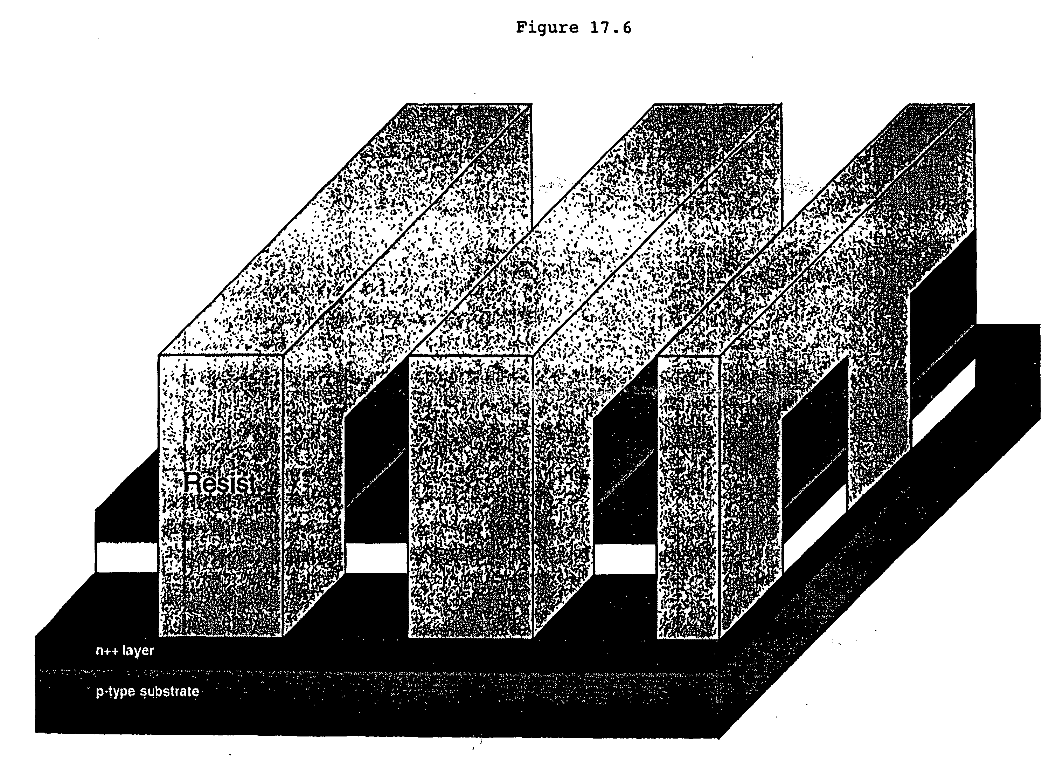

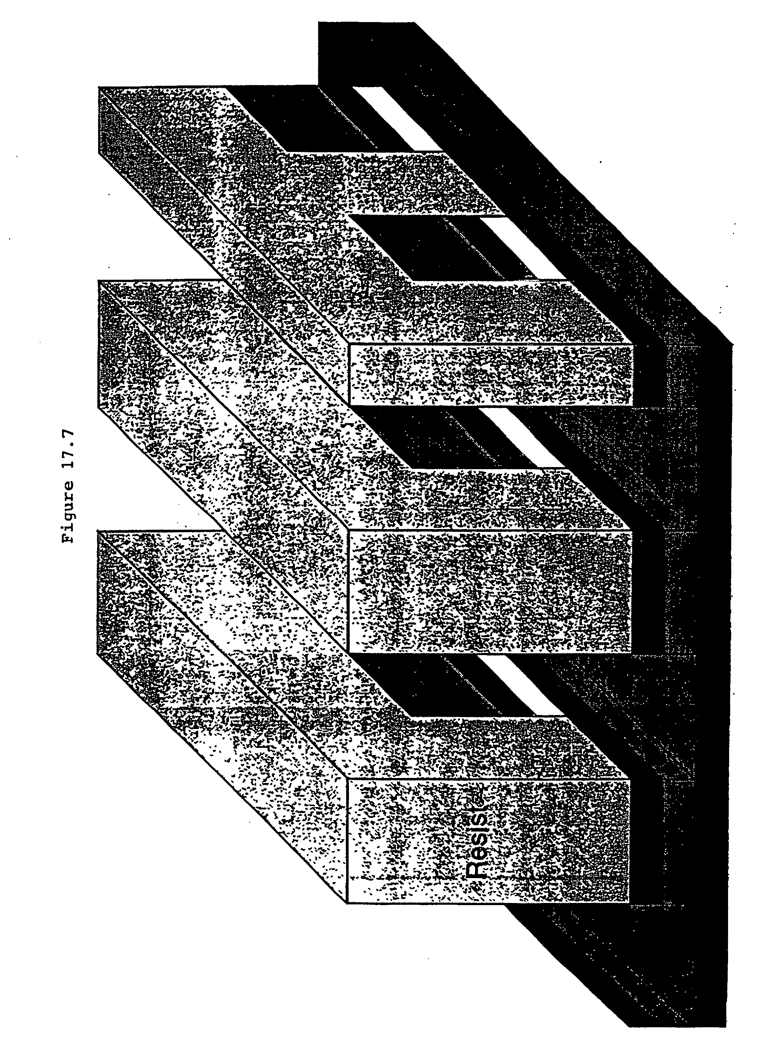

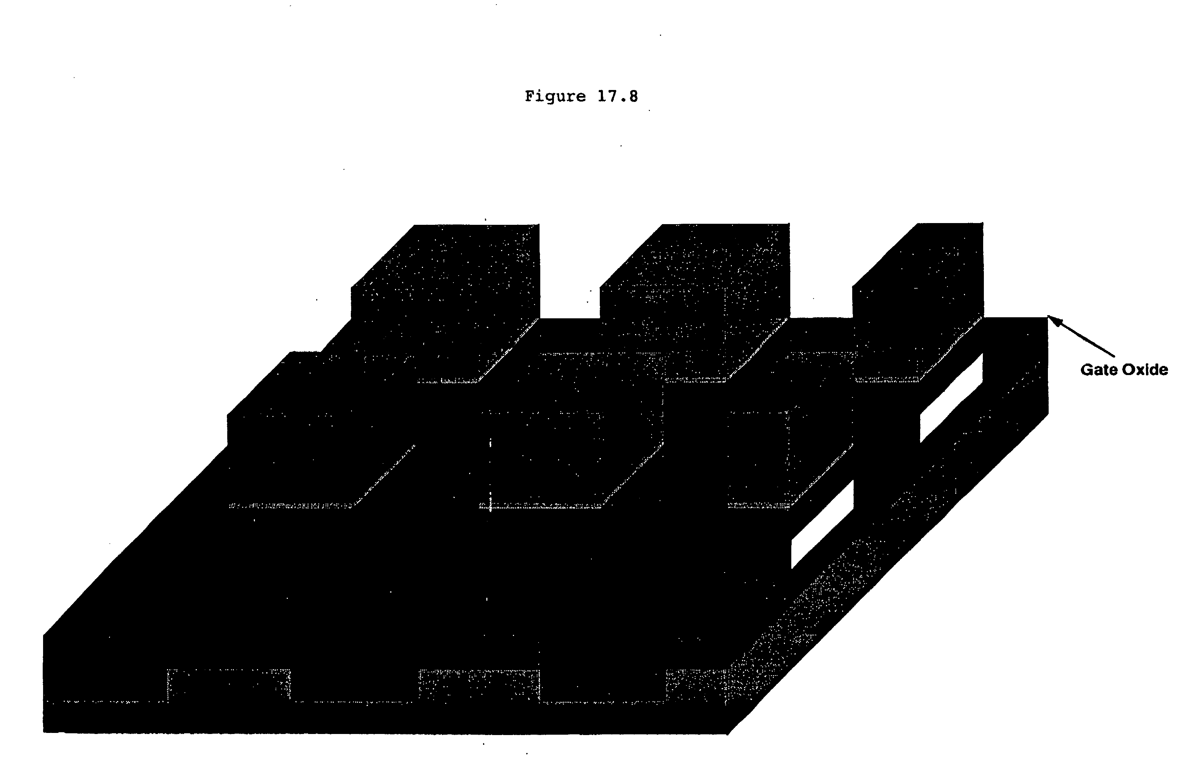

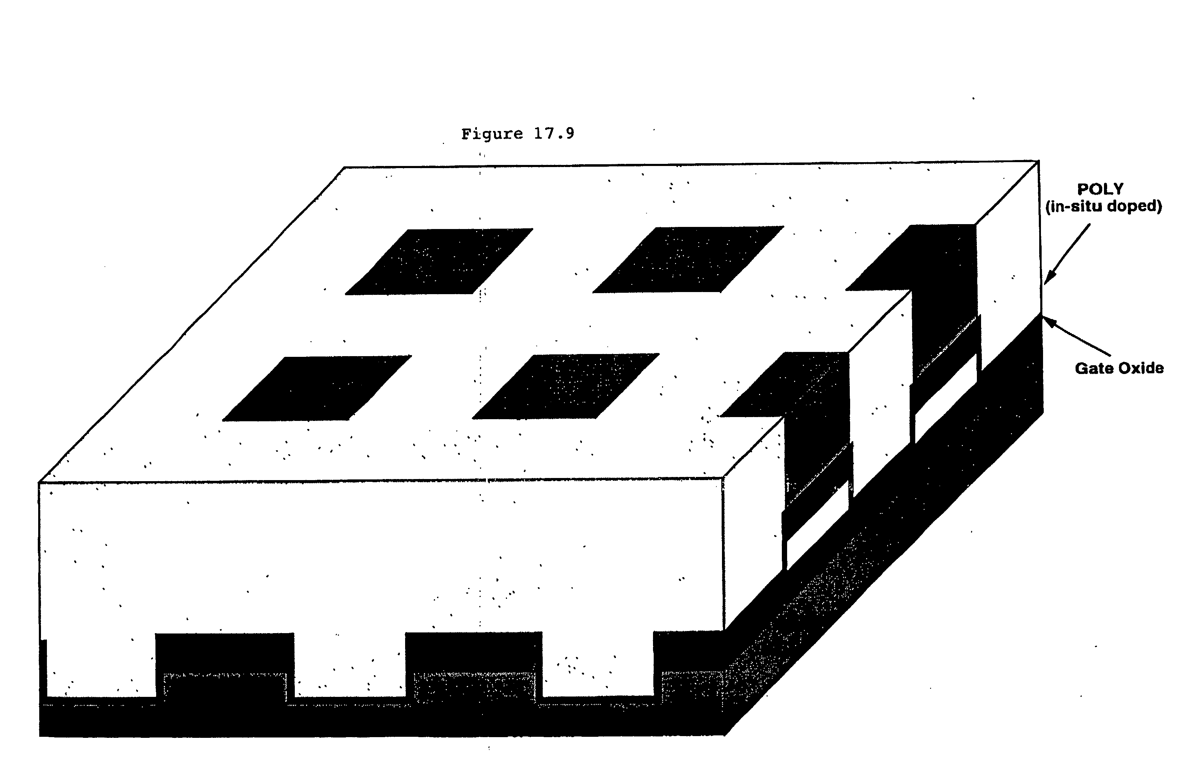

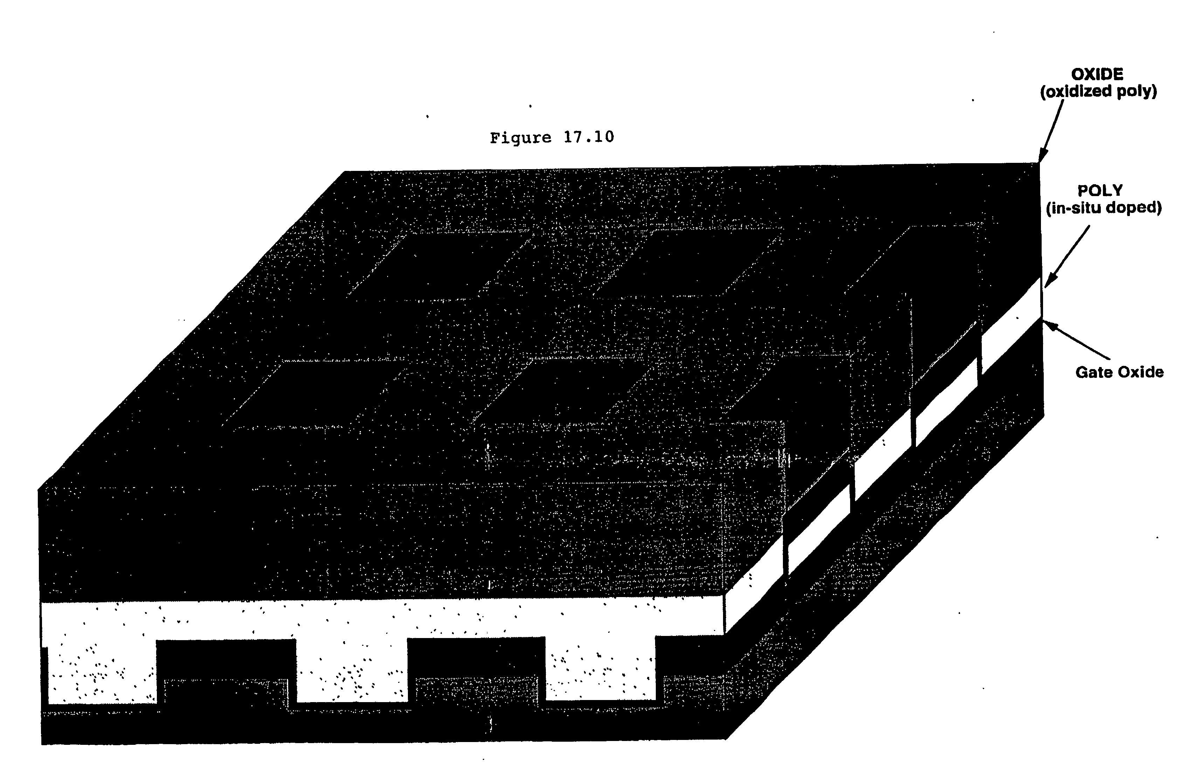

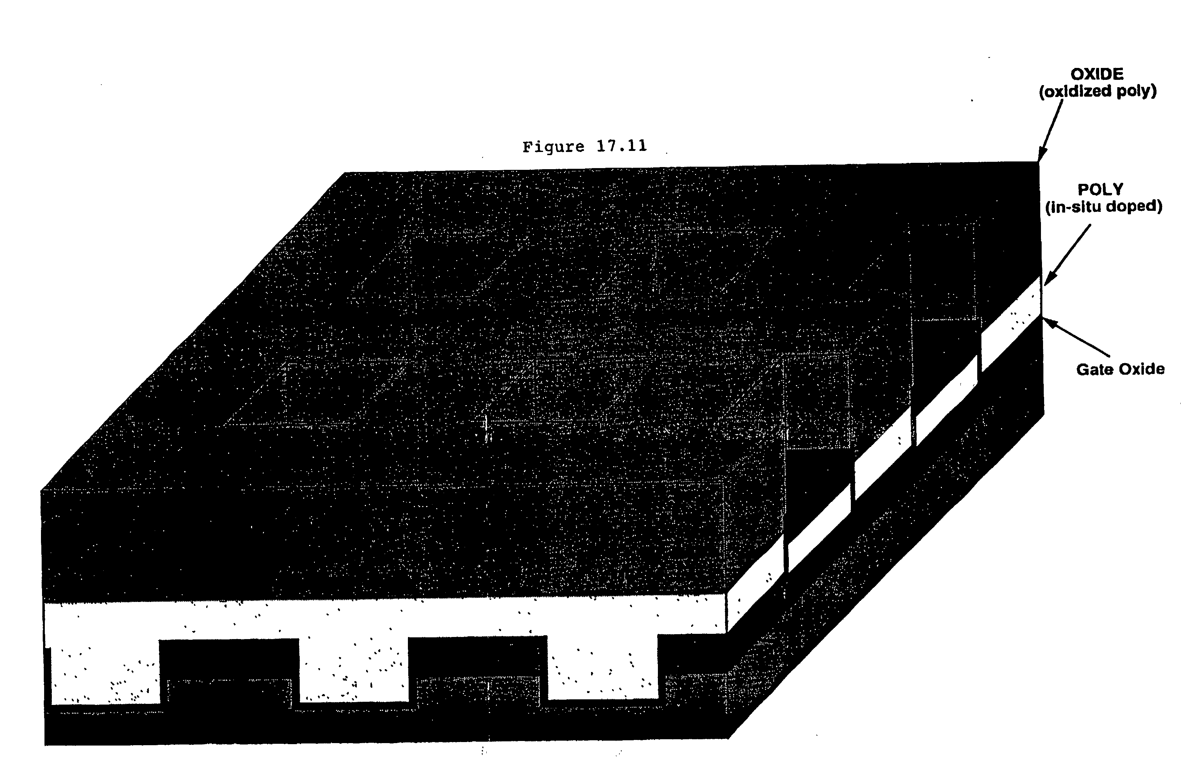

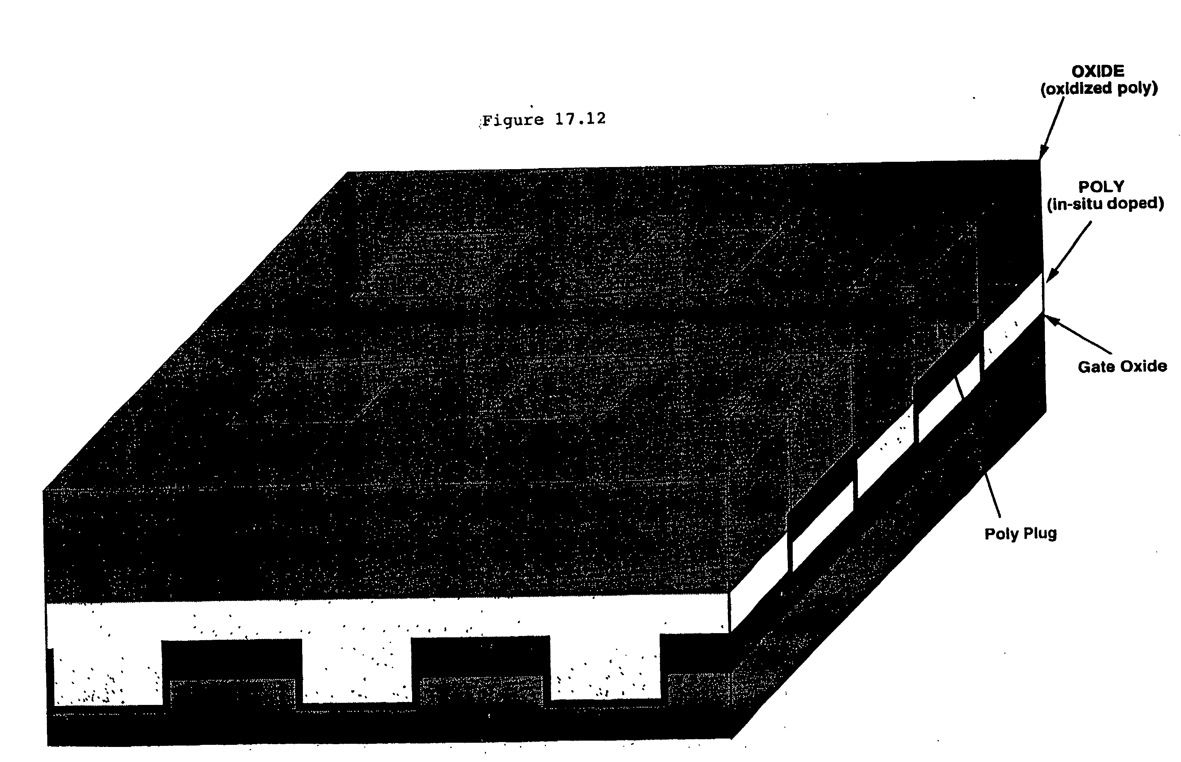

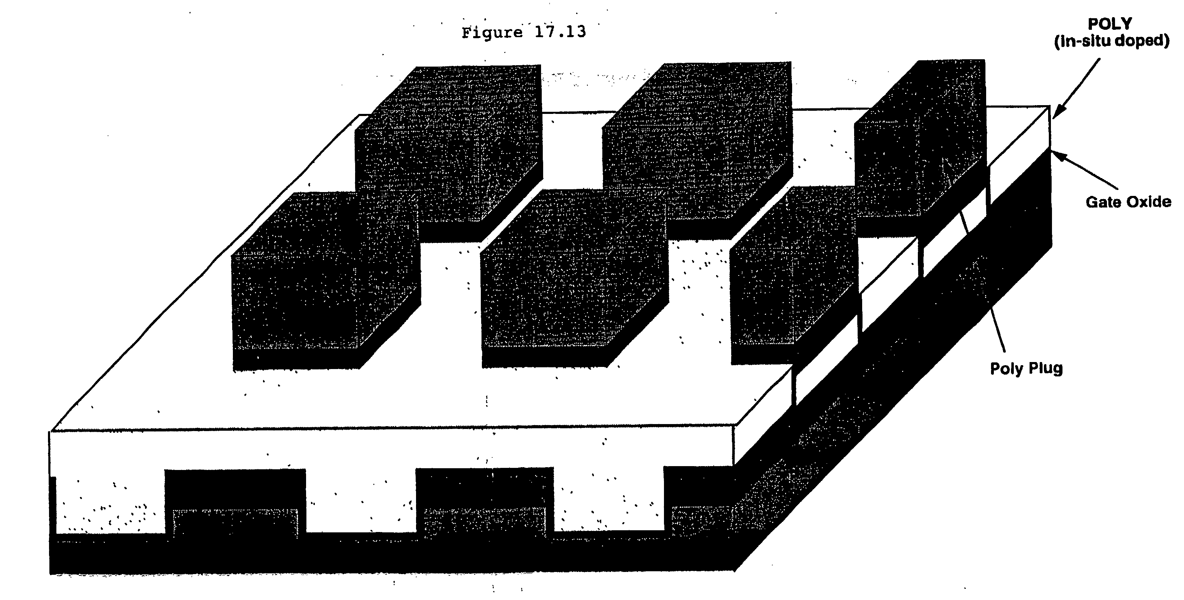

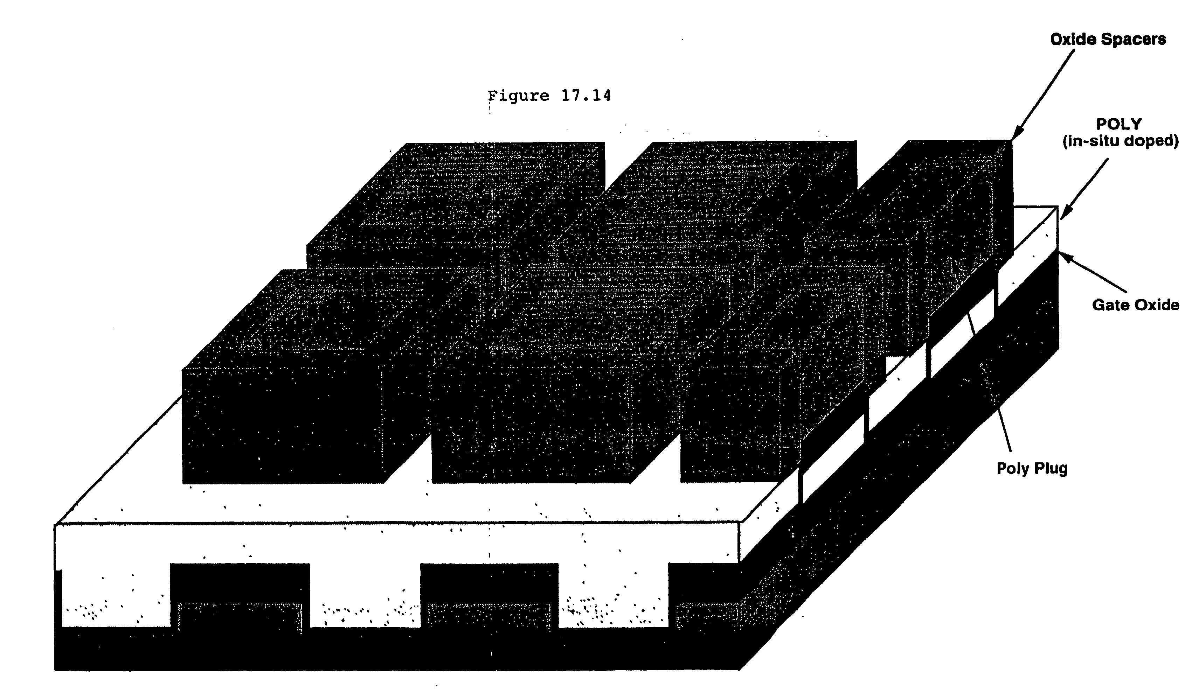

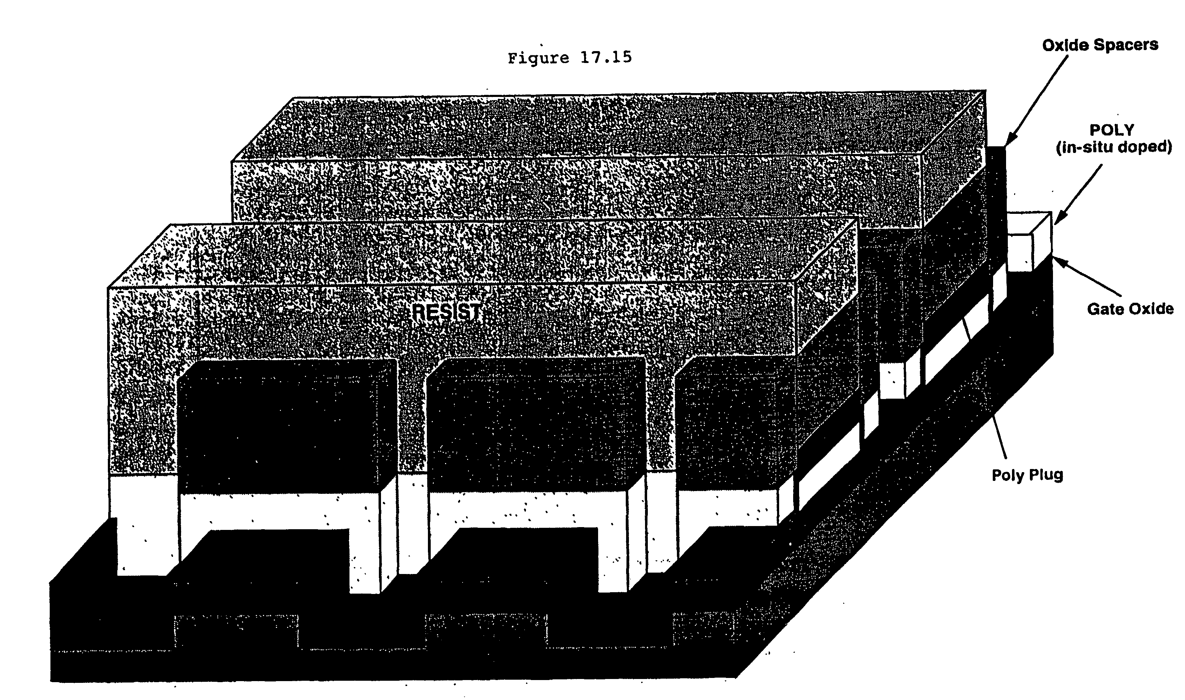

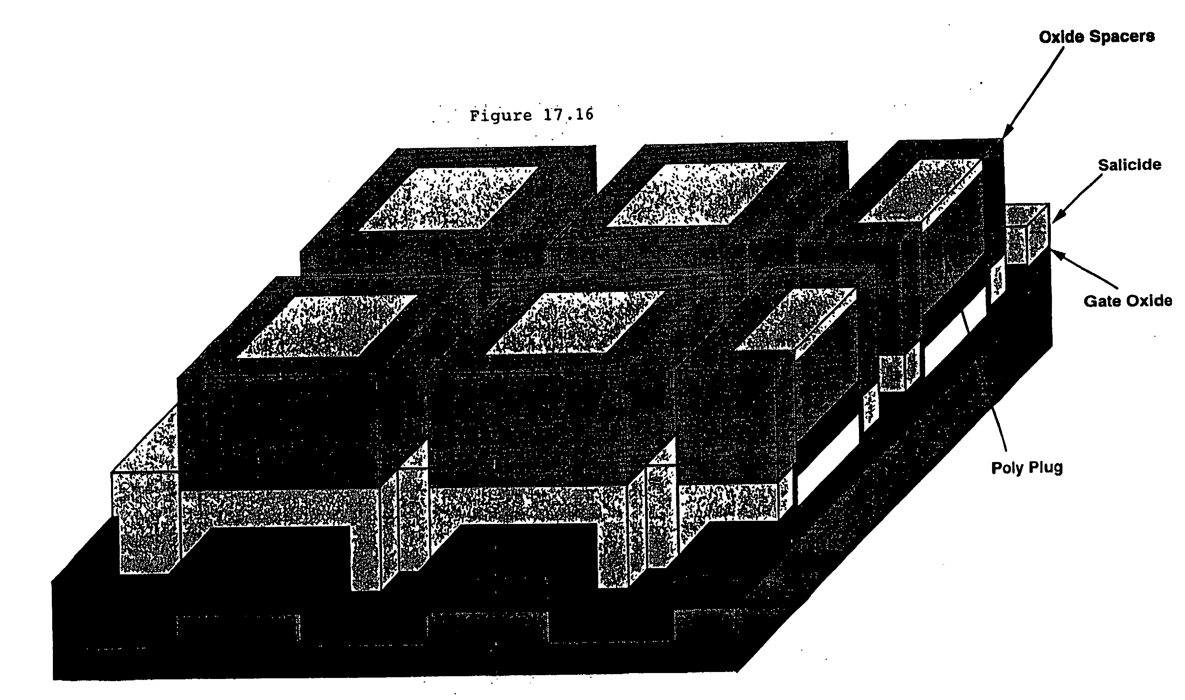

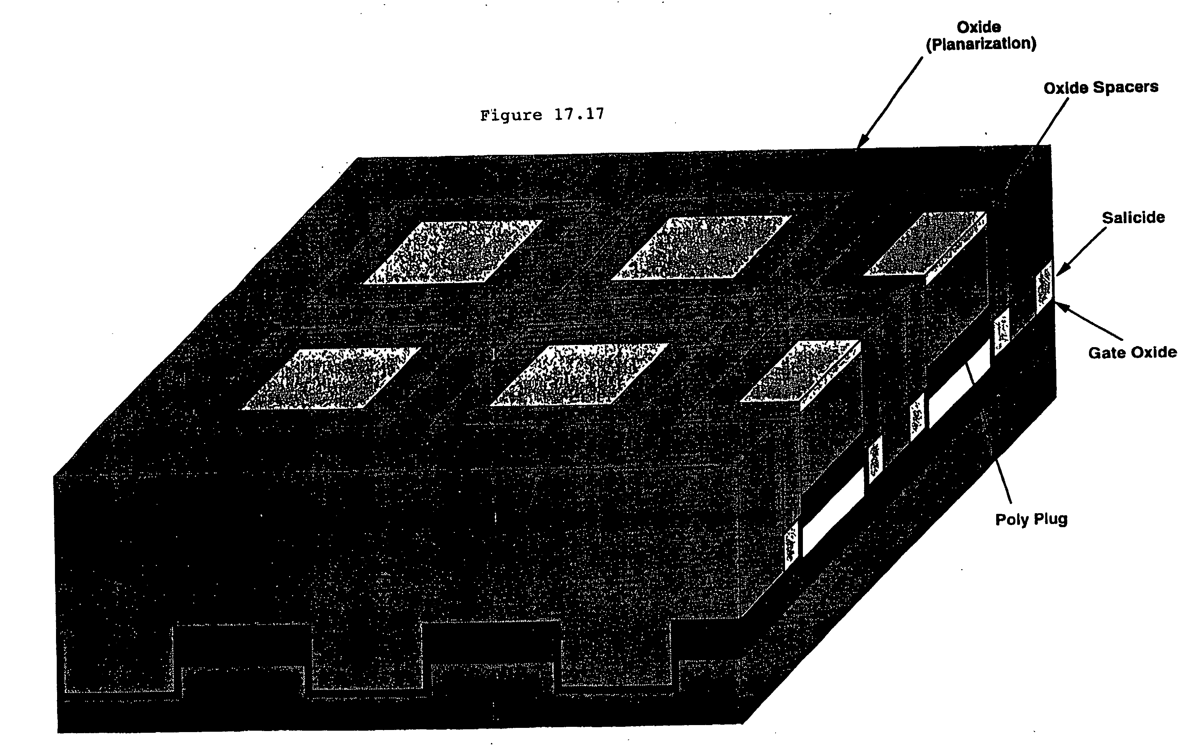

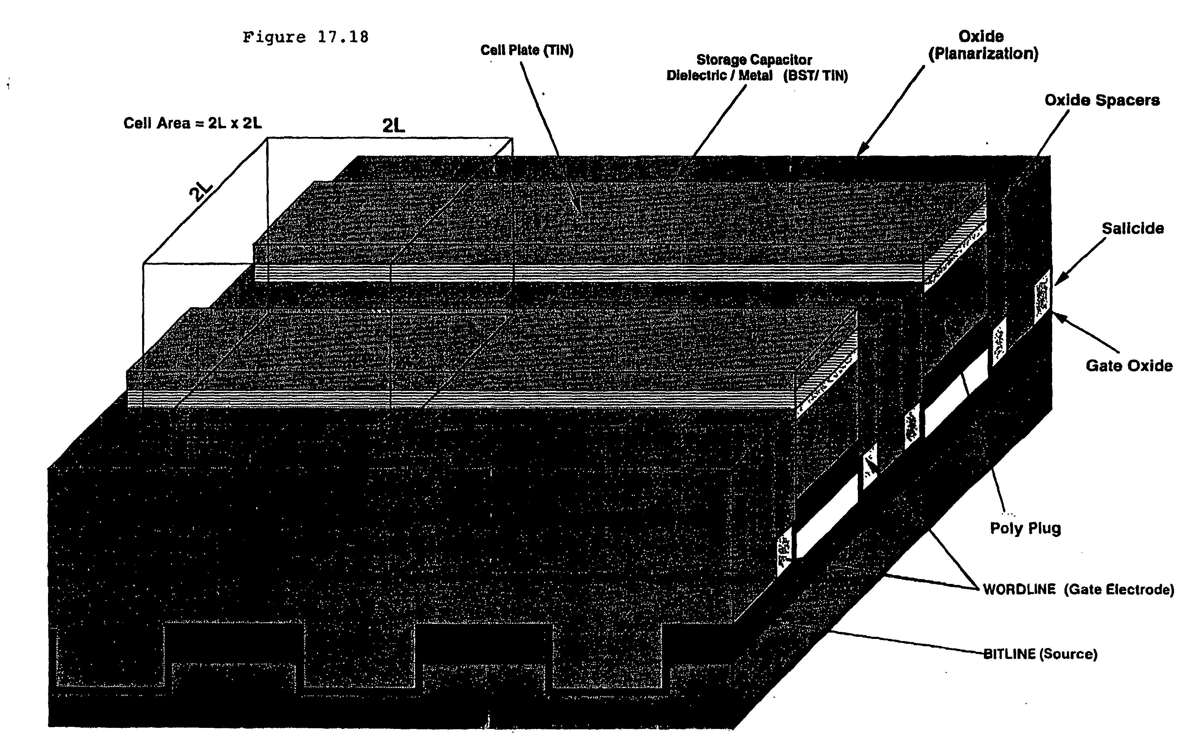

The following flows: flow 5, flow 6, and flow 7 related to figs. 17, 18, and 19 respectively are examples of manufactured (1T + 1C) cells.

### Flow 5

1) Undoped substrate.
2) Full Clean.
3) Epi-growth of the vertical transistor.
4) CVD of thin (~20 nm) oxide/ thick (>200 nm) nitride. FIG17.1
5) Litho (MASK1: lines and spaces with minimum dimensions).
6) Dry etch of nitride, stopping on the oxide. **FIG17.2**
7) HF-dip (or vapor). **FIG17.3**

8) Damageless (dry or wet) etch of crystalline silicon layers (Drain & Channel), stopping on the bottom highly doped layer (Source).

In order to obtain some selectivity (>40:1 for dry etch, and much larger for wet etch), it is possible to have SiGe strained layers in the Source region.

9) Resist strip. **FIG17.4**

10) Litho (MASK2 lines and spaces perpendicular to the first ones).

11) Dry etch of nitride, stopping on the oxide. **FIG17.5**

12) HF-dip (or vapor). **FIG17.6**

13) Damageless (dry or wet) etch of the full epi-stack into the undoped substrate. **FIG17.7**

14) Resist strip.

15) Full Clean.

16) Gate oxidation. **FIG17.8**

17) CVD of a "thick" layer of in-situ doped poly SiGe (or just Ge).

18) Poly etchback, stopping on the nitride level of the squares defined by the double trenching. **FIG17.9**

19) Low temperature, (PE ?) oxidation of the poly SiGe (or just Ge).

At least for furnace wet oxidation, below 700 C, poly SiGe oxidizes much faster than just poly Si. Experimental results show that with just 30% Ge, there is an order of magnitude improvement in the oxidation rate at 700 C. For larger Ge content or even just Ge poly, it is reasonable to expect even larger differences in oxidation rates. **FIG17.10**

{The interface between poly-SiGe and oxidized-poly-SiGe must be below the thin oxide deposited at the beginning of the flow. This constraint can be relaxed a bit by performing step 21.}

20) Selective (against oxide) etch (dry or wet), of the nitride.

21) Low temperature (PE ?) poly (SiGe or just Ge) oxidation. This creates an oxide on the poly side walls thereby preventing a short with the contact to the top of the transistor.

Due to the large difference in oxidation rates between poly SiGe (or just Ge) and crystalline silicon, a neglegible oxide will grow under the thin deposited one at the beginning of the process.

This removes any possible problems due inhomogeneities in steps 18 and 19.

22) Oxide (Spacer etch process) etchback to remove the thin PE-oxide layer, removing the least oxidized poly possible (which is much thicker than the deposited thin oxide). **FIG17.11**

23) In-situ doped poly plug by selective growth, or blanket deposition and etchback. **FIG17.12**

24) HF to remove the oxidized poly. **FIG17.13**

25) Low temperature (PE ?) oxidation, to form a thin (< 5 nm) film.

26) CVD and etchback of oxide, to make spacers. This thickness, being larger than the stepper's overlay accuracy, will define the width of the trench btween the gates of the different cells. **FIG17.14**

27) Litho (MASK4: Resist lines to protect the BITLINES).

28) Selective dry etch of poly (against oxide spacers).

**FIG17.15**

29) Resist strip. **FIG17.16**

30) Cobalt (or Nickel) salicidation of the poly gate electrode and of the top of the poly plugs. These silicides can be formed at low temperature (300 C for Ni), and cannot be dry etched. It might be difficult to remove the unreacted metal from the bottom of the trenches.

It should also react on the side walls of the poly, which is under the oxide spacers.

31) Planarization by oxide deposition (and/or SOG), and etchback. **FIG17.17**

Prior to SOG deposition, perhaps it would be better to grow (PE ?) a thicker oxide on the bottom, in order to better protect the gate area.

32) Deposition of the capacitor stack (for example, CVD of BaSrTiO (BST)/ TiN). Given a large enough capacitance through the use of the very strong dielectric ( >500), a small capacitance loss due to possible misalignement of the cell plate patterning to the salicided plugs, is admissible.

By skipping the deposition of bottom electrode (on the salicided plugs, under the strong dielectric), process complexities and tolerance constraints are greatly reduced for the patterning of the cell plate.

The selective growth of a metal on the salicided plugs (thereby putting the distance between individual capacitors to a minimum) could further minimize the capacitance loss.

33) Litho (Mask5: definition of the cell plate)

34) Dry etch of the cell plate (TiN), stopping on the strong dielectric film.

35) Resist strip. **FIG17.18**

**Flow 6**

1) P-type substrate, for NMOS cell transistor (n-type substrate and PMOS cell transistor could also be used).
2) Pre-epitaxy clean.
3) Epi-growth of the vertical transistor.
4) CVD of thin (20 nm for example) oxide/ thick (>200 nm for example) nitride.
**FIG18.1**
5) Litho (MASK1: lines and spaces with minimum dimensions).
6) Dry etch of nitride, stopping on the oxide.

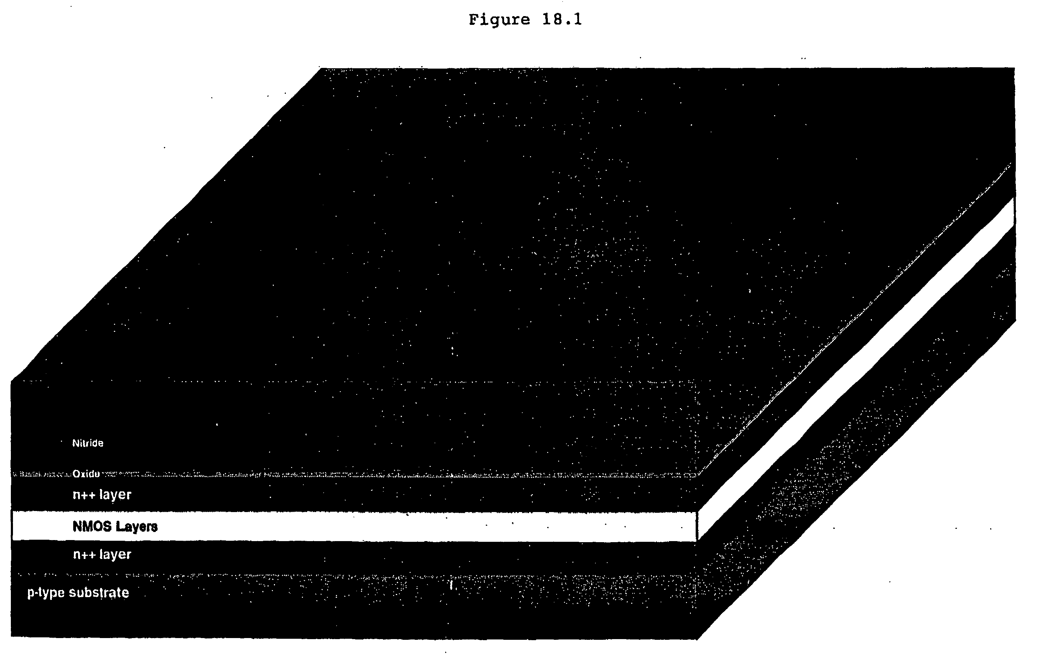

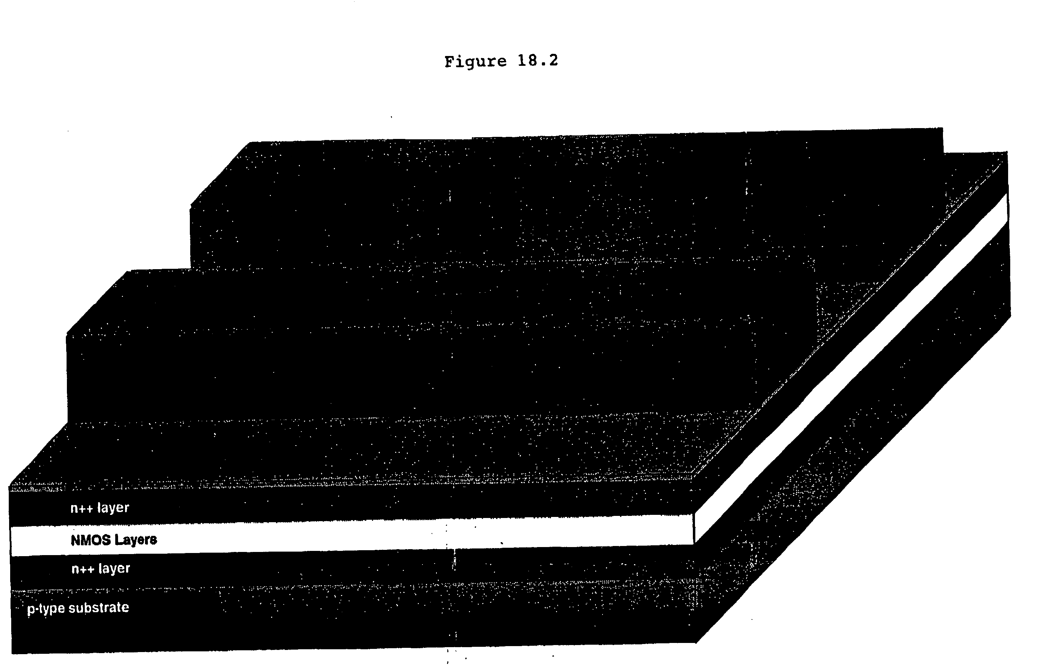

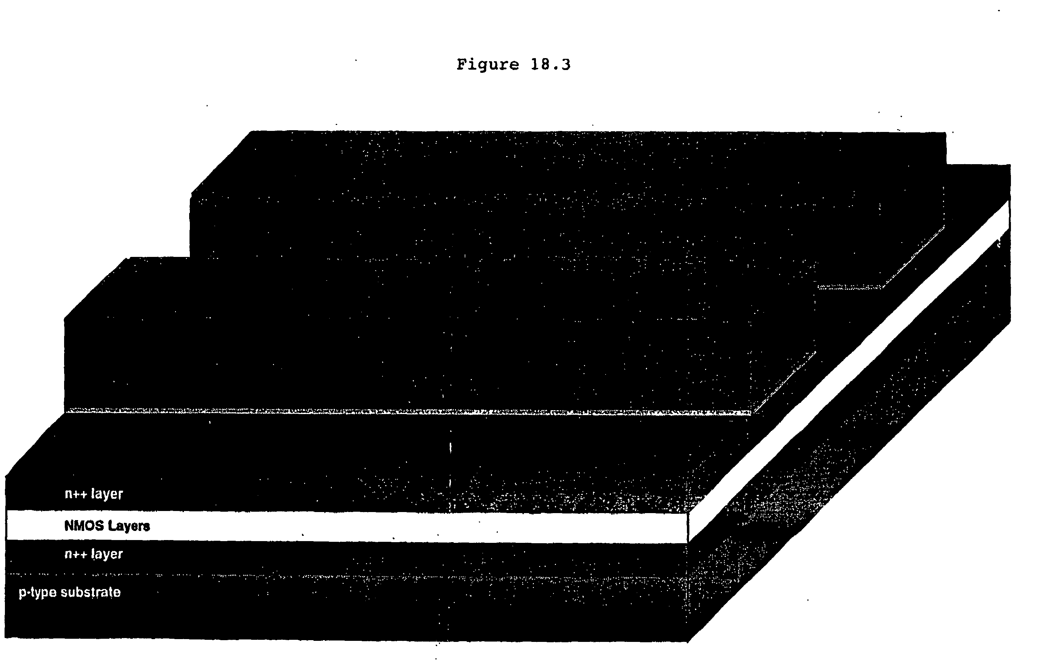

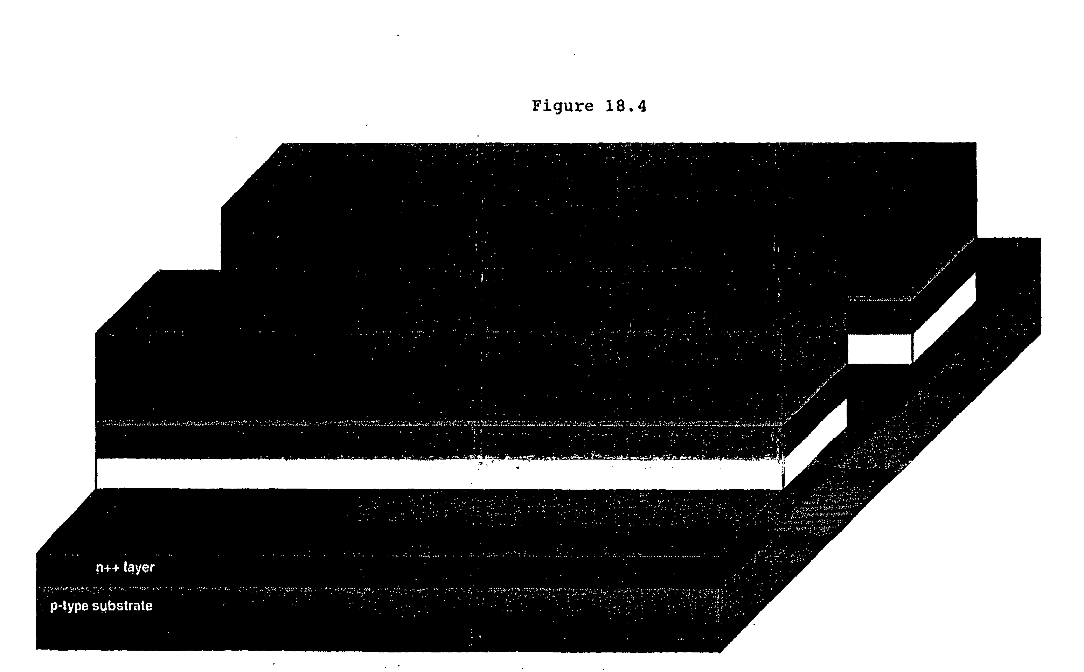

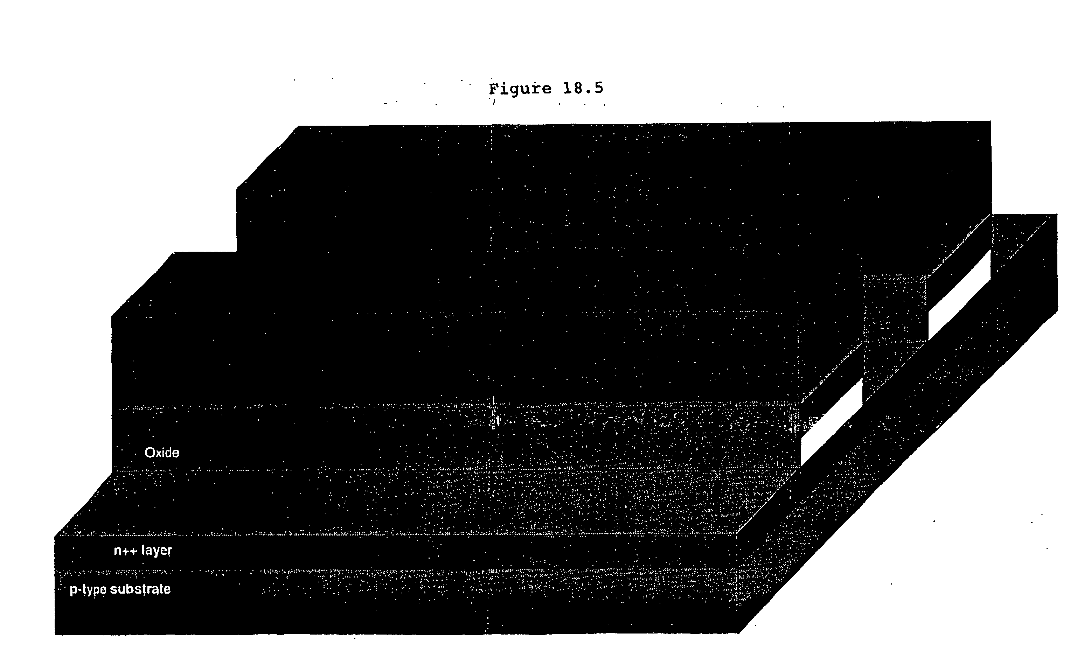

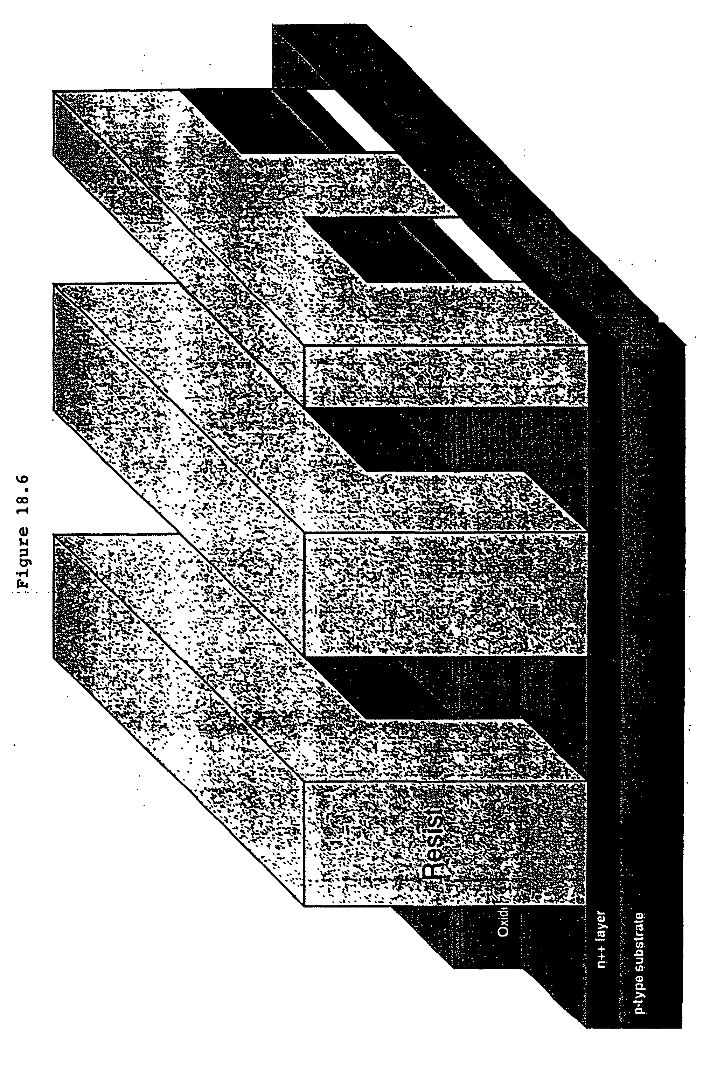

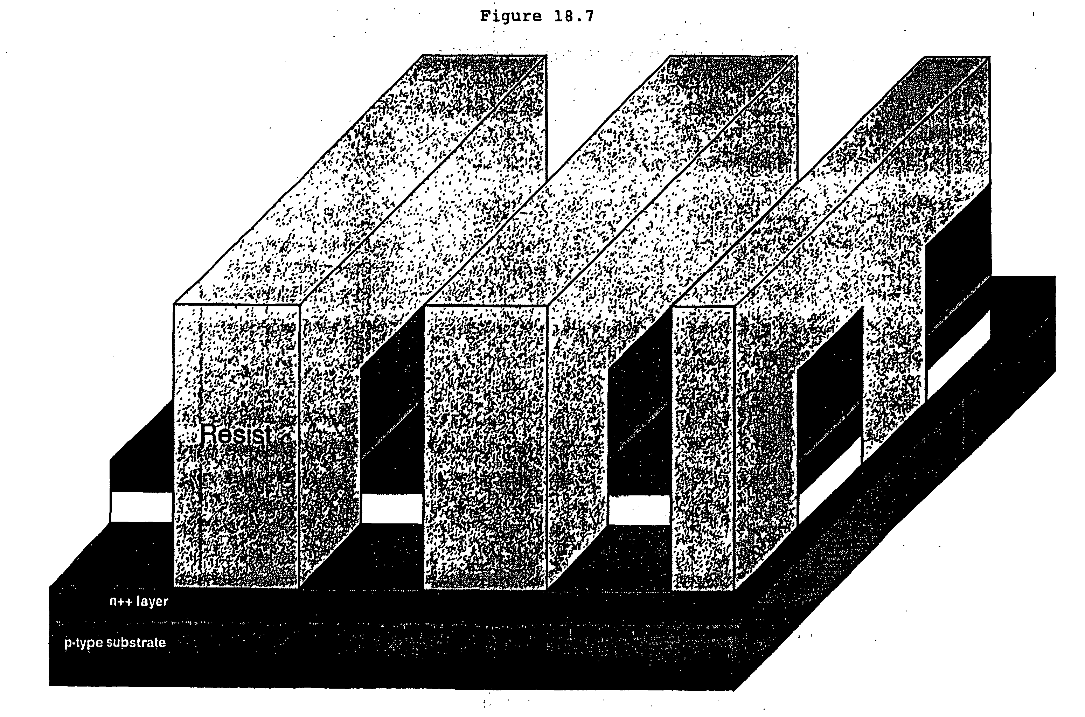

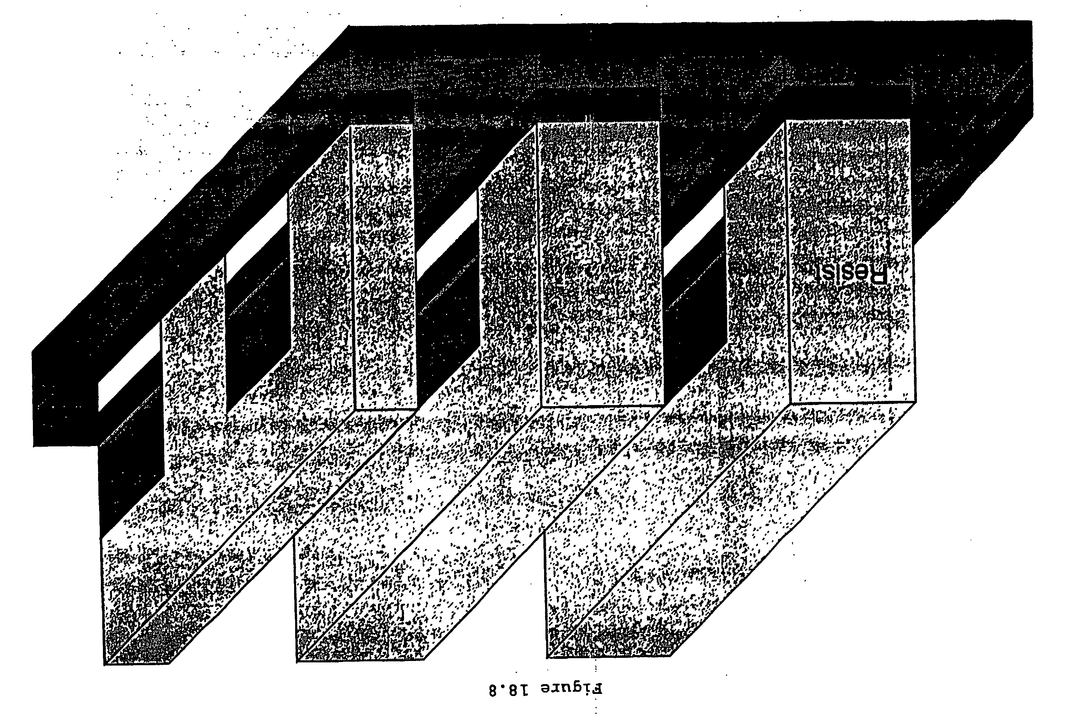

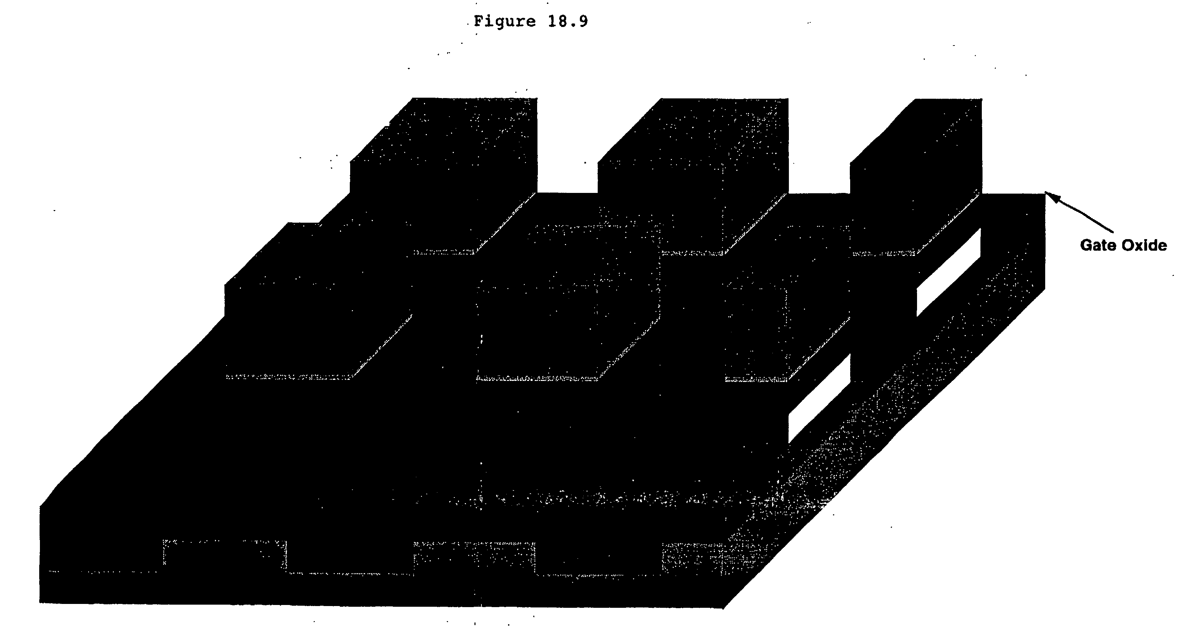

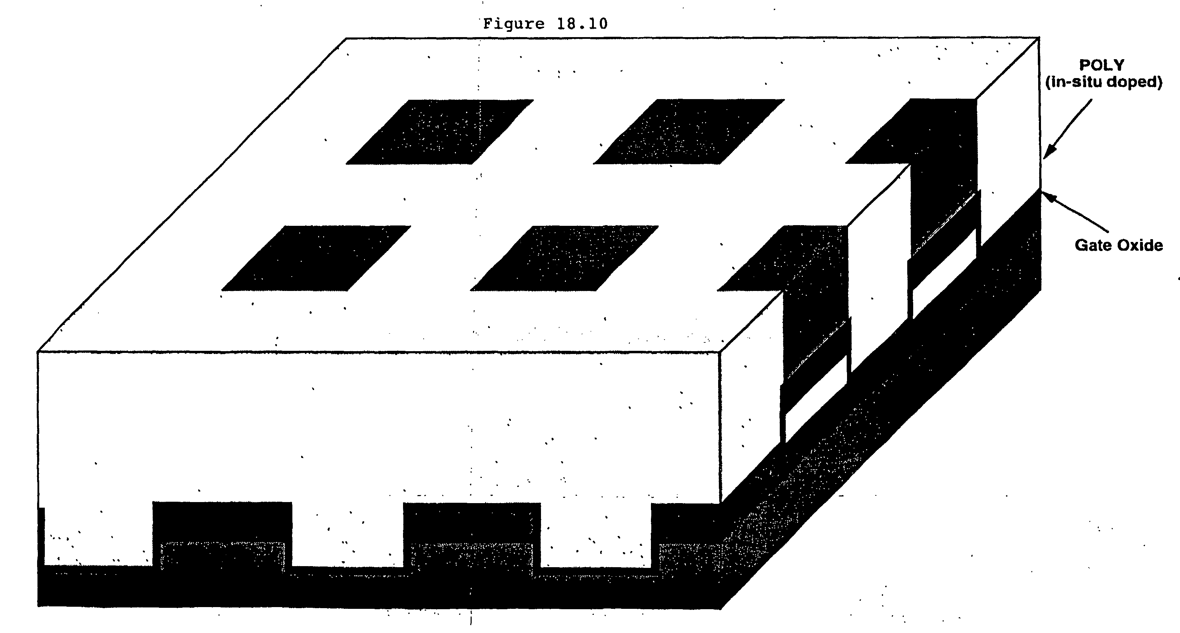

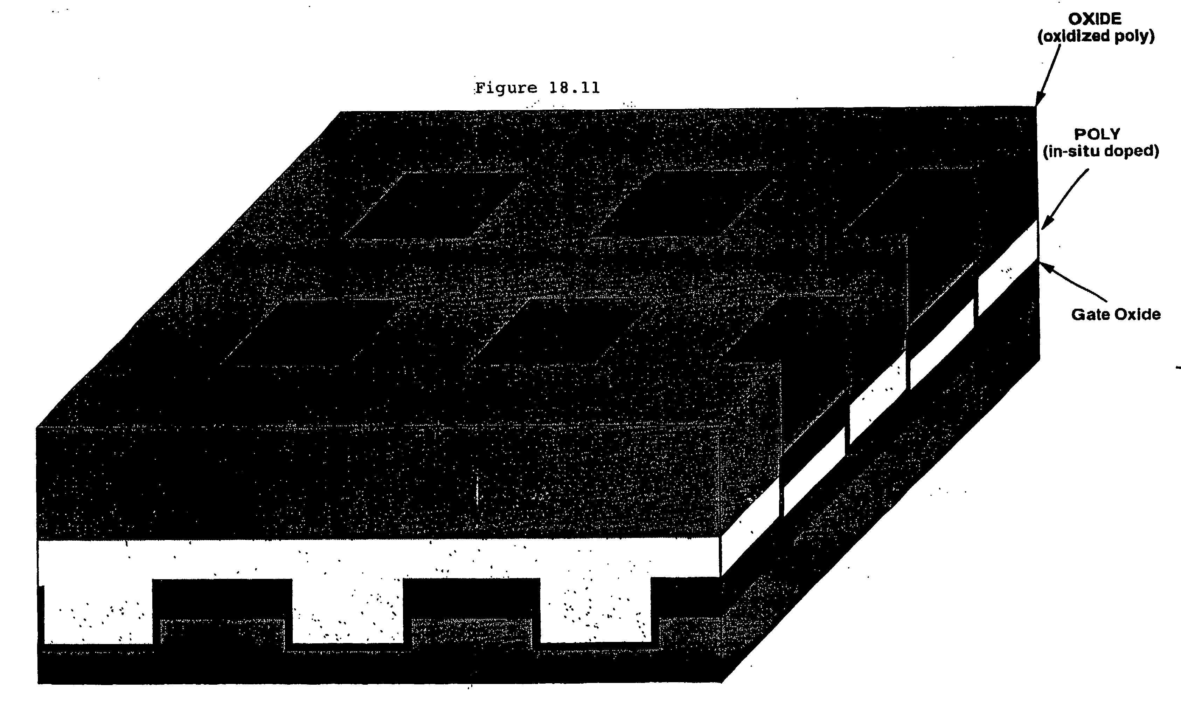

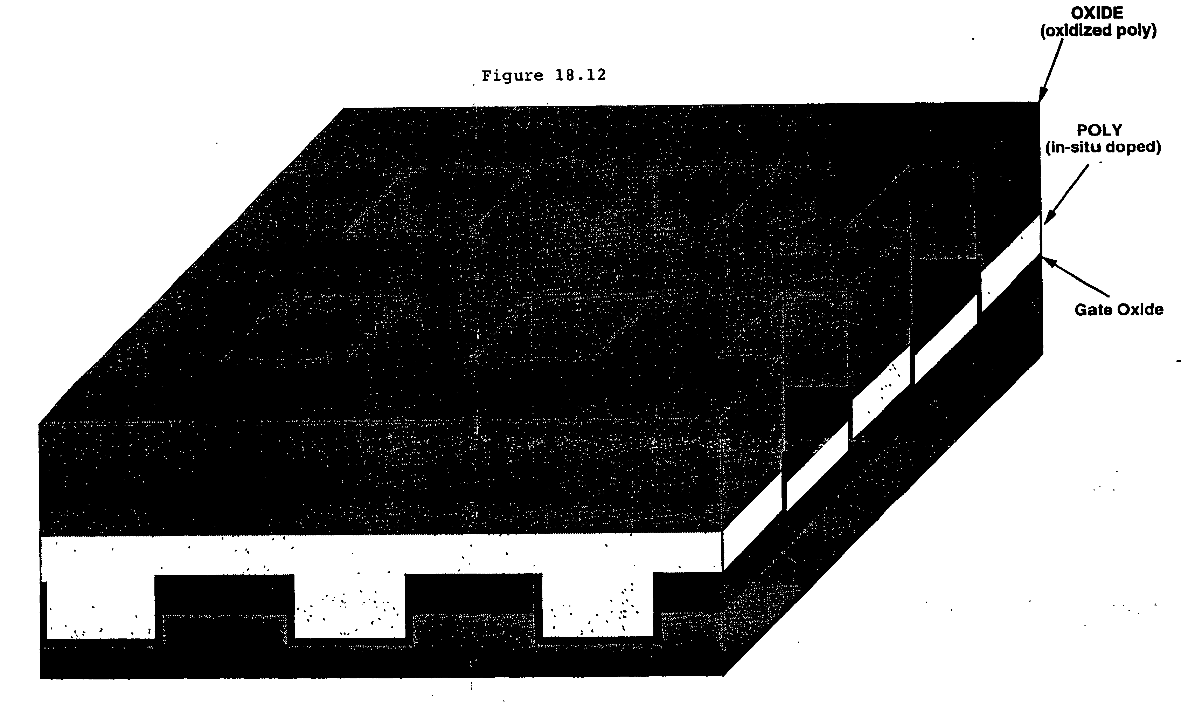

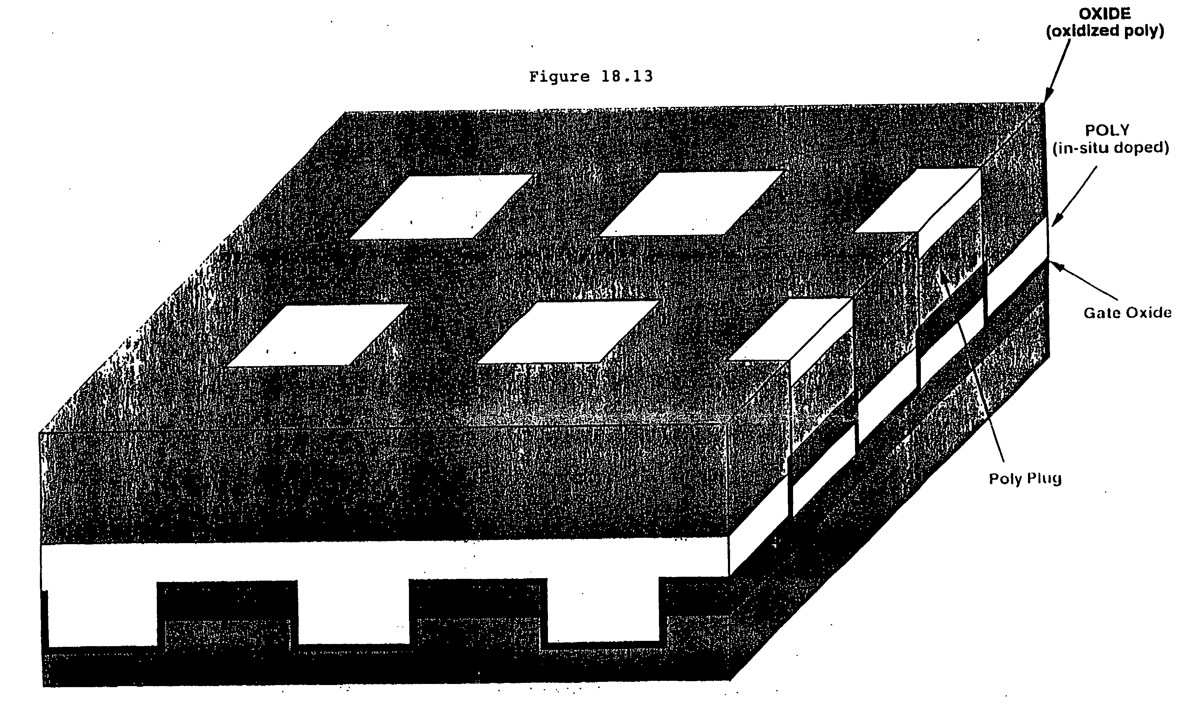

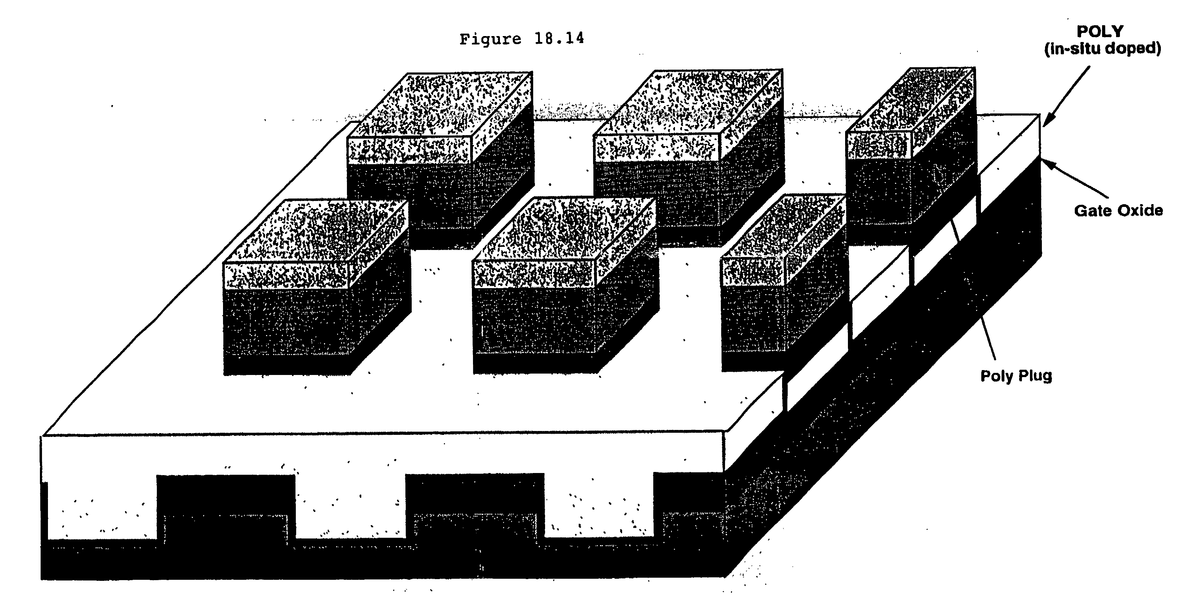

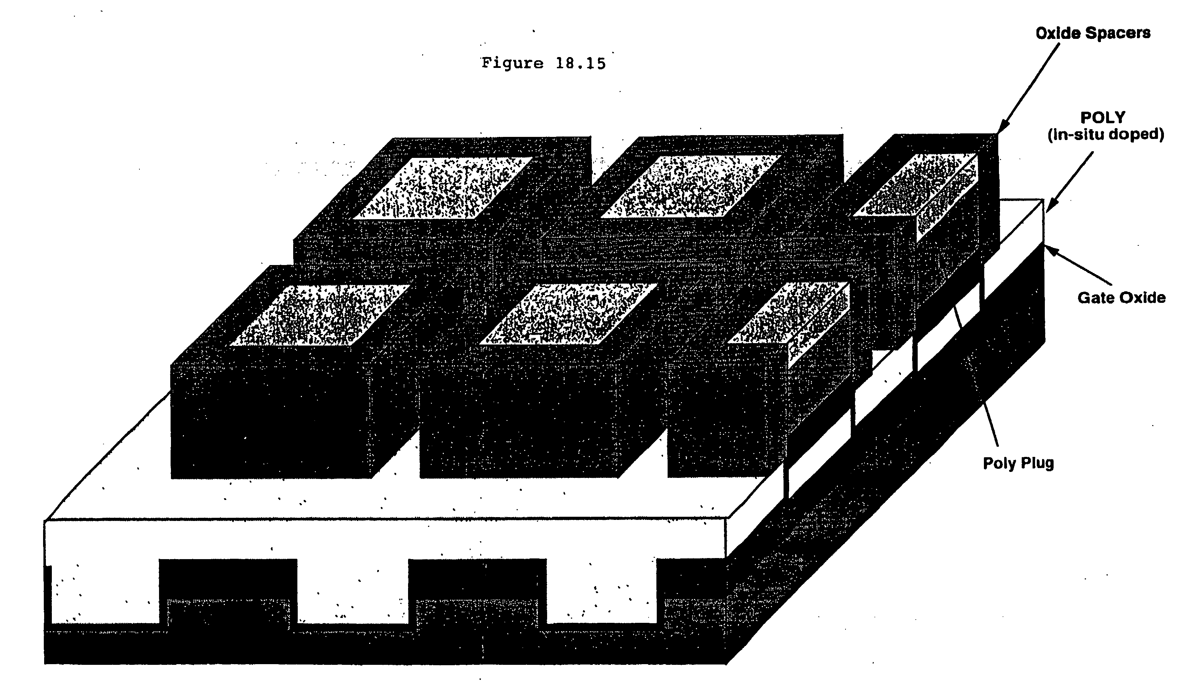

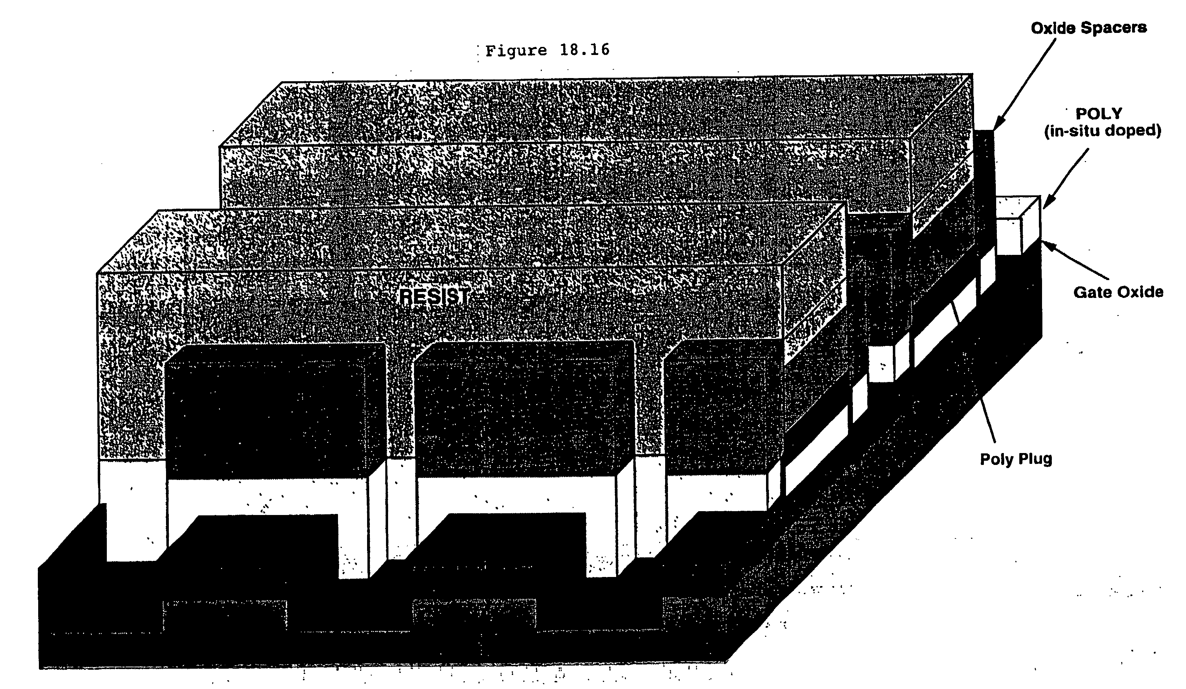

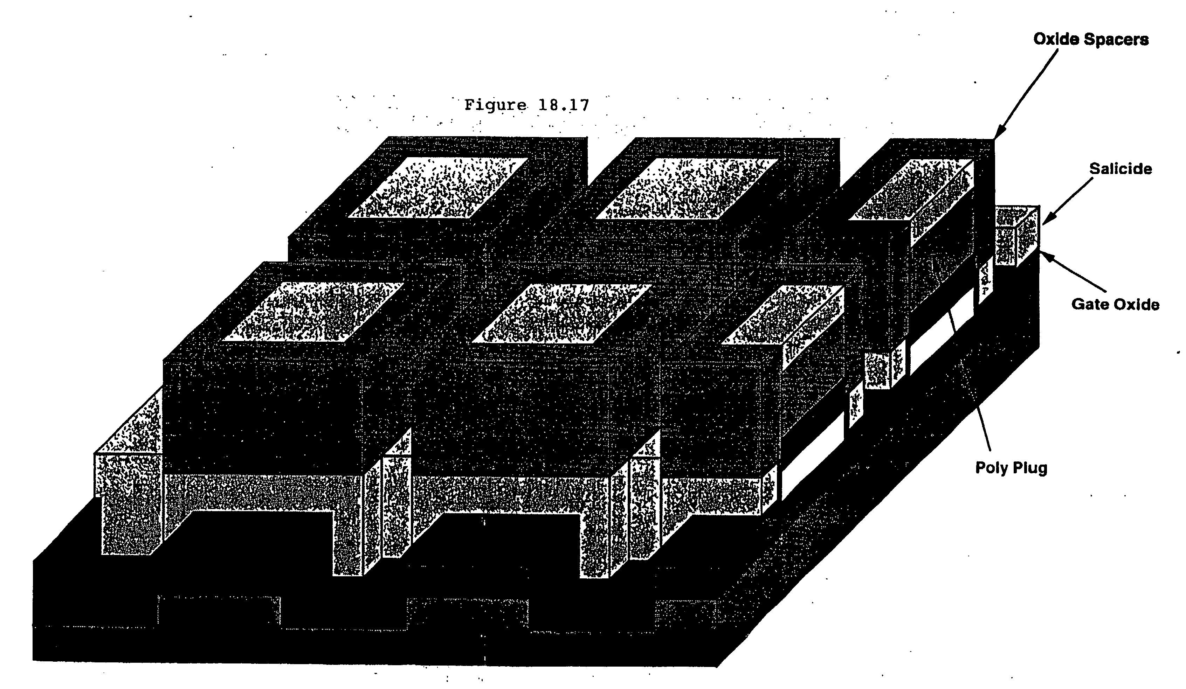

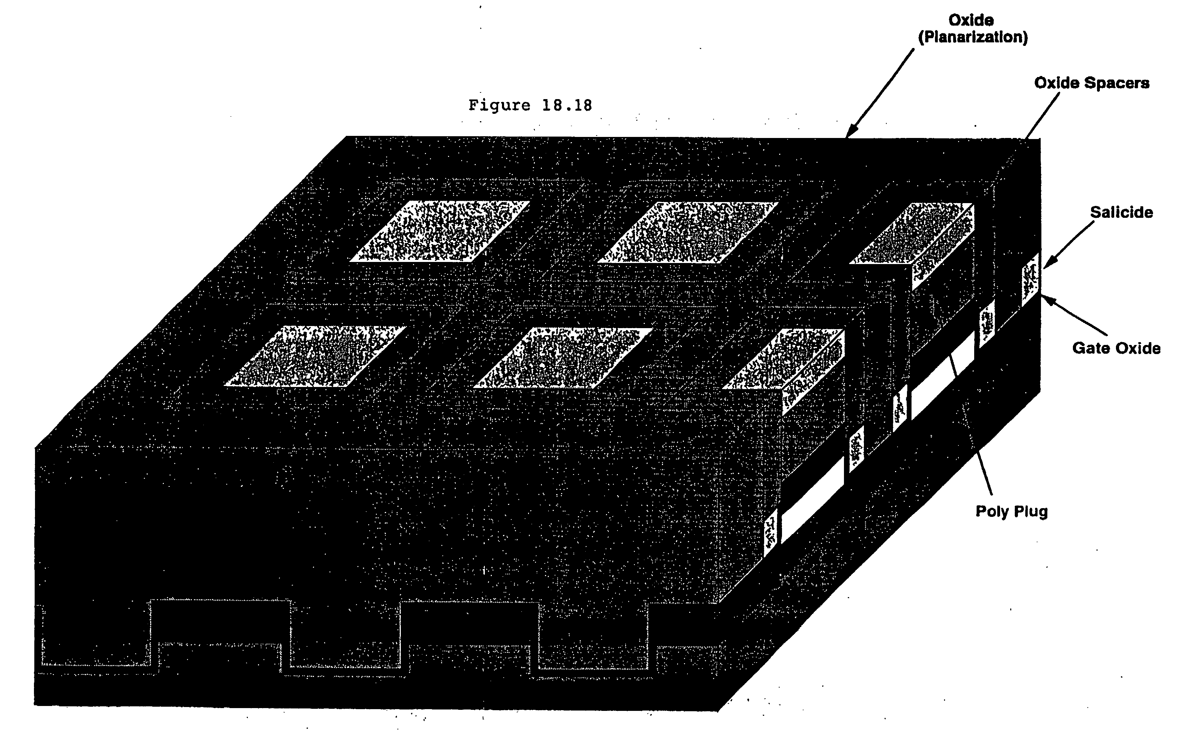

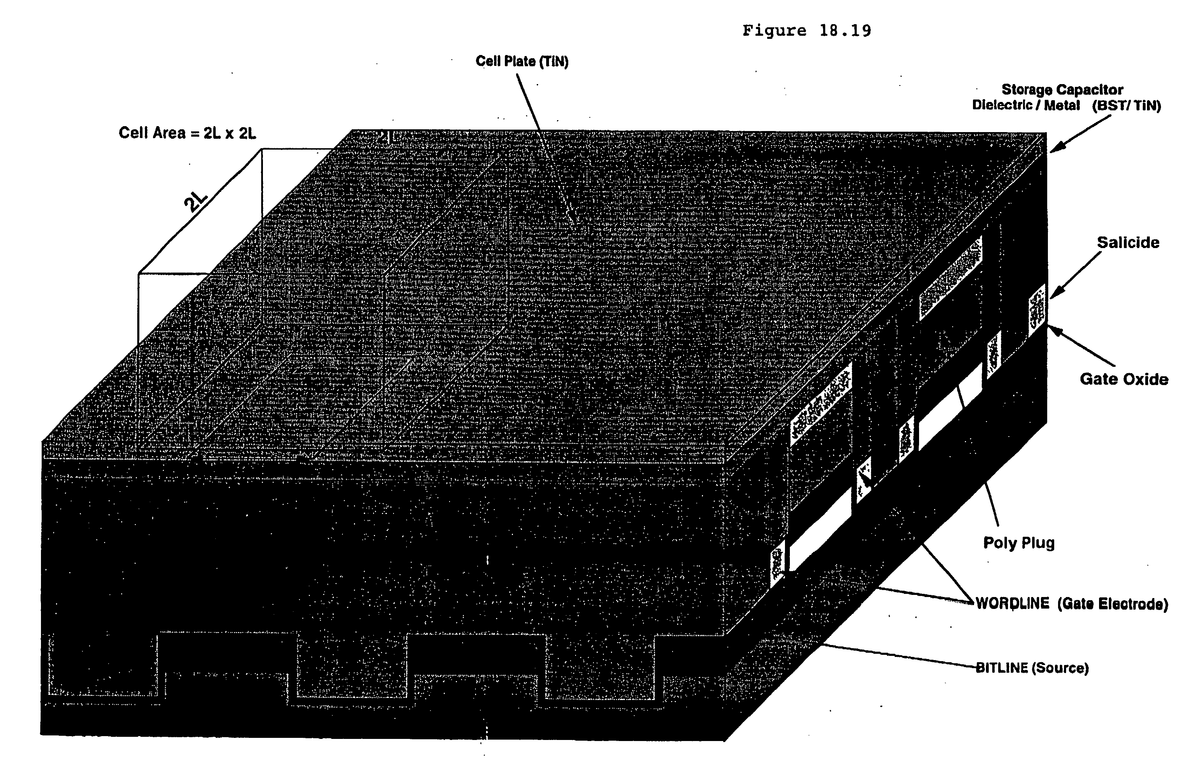

**FIG18.2** (resist is not shown)
7) Oxide removal (HF dip or vapor for example).
**FIG18.3** (resist is not shown)
8) Damageless (dry or wet) etch of crystalline silicon layers (Drain & Channel), stopping on the bottom highly doped layer (Source). Strained SiGe layers can be incorporated in the source region, to provide an etch marker layer (selectivities > 40:1 for dry etch, and much larger for wet etch).
9) Resist strip.
**FIG18.4**
10) Clean.
11) Low temperature (plasma assisted for example) thin oxide film growth, for protection of the semiconductor areas, against nitride etch.
**FIG18.5**
12) Litho (MASK2 lines and spaces perpendicular to the first ones).
13) Dry etch of nitride, stopping on the oxide.
**FIG.18.6**
14) Oxide removal (HF dip or vapor for example).
**FIG.18.7**
15) Damageless (dry or wet) etch of the full epi-stack into the undoped substrate.
**FIG.18.8**
16) Resist strip.
17) Clean.
18) Gate dielectric formation (growth or deposition). Oxide growth is shown.
**FIG.18.9**
19) Deposition (CVD for example) of in-situ doped poly SiGe (Ge content can be from 0 to 100%).
20) Poly etchback, stopping on the nitride level of the squares defined by the double trenching.
**FIG.18.10**
21) Low temperature, (plasma assited for example) oxidation of the poly. The interface between oxidized poly should be below the thin oxide deposited at the beginning of the flow.
**FIG.18.11**
22) Selective (against oxide) etch (dry or wet), of the nitride.
23) Removal of thin oxide film from the bottom of the hole.
**FIG.18.12**
24) In-situ doped poly plug by selective growth, or blanket deposition and etchback.
25) Formation of a salicide (Ni or Co for example) on the top of the poly plugs, or selective deposition of a conductive material (TiN for example). The material which is arranged on top of the plugs, should be a good mask against dry etch poly.
**FIG.18.13** (a silicide is shown)
26) Oxidised poly removal against the material on top of the poly plugs. (HF dip or vapor for example).
**FIG.18.14**
27) Deposition (CVD for example) and etchback of oxide, to make spacers. This thickness, being larger than the stepper's overlay accuracy, will define the width of the trench btween the gates of the different cells. It also makes possible a surrounding gate for the vertical MOSFETs.
**FIG.18.15**
28) Litho (MASK4: Resist lines to protect the BITLINES).
29) Selective dry etch of poly (against oxide spacers and gate dielectric).
**FIG.18.16**
30) Resist strip.

31) Optional (Cobalt or Nickel) silicidation of the poly gate electrode and of the top of the poly plugs. These silicides can be formed at low temperature (350 C for Ni).
**FIG.18.17**
32) Planarization. It can be done by oxide deposition, and etchback; and/or SOG.
**FIG.18.18**
29) Deposition of the capacitor stack. For example, the dielectric can be BST (BaSrTiO) and the cell plate can be TiN.
**FIG.18.19**

Contacts to the bitlines and word lines can be etched through the cell plate. Appropriate care must be taken to avoid a short between the cell plate and those contacts. Such is possible through the formation of spacers inside the contact holes, prior to the formation of the conductive plug. This way, the patterning of the cell plate is not necessary.

**Flow 7**

1) P-type substrate, for NMOS cell transistor (n-type substrate and PMOS cell transistor could also be used).
2) Pre-Epitaxial Clean.
3) Epi-growth of the vertical transistor.
4) Deposition of capacitor's bottom electrode.
5) Deposition of capacitor's dielectric.
6) Deposition of capacitor's top electrode (one or more films of pure or alloyed metals).
**FIG.19.1**
7) Litho (MASK1: lines and spaces with minimum dimensions).
8) Dry etch of the capacitor layers (top electrode, dielectric and bottom electrode).
**FIG.19.2**
9) Dry etch of crystalline silicon layers (Drain & Channel), stopping on the bottom highly doped layer (Source).
     In order to obtain some selectivity (>40:1 for dry etch, and much larger for wet etch), it is possible to have SiGe strained layers in the Source region.
10) Resist strip.
**FIG.19.3**
11) Litho (MASK2 lines and spaces perpendicular to the first ones).
12) Dry etch of the capacitor layers (top electrode, dielectric and bottom electrode).
**FIG.19.4**
13) Damageless (dry or wet) etch of the full epi-stack into the undoped substrate.
**FIG.19.5**
14) Resist strip.
**FIG.19.6**
15) Clean.
16) Deposition of gate dielectric.

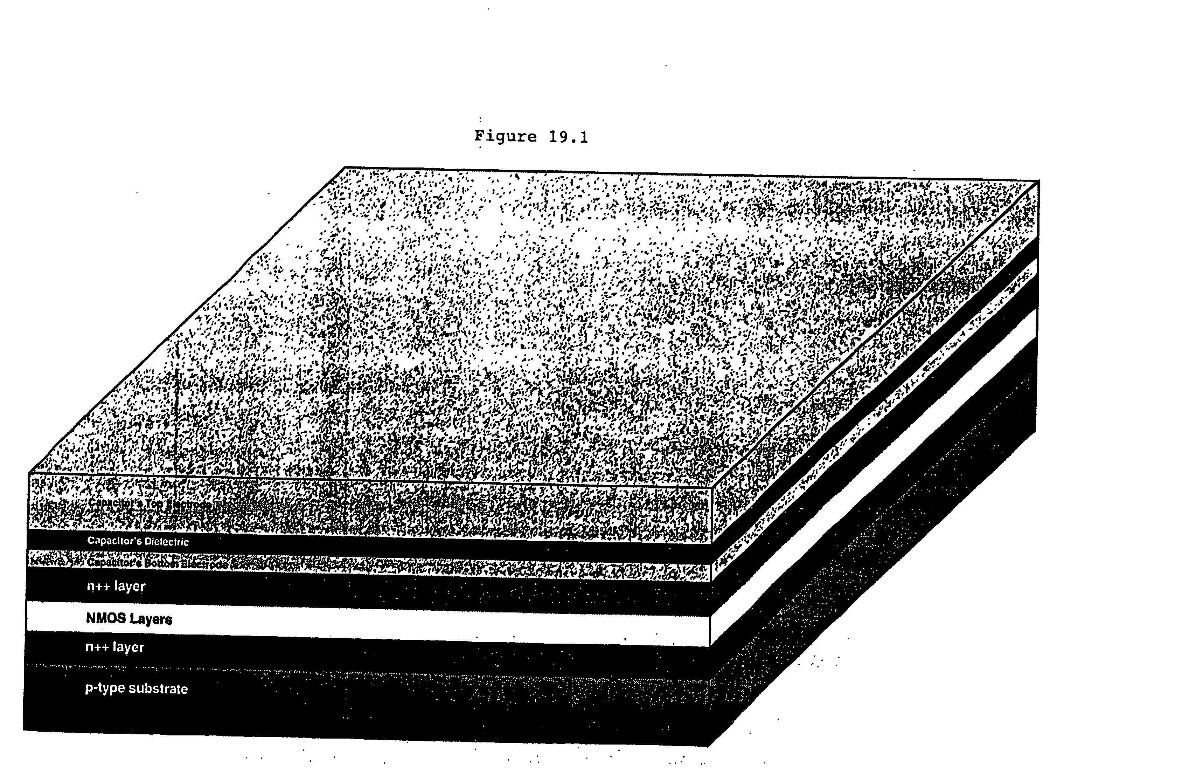

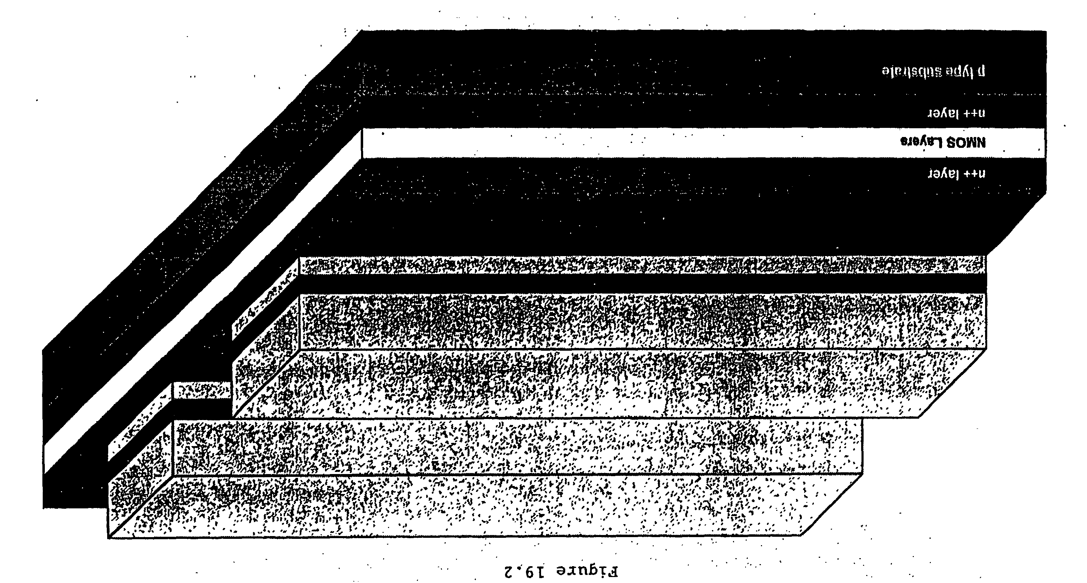

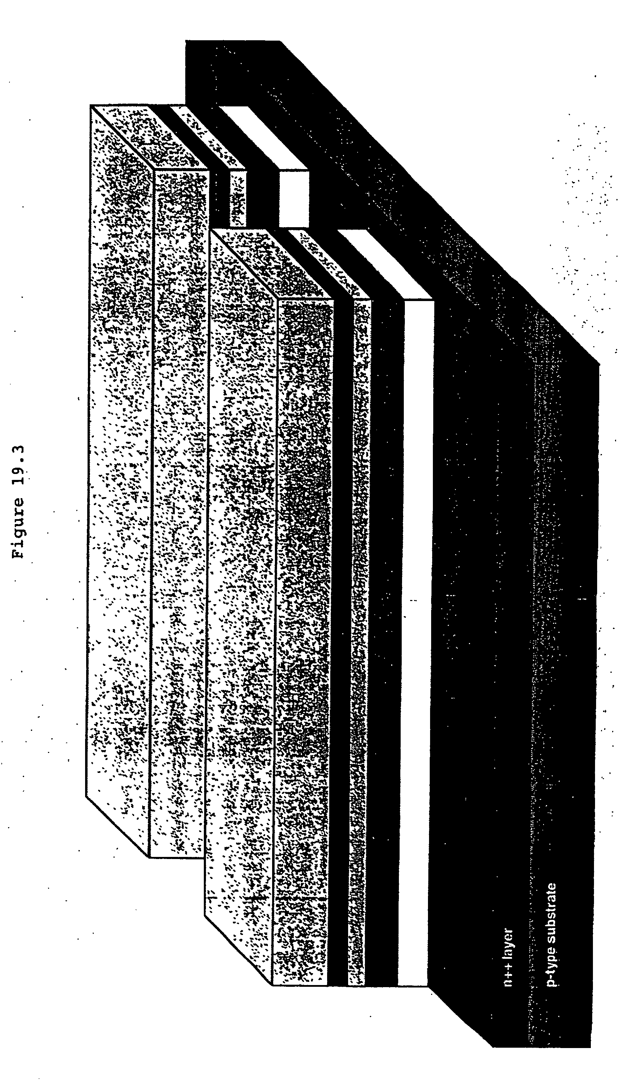

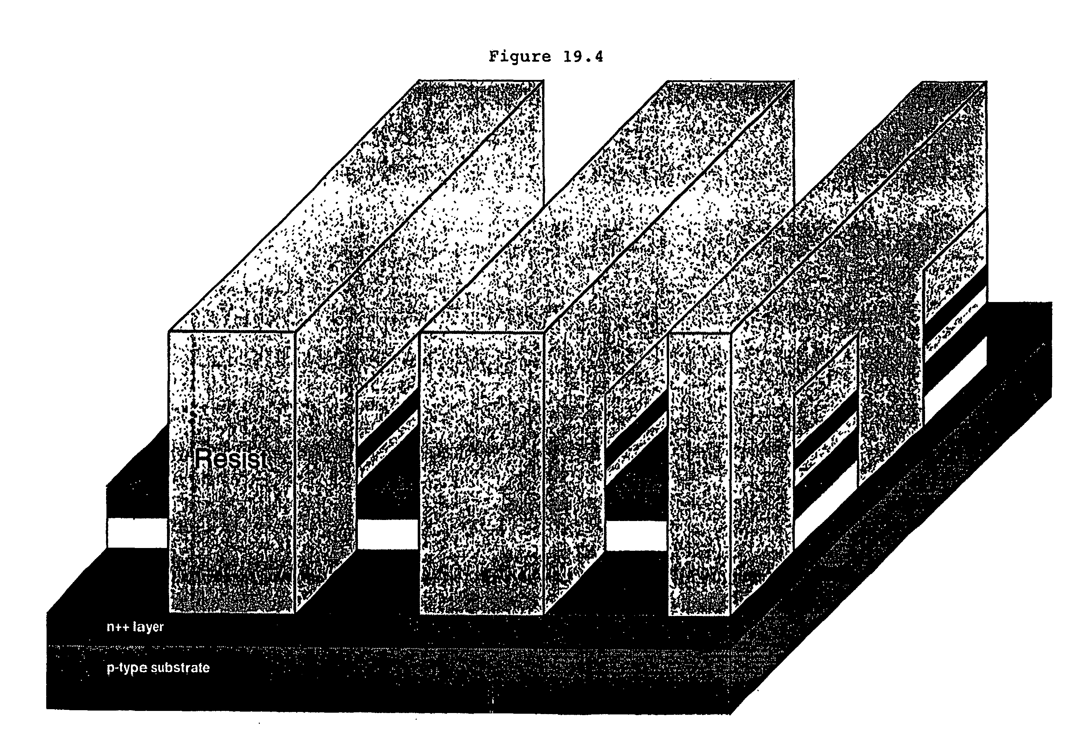

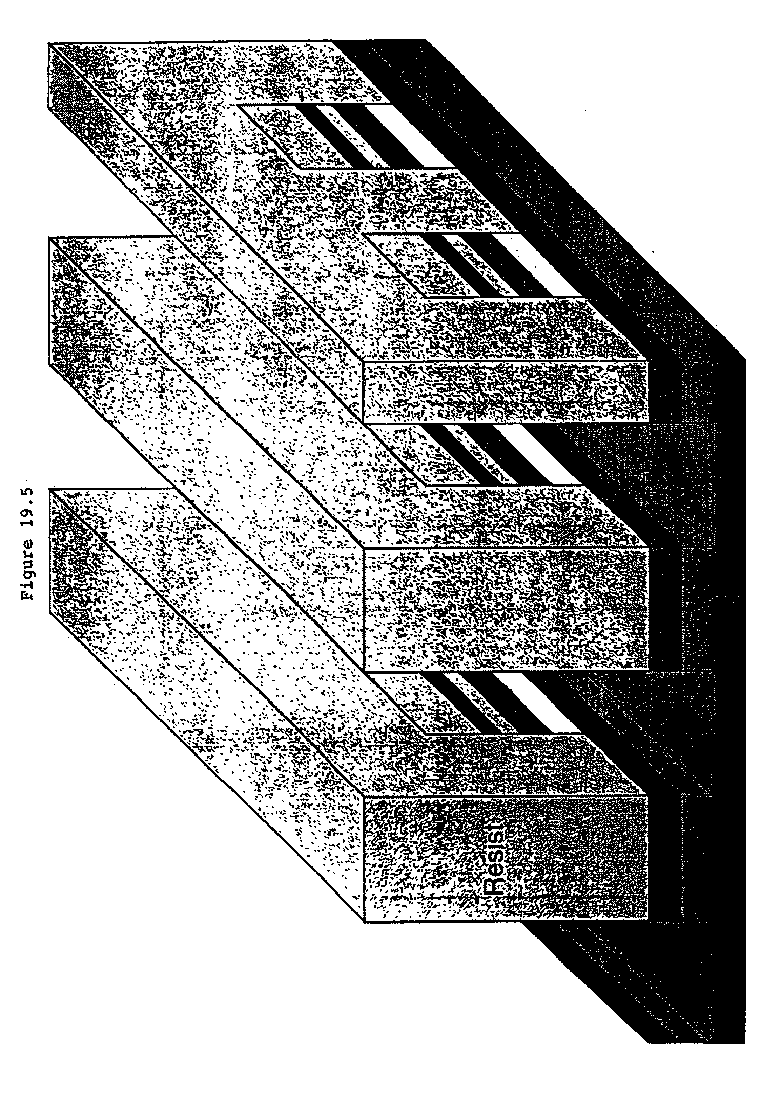

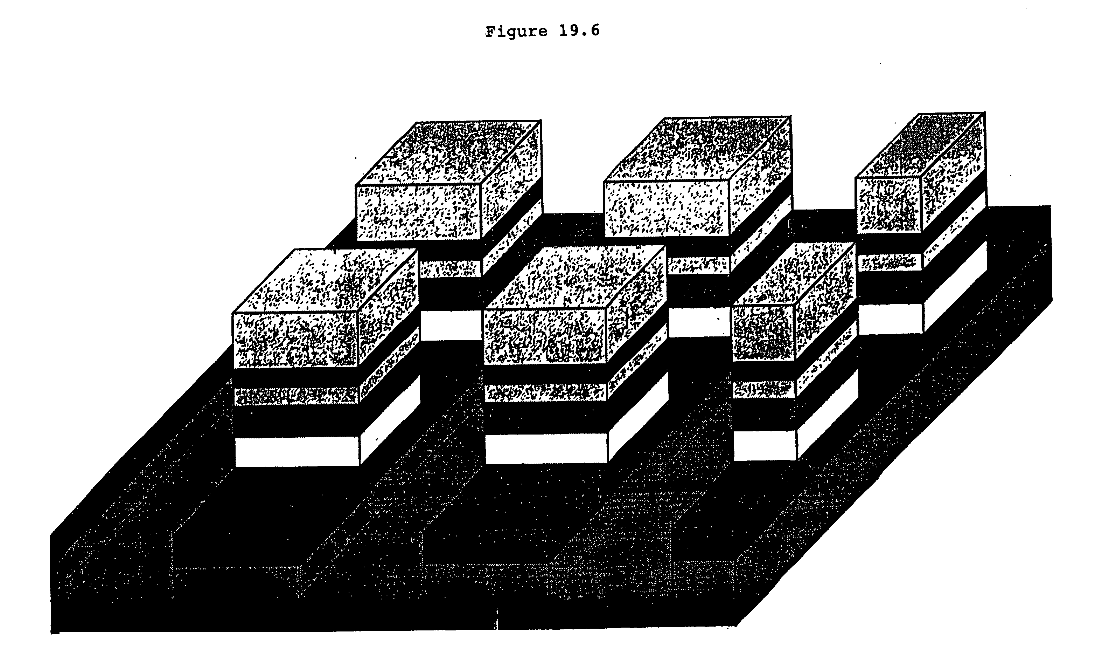

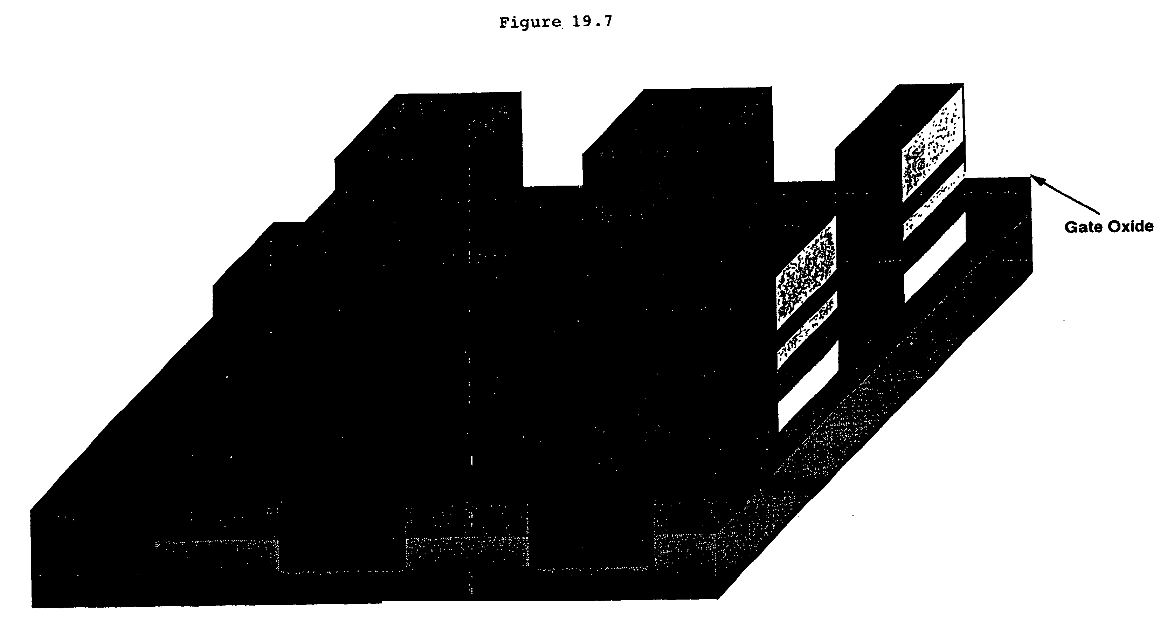

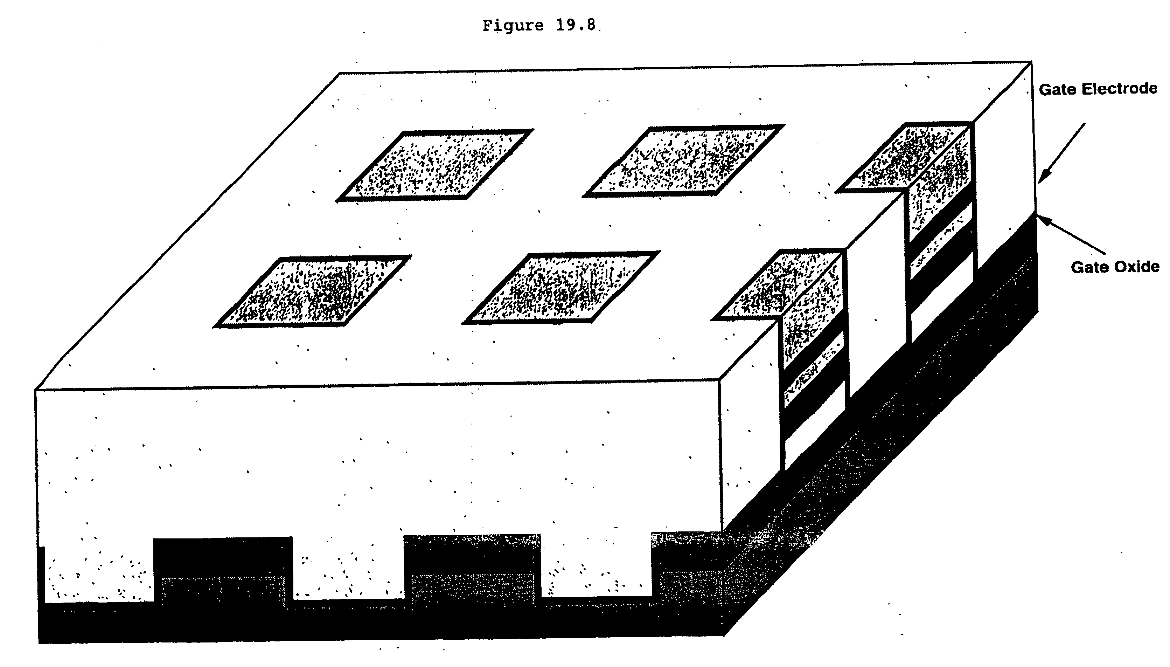

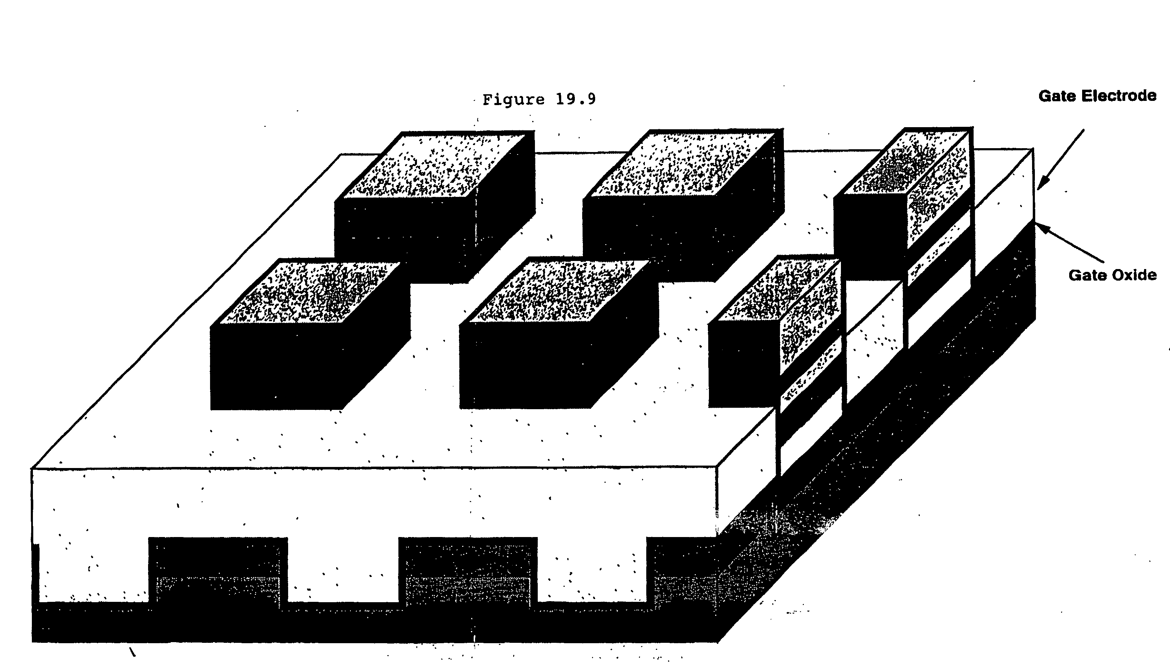

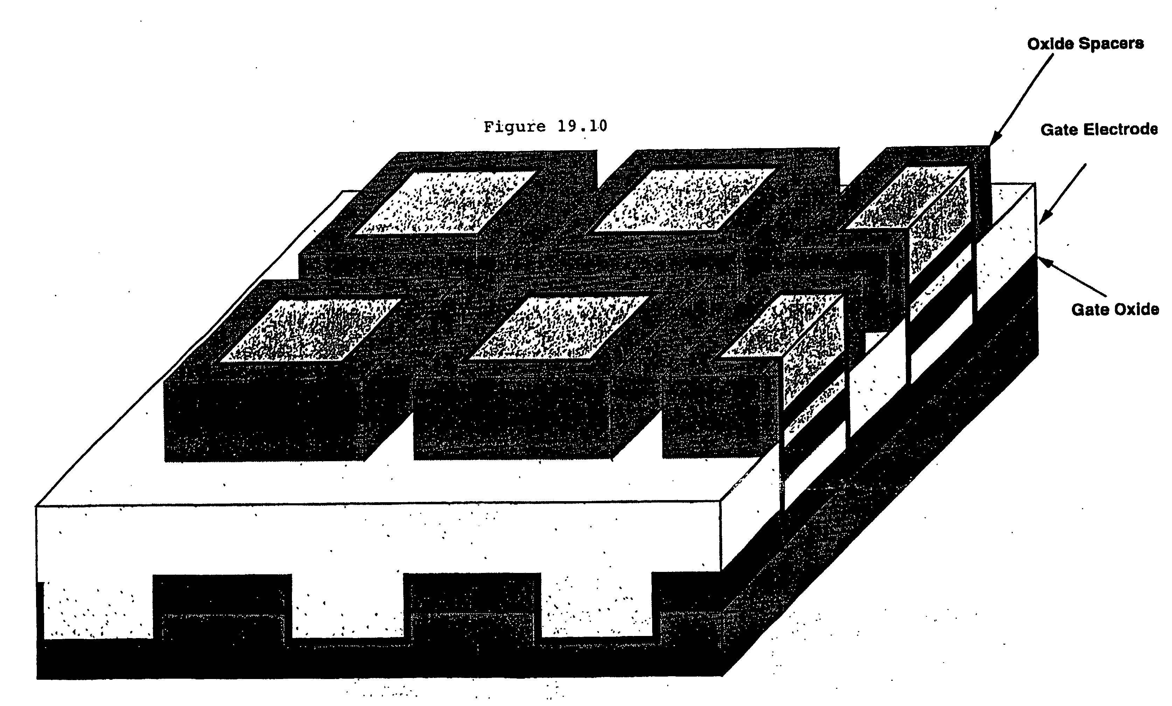

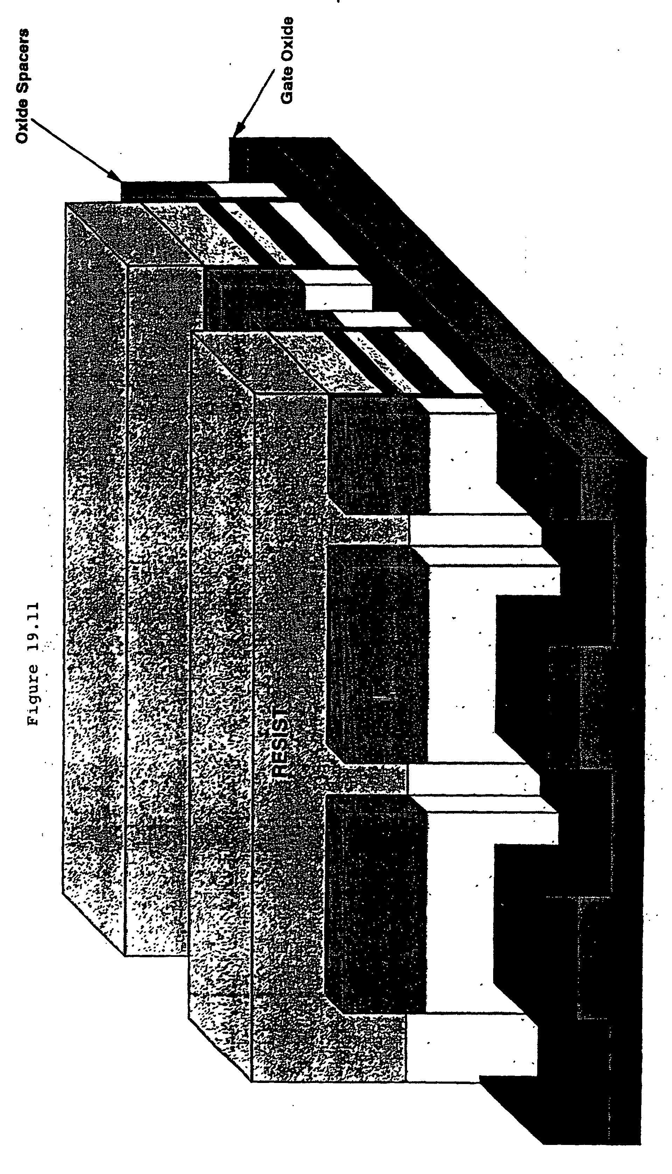

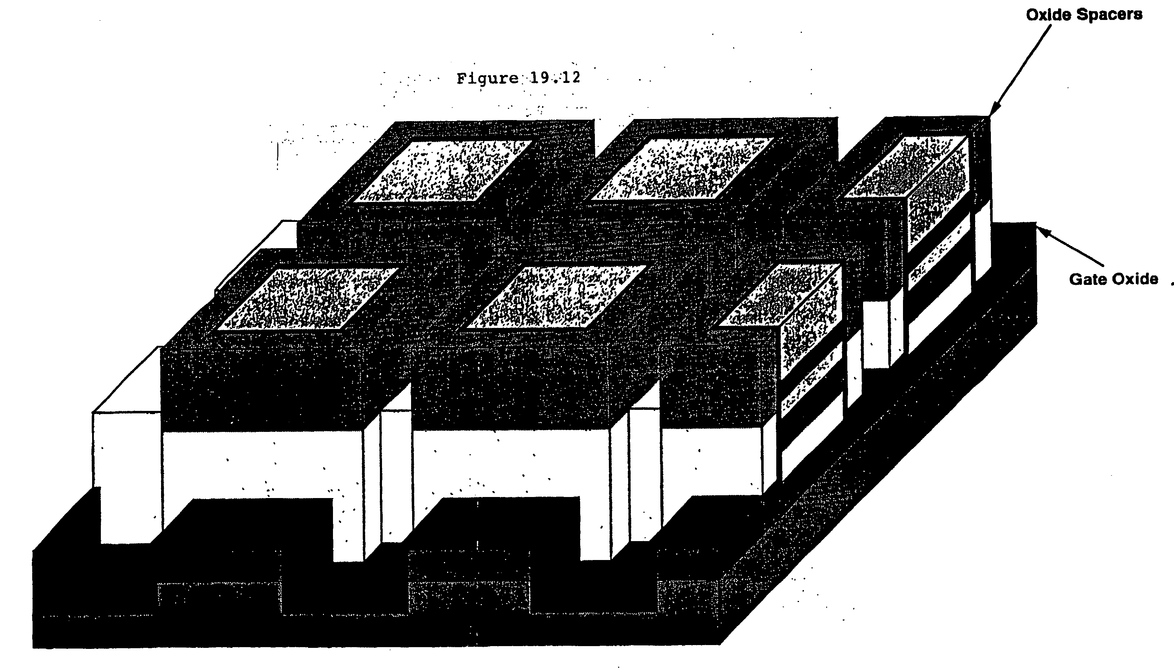

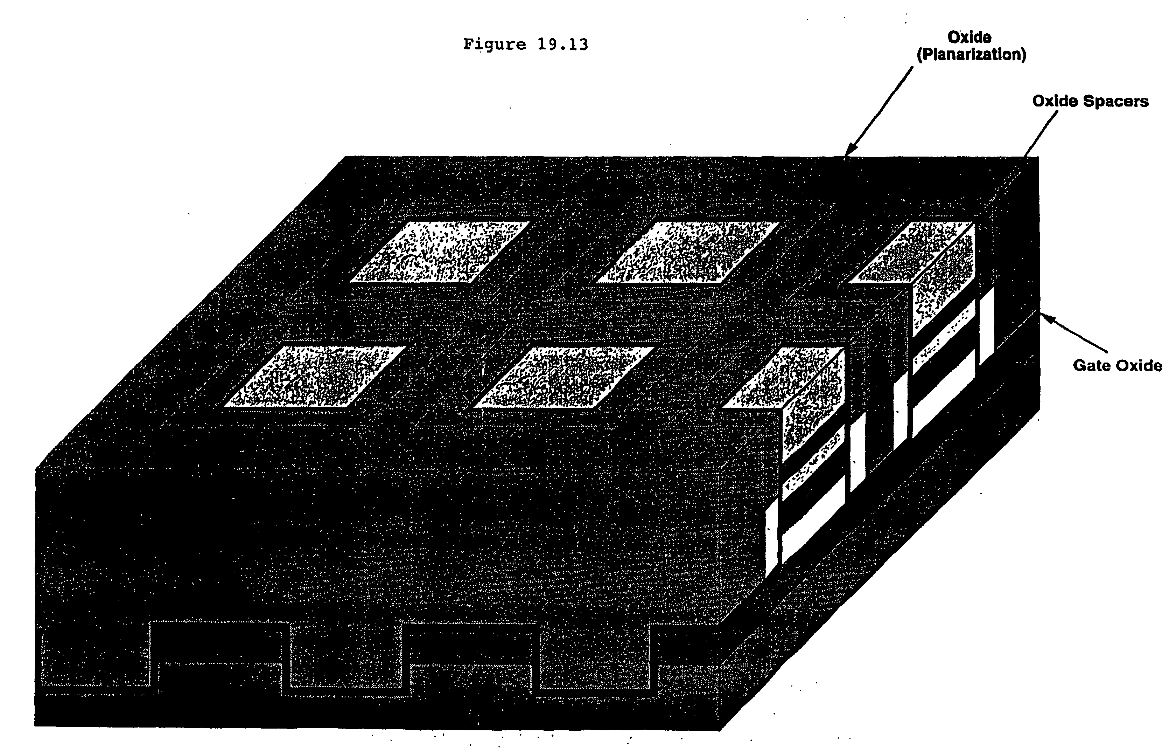

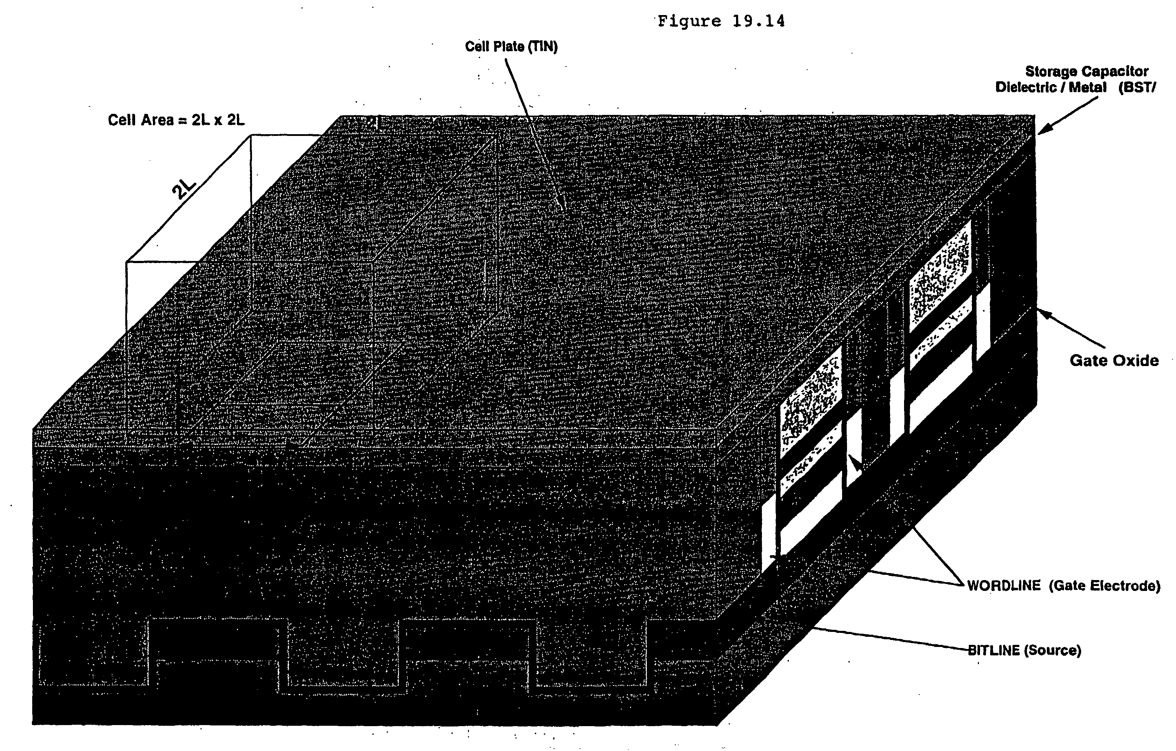

**FIG.19.7** (a deposited oxide is shown)
17) Deposition of a gate electrode [poly SiGe (Ge % can be from 0 to 100%) or metal].
18) Etchback of gate electrode, stopping on the gate dielectric on top of capacitor.
**FIG.19.8**
19) Controlled recess of the gate electrode. If the gate electrode is poly Si or SiGe (or even just Ge), low temperature, (PE ?) oxidation can be used. If the gate electrode was a metal (W for example), then a simple etchback could be used.
     The recess should go below the bottom capacitor electrode.
**FIG.19.9**
20) If the gate electrode recess was done through poly oxidation, then this oxide must be removed (HF dip or vapor for example)
21) CVD and etchback of oxide, to make spacers. This thickness, being larger than the stepper's overlay accuracy, will define the width of the trench between the gates of the different cells. It also makes possible the gate all around.
**FIG.19.10**
22) Litho (MASK4: Resist lines to protect the BITLINES).
23) Selective dry etch of gate electrode (against oxide spacers).
**FIG.19.11**

24) Resist strip.
**FIG.19.12**
25) Planarization by oxide deposition (and/or SOG), and etchback.
**FIG.19.13**
26) Deposition of metal (cell plate)
Cell plate common to all capacitors
**FIG.19.14**

Contacts to the bitlines and word lines can be etched through the cell plate. Appropriate care must be taken to avoid a short between the cell plate and those contacts. Such is possible through the formation of spacers inside the contact holes, prior to the formation of the conductive plug. This way, the patterning of the cell plate is not necessary.

2. Two transistors and one capacitor (2T + 1C) new cell

Also, a new design has been developed with two (complementary) transistors and one capacitor (2T cells). Such cell allows the doubling of the dynamic range of the applied bias at the capacitor's plates. With planar technologies, the second transistor in the cell would imply an area penalty, which might not be justifiable. With vertical transistors (PMOS and NMOS) stacked upon each other, and with the capacitor (insulator) in-between them, there is no area penalty, and the fabrication of the cell is highly self-aligned.

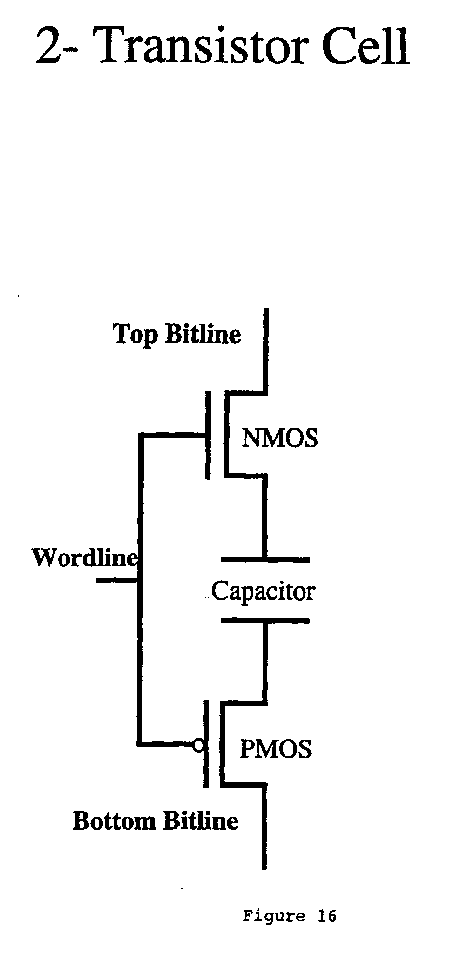

Figure 16 shows the schematic of the cell, which in fact is very suitable to store analogue signals. The operation of this cell is the following :

*Write operation :*

Btl1 (Source of the Top Transistor - NMOS)

= value to be written

Btl2 (Source of the Bottom Transistor - PMOS)

= value to be written

Wordline (Gate) = 0 --> 1 to turn the NMOS on and bring the Btl1 value to the capacitor top plate (while PMOS is off and therefore the bottom plate is isolated from Btl2)
Wordline (Gate) = 0 --> 1 to turn the PMOS on and bring the Btl2 value to the capacitor bottom plate (while NMOS is off and therefore the top plate is isolated from Btl1)

*Read operation :*

Btl1 (Source of Top Transistor - NMOS) = read mode

Btl2 (Source of Bottom Transistor - PMOS) = read mode

Wordline (Gate) = 0 --> 1 brings Btl1 to the potential of top plate (bottom plate is isolated from Btl2)
Wordline (Gate) = 0 --> 1 brings Btl2 to the potential of bottom plate (top plate is isolated from Btl1)

The new T2 cell will also markedly improve performance of Multiple Value (MV) RAMs. The reason for this increase is that the dual transistor cell doubles the voltage across the capacitor by providing both polarities, and therefore the number of multiple voltage levels can also be doubled.

Furthermore, if the capacitor's insulator has ferroelectric properties, there is no need for changes in the flow in order to have a Ferroelectric Random Access Memory (FRAM). The dual MOSFET cell is highly desirable for FRAMs because it provides positive and negative polarities to the capacitor plates. This is a highly useful feature for circuits with such materials.

Since the 2T Cell includes NMOS and PMOS and since they are in a configuration where the Front-End is processed in the same way as in Vertical integration of Vertical MOSFETs, both cell and logic transistors are made simultaneously. This is achieved without any duplication of process steps. All process steps like epitaxy, etch of vertical structures, gate stack formation, planarization, etc., are done only once. The differentiation is introduced when contacts and interconnects are made. For cell transistors, only the sources and gates are contacted (each drain faces a plate of the capacitor). For logic transistors, drains can also be contacted. For the bottom transistor, this means a contact hole etch through the capacitor. This represents a huge process simplification and cost saving compared to standard DRAM fabrication.

These enhancements are independent of the ways the transistors are fabricated : ion implantation, solid phase recrystallization, poly transistors, fully epitaxial CVD (or other methods), etc., and also of the substrates used (Bulk or SOI). Due to the intrinsic nature of each of these processes, it is natural to expect maximum electrical performance if those transistors are fully epitaxially grown. Maximum electrical performance can be directly translated into the number of multiple voltage levels possible, for a given voltage supply.

The fabrication of the two-transistor cell (2T cell) is ideally achieved with the capacitor's dielectric being epitaxially compatible with silicon. In that case, the process flow would start wide the epitaxy of the bottom transistor layers, followed by the epitaxy of the insulator, and by the epitaxy of the top transistor layers. The epitaxy approach has the added advantage that an epitaxial insulator will be able to withstand far more write/read cycles than silicon dioxide for example (1E06). This will in turn allow more applications.

A second possibility is with wafer-bonding. In this case, PMOS and the NMOS would be epitaxially grown on two separate wafers, and then bonded together, with the insulator sandwiched between them. In this case, it seems that it is also possible to have single crystal (ferroelectric or not) insulator.

A third alternative is to make the top transistor as a poly transistor, where in-situ doped poly layers would be deposited sequentially on the capacitor's dielectric to form the active regions of the transistor.

In all cases, the entire process to make the cell is self-aligned for both transistors and for the capacitor. In all cases also, both transistors can have two (source/channel and channel/drain) or of Multi-Junction type.

Since all the processing is identical until Back-Ends the difference between a logic circuit with some memory and a memory circuit with some logic, is that for the first one, the voltage supply will be lower, and therefore, the number of junctions in a transistor will be low (or the minimum), and so will be the number of values possible to store in the capacitor. For the memory, the number of storage levels is maximised and therefore all transistors in the memory cell and CMOS logic are of the Multi-Junction type. Naturally there might be a limit on the number of logic transistors, due to power dissipation.

In fact, the process flow for the 2T cell, can simplify and unify the fabrication of logic, memory and power transistors in a single die. The power dissipation problem affecting Multi-Junctions can be solved by having Multiple-Heterojunctions in place of Multiple-Homojunctions, due to the fact the current can be ballistic at room temperature, if Vertical Multi-Heterojunction MOSFETs are used.

Assuming a stepper with 0.3S μm resolution for dense lines and spaces, the area of a cell is given by:

$$A= (2 \times 0.35 \times 2 \times 0.35) = (07 \times 07) = 0.49 \text{ cm}^2.$$

Since $1 \mu m^2 = 1E^{-8} \text{ cm}^2$, and since $1 \text{ Giga} = 1E^9$, the area taken by 1 Giga cells is:

$$\text{cells is } 0.49 \ \mu m^2 \times 1E9 = 4.9E^8 \ \mu m^2 = 4.9 \text{ cm}^2.$$

As an example, ASML PAS 5500/100 has 6.028 cm$^2$ field. It is certainly possible to include one Gigabit die and all the necessary logic circuitry in this field.

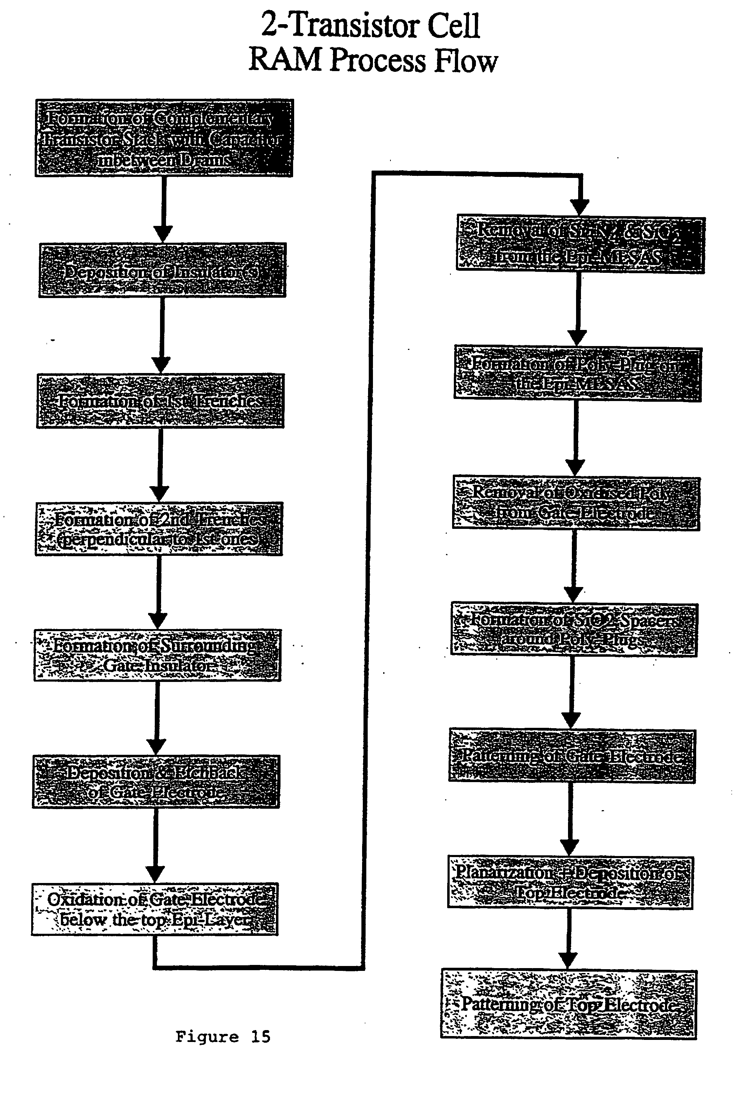

Figure 15 is describing a general process flow for manufacturing Vertical MISFET memory cell according to the second embodiment of the present invention comprising at least the following steps:

- Formation of Complementary Transistor Stack with Capacitor in etween Drains;
- Deposition of Insulator(s);
- Formation of 1st Trenches;
- Formation of 2nd Trenches (perpendicular to 1st ones);
- -Formation of Surrounding Gate Insulator;
- Deposition of Etchback of Gate Electrode;

- Oxidation of Gate Electrode below the top Epi-Layer;
- Removal of $Si_3N_4$ & $SiO_2$ from the Epi-MESAS;
- Formation of Poly-Plug on the Epi-MESAS;
- Removal of Oxidised Poly from Gate Electrode;
- Formation of $SiO_2$ Spacers around Poly-Plugs;
- Patterning of Gate Electrode;
- Planarization + Deposition of Top Electrode;
- Patterning of Top Electrode

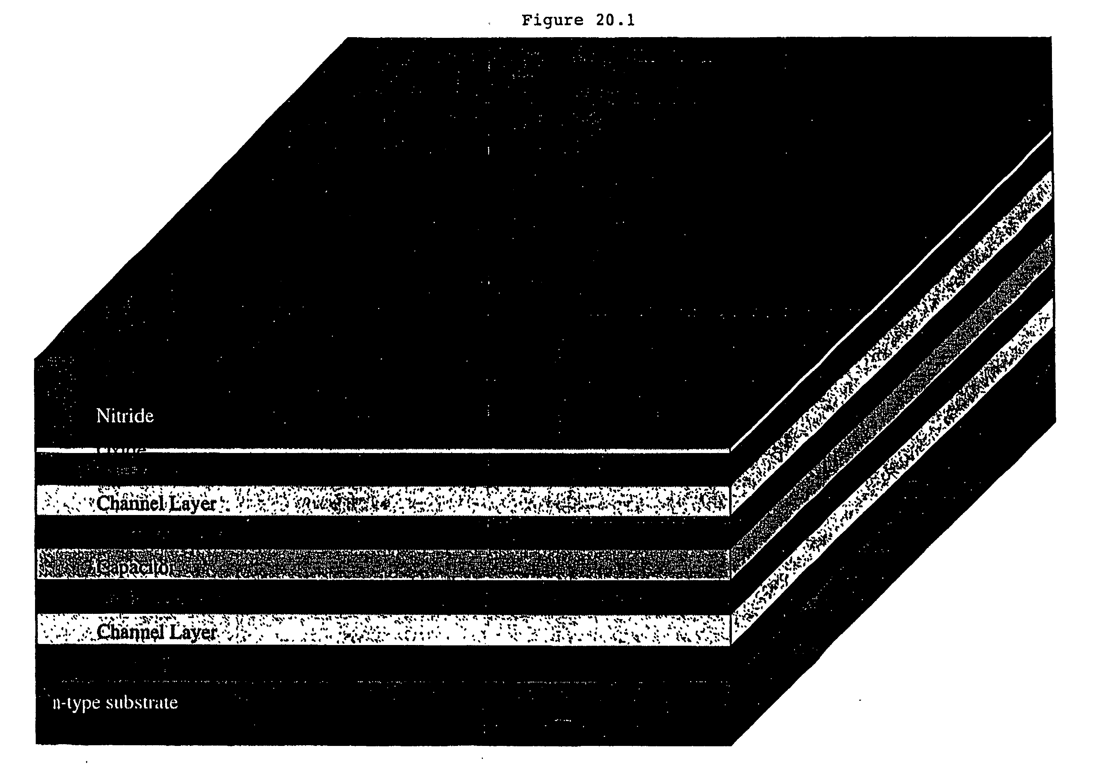

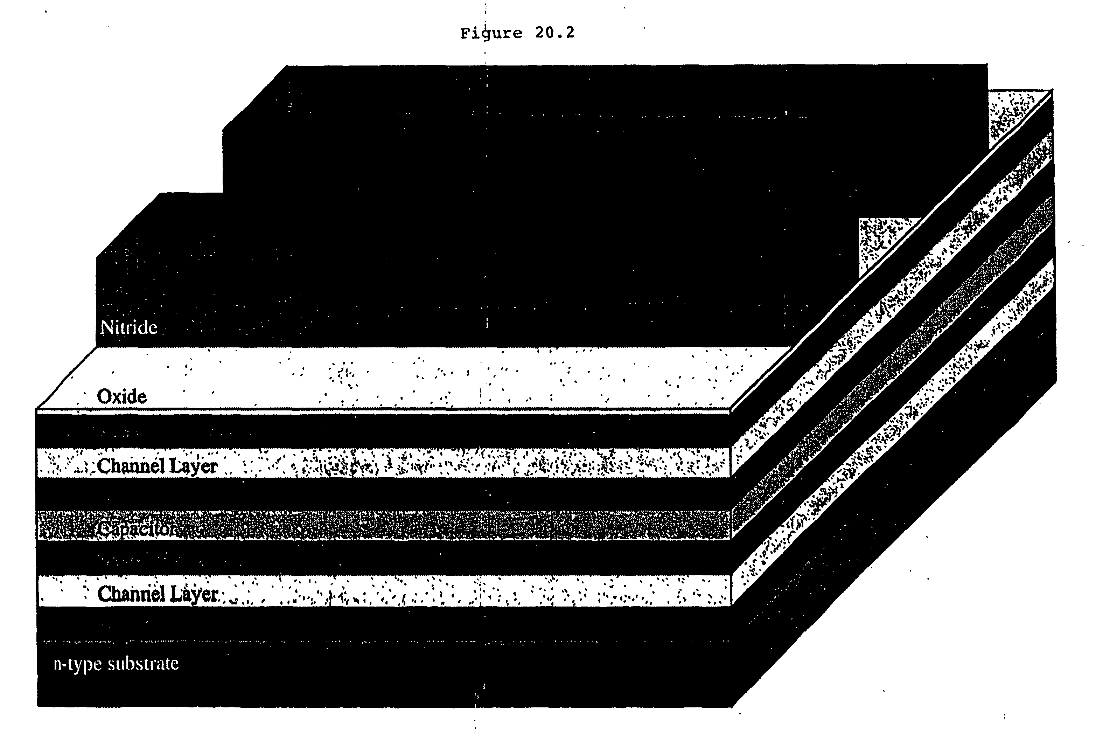

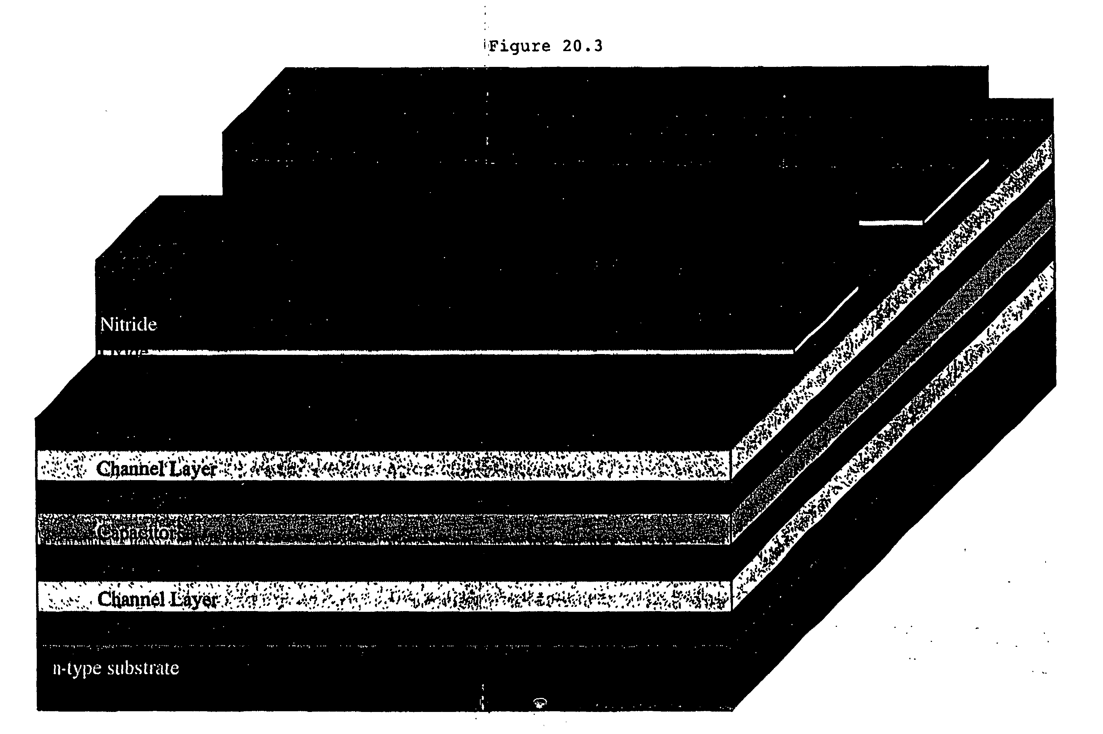

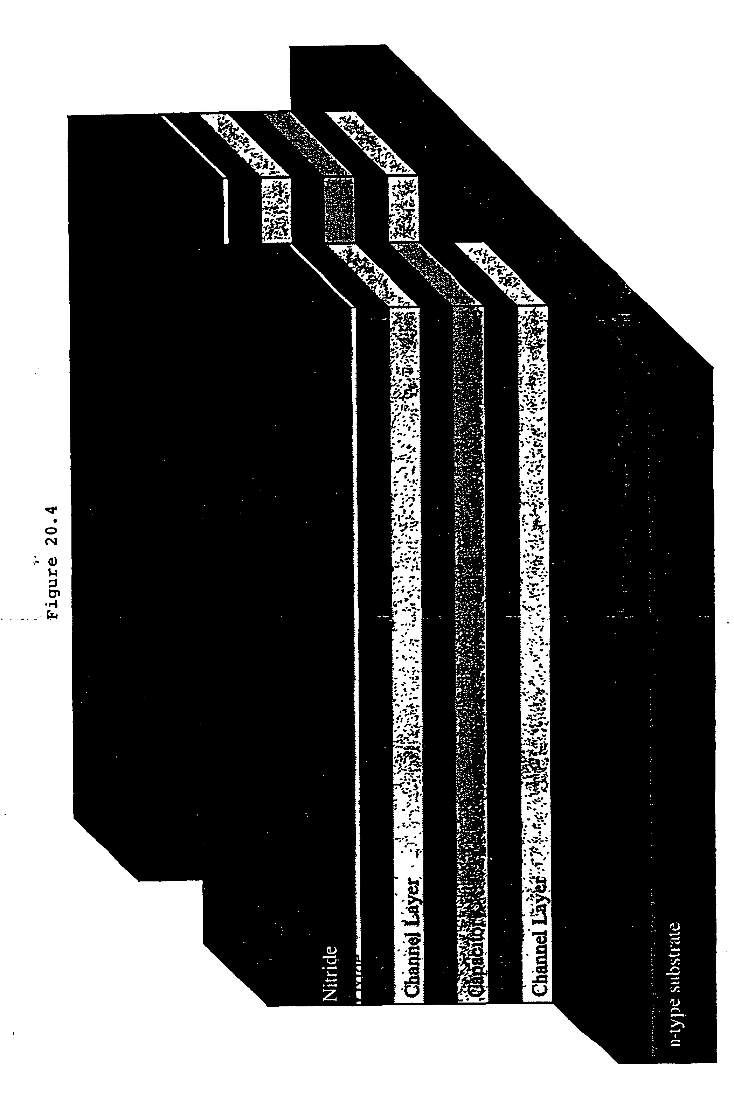

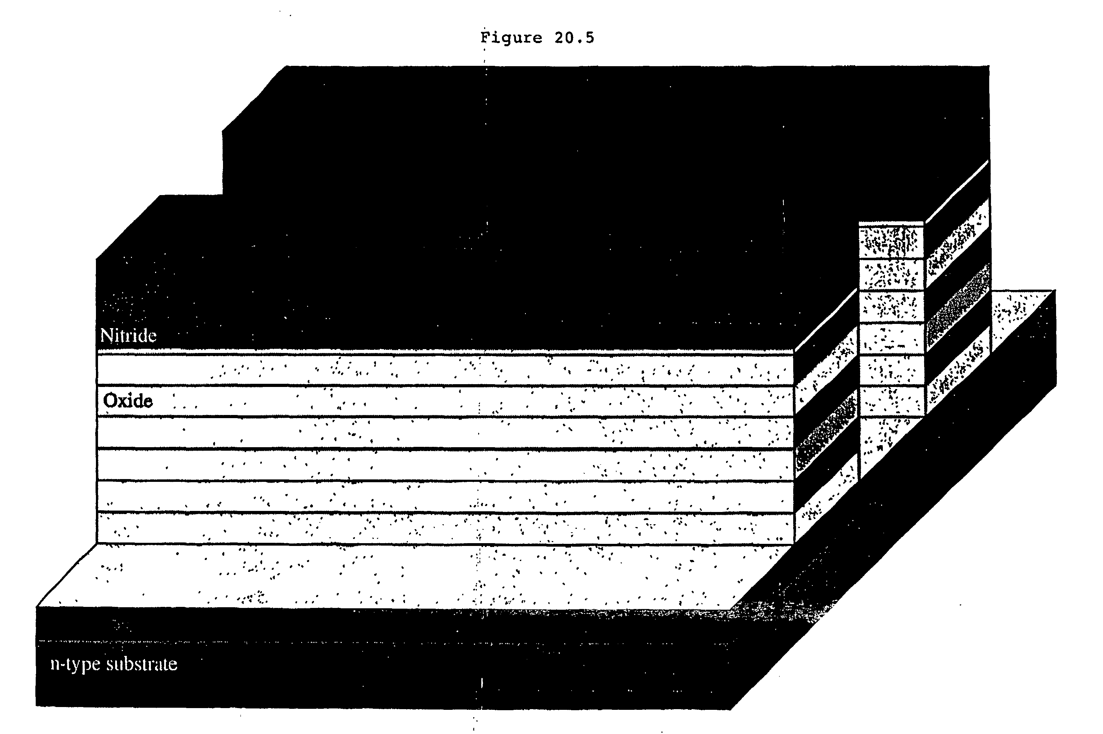

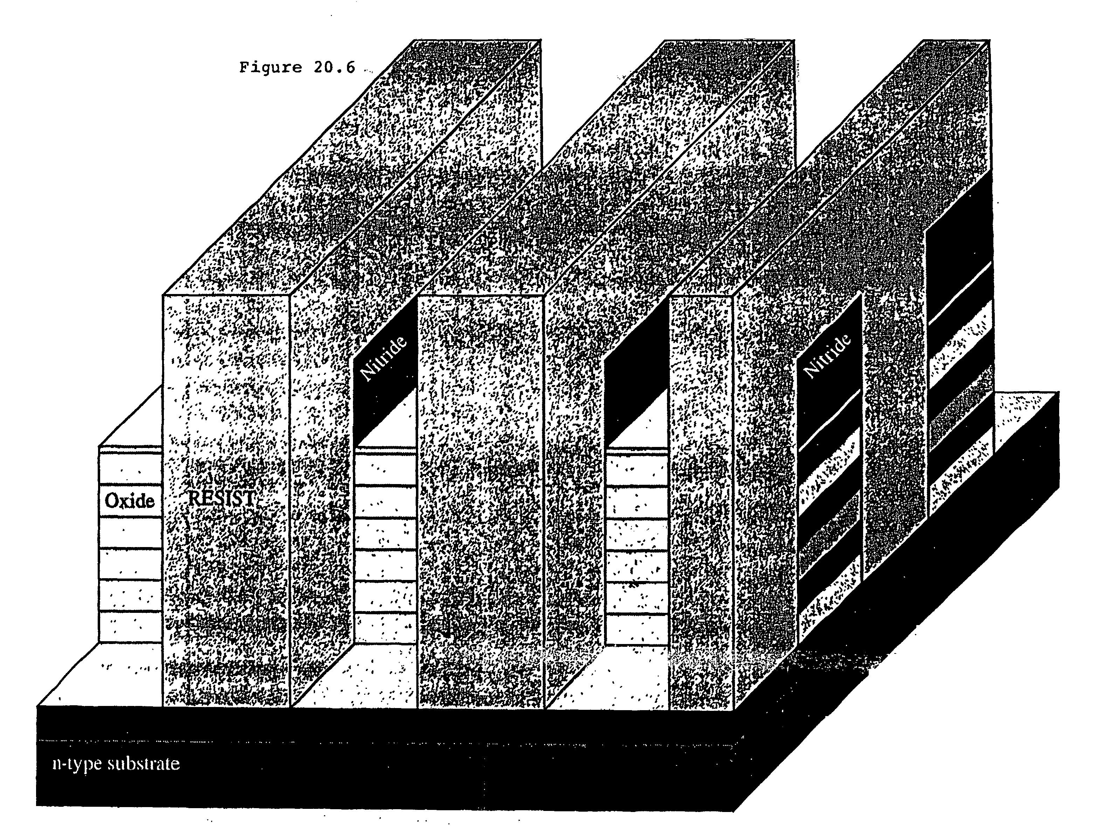

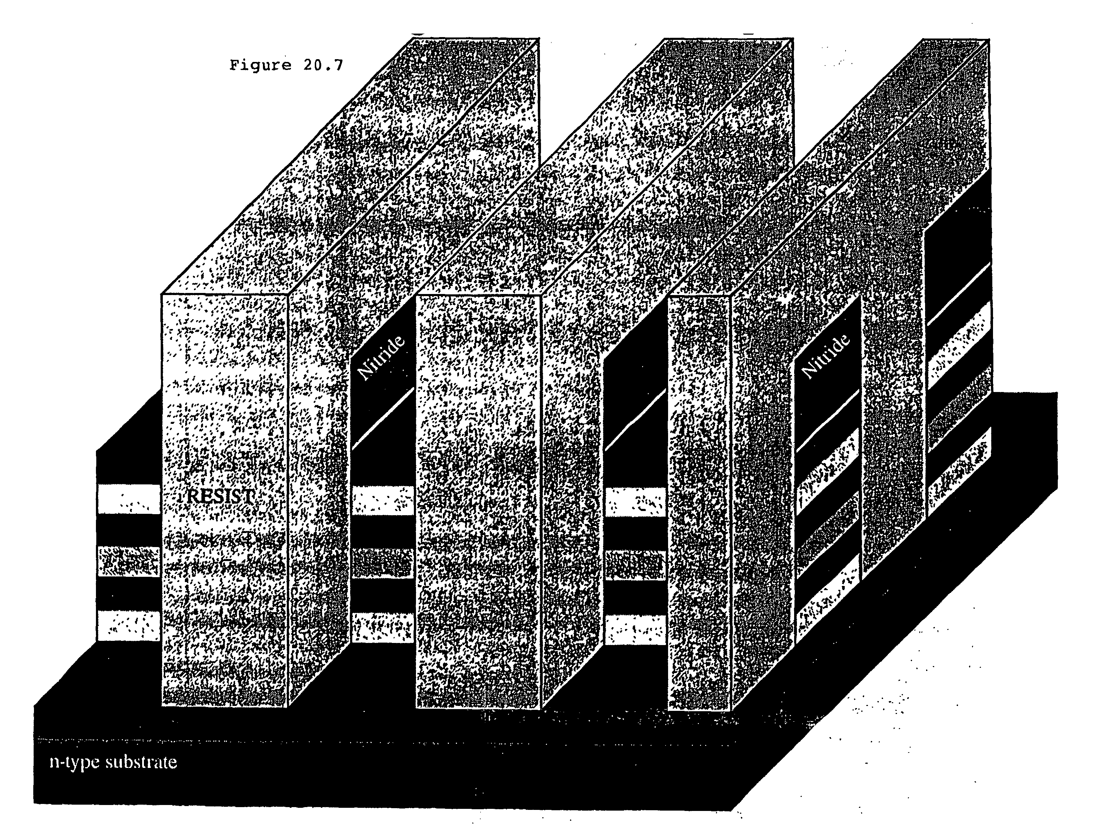

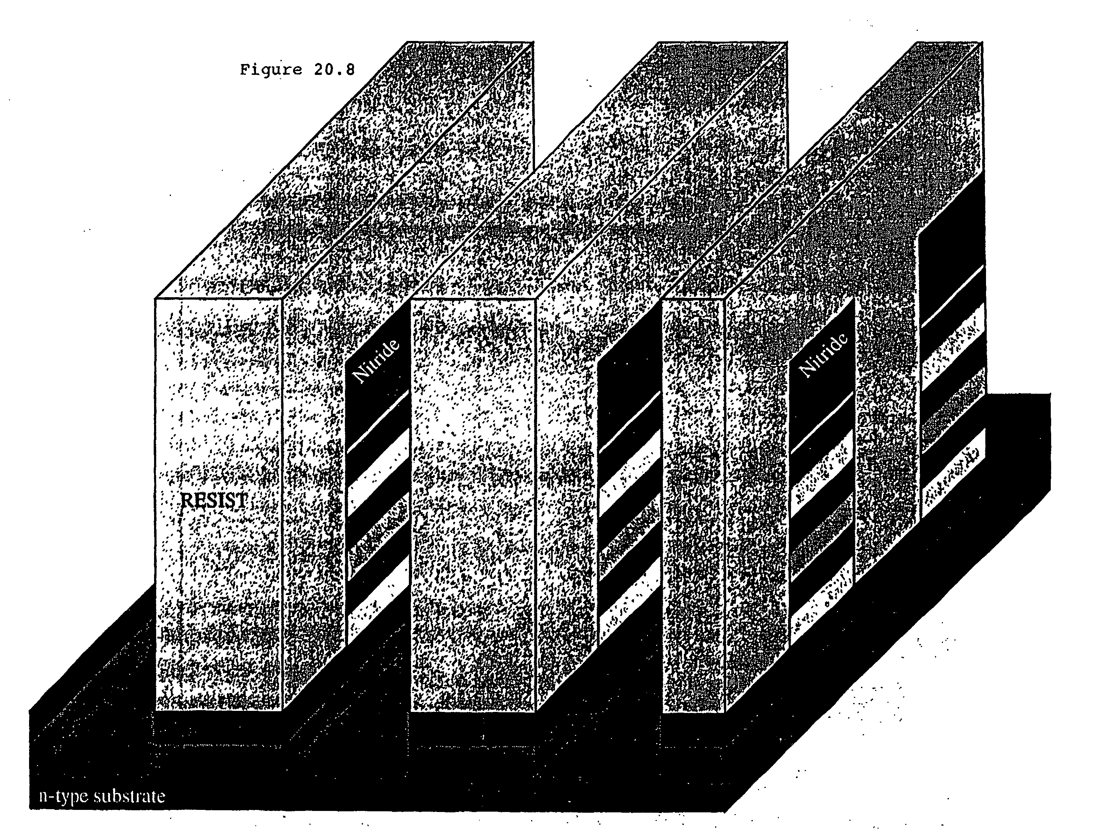

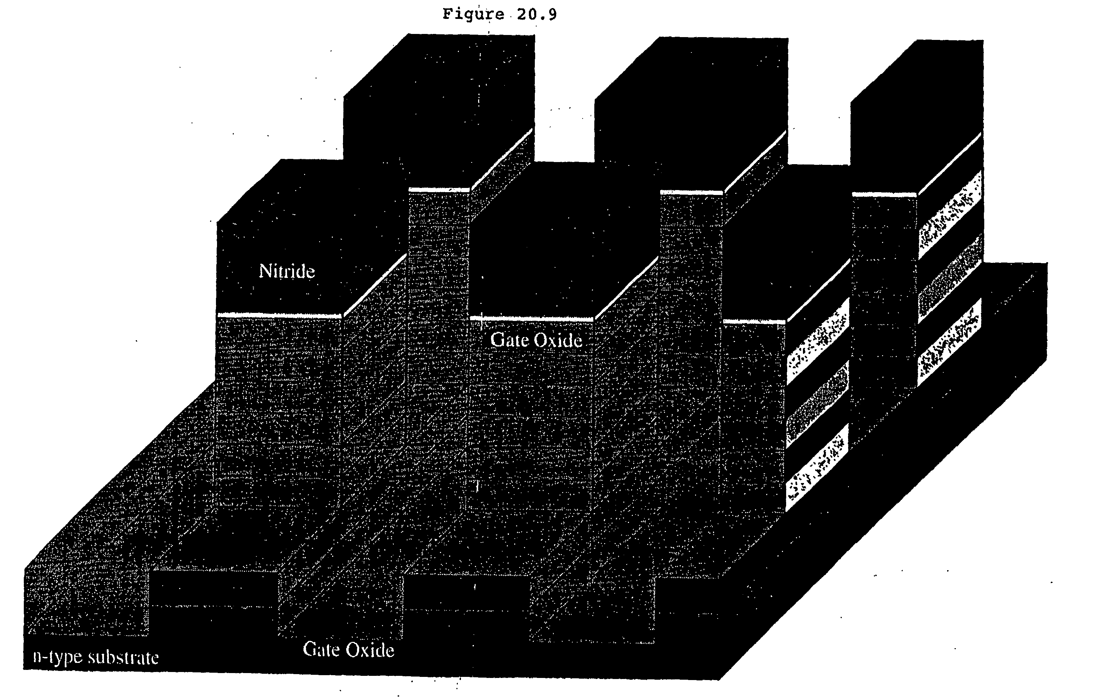

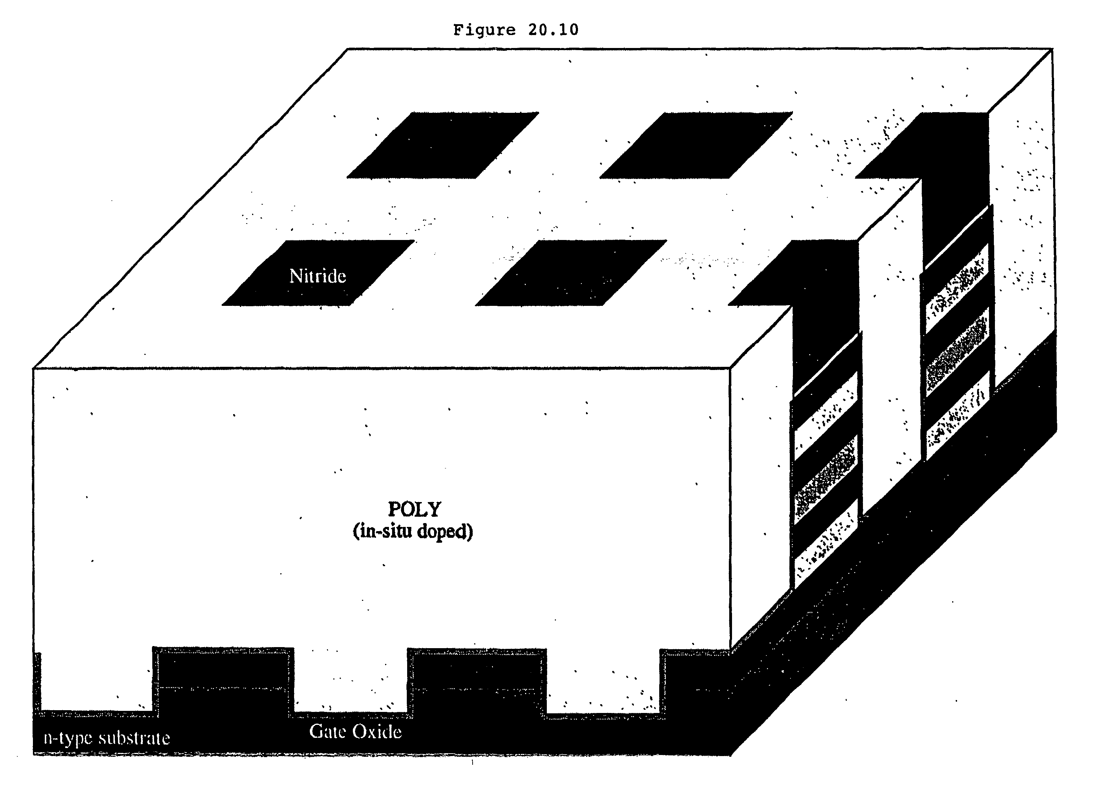

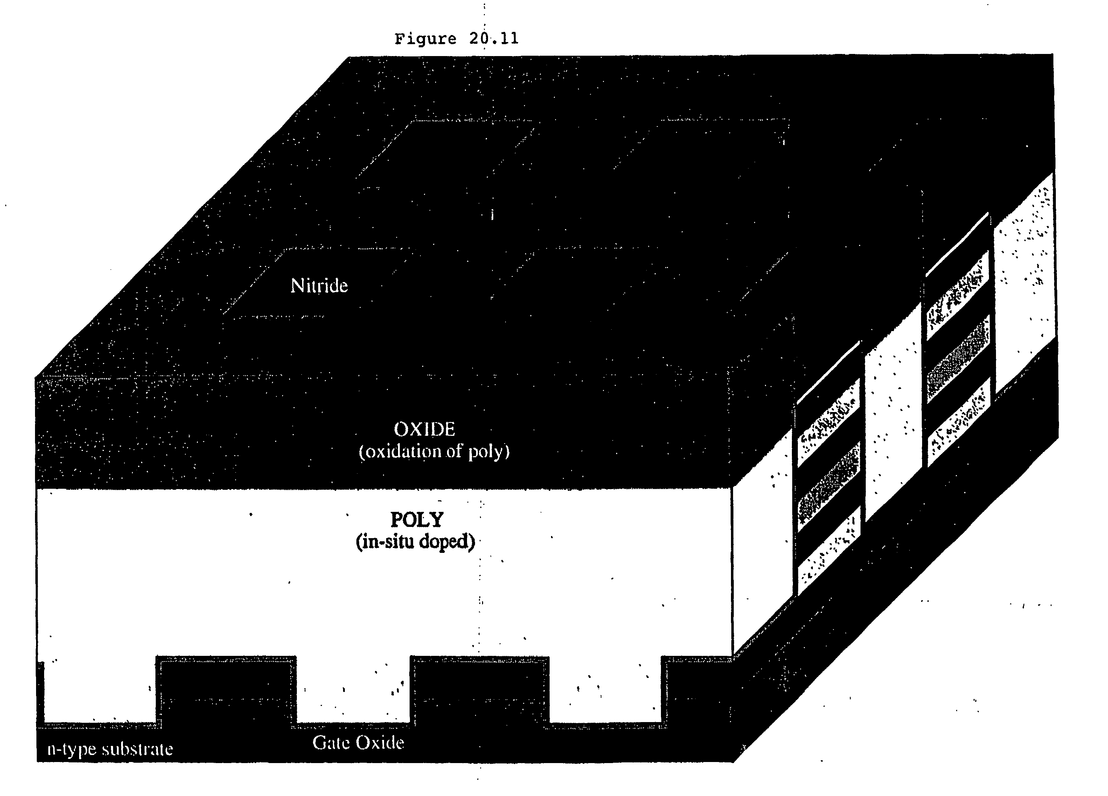

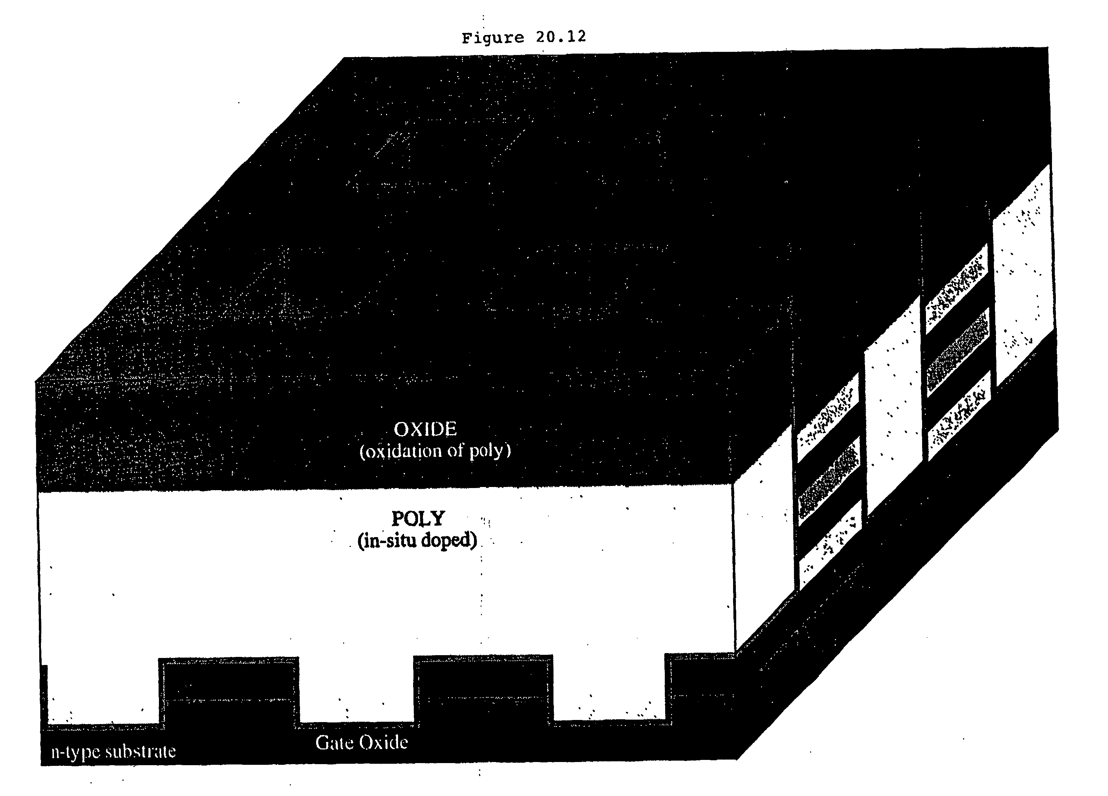

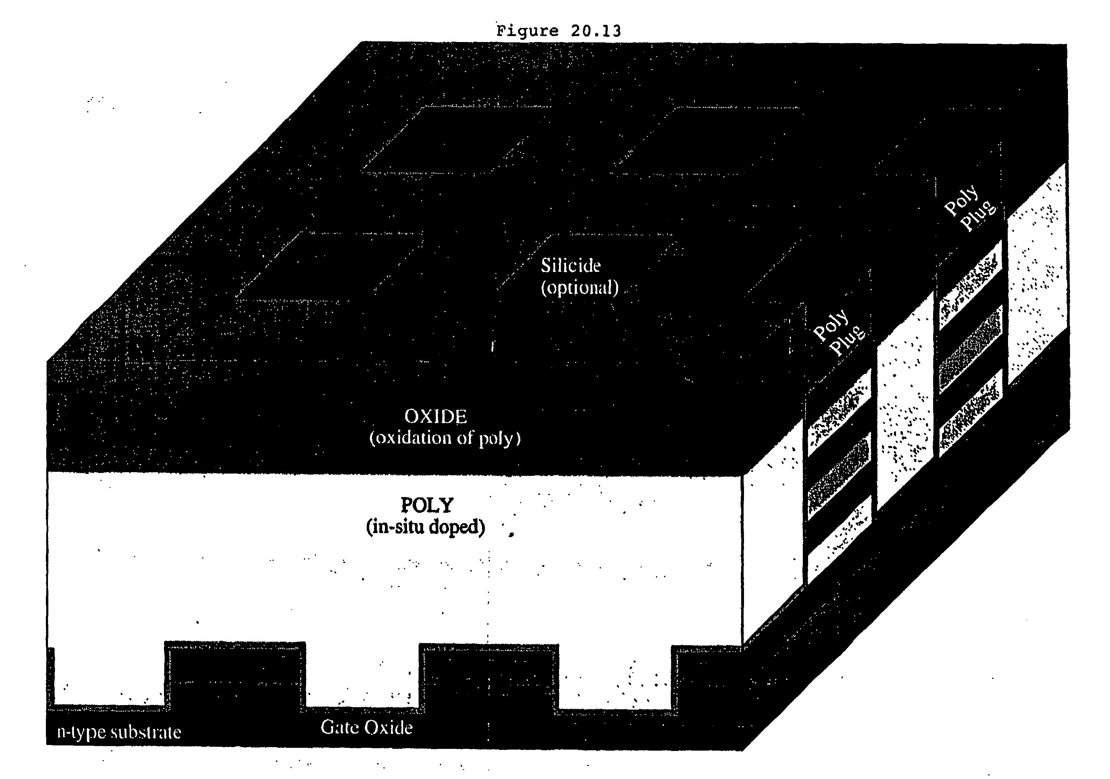

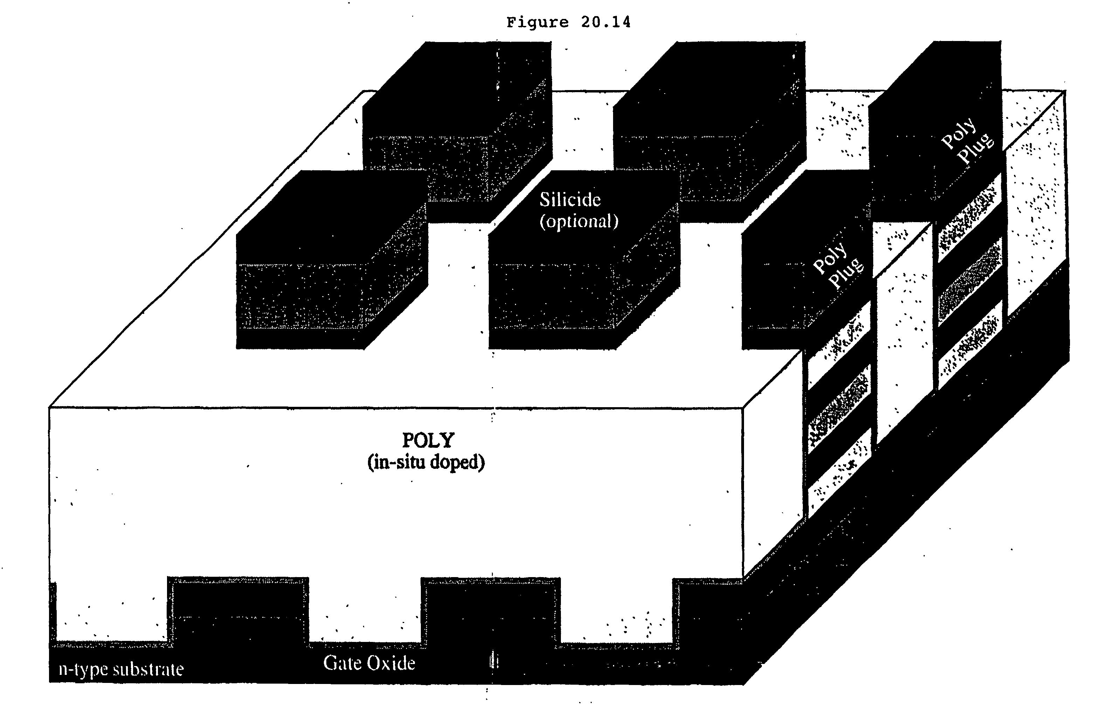

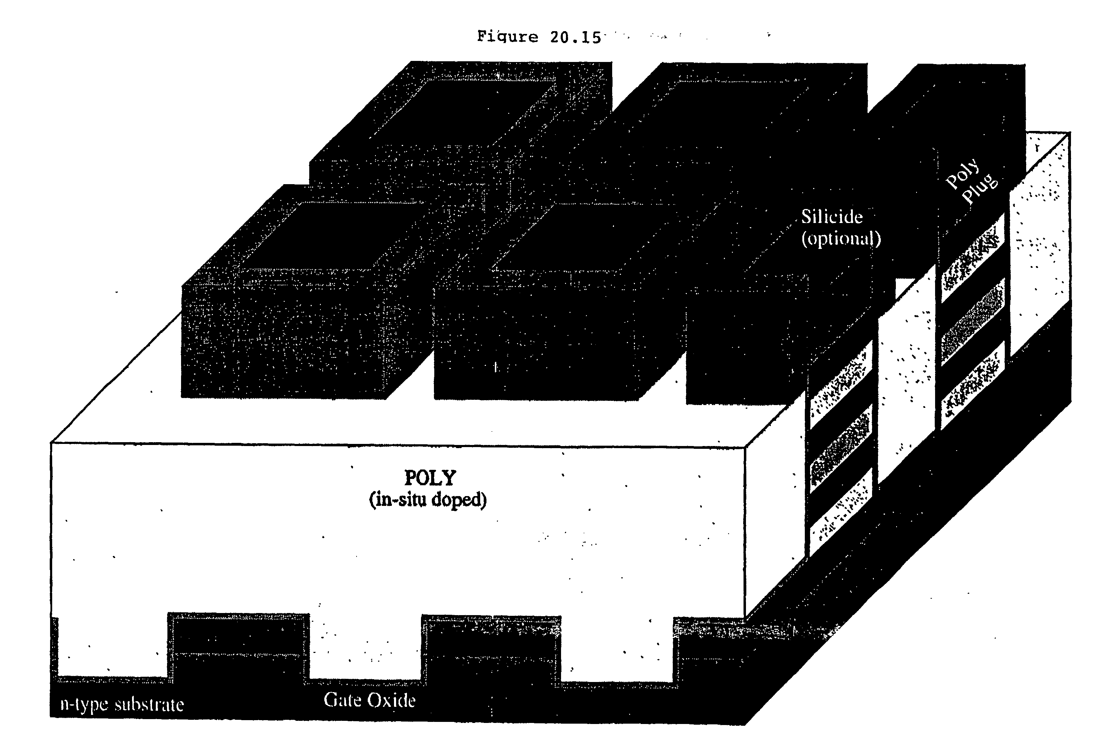

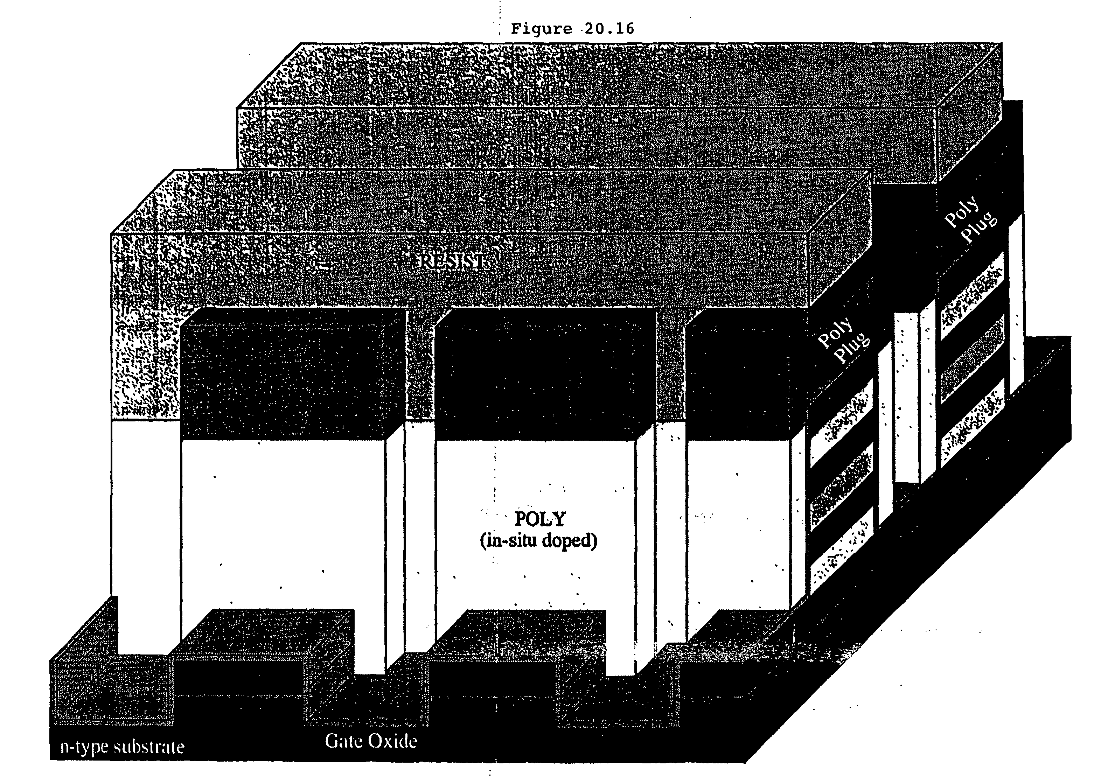

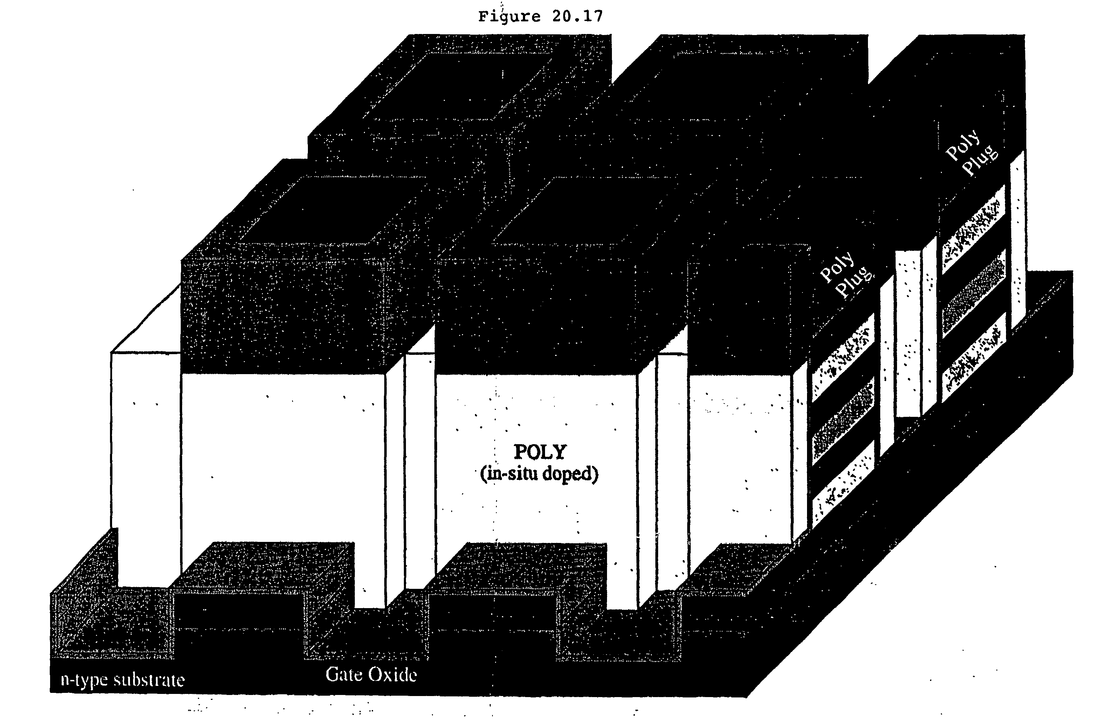

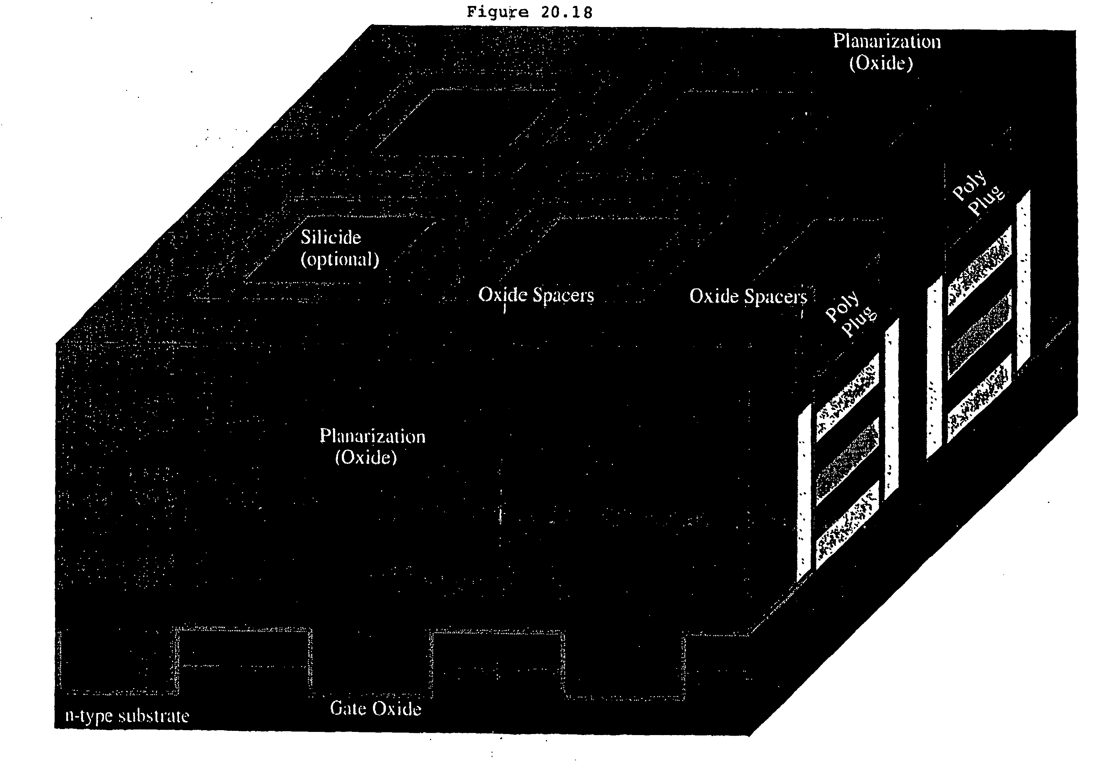

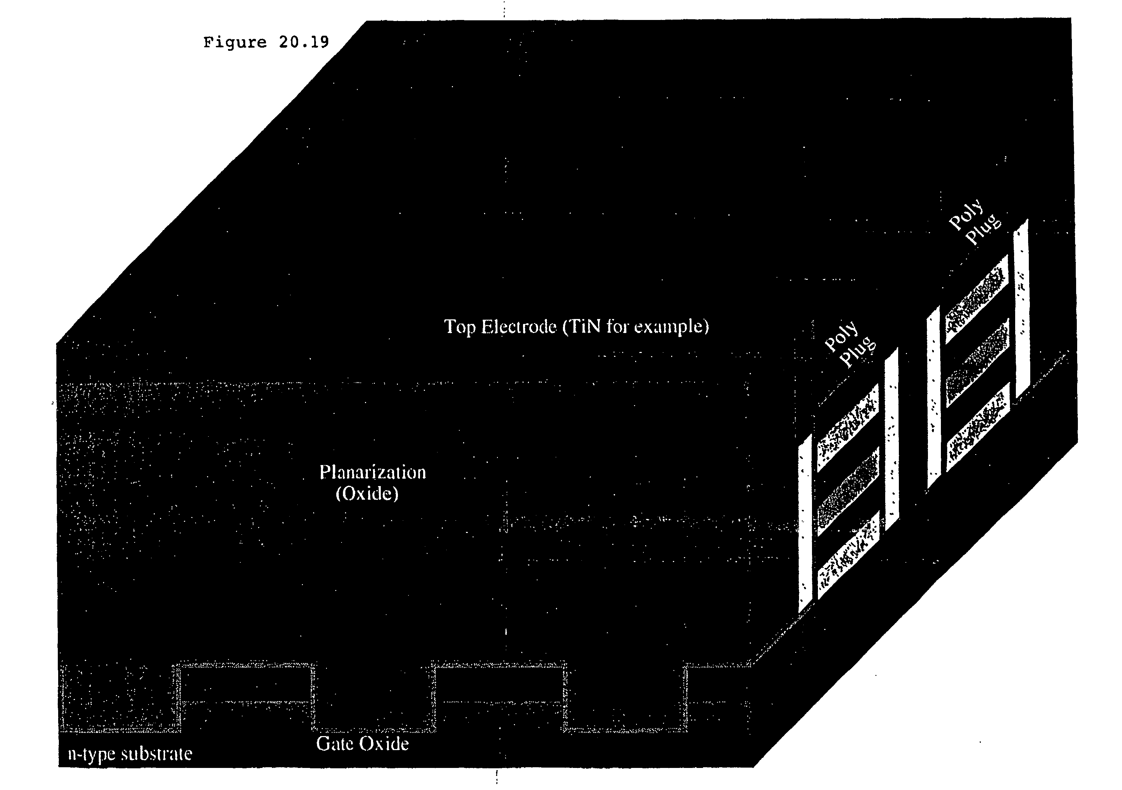

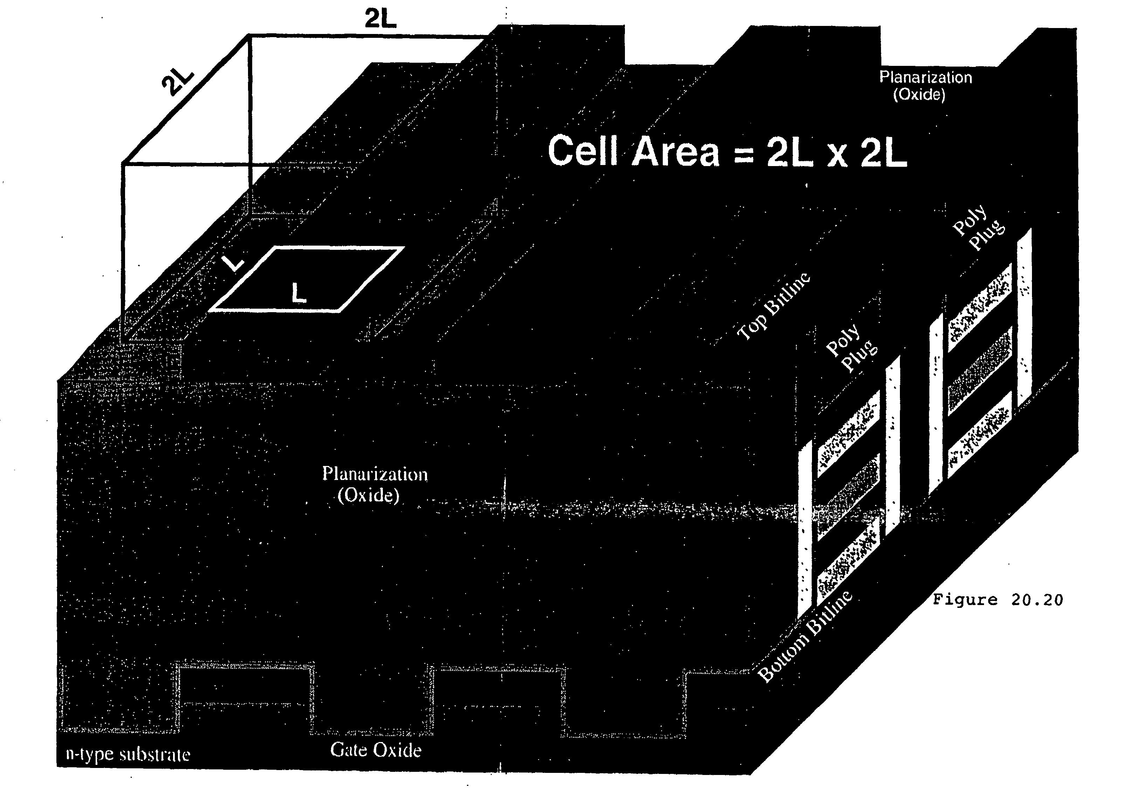

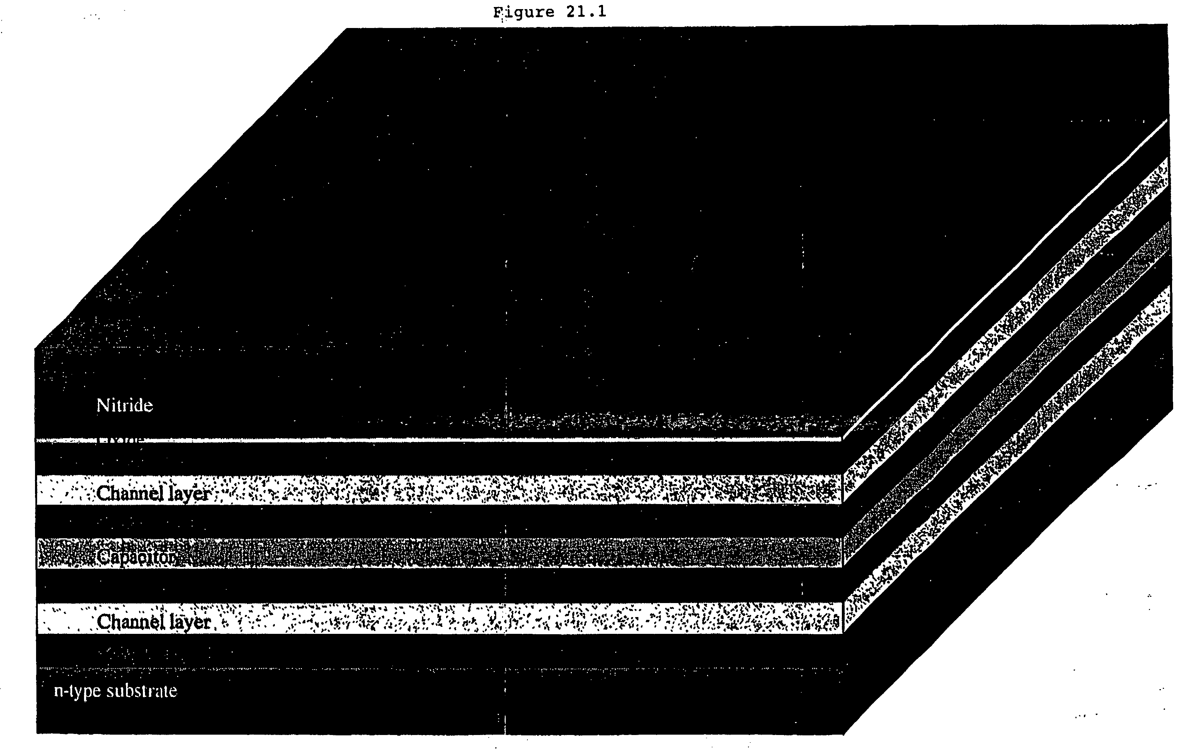

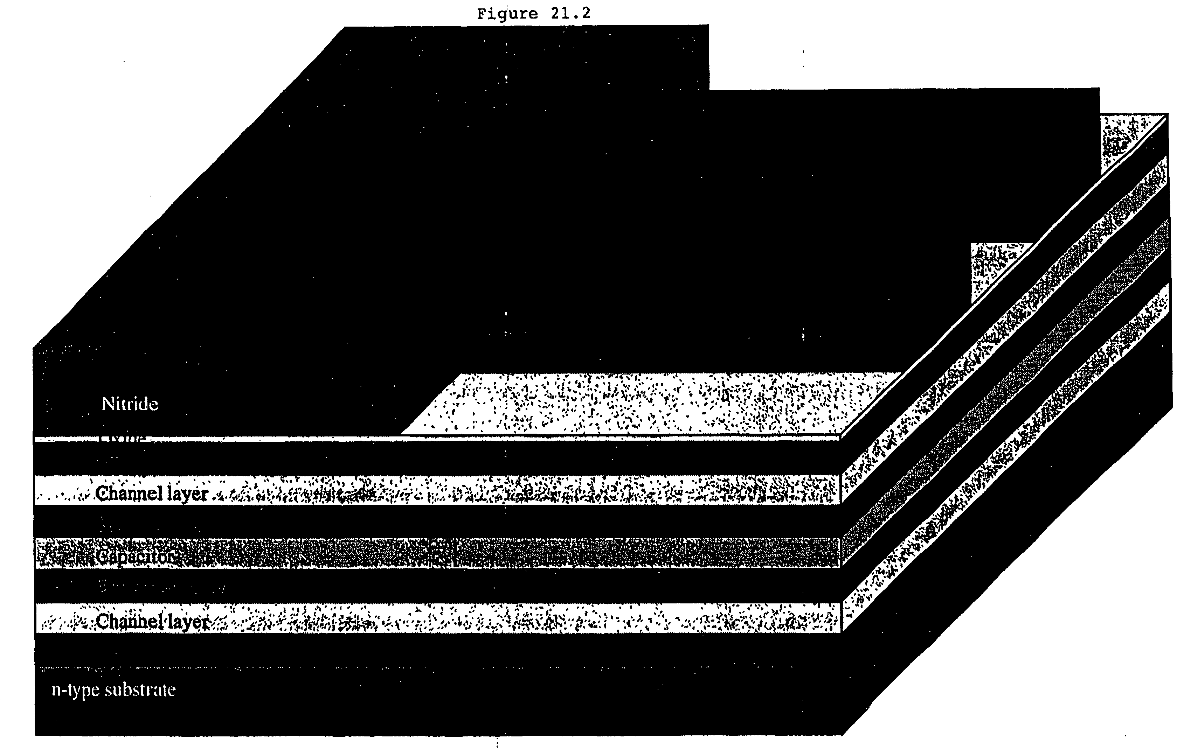

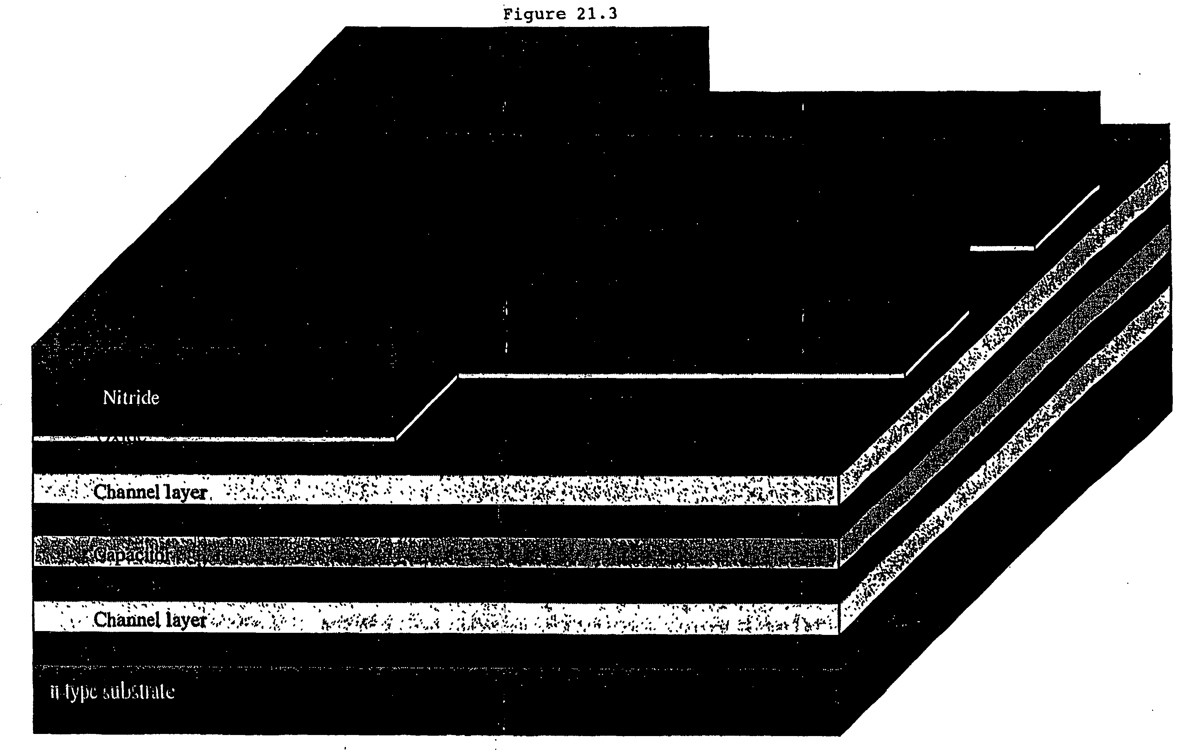

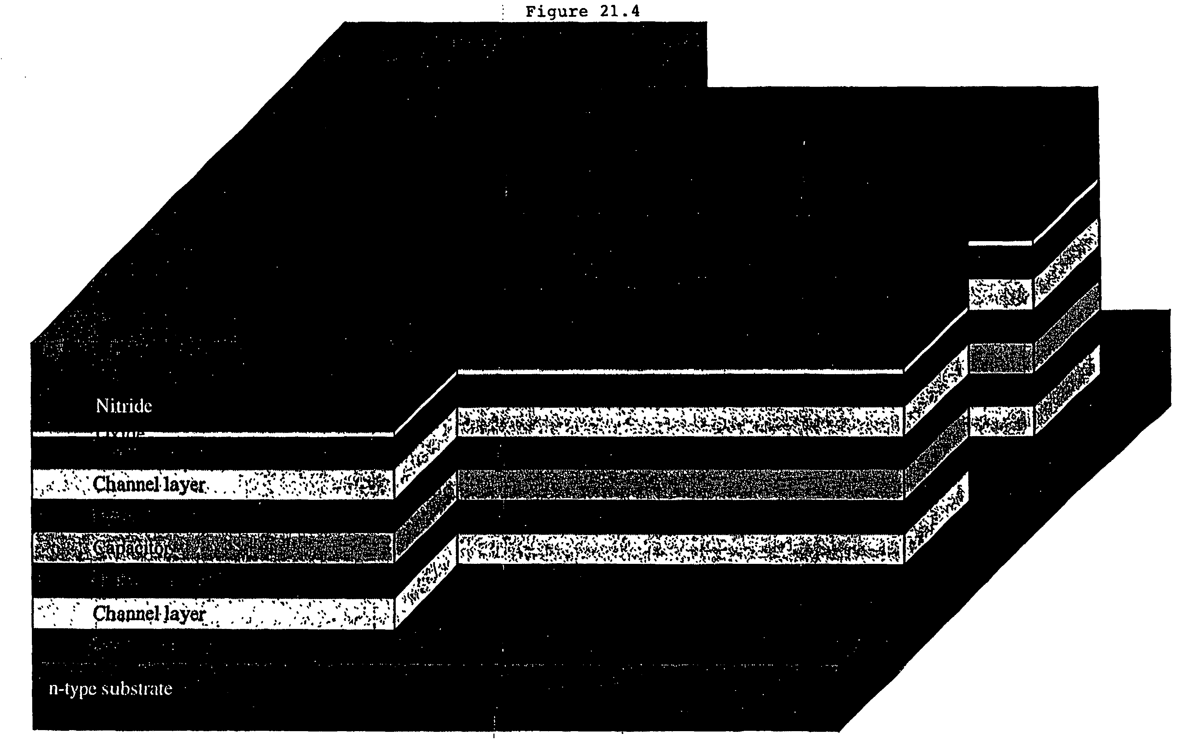

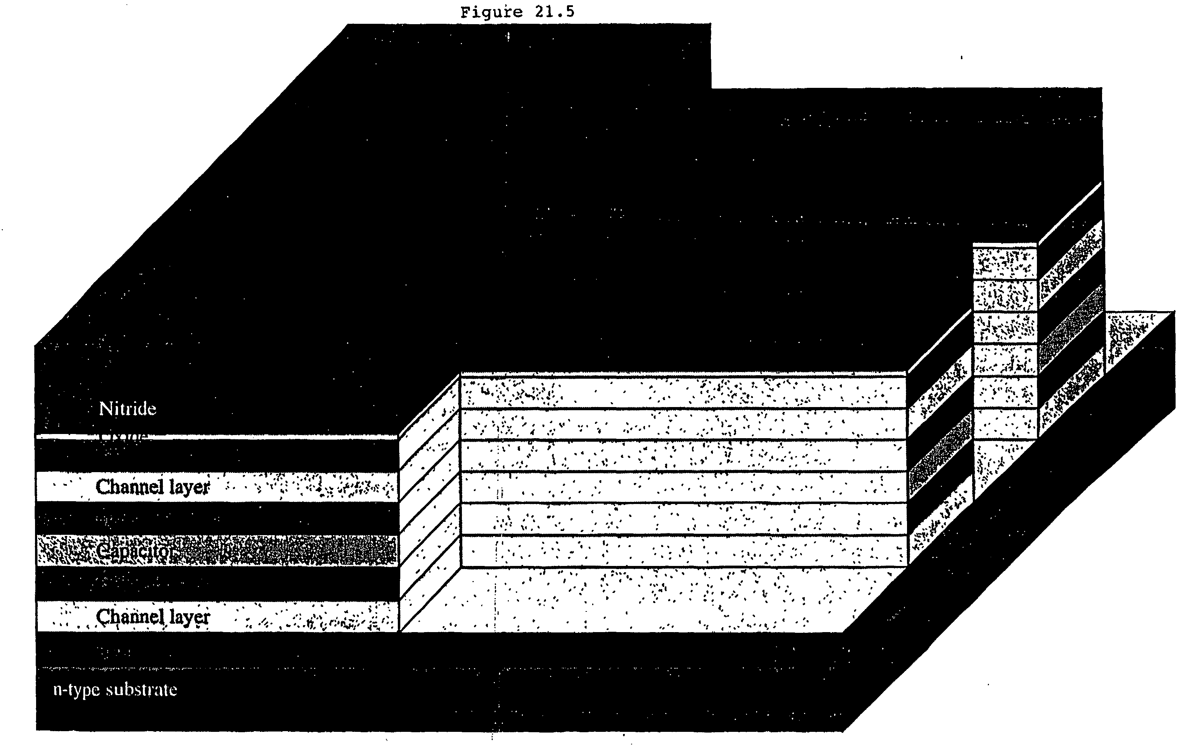

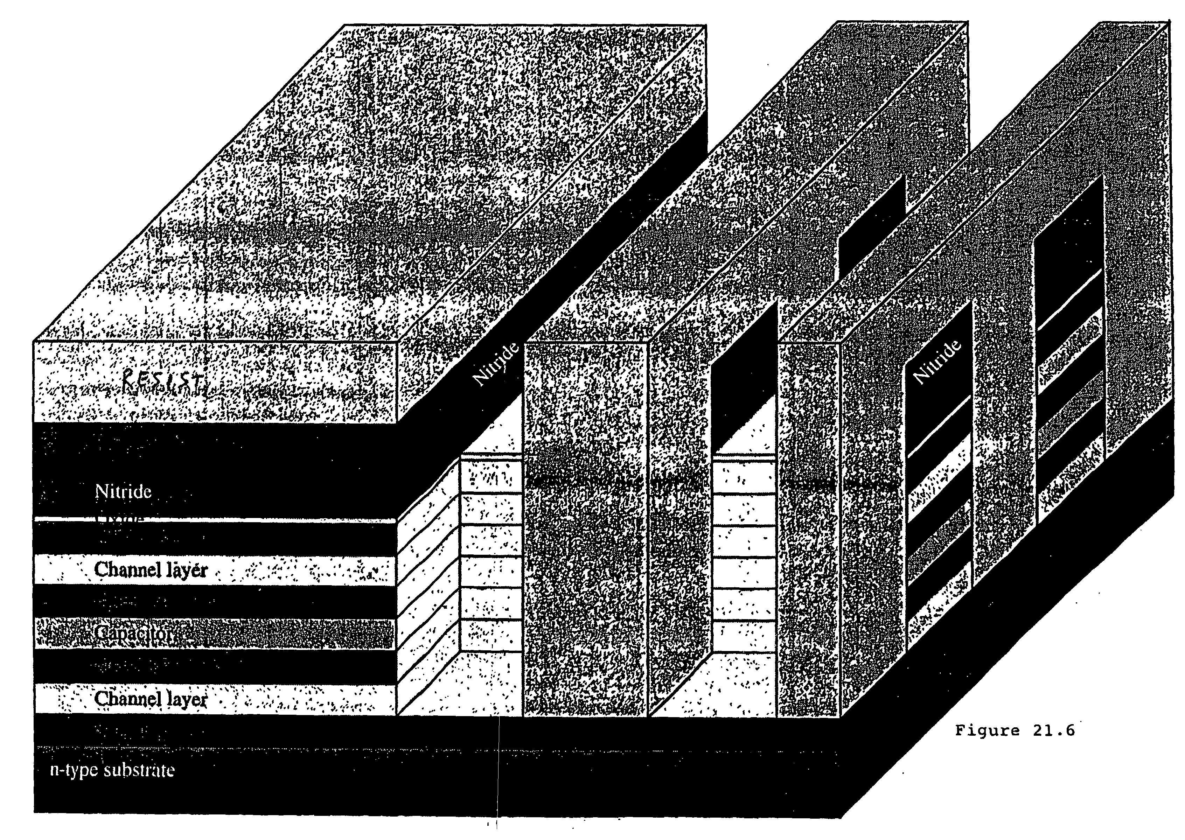

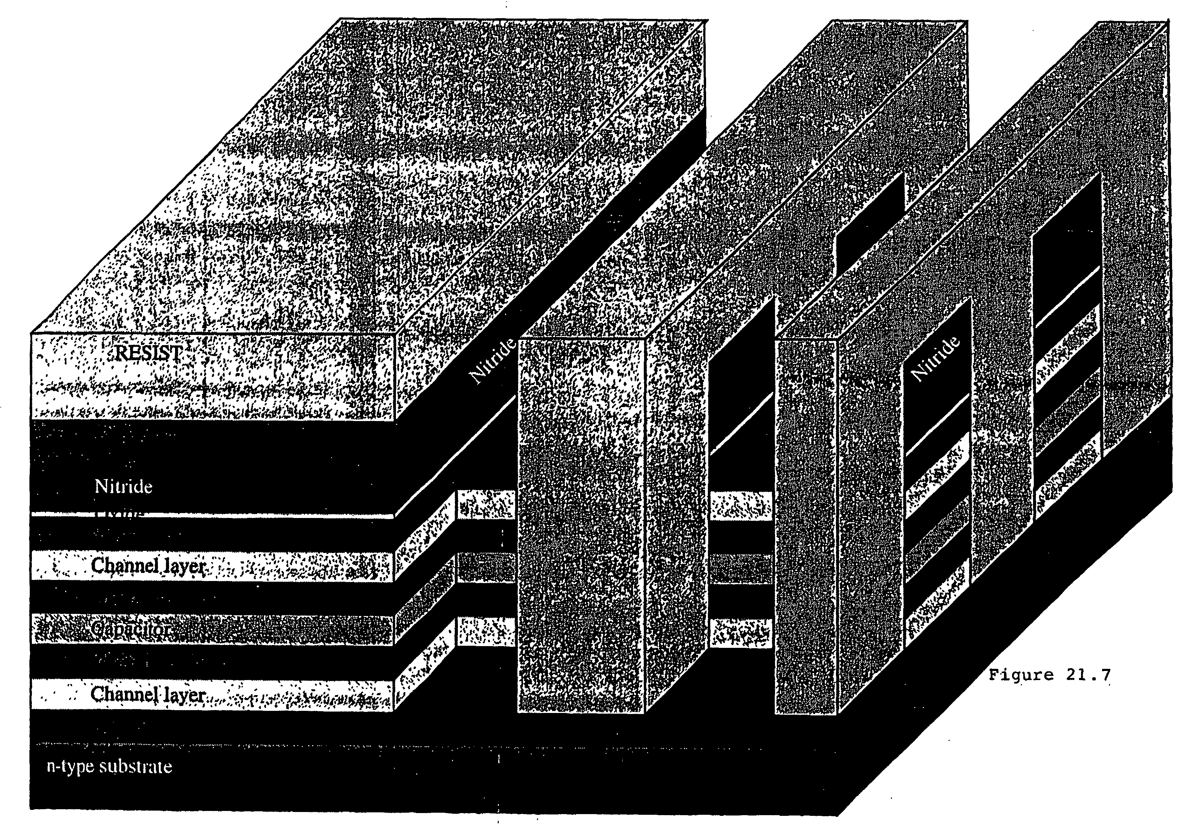

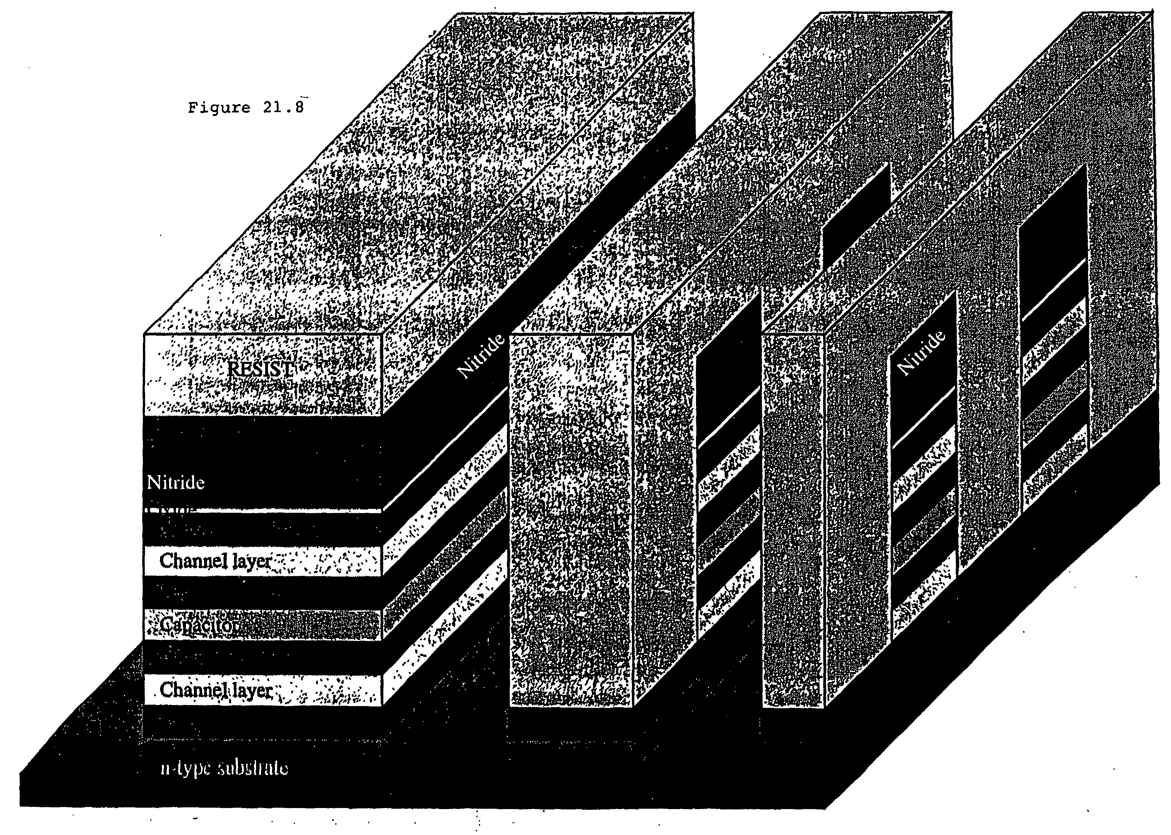

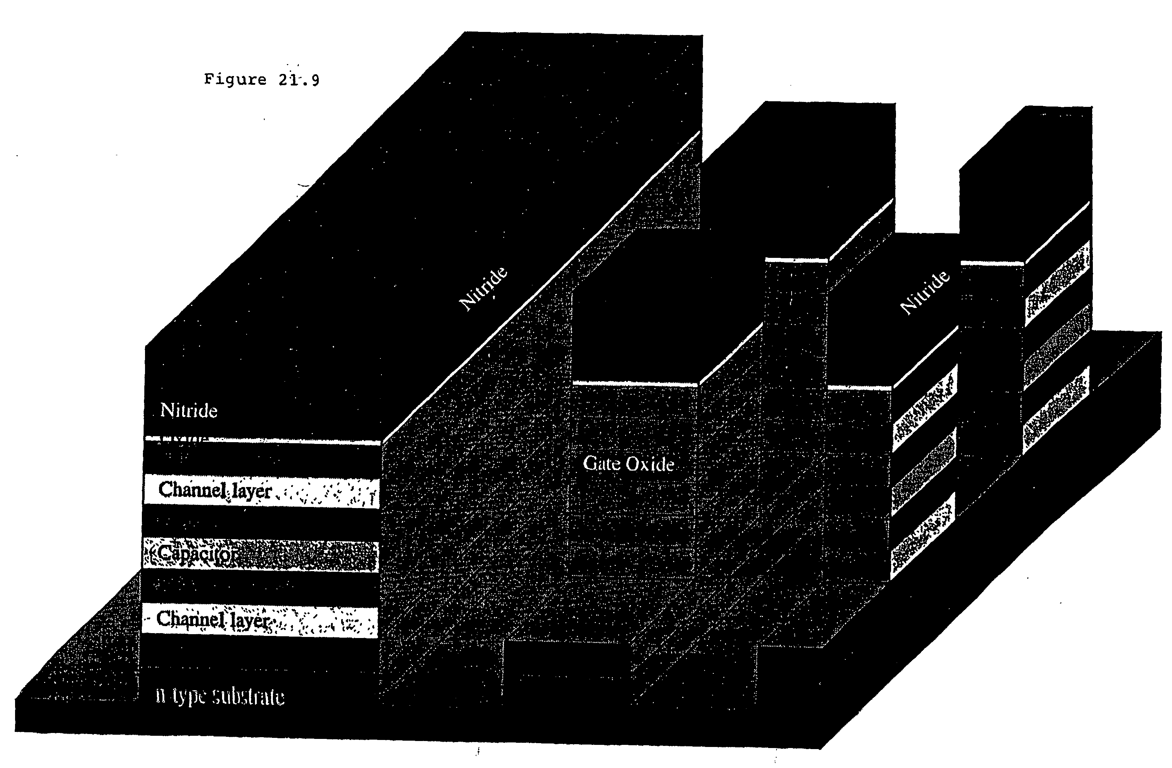

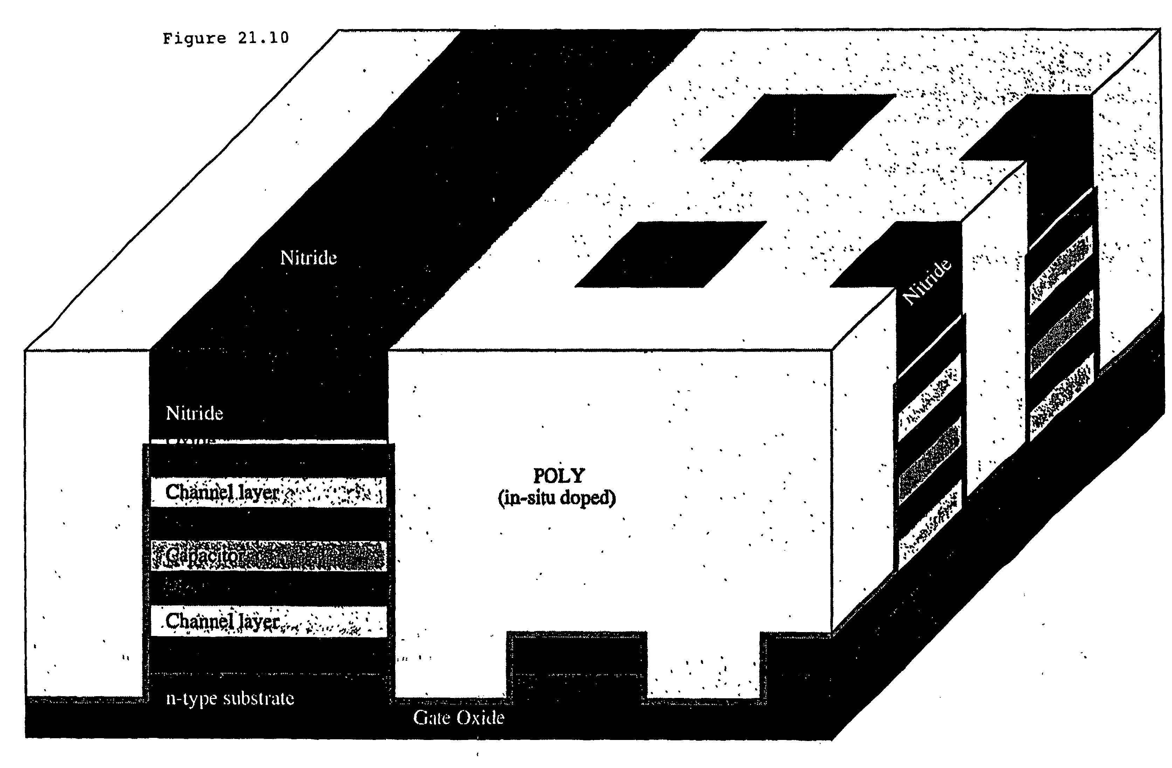

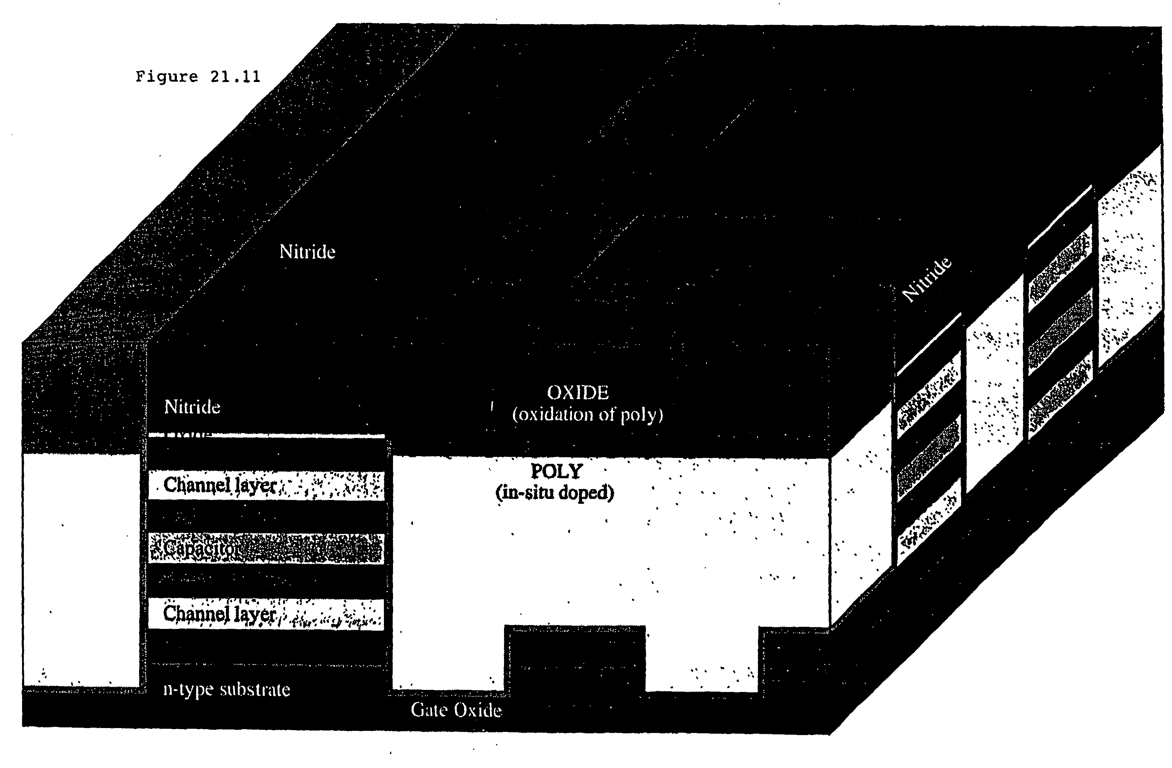

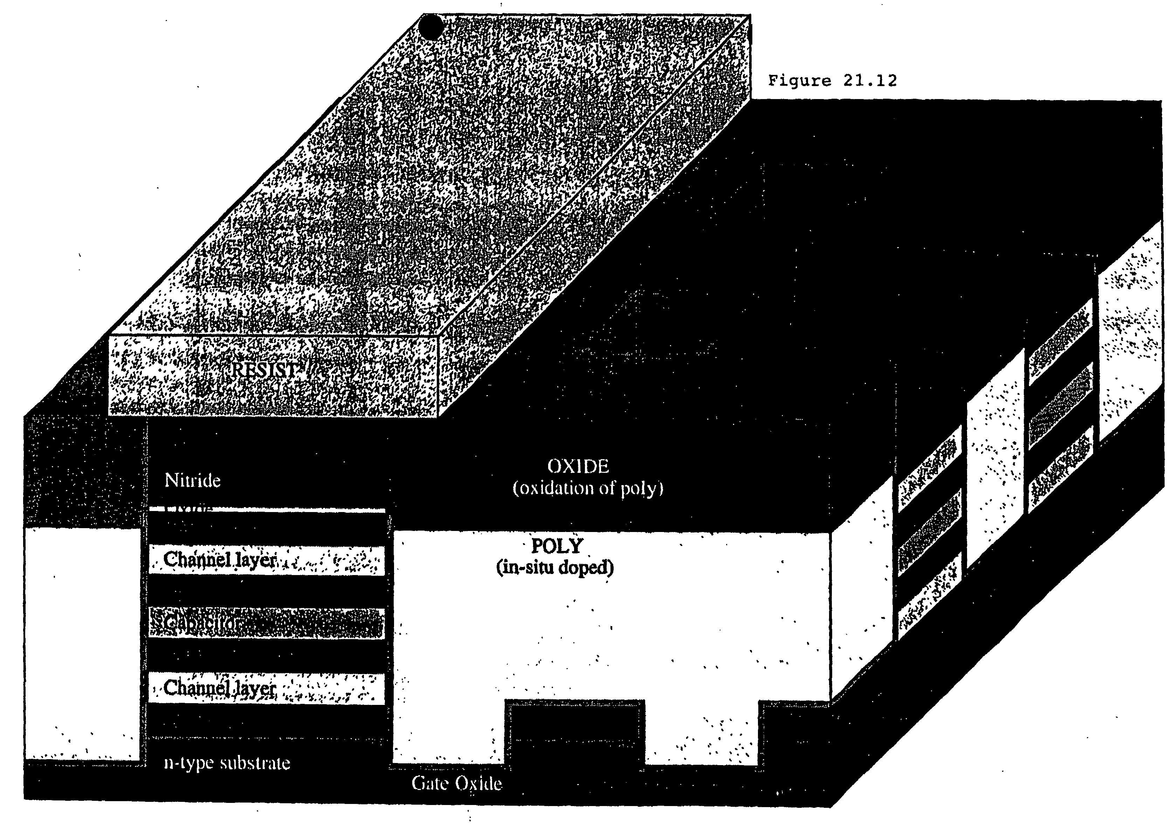

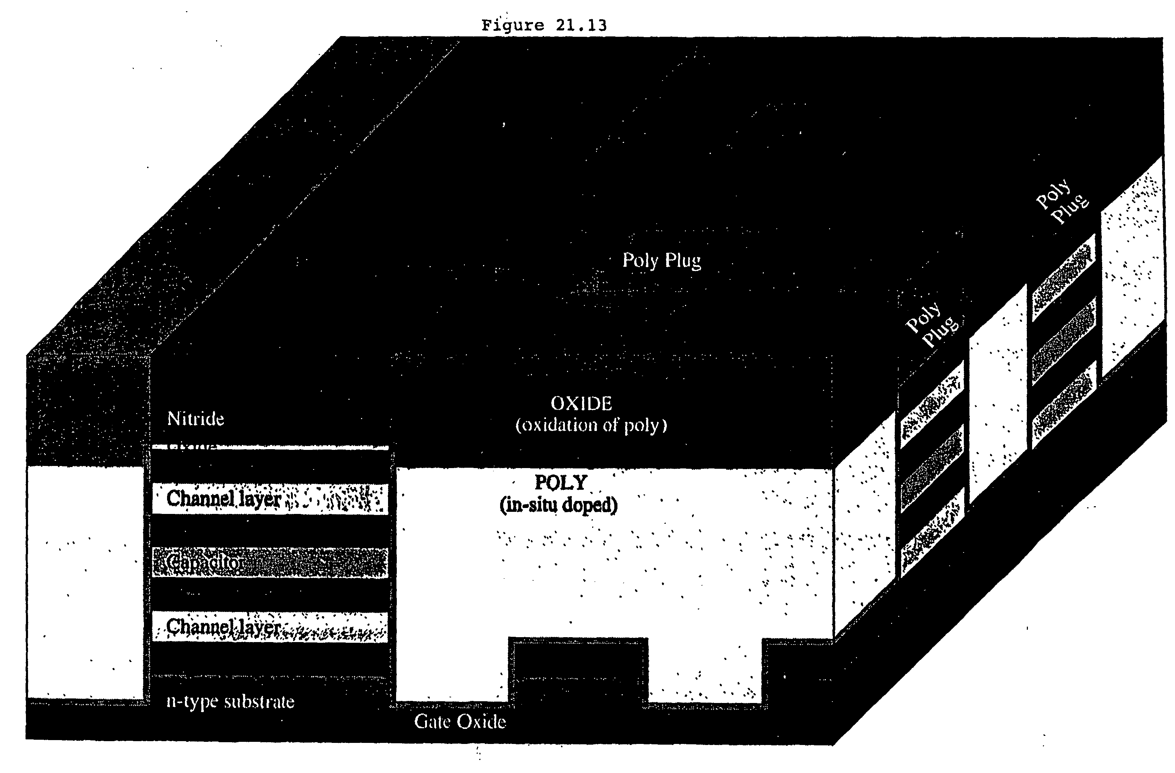

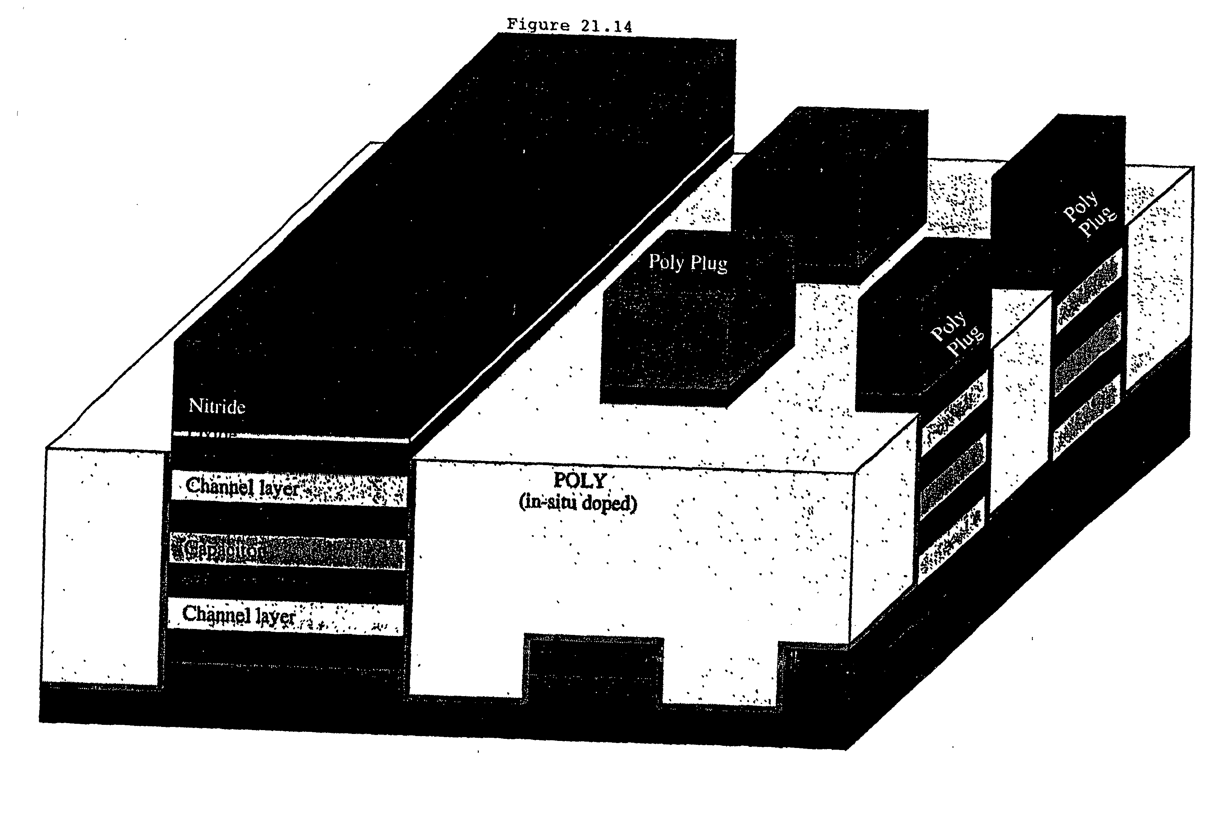

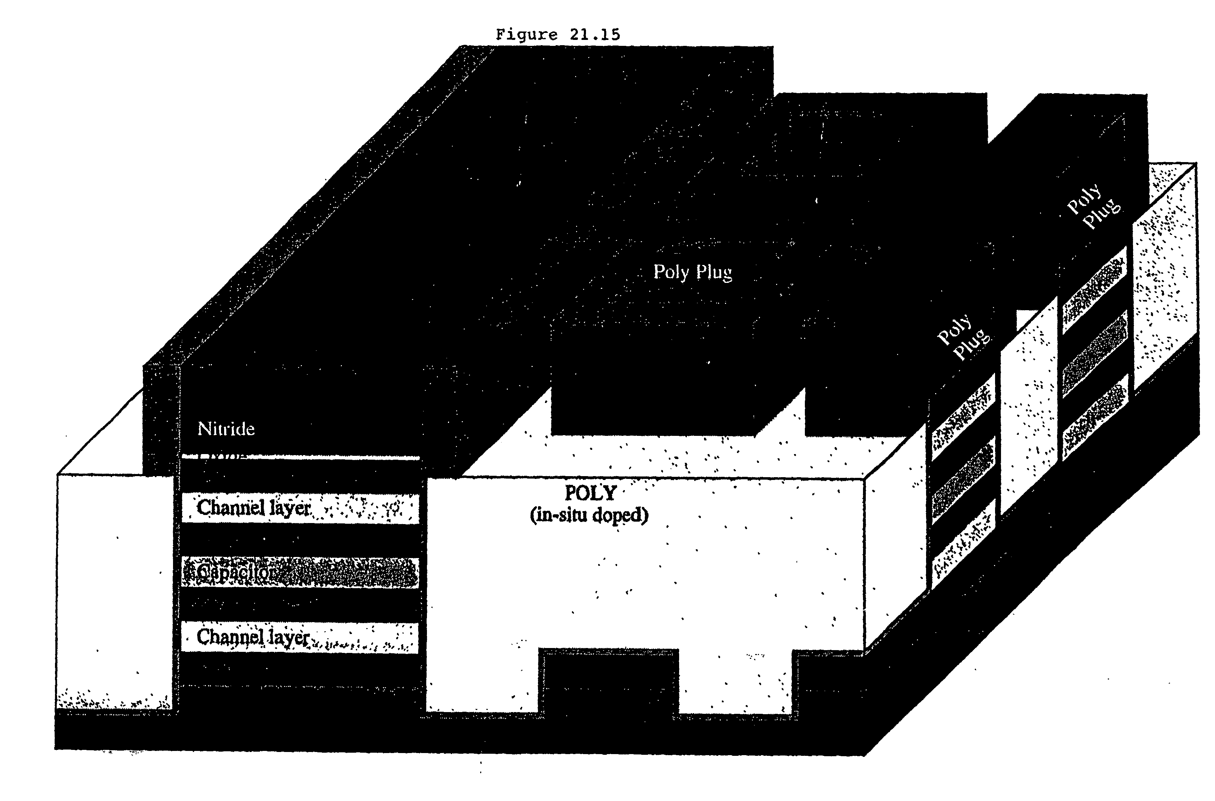

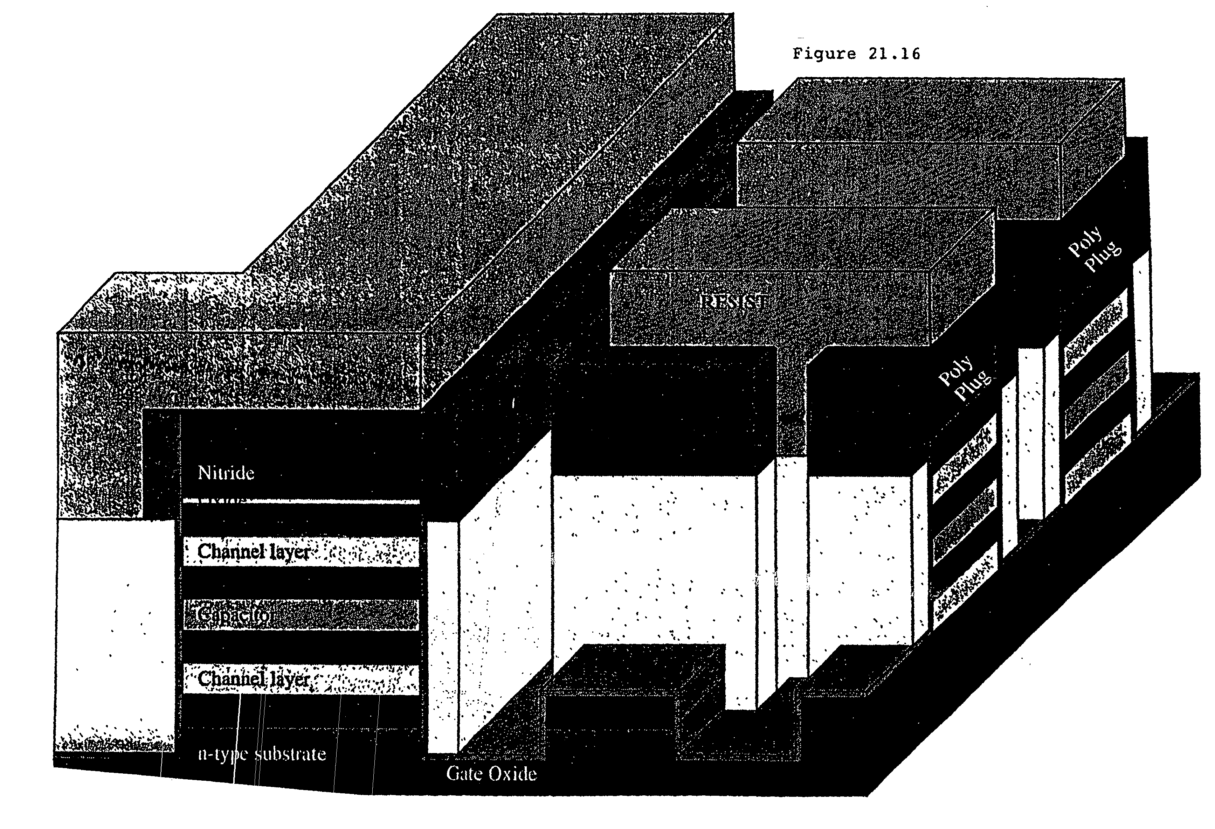

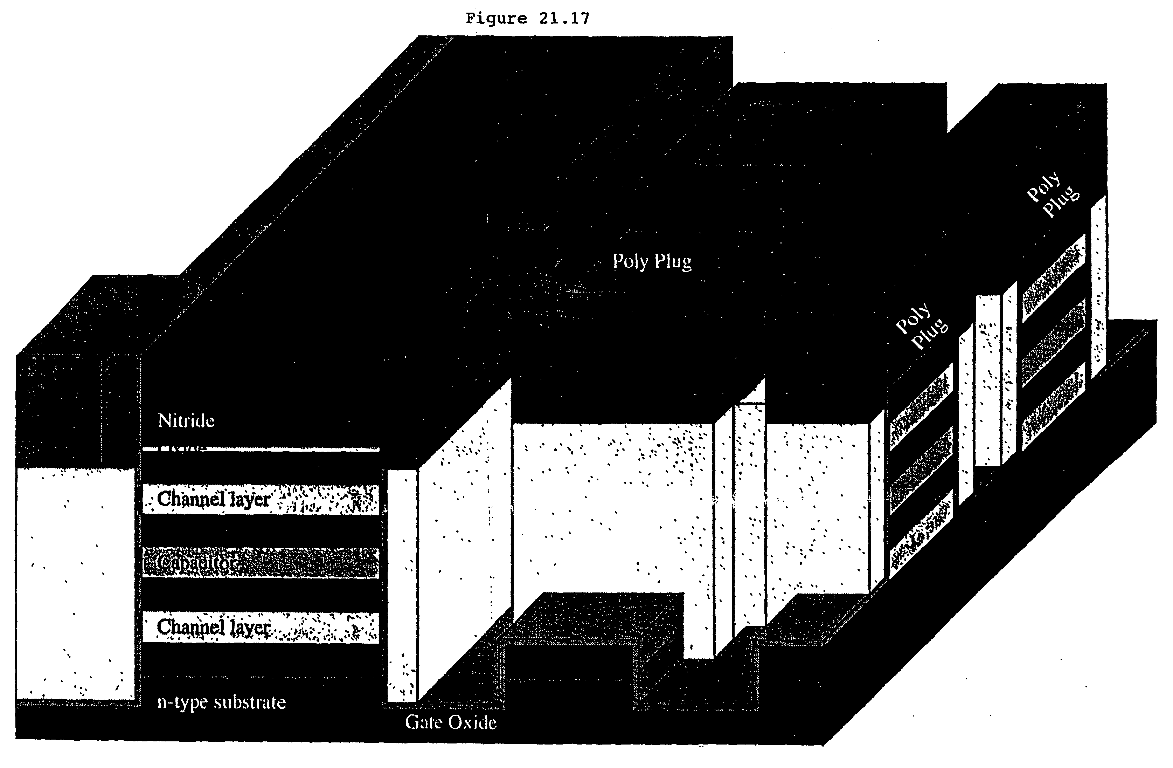

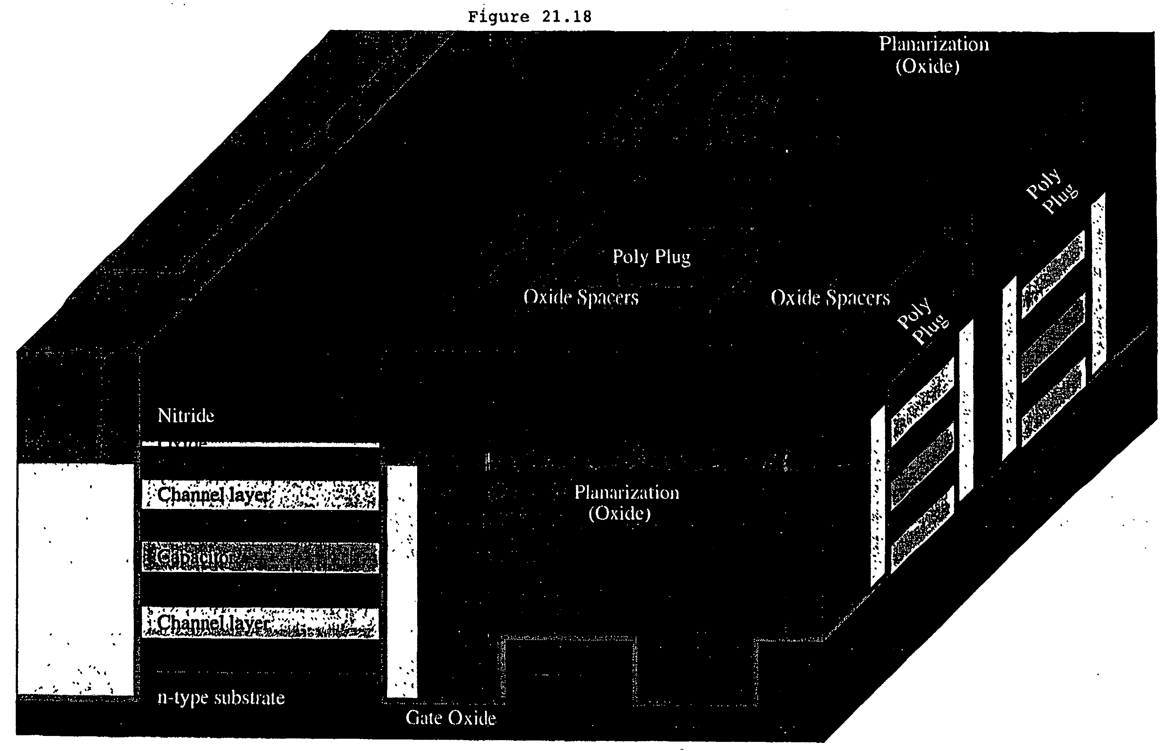

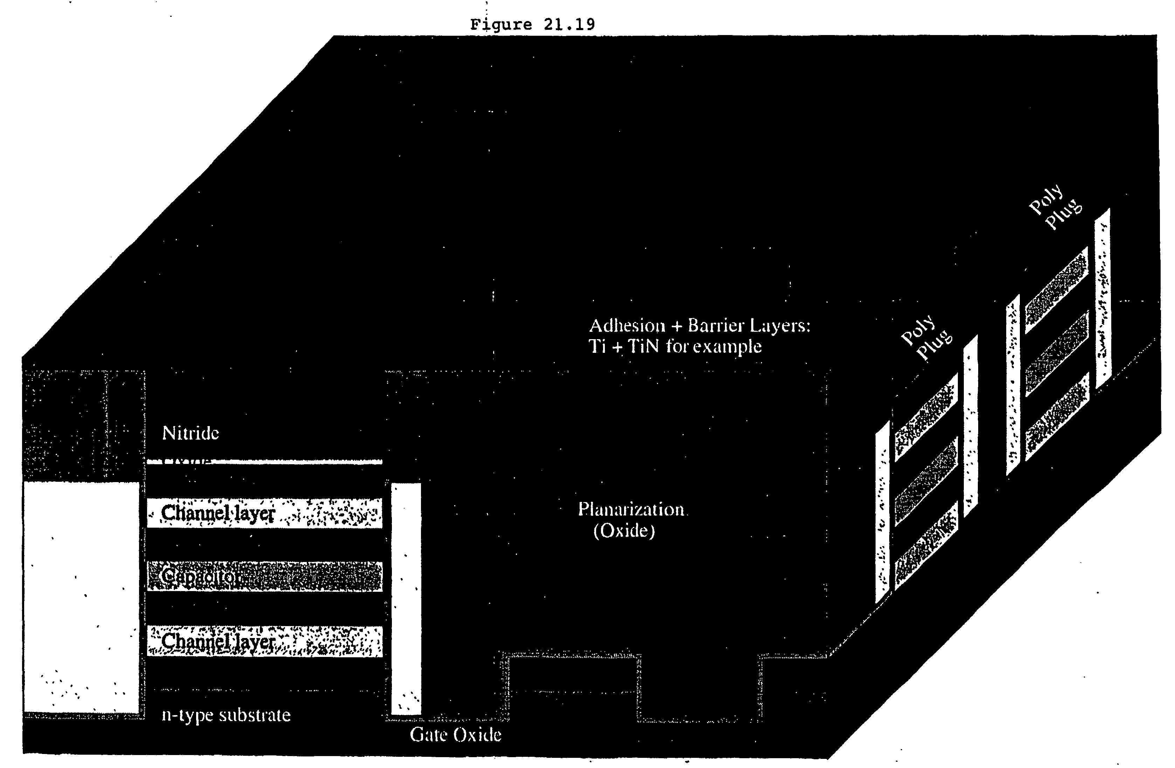

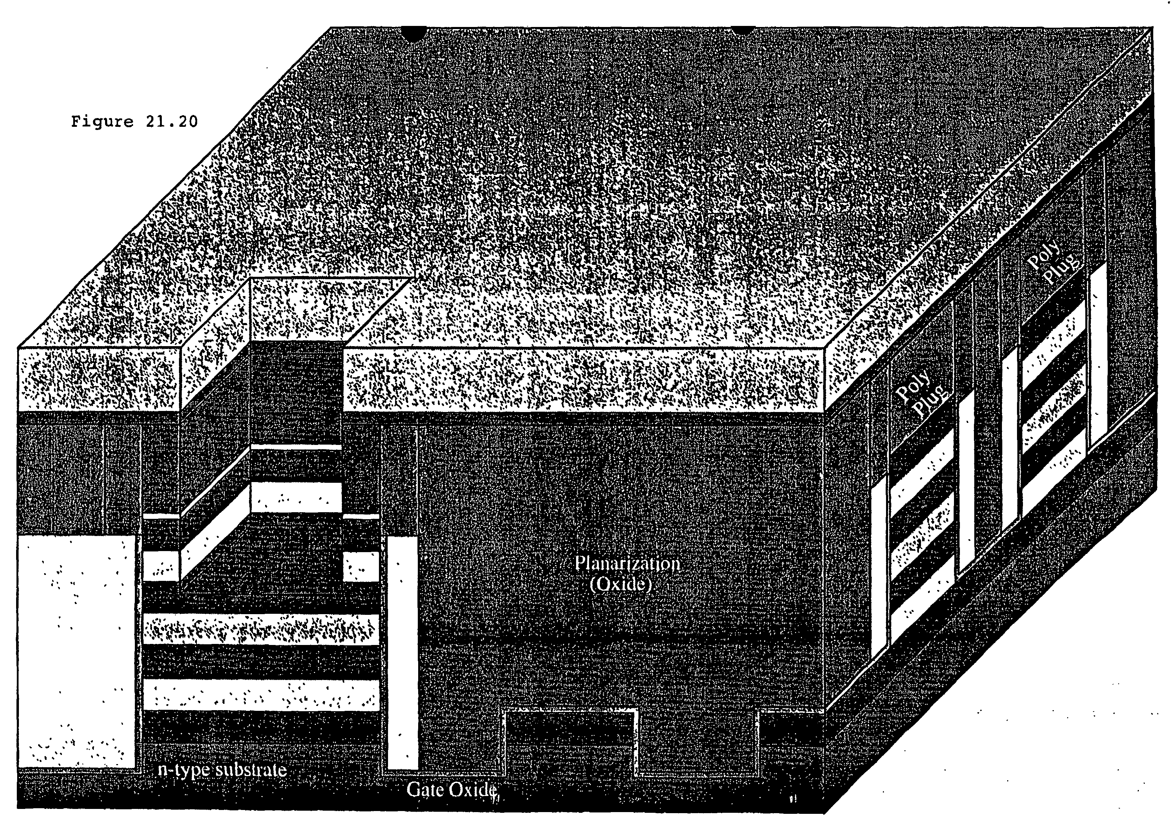

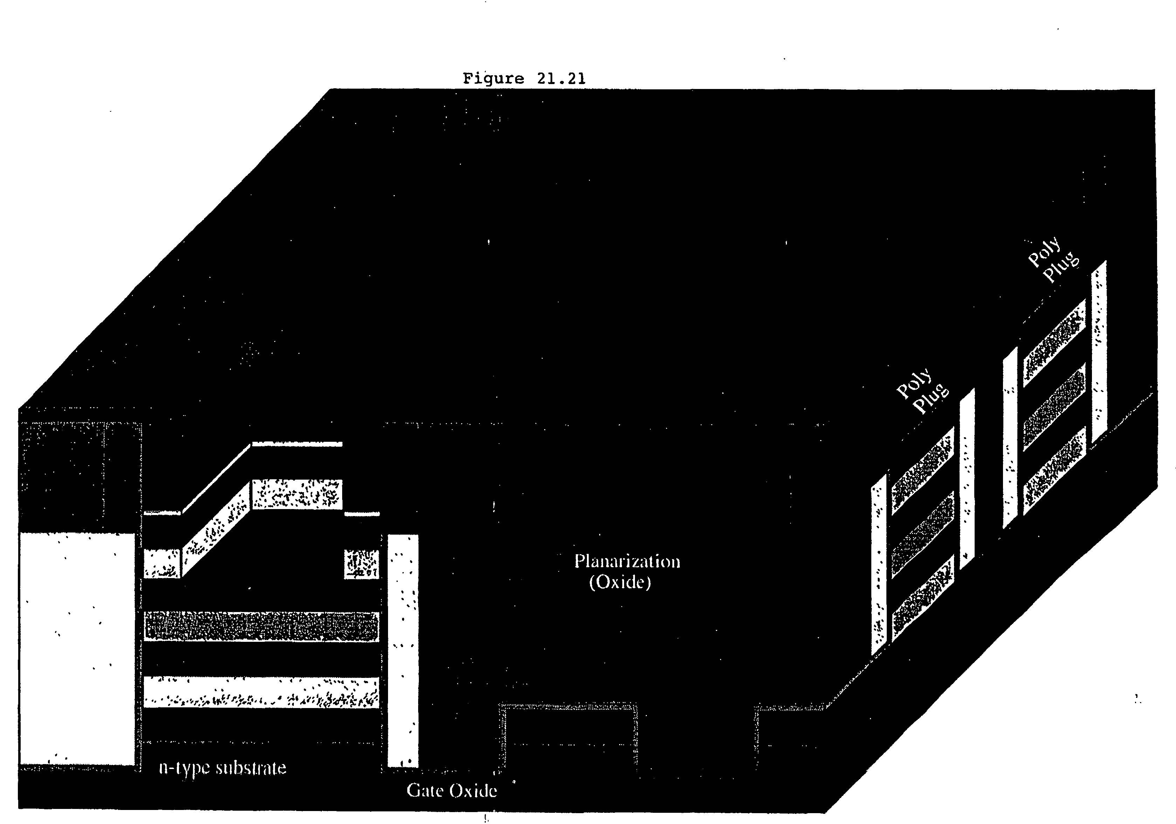

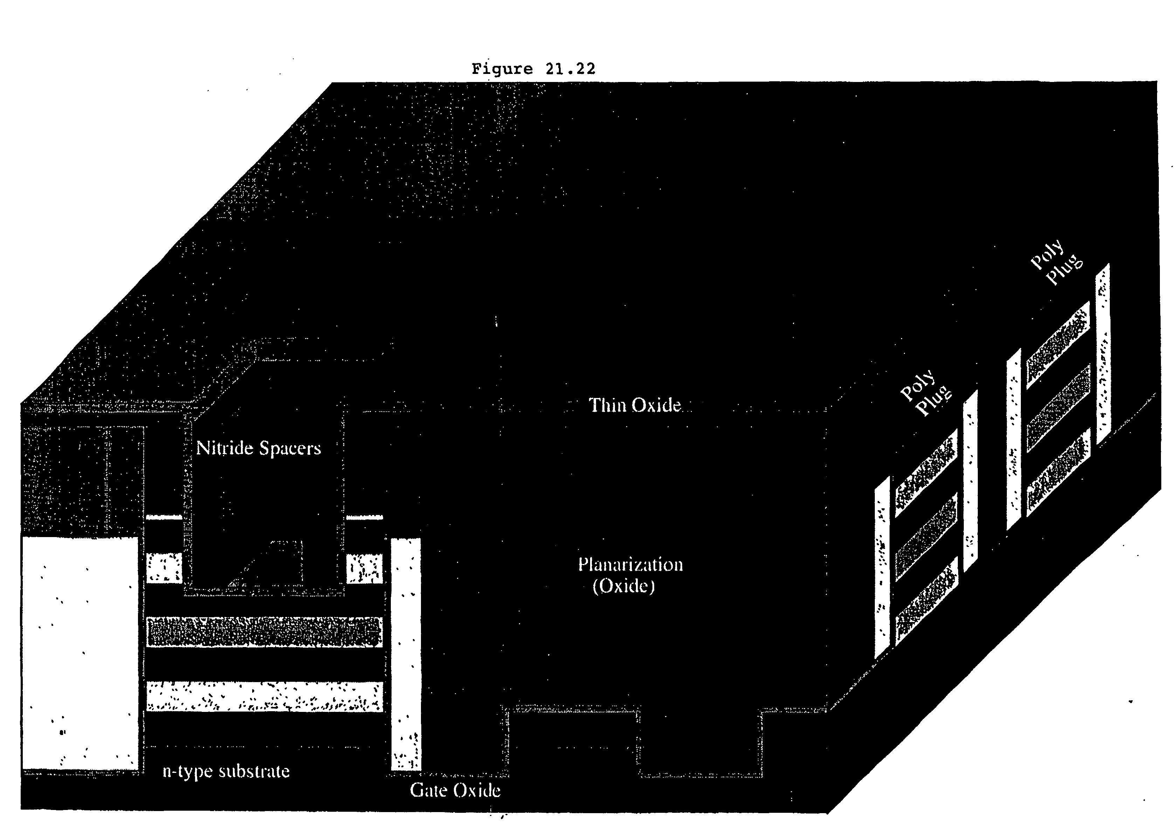

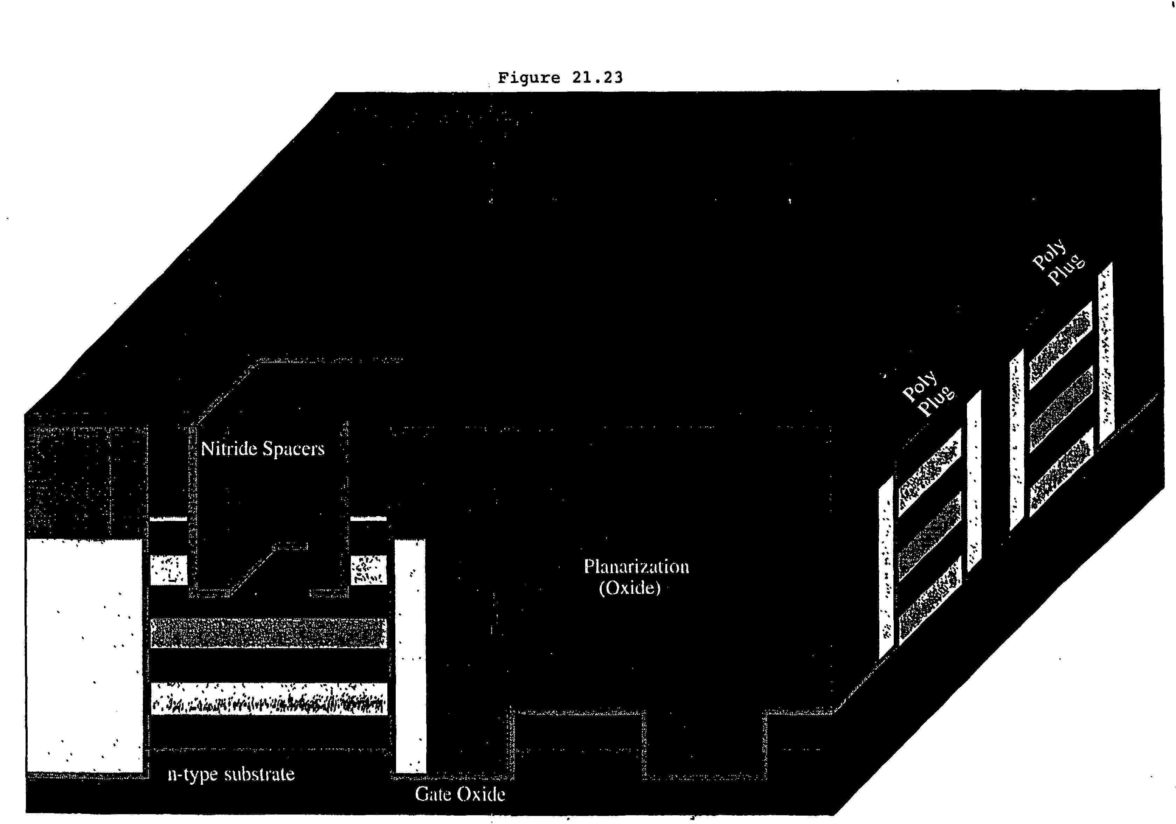

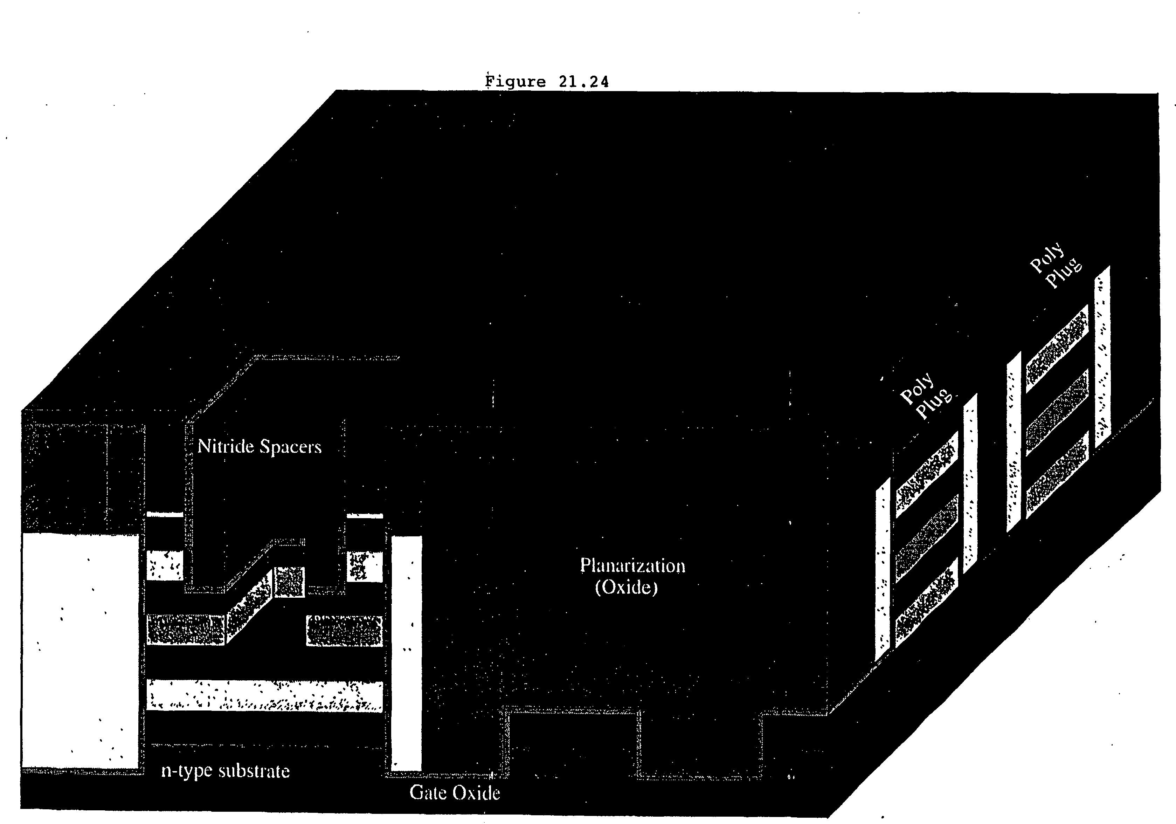

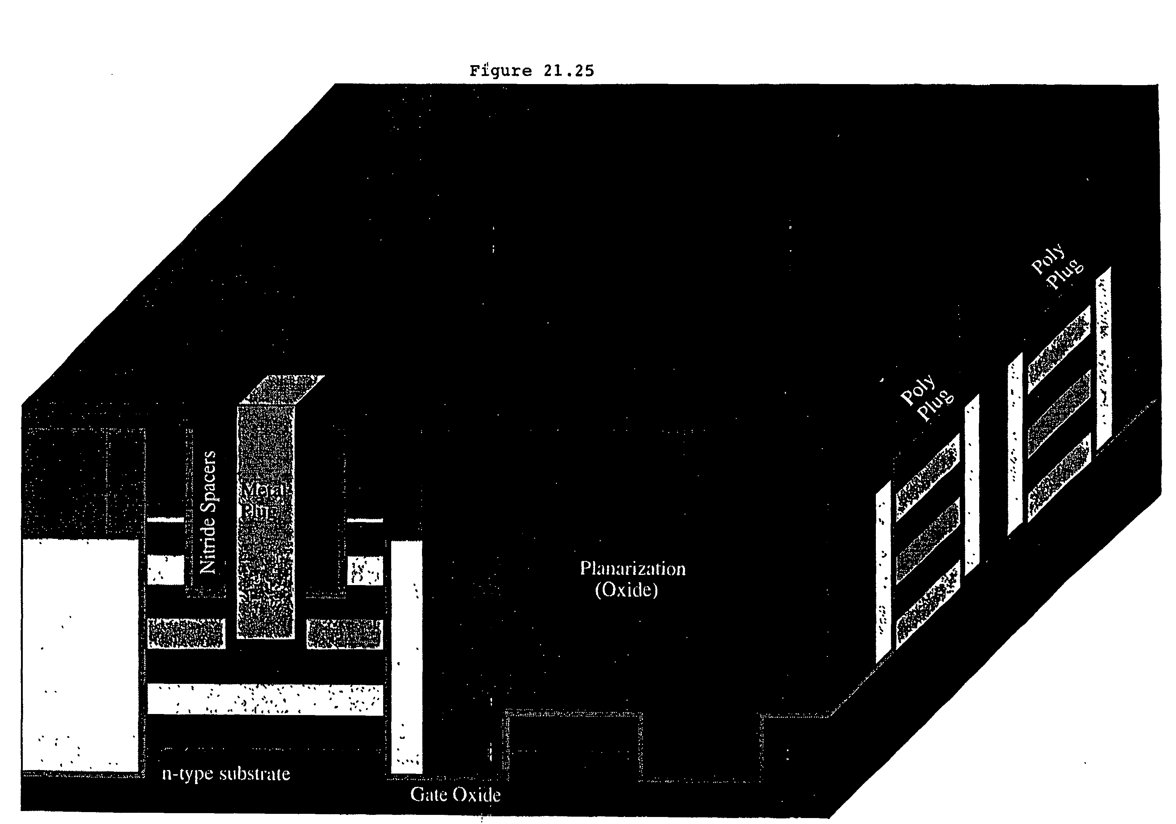

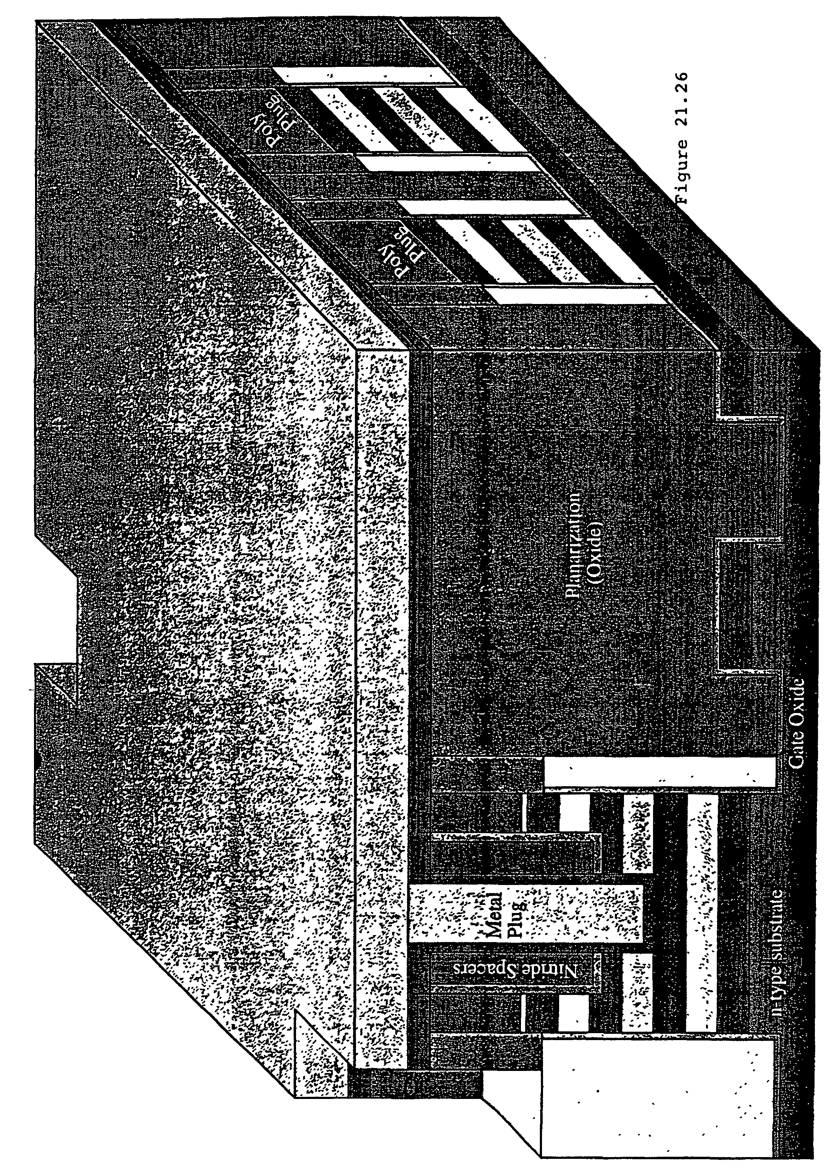

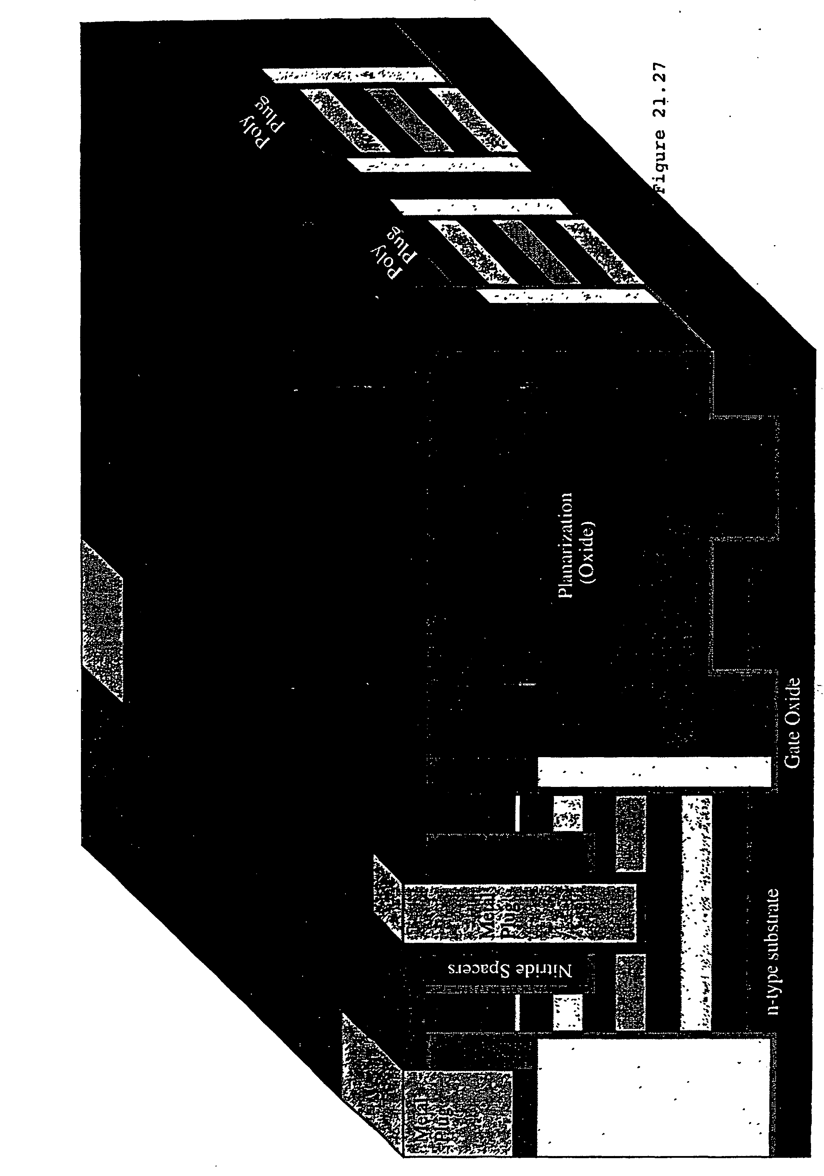

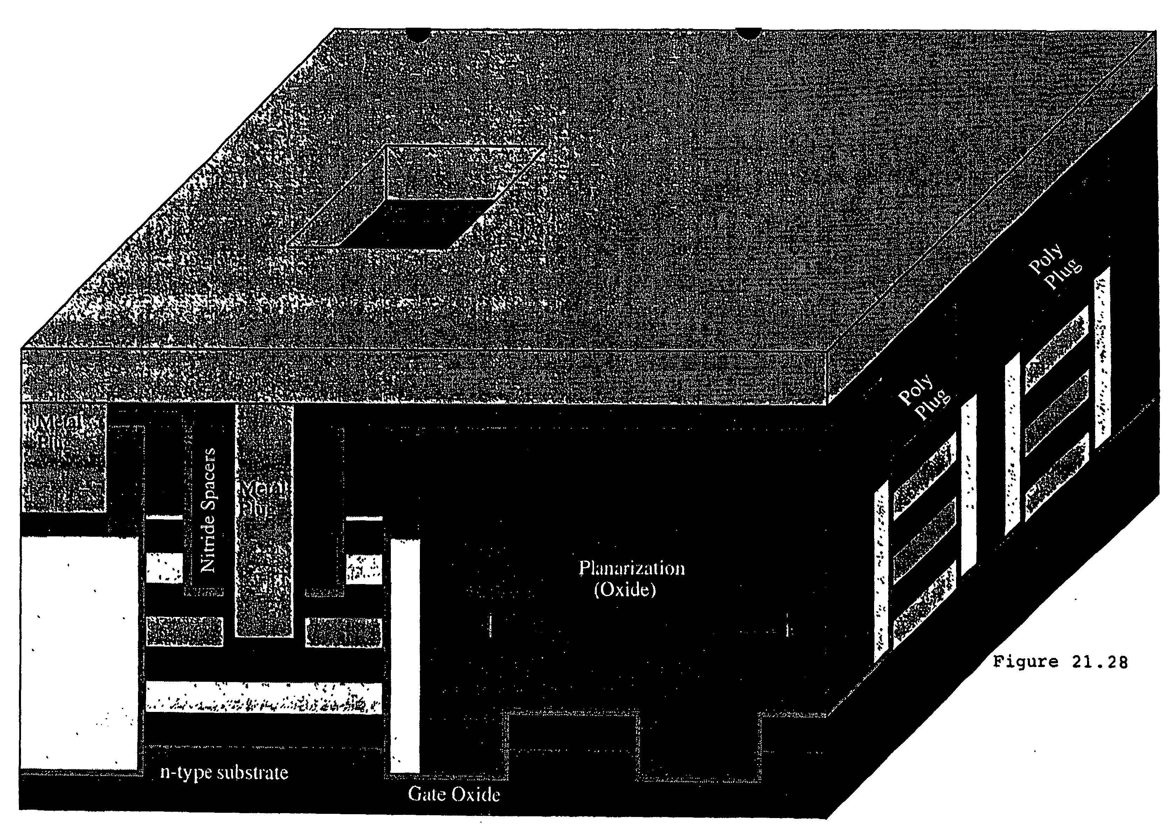

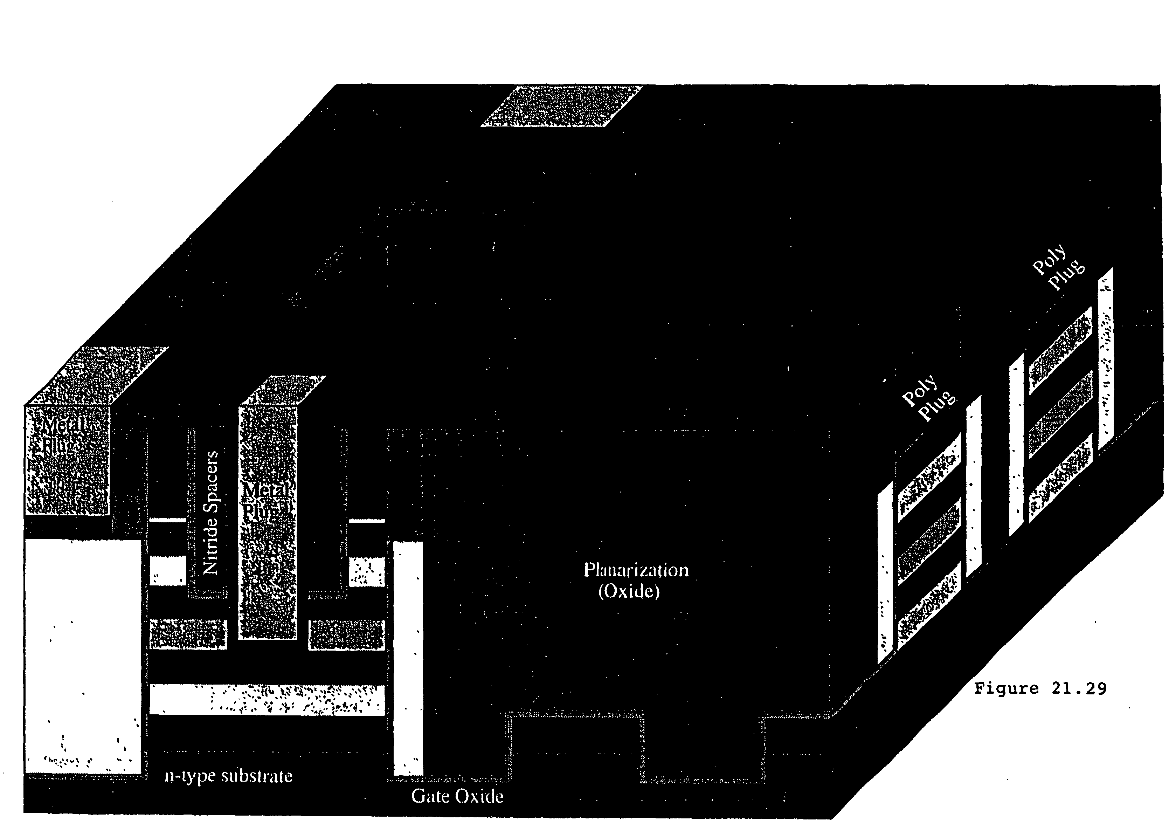

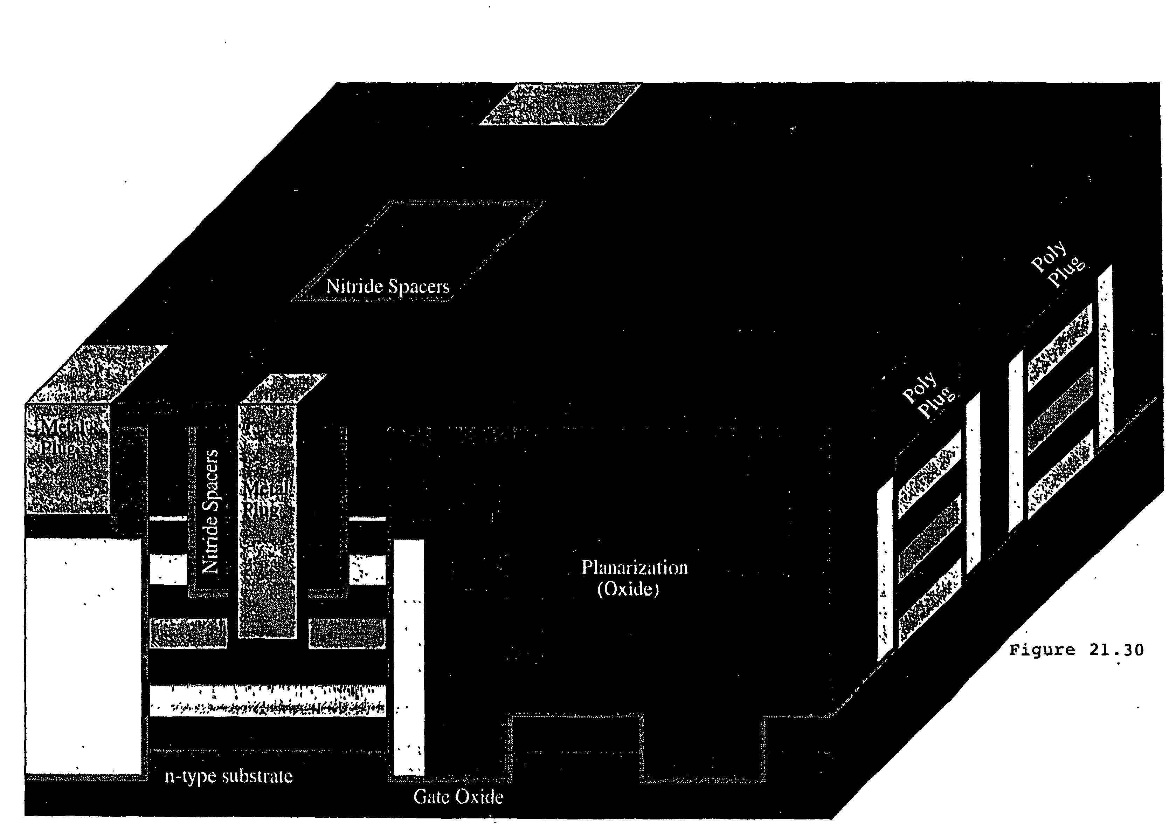

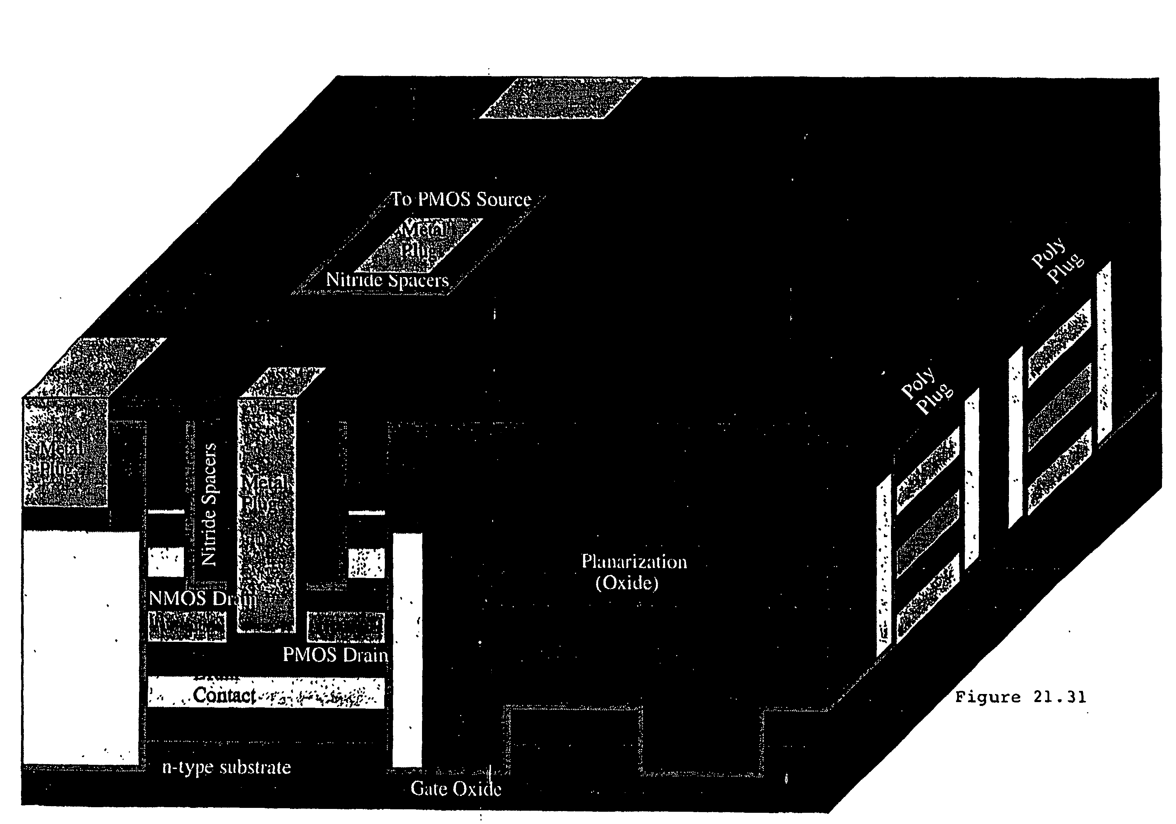

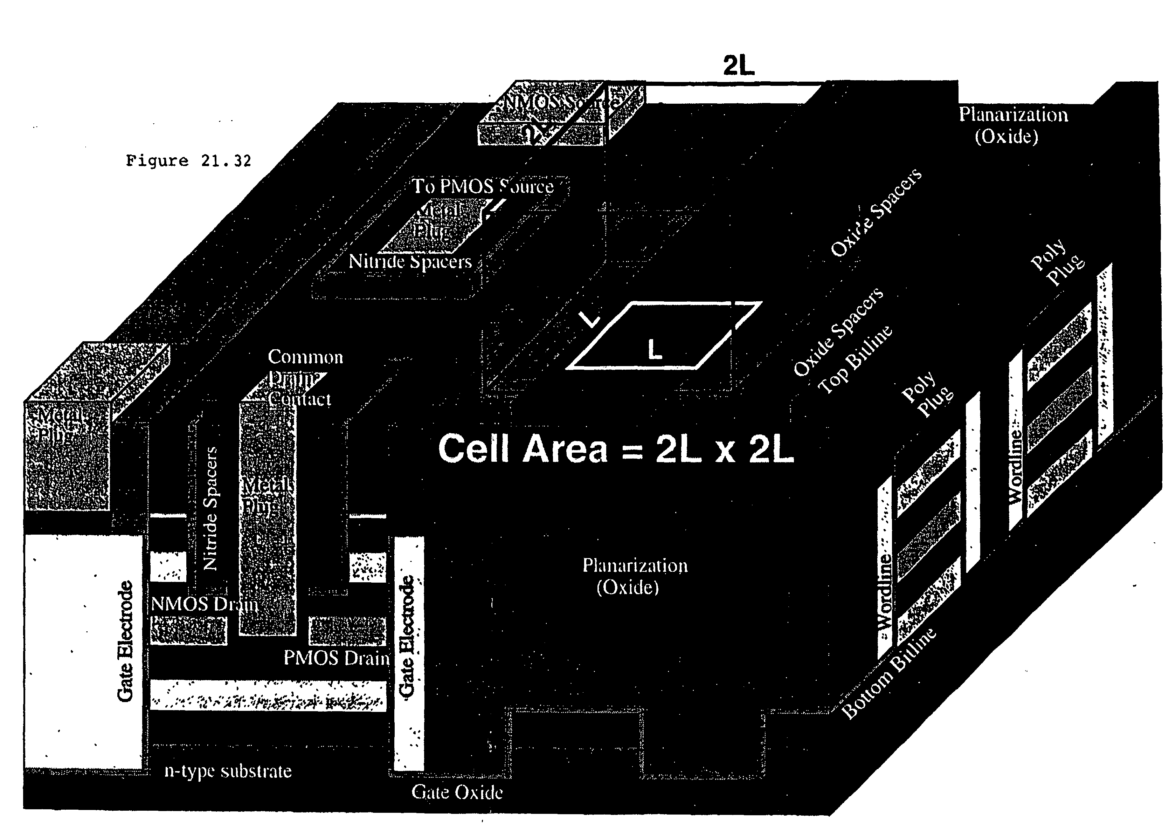

The following flows: flow 8, flow 9 related to figs. 20 and 21 respectively are examples of manufactured (2T + 1C) cells.

**Flow 8**

**(2T Cell: With Fully Epitaxial Stack)**

1) N-type substrate.
2) Pre-Epitaxial Clean.
3) Epi-deposition of PMOS layers.
4) + deposition of epitaxial insulator
5) + epi-deposition of NMOS layers
6) CVD of thin oxide + thick nitride.
**FIG.20.1**
7) Litho MASK1: lines and spaces (with minimum dimensions for cell transistors).
8) Dry etch of nitride, stopping on oxide.
9) Resist strip + clean.
**FIG.20.2**
10) Damageless oxide removal: HF vapor for example.
**FIG.20.3**
11) Damageless dry etch of crystalline silicon layers, stopping in the bottom highly doped layer (PMOS Source). In order to obtain some selectivity (>40:1 for dry etch, and more for wet etch), it is possible to have SiGe strained layers in the.Source region.
**FIG.20.4**
12) Low temperature growth of a sacrificial oxide. **FIG.20.5**
13) Litho (MASK2 lines and spaces perpendicular to the first ones).
14) Dry etch of nitride, stopping on oxide.
**FIG.20.6**
15) Resist strip + clean.
16) Oxide removal: HF vapor for example.
**FIG.20.7**
17) Damageless dry etch of the full epi-stack into the substrate.
**FIG.20.8**
18) Formation of the gate dielectric (a grown oxide is shown).
**FIG.20.9**
19) Deposition of a Si mid-gap gate electrode (for example p++ poly Ge, with a ramping to p++ poly Si; or metal like TiN).
20). Etchback of gate electrode; stopping on nitride.
**FIG.20.10**
21) Controlled recess of the gate electrode. If the gate electrode is p++ poly, low temperature oxidation (Plasma Enhanced, for example) can be used. If the gate electrode was a metal, then a timed etchback could be performed. The recess must go below the junction layer of the top transistor (source of NMOS in this case). An oxidation of poly gate is shown in the figure.
**FIG.20.11**
22) If the gate recess, is achieved by poly oxidation, then an immediate selective removal of nitride can be performed. If the gate electrode is a metal, then a planarization step is needed, after the gate electrode recess. Then , nitride should be selectively etched. **FIG.20.12**

23) In-situ doped poly plugs are made by selective CVD. Blanket CVD and etchback could also be used.
**FIG.20.13**
24) Selective removal of oxidised poly (or deposited oxide in case of metal gate electrode).
**FIG.20.14**
25) CVD and etchback of oxide, to make spacers. This thickness, being larger than the stepper's overlay accuracy, will define the width of the trench between the gates of the different cells. It also makes possible the gate all around.
**FIG.20.15**
26) Litho (MASK4: Resist lines to protect the BITLINES).
27) Selective dry etch of gate electrode (against oxide spacers).
**FIG.20.16**
28) Resist strip + clean.
**FIG.20.17**
29) Planarization by oxide deposition (and/or SOG), and etchback.
**FIG.20.18**
30) Deposition of metal.
**FIG.20.19**
31) Litho (MASK5: Top BITLINE)
32) .Dry etch of metal, selective against the underlying oxide.
**FIG.20.20**

**Flow 9**

**(Simultaneous fabrication of 2T Cell & CMOS)**

1) N-type substrate.
2) Pre-Epitaxial Clean.
3) Epi-deposition of PMOS layers.
4) + deposition of epitaxial insulator
5) + epi-deposition of NMOS layers
6) CVD of thin oxide + thick nitride.
**FIG.21.1**
7) Litho MASK1: lines and spaces (with minimum dimensions for cell transistors).
8) Dry etch of nitride, stopping on oxide.
9) Resist strip + clean.
**FIG.21.2**
10) Damageless oxide removal: HF vapor for example.
**FIG.21.3**
11) Damageless dry etch of crystalline silicon layers, stopping in the bottom highly doped layer (PMOS Source). In order to obtain some selectivity (>40:1 for dry etch, and more for wet etch), it is possible to have SiGe strained layers in the Source region.
**FIG.21.4**
12) Low temperature growth of a sacrificial oxide.
**FIG.21.5**
13) Litho (MASK2 lines and spaces perpendicular to the first ones).
14) Dry etch of nitride, stopping on oxide.
**FIG.21.6**
15) Oxide removal: HF vapor for example.
**FIG.21.7**
16) Damageless dry etch of the full epi-stack into the substrate.
**FIG.21.8**
17) Resist strip + clean.
18) Formation of the gate dielectric (a grown oxide is shown).
**FIG.21.9**
19) Deposition of a Si mid-gap gate electrode (for example p++ poly Ge, with a ramping to p++ poly Si; or metal like TiN).
20) Etchback of gate electrode, stopping on nitride.

**FIG.21.10**

21) Controlled recess of the gate electrode. If the gate electrode is p++ poly, low temperature oxidation (Plasma Enhanced, for example) can be used. If the gate electrode was a metal, then a timed etchback could be performed. The recess must go below the junction layer of the top transistor (source of NMOS in this case). An oxidation of poly gate is shown in the figure.

**FIG.21.11**

22) Litho (MASK3 resist lines to protect CMOS areas).

23) Selective nitride removal.

**FIG.21.12**

24) Resist strip + clean.

25) In-situ doped poly plugs are made by selective CVD. Blanket CVD and etchback could also be used.

**FIG.21.13**

26) Selective oxide (oxidised'poly) removal.

**FIG.21.14**

27) Formation of oxide spacers: CVD and etchback of oxide.

**FIG.21.15**

28) Litho (MASK4: Resist lines to protect the gates of BITLINES & CMOS).

29) Dry etch of gate electrode, masked by resist and self-aligned with oxide spacers.

**FIG.21.16**

30) Resist strip + clean.

**FIG.21.17**

31) Planarization by oxide deposition (and/or SOG), and etchback.

**FIG.21.18**

32) Deposition of an adhesion layer plus an metallic barrier/etchstop (Ti/TiN for example).

**FIG.21.19**

33) Litho (MASK5: Contact Hole to drains of NMOS and PMOS -> CMOS Inverter).

34) Dry etch of TiN/Ti + Nitride stopping on thin Oxide

35) Damageless dry etch of Source/Channel of top transistor, stopping inside the drain of that transistor.

**FIG.21.20**

36) Resist strip + clean.

**FIG.21.21**

37) Formation of Nitride spacers: CVD of thin oxide + nitride, etchback of nitride.

**FIG.21.22**

38) Damageless selective removal of oxide: HF vapor for example.

**FIG.21.23**

39) Self-aligned dry etch of drain of top transistor and insulator, stopping in the drain of the bottom transistor.

**FIG.2.1.24**

40) Formation of a metal plug. For example by CVD and etchback.

**FIG.21.25**

41) Litho (MASK6: Contact Holes to CMOS Gate, and top transistor - NMOS - Source).

42) Dry etch of Oxide, stopping on poly & TiN.

**FIG.21.26**

43) Resist strip + clean.

44) Formation of metal plugs (CVD and etchabck for example).

**FIG.21.27**

45) Litho (MASK7: Contact Holes to bottom transistor - PMOS - Source).

46) Dry etch of TiN/Ti, nitride, stopping on oxide.

47) Damageless dry etch of NMOS layers and PMOS drain & channel, until PMOS Source.

**FIG.21.28**

48) Resist strip + clean.

**FIG.21.29**

49) Formation of nitride spacers: CVD of thin oxide and nitride, etchback of nitride.

50) Removal of oxide by HF vapor *for* example.

**FIG.21.30**

51) Formation of a metal plug, by CVD and etchback for example.

**FIG.21.31**

52) Litho (MASKS: Top BITLINES and contacts to CMOS)

53) Dry etch of metal, selective against the underlying oxide/nitride.

FIG.21.32

## Claims

**1.** Silicon-germamiun or silicon-carbide based Vertical MISFET device which comprises a stack of several layers including at least a source layer (7 or 7'), a channel layer (3 or 3') and a drain layer (1 or 1'), wherein:

- the channel layer (3 or 3') is undoped or lowly doped,
- a heterojunction is formed between the source (7 or 7') and the channel (3 or 3'),
- a gate (13 or 13') is overlapping, at least partially any of the source (7 or 7'), the channel (3 or 3') and the drain (1 or 1') layers with an insulating layer (11 or 11') between said gate and said stack of several layers, and

**characterized in that**

- said gate (13 or 13') is overlapping at an essentially right angle to the stacking direction, said said source (7 or 7'), channel (3 or 3') and drain (1 or 1') layers,
- an undoped or lowly doped region (5 or 5') is present in the source adjacent to the source/channel interface.

**2.** Device according to claim 1, wherein the device is of the PMOS type , and wherein:

- the drain (1) is made of a highly p-type doped material preferably the same material as the channel material,
- the channel (3) is an undoped material,
- the source comprises at least a double layer consisting in an undoped or lowly p-type doped region (5) and a highly p-type doped region (7), both made of a second material which has a valence band edge with a lower potential energy than the valence band edge of the channel material.

**3.** Device according to claim 2, wherein the device is of the PMOS type , and wherein :

- the drain (1) comprises a highly doped p++ layer preferably Si layer,
- the channel (3) is an undoped layer preferably Si layer, and
- the source comprises at least a double layer consisting in an undoped or lowly doped $Si_{1-x}Ge_x$ layer (5) and a highly doped p++ possibly graded SiGe layer (7).

**4.** Device according to claim 1, wherein the device is of the NMOS type , and wherein:

- the drain (1') is made of a highly n-doped material preferably the same material as the channel material,
- the channel (3') is an undoped material, and
- the source comprises at least a double layer consisting in an undoped or lowly n-type doped region (5') and a highly n-type doped region (7'), both made of a second material which has a conduction band edge with a lower potential energy than the conduction band edge of the channel material.

**5.** Device according to claim 4, wherein the device is of the NMOS type, and wherein:

- the drain (1') comprises a highly doped n++ layer preferably Si layer,
- the channel (3') is an undoped layer preferably Si layer,
- the source comprises at least a double layer consisting in an undoped or lowly doped $Si_{1-x-y}Ge_xC_y$ or $Si_{1-y}C_y$ layer (5'), and a highly doped n++ possibly graded $Si_{1-x-y}Ge_xC_y$ or $Si_{1-y}C_y$ layer (7').

**6.** Device according to claim 4, wherein the device is of the NMOS type and wherein :

- the drain (1') comprises a highly doped n++ layer preferably Ge layer,
- the channel (3'a) is an undoped layer preferably Ge layer,
- the source comprises at least a double layer consisting in an undoped or lowly doped $Si_{1-y}Ge_y$ layer (5'a), and a highly doped n++ possibly graded SiGe layer (7'a).

**7.** Complementary device comprising at least one stack of one device of the NMOS type according to anyone of the claims 4 - 6 grown on the top of one device of the PMOS type according to anyone of the claims 2 - 3 having their drains (1 and 1') facing each other.

8. Complementary device comprising at least one stack of one device of the PMOS type according to anyone of the claims 2 - 3 grown on the top of one device of the NMOS type according to anyone of the claims 4 - 6 having their source (7 and 7') facing each other.

9. Complementary device having at least one stack of one PMOS type device according to anyone of the claims 2 - 3 grown on the top of one device of the NMOS type according to anyone of the claims 4 - 6, itself grown on the top of one device of the PMOS type according to anyone of the claims 2 - 3.

10. Complementary device having at least one stack of one NMOS type device according to anyone of the claims 4 - 6 grown on the top of one device of the PMOS type according to anyone of the claims 2 - 3, itself grown on the top of one device of the NMOS type accordng to anyone of the claims 4 - 6.

11. Use of the complementary device according to anyone of the preceding claims 7 - 10 in order to have a CMOS inverter, a PMOS pass transistor or an NMOS pass transistor.

12. Process of manufacturing one silicon-germanium based or silicon-carbide based Vertical MISFET device or a stack of several Vertical MISFET devices, according to any one of claims 1 to 10, each of the MISFET devices comprising a stack of several layers including at least a source layer, a channel layer and a drain layer, a heterojunction being present between said source layer and said channel layer, and having a surrounding gate and insulator overlapping at least partially any of the several layers of the MISFET device, and further having an undoped or lowly doped region (5 or 5') in the source adjacent to the source/channel interface, said gate and insulator being at a right angle to the stacking direction of said several layers, said process being **characterized in that**:

   - one epitaxial deposition sequence on a silicon substrate is used for defining the several layers of each Vertical MISFET device possibly stacked,
   - a patterning step consisting in a lithographic/etch step is used to create the surrounding gate around the possibly stacked device or devices, and
   - other patterning steps are used to make contact to the source and to the drain of each Vertical MISFET device possibly stacked.

13. Process of manufacturing Vertical MISFET device according to claim 12, wherein the patterning step used in order to make the contact to the drain of the devices is performed in order to have said drain common to several stacked devices preferably made inside the perimeter of the stacked device or devices.

14. Process according to claim 12 or 13,
wherein the epitaxial deposition sequence uses a virtual $Si_{1-x}Ge_x$ substrate in order to create a heterojunction in the PMOS or NMOS device or devices.

15. Process according to claim 14, wherein a heterojunction is created by incorporating group IV elements and appropriate dopants in the virtual $Si_{1-x}Ge_x$ substrate in order to create significant energy barriers.

16. Process according to anyone of the preceding claims 12 -15 intended to manufacture Heterojunction Vertical MISFET devices comprising at least the following steps:

   - Epitaxy of Several Layers of the Vertical MISFET device;
   - Deposition of Insulator or Insulators;
   - Mask 1: Definition of Configuration units (MESAS) each corresponding to one stack;
   - Formation of Gate Stack on Mesas Sidewalls;
   - Gate Electrode Etchback (Spacer-like Electrode);
   - Planarization: Filling of Spaces Between Mesas;
   - Mask 2: Formation of Gate Contact Pad;
   - Mask 3: (Common) Drain Contact Holes
   - Formation of Spacers at least Partially on the Internal Side Walls of the Top/Bottom Device;
   - Contact Hole Filling with Silicide and Metal;
   - Mask 4: Contact Hole to Source of Top Device;
   - Contact Hole Filling with Silicide and Metal;

- Metallization

**17.** RAM circuit having memory cells and a logic circuitry, each of said memory cells comprising at least one Vertical MISFET device according to any one of claims 1 to 6, said device having itself a stack of several layers including at least a source layer, a channel layer and a drain layer and comprising a capacitor on the top of the stack of several layers of the Vertical MISFET device.

**18.** RAM circuit having memory cells and a logic circuitry, each of said memory cells comprising at least two Vertical MISFET devices according to any one of claims 1 to 6, on the top of each other and having a capacitor there between.

**19.** RAM circuit according to claim 17 or 18, wherein the Vertical MISFET device or devices is or are Heterojunction Vertical MISFET device or devices which comprise at least:

- a channel layer which is undoped or lowly doped;
- a heterojunction which is formed between the source and the channel with a presence of an undoped or lowly doped region in the source near the source/channel interface, and
- a gate which is overlapping, preferably essentially at right angle, at least partially the source, the channel, and the drain layers with an insulate layer there between.

**20.** RAM circuit according to any one of the claims 17 - 19, wherein the on-chip logic circuitry is using either planar transistor or transistors or Vertical MISFET device or devices and preferably, Vertical Heterojunction MISFET device or devices.

**Patentansprüche**

**1.** Ein auf Silizium-Germanium oder Siliziumcarbid basierendes vertikales MISFET Bauelement, das einen Stapel aus mehreren Schichten umfasst, der mindestens eine Sourceschicht (7 oder 7'), eine Kanalschicht (3 oder 3') und eine Drainschicht (1 oder 1') enthält, wobei:

- die Kanalschicht (3 oder 3') nichtdotiert oder nur leicht dotiert ist,
- ein Heteroübergang zwischen der Source (7 oder 7') und dem Kanal (3 oder 3') gebildet wird,
- ein Gate (13 oder 13') zumindest teilweise die Sourceschicht (7 oder 7'), die Kanalschicht (3 oder 3') oder die Drainschicht (1 oder 1') überlappt, wobei eine Isolierschicht (11 oder 11') sich zwischen dem besagten Gate und dem besagten Stapel aus mehreren Schichten befindet, und

**dadurch kennzeichnet, dass:**

- das besagte Gate (13 oder 13') in einem wesentlich rechten Winkel zur Stapelrichtung die besagten Sourceschicht (7 oder 7'), Kanalschicht (3 oder 3') und Drainschicht (1 oder 1') überlappt und
- ein nichtdotierter oder leicht dotierter Bereich (5 oder 5') in der Source vorhanden ist, die an die Source/Kanal-Schnittstelle angrenzt.

**2.** Ein Bauelement nach Anspruch 1, wobei das Bauelement vom PMOS-Typ ist und wobei:

- der Drain (1) aus hoch p-Typ-dotiertem Material, vorzugsweise aus dem selben Material wie das Kanalmaterial, besteht,
- der Kanal (3) ein nichtdotiertes Material ist,
- die Source zumindest eine Doppelschicht enthält, die aus einem nichtdotierten oder leicht p-Typ-dotierten Bereich (5) und einem hoch p-Typ-dotierten Bereich (7) besteht,

wobei beide aus einem zweiten Material mit einer Valenzbandkante mit einer niedrigeren potentiellen Energie bestehen als die Valenzbandkante des Kanalmaterials.

**3.** Ein Bauelement nach Anspruch 2, wobei das Bauelement ein PMOS-Typ ist und wobei:

- der Drain eine hochdotierte p++ Schicht, vorzugsweise eine Si-Schicht, umfasst

- der Kanal (3) eine nichtdotierte Schicht, vorzugsweise eine Si-Schicht, ist und
- die Source mindestens eine Doppelschicht enthält, die aus einer nichtdotierten oder leicht dotierten $Si_{1-x}Ge_x$-Schicht (5) und einer hochdotierten p++, eventuell abgestuften SiGe-Schicht (7), besteht.

4. Ein Bauelement nach Anspruch 1, wobei das Bauelement ein NMOS-Typ ist und worin :

- der Drain (1') aus hoch n-dotiertem Material, vorzugsweise aus dem selben Material wie das Kanalmaterial besteht,
- der Kanal (3') aus nichtdotiertem Material besteht und
- die Source mindestens eine Doppelschicht enthält, die aus einem nichtdotierten oder leicht n-Typ-dotierten Bereich (5') und einem hoch n-Typ-dotierten Bereich (7') besteht,

wobei beide aus einem zweiten Material bestehen, das eine Leitungsbandkante mit einer niedrigeren potentiellen Energie hat als die Leitungsbandkante des Kanalmaterials.

5. Ein Bauelement nach Anspruch 4, wobei das Bauelement ein NMOS-Typ ist und wobei:

- der Drain (1') eine hochdotierte n++-Schicht, vorzugsweise eine Si-Schicht, enthält,
- der Kanal (3') aus einer nichtdotierten Schicht, vorzugsweise einer Si-Schicht, besteht,
- die Source mindestens eine Doppelschicht enthält, die aus einer nichtdotierten oder leicht dotierten $Si_{1-x-y}Ge_x$-$C_y$ oder $Si_{1-y}C_y$-Schicht (5') und einer hochdotierten n++, eventuell einer abgestuften $Si_{1-x-y}Ge_xC_y$- oder $Si_{1-y}C_y$-Schicht (7'), besteht.

6. Ein Bauelement nach Anspruch 4, wobei das Bauelement ein NMOS-Typ ist und wobei:

- der Drain (1') eine hochdotierte n++ Schicht, vorzugsweise eine Germaniumschicht, enthält,
- der Kanal (3'a) eine nichtdotierte Schicht, vorzugsweise eine Ge-Schicht, enthält,
- die Source mindestens eine Doppelschicht enthält, die aus einer nichtdotierten oder leicht dotierten $Si_{1-y}Ge_y$-Schicht (5'a) und einer hochdotierten n++, eventuell einer abgestuften SiGe-Schicht (7'a), besteht.

7. Ein zusätzliches Bauelement, das mindestens einen Stapel eines Bauelements des NMOS-Typs nach irgendeinem der Ansprüche 4 bis 6 enthält, das auf einem Bauelement des PMOS-Typs nach irgendeinem der Ansprüche 2 bis 3 gezogen wurde und wobei sich ihre Drains (1 und 1') gegenüberliegen.

8. Ein zusätzliches Bauelement, das mindestens einen Stapel eines Bauelements des PMOS-Typs nach irgendeinem der Ansprüche 2 bis 3 enthält, das auf einem Bauelement des NMOS-Typs nach irgendeinem der Ansprüche 4 bis 6 gezogen wurde und wobei sich ihre Sourcen (7 und 7') gegenüberliegen.

9. Ein zusätzliches Bauelement, das mindestens einen Stapel eines Bauelements des PMOS-Typs nach irgendeinem der Ansprüche 2 bis 3 enthält, das auf einem Bauelement des NMOS-Typs nach irgendeinem der Ansprüche 4 bis 6 gezogen wurde und das selbst auf einem Bauelement des PMOS-Typs nach irgendeinem der Ansprüche 2 bis 3 gezogen wurde.

10. Ein zusätzliches Bauelement, das mindestens einen Stapel eines Bauelements des NMOS-Typs nach irgendeinem der Ansprüche 4 bis 6 enthält, das auf einem Bauelement des PMOS-Typs nach einem der Ansprüche 2 bis 3 gezogen wurde und das selbst auf einem Bauelement des NMOS-Typs nach irgendeinem der Ansprüche 4 bis 6 gezogen wurde.

11. Einsatz des zusätzlichen Bauelements nach irgendeinem der vorhergehenden Ansprüche 7 bis 10, um einen CMOS-Umrichter, einen PMOS-Pass-Transistor oder einen NMOS-Pass-Transistor zu erzielen.

12. Herstellungsverfahren für ein auf Silizium-Germanium oder Siliziumcarbid basierendes vertikales MISFET Bauelement oder einen Stapel aus mehreren vertikalen MISFET Bauelemente nach einem der Ansprüche 1 bis 10, wobei jedes der MISFET Bauelemente einen Stapel aus mehreren Schichten umfasst, der mindestens eine Sourceschicht, eine Kanalschicht und eine Drainschicht enthält, sowie einen Heteroübergang zwischen der besagten Sourceschicht und der besagten Kanalschicht, ein umliegendes Gate und einen Isolator, die mindestens teilweise irgendeine der verschiedenen Schichten des MISFET Bauelements überlappen, und das des weiteren über einen nichtdotierten oder leicht dotierten Bereich (5 oder 5') in der Source verfügt, die an die Source/Kanal-Schnittstelle angrenzt, wobei das besagte Gate und der besagte Isolator in einem rechten Winkel zur Stapelrichtung der besagten verschiedenen Schichten liegen, wobei das besagte Verfahren **dadurch gekennzeichnet ist, dass**:

- eine epitaxiale Ablagerungssequenz auf einem Siliziumsubstrat zur Festlegung der verschiedenen Schichten der eventuell gestapelten vertikalen MISFET Bauelemente verwendet wird,
- ein Musterbildungsschritt, der in einem Lithographie/Ätzschritt besteht, verwendet wird, um das umliegende Gate um das (die) eventuell gestapelte(n) Bauelement(e) herzustellen und
- weitere Musterbildungsschritte verwendet werden, um der Kontakt zur Source und zum Drain jedes der eventuell gestapelten vertikalen MISFET Bauelemente herzustellen.

13. Herstellungsverfahren für ein vertikales MISFET Bauelement nach Anspruch 12, wobei der Musterbildungsschritt zur Herstellung des Kontaktes zum Drain der Bauelemente durchgeführt wird, damit der besagte Drain derselbe für verschiedene gestapelte Bauelemente ist, vorzugsweise innerhalb der Begrenzung der (des) gestapelten Bauelemente(s).

14. Verfahren nach Anspruch 12 oder 13, wobei bei der epitaxialen Ablagerungssequenz ein virtuelles $Si_{1-x}Ge_x$ Substrat verwendet wird, um einen Heteroübergang in dem (den) PMOS oder NMOS Bauelement(en) herzustellen.

15. Verfahren nach Anspruch 14, wobei ein Heteroübergang durch Zugabe von Elementen der Gruppe IV und geeigneten Dotierungsmitteln in den virtuellen $Si_{1-x}Ge_x$ Substraten hergestellt wird, um bedeutende Energiebarrieren zu erzeugen.

16. Verfahren nach einem der vorhergehenden Ansprüche 12 bis 15 zur Herstellung vertikaler MISFET Bauelemente mit Heteroübergang, das zumindest die nachfolgenden Schritte umfasst:

- Epitaxie von verschiedenen Schichten des vertikalen MISFET Bauelements;
- Beschichtung von dem Isolator oder den Isolatoren;
- Maske 1: Definition der Strukturierungseinheiten (MESAS), wovon sich jede auf einen Stapel bezieht;
- Bildung eines Gatestapels auf den Mesa-Seitenwänden;
- Rückätzen der Gateelektrode (abstandshalterähnliche Elektrode);
- Planarisierung: Ausfüllen der Zwischenräume der Mesa-Struktur;
- Maske 2: Bildung eines Gatekontaktplättchens;
- Maske 3: (Gemeinsame) Kontaktfenster für den Drain;
- Bildung von Abstandhaltern, die sich zumindest teilweise an den inneren Seitenwänden des oberen und unteren Bauelements befindet;
- Ausfüllen der Kontaktfenster mit Silizid und Metall;
- Maske 4: Kontaktfenster zur Source des oberen Bauelements;
- Ausfüllen der Kontaktfenster mit Silizid und Metall;
- Metallisierung.

17. Eine RAM-Schaltung mit Speicherzellen und einer logischen Schaltung, wobei jede der besagten Speicherzellen mindestens ein vertikales MISFET Bauelement nach einem der Ansprüche 1 bis 6 enthält, wobei das besagte Bauelement selbst einen Stapel aus mehreren Schichten beinhaltet, der mindestens eine Sourceschicht, eine Kanalschicht und eine Drainschicht umfasst und wobei oberhalb des Stapels aus mehreren Schichten des vertikalen MISFET Bauelements ein Kondensator vorhanden ist.

18. Eine RAM-Schaltung mit Speicherzellen und einer logischen Schaltung, wobei jede der besagten Speicherzellen mindestens zwei übereinander angeordnete vertikale MISFET Bauelemente nach einem der Ansprüche 1 bis 6 enthält, zwischen denen sich ein Kondensator befindet.

19. Eine RAM-Schaltung nach den Ansprüchen 17 oder 18, wobei das oder die vertikalen MISFET Bauelement(e) ein oder mehrere vertikale MISFET Bauelemente mit Heteroübergang sind, die mindestens Folgendes beinhalten:

- eine nichtdotierte oder leicht dotierte Kanalschicht;
- einen Heteroübergang, der zwischen der Source und dem Kanal durch das Vorhandensein eines nichtdotierten oder leicht dotierten Bereiches innerhalb der Source in der Nähe der Source/Kanal-Schnittstelle gebildet wird, sowie

- ein Gate, das vorzugsweise in einem wesentlich rechten Winkel zumindest teilweise die Source-, Kanal- und Drainschichten mit einer Isolierschicht dazwischen überlappt.

20. Eine RAM-Schaltung nach irgendeinem der Ansprüche 17 bis 19, wobei für die on-Chip logische Schaltung entweder einen oder mehrere Planartransistor(en) oder ein oder mehrere vertikale MISFET Bauelement(e) oder vorzugsweise ein oder mehrere vertikale MISFET Bauelement(e) mit Heteroübergang verwendet werden.


**Revendications**

1. Dispositif MISFET vertical à base de silicium-germanium ou de carbure de silicium, qui comprend une pile de plusieurs couches comprenant au moins une couche de source (7 ou 7'), une couche de canal (3 ou 3') et une couche de drain (1 ou 1'), dans lequel :

   - la couche de canal (3 ou 3') n'est pas dopée ou est faiblement dopée,
   - une hétérojonction est formée entre la source (7 ou 7') et le canal (3 ou 3'),
   - une grille (13 ou 13') chevauche, au moins partiellement, l'une quelconque des couches de source (7 ou 7'), de canal (3 ou 3') et de drain (1 ou 1'), une couche isolante (11 ou 11') étant appliquée entre ladite grille et ladite pile de plusieurs couches, et

   **caractérisé en ce que** :

   - ladite grille (13 ou 13') chevauche, à angle essentiellement droit par rapport à la direction d'empilage, lesdites couches de source (7 ou 7'), de canal (3 ou 3') et de drain (1 ou 1'),
   - une région non dopée ou faiblement dopée (5 ou 5') est présente dans la source adjacente à l'interface source/canal.

2. Dispositif selon la revendication 1, dans lequel le dispositif est du type PMOS et dans lequel :

   - le drain (1) est constitué d'un matériau fortement dopé de type p, de préférence le même matériau que le matériau du canal,
   - le canal (3) est un matériau non dopé,
   - la source comprend au moins une double couche constituée d'une région non dopée ou faiblement dopée de type p (5) et d'une région fortement dopée de type p (7), toutes deux étant constituées d'un deuxième matériau qui a une limite de bande de valence avec une énergie potentielle inférieure à celle de la limite de bande de valence du matériau de canal.

3. Dispositif selon la revendication 2, dans lequel le dispositif est du type PMOS et dans lequel :

   - le drain (1) comprend une couche fortement dopée p++, de préférence une couche de Si,
   - le canal (3) est une couche non dopée, de préférence une couche de Si, et
   - la source comprend au moins une double couche constituée d'une couche de $Si_{1-x}Ge_x$ non dopée ou faiblement dopée (5) et d'une couche de SiGe fortement dopée p++ éventuellement graduelle (7).

4. Dispositif selon la revendication 1, dans lequel le dispositif est du type NMOS et dans lequel :

   - le drain (1') est constitué d'un matériau fortement dopé n, de préférence le même matériau que le matériau de canal,
   - le canal (3') est un matériau non dopé, et
   - la source comprend au moins une double couche constituée d'une région non dopée ou faiblement dopée de type n (5') et d'une région fortement dopée de type n (7'), toutes deux étant constituées d'un deuxième matériau qui a une limite de bande de conduction avec une énergie potentielle inférieure à celle de la limite de bande de conduction du matériau de canal.

5. Dispositif selon la revendication 4, dans lequel le dispositif est du type NMOS et dans lequel :

   - le drain (1') comprend une couche fortement dopée n++, de préférence une couche de Si,
   - le canal (3') est une couche non dopée, de préférence une couche de Si,

- la source comprend au moins une double couche constituée d'une couche de $Si_{1-x-y}Ge_xC_y$ ou de $Si_{1-y}C_y$ non dopée ou faiblement dopée (5') et d'une couche de $Si_{1-x-y}Ge_xC_y$ ou de $Si_{1-y}C_y$ fortement dopée n++, éventuellement graduelle (7').

6. Dispositif selon la revendication 4, dans lequel le dispositif est du type NMOS et dans lequel :

- le drain (1') comprend une couche fortement dopée n++, de préférence une couche de Ge,
- le canal (3'a) est une couche non dopée, de préférence une couche de Ge,
- la source comprend au moins une double couche constituée d'une couche de $Si_{1-y}Ge_y$ non dopée ou faiblement dopée (5'a) et d'une couche de SiGe fortement dopée n++ éventuellement graduelle (7'a).

7. Dispositif complémentaire comprenant au moins une pile d'un dispositif du type NMOS selon l'une quelconque des revendications 4 à 6 que l'on a fait croître par-dessus un dispositif du type PMOS selon l'une quelconque des revendications 2 à 3, ayant leurs drains (1 et 1') se faisant face l'un à l'autre.

8. Dispositif complémentaire comprenant au moins une pile d'un dispositif du type PMOS selon l'une quelconque des revendications 2 à 3 que l'on a fait croître par-dessus un dispositif du type NMOS selon l'une quelconque des revendications 4 à 6, ayant leurs sources (7 et 7') se faisant face l'une l'autre.

9. Dispositif complémentaire ayant au moins une pile d'un dispositif du type PMOS selon l'une quelconque des revendications 2 à 3 que l'on a fait croître par-dessus un dispositif du type NMOS selon l'une quelconque des revendications 4 à 6 que l'on a fait croître lui-même par-dessus un dispositif du type PMOS selon l'une quelconque des revendications 2 à 3.

10. Dispositif complémentaire ayant au moins une pile d'un dispositif du type NMOS selon l'une quelconque des revendications 4 à 6 que l'on a fait croître par-dessus un dispositif du type PMOS selon l'une quelconque des revendications 2 à 3 que l'on a fait croître lui-même par-dessus un dispositif du type NMOS selon l'une quelconque des revendications 4 à 6.

11. Utilisation du dispositif complémentaire selon l'une quelconque des revendications précédentes 7 à 10 pour avoir un inverseur CMOS, un transistor passant PMOS ou un transistor passant NMOS.

12. Procédé de fabrication d'un dispositif MISFET vertical à base de silicium-germanium ou à base de carbure de silicium ou d'une pile de plusieurs dispositifs MISFET verticaux selon l'une quelconque des revendications 1 à 10, chacun des dispositifs MISFET comprenant une pile de plusieurs couches comprenant au moins une couche de source, une couche de canal et une couche de drain, une hétérojonction étant présente entre ladite couche de source et ladite couche de canal et ayant une grille environnante et un isolant chevauchant au moins partiellement l'une quelconque des diverses couches du dispositif MISFET, et ayant par ailleurs une région non dopée ou faiblement dopée (5 ou 5') dans la source adjacente à l'interface source/canal, ladite grille et ledit isolant formant un angle droit avec la direction d'empilage desdites diverses couches, ledit procédé étant **caractérisé en ce que** :

- une séquence de dépôt épitaxial sur un substrat de silicium est utilisée pour définir les diverses couches de chaque dispositif MISFET vertical éventuellement empilé,
- une étape de formation de motifs constituée d'une étape lithographique/de gravure est utilisée pour créer la grille environnante autour du ou des dispositifs éventuellement empilés, et
- d'autres étapes de formation de motifs sont utilisées pour établir un contact avec la source et avec le drain de chaque dispositif MISFET vertical éventuellement empilé.

13. Procédé de fabrication d'un dispositif MISFET vertical selon la revendication 12, dans lequel l'étape de formation de motifs utilisée pour établir le contact avec le drain des dispositifs est effectuée de manière à avoir ledit drain commun à plusieurs dispositifs empilés, ce qui est de préférence réalisé dans le périmètre du ou des dispositifs empilés.

14. Procédé selon la revendication 12 ou 13, dans lequel la séquence de dépôt épitaxial utilise un substrat virtuel de $Si_{1-x}Ge_x$ pour créer une hétérojonction dans le ou les dispositifs PMOS ou NMOS.

15. Procédé selon la revendication 14, dans lequel une hétérojonction est créée en incorporant des éléments du groupe IV et des dopants appropriés dans le substrat virtuel de $Si_{1-x}Ge_x$ pour créer des barrières d'énergie importantes.

**16.** Procédé selon l'une quelconque des revendications précédentes 12 à 15 destiné à fabriquer des dispositifs MISFET verticaux à hétérojonction comprenant au moins les étapes suivantes :

- épitaxie de plusieurs couches du dispositif MISFET vertical;
- dépôt d'un ou de plusieurs isolants;
- masque 1 : définition d'unités de configuration (MESAS) correspondant chacune à une pile;
- formation d'une pile de grilles sur les parois latérales des mesas;
- gravure en retrait des électrodes de grilles (électrode de type espaceur);
- planarisation : remplissage des espaces entre les mesas;
- masque 2 : formation d'un plot de contact de grilles;
- masque 3 : trous de contact de drains (communs);
- formation d'espaceurs au moins partiellement sur les parois latérales internes du dispositif supérieur/inférieur;
- remplissage du trou de contact par un siliciure et un métal;
- masque 4 : trou de contact avec la source du dispositif supérieur;
- remplissage du trou de contact avec du siliciure et un métal;
- métallisation.

**17.** Circuit RAM ayant des cellules de mémoire et un circuit logique, chacune desdites cellules de mémoire comprenant au moins un dispositif MISFET vertical selon l'une quelconque des revendications 1 à 6, ledit dispositif ayant lui-même une pile de plusieurs couches comprenant au moins une couche de source, une couche de canal et une couche de drain et comprenant un condensateur par-dessus la pile de plusieurs couches du dispositif MISFET vertical.

**18.** Circuit RAM ayant des cellules de mémoire et un circuit logique, chacune desdites cellules de mémoire comprenant au moins deux dispositifs MISFET verticaux selon l'une quelconque des revendications 1 à 6, disposés l'un par-dessus l'autre et ayant entre eux un condensateur.

**19.** Circuit RAM selon la revendication 17 ou 18, dans lequel le dispositif ou les dispositifs MISFET verticaux est ou sont un ou des dispositifs MISFET verticaux à hétérojonction qui comprennent au moins :

- une couche de canal qui n'est pas dopée ou faiblement dopée;
- une hétérojonction qui est formée entre la source et le canal avec la présence d'une région non dopée ou faiblement dopée dans la source à proximité de l'interface source/canal, et
- une grille qui chevauche, de préférence essentiellement à angle droit, au moins partiellement les couches de source, de canal et de drain avec une couche isolante disposée entre elles.

**20.** Circuit RAM selon l'une quelconque des revendications 17 à 19, dans lequel le circuit logique sur puce utilise un ou des transistors planar ou un ou des dispositifs MISFET verticaux et, de préférence, un ou des dispositifs MISFET verticaux à hétérojonction.

Figure 1a

**$E_V$ and $E_F$ for Drain Bias (at channel breakdown field)**

Figure 1b

EP 0 749 162 B1

Figure 1c

EP 0 749 162 B1

# PMOS

Figure 2a

NMOS

Figure 2b

# PMOS

Figure 3a

# NMOS

Figure 3b

EP 0 749 162 B1

Figure 4a

Figure 4b

Gate Pad

Gate Electrode

11

13

Gate Insulator

Spacer

25

Out

21

Spacer contact to Drains

NMOS Source

NMOS Channel

NMOS Drain

Lowly Doped Silicon

PMOS Drain

PMOS Channel

PMOS Source

GND (p-type wafer)

-VSS

23

Gate Insulator

Gate Electrode

5'+7'

3'

1'

15

1

3

5+7

Figure 5

Figure 6

46

NMOS Pass Transistor

Figure 7

PMOS Pass Transistor

Gate Pad

Gate Electrode

Gate Insulator

Spacer

Spacer

PMOS Drain

PMOS Channel

PMOS Source

N-TYPE WAFER

Gate Insulator

Gate Electrode

Figure 8

# Vertical CMOS
# Process Flow

Epitaxy of Device Layers &
Deposition of Insulator(s)

Mask 1: Definition of MESAS

Formation of Gate Stack
on MESAS sidewalls

Gate Electrode Etchback
(Electrodes like Spacers)

Planarization - Filling of
Spaces between MESAS

Mask 2: Formation of
Gate Contact Pad

Mask 3: (common) Drain
Contact Holes

Spacers on the internal side-
walls of the top Device

Contact Hole Filling
with Silicide & Metal

Mask 4: Contact Hole to
Source of Top Device

Contact Hole Filling
with Silicide & Metal

Metallization

Figure 9

Figure 10.1

Figure 10.2

EP 0 749 162 B1

Figure 10.3

0.6 µm  1.5 µm  0.6 µm

Nitride
Oxide
n++ layer
BARRIER
p++ layer
PMOS
High (5 E20) Boron Doped Layer
Wafer Bulk (undoped)

Figure 10.4

Figure 10.5

Gate Dielectric

Gate Electrode

0.46 μm

0.46 μm

Nitride

Oxide

n++ layer

BARRIER

p++ layer

PMOS

Highly (1E20) Boron Doped Layer

Wafer Bulk (undoped)

Figure 10.6

EP 0 749 162 B1

Figure 10.7

Figure 10.8

Figure 10.9

Oxide

Nitride

Oxide

n++ layer

p++ layer

BARRIER

PMOS

Wafer Bulk (undoped)

Figure 10.10

0.27 µm    0.27 µm    0.78 µm    0.26 µm    0.26 µm    0.27 µm    0.27 µm

0.26 µm    0.26 µm

Oxide

Nitride
Oxide
n++ layer
BARRIER
p++ layer
PMOS

High (A 1 20) Boron Doped Layer

Wafer Bulk (undoped)

Figure 10.11

EP 0 749 162 B1

Figure 10.12

Figure 10.13

0.26 μm

Oxide

Nitride

Oxide

n++ layer

BARRIER

p++ layer

PMOS

Wafer Bulk (undoped)

Fig. 10.14

Figure 10.15

EP 0 749 162 B1

Figure 10.16

$TiSi_2$  TiN

Oxide

Nitride

Oxide

n++ layer

BARRIER

p++ layer

PMOS

Highly (1E20) Boron Doped Layer

Wafer Bulk (undoped)

Figure 10.17

Figure 10.18

Figure 10.19

Figure 10.20

0.54 µm

Oxide

Nitride

Oxide

Oxide

n++ layer

p++ layer

BARRIER

PMOS

Wafer Bulk (undoped)

Figure 10.21

Figure 10.22

Figure 10.22

EP 0 749 162 B1

Figure 10.23

Oxide

Nitride

Oxide

Oxide

0.26 μm

Nitride

Oxide

n++ layer

p++ layer

BARRIER

PMOS

Light (3×1E20 Boron) Epitaxial Layer

Wafer Bulk (undoped)

Figure 10.24

0.26 µm

Oxide

Oxide

Nitride

Oxide

Nitride

n++ layer

BARRIER

p++ layer

PMOS

Highly (>1E20) Boron Doped Layer

Wafer Bulk (undoped)

EP 0 749 162 B1

Figure 10.25

Figure 10.26

Figure 10.27

Figure 10.28

Oxide

Oxide

Oxide

Nitride

Oxide

Oxide

n++ layer

p++ layer

BARRIER

PMOS

Wafer Bulk (undoped)

Figure 10.29

EP 0 749 162 B1

Figure 10.30

METALLIZATION & PASSIVATION

Figure 10.31

METALLIZATION & PASSIVATION

Nitride

Oxide

n++ layer

p++ layer

BARRIER

PMOS

Highly STEP Boron Doped HEpin

Silicide (smallest barrier height for holes)

Copper alloy

EP 0 749 162 B1

Figure 11.1

Nitride
Oxide
NMOS
n++ layer
BARRIER
p++ layer
PMOS
Highly (S1E 20) p-type Doped Layer
Wafer Bulk (undoped)

Figure 11.2

Figure 11.3

1.5 μm

0.3 μm

0.3 μm

Nitride

Oxide

NMOS

n++ layer

BARRIER

p++ layer

PMOS

Wafer Bulk (undoped)

Figure 11.4

1.5 µm

0.3 µm

0.3 µm

Nitride

Oxide

NMOS

n++ layer

BARRIER

p+ layer

PMOS

Highly Epoxic-type Doped Layer

Wafer Bulk (undoped)

Figure 11.5

Nitride
Oxide
NMOS
n++ layer
BARRIER
SRI layer
PMOS
(n-type) (p-type) Doped layer
Wafer Bulk (undoped)

Figure 11.6

Figure 11.7

Figure 11.8

EP 0 749 162 B1

Figure 11.9

Figure 11.10

Figure 11.11

Figure 11.12

Gate Dielectric
Nitride
Oxide
NMOS
n++ layer
BARRIER
P LAYER
PMOS
Highly (1E20) P-type Doped Layer
Wafer Bulk (undoped)

EP 0 749 162 B1

Figure 11.13

93

Figure 11.14

EP 0 749 162 B1

Figure 11.15

EP 0 749 162 B1

Figure 11.16

PSG

Nitride

Oxide

NMOS

n++ layer

BARRIER

PMOS

Wafer Bulk (undoped)

Figure 11.17

Figure 11.18

Figure 11.18

EP 0 749 162 B1

Figure 11.19

Figure 11.20

Figure 11.21

EP 0 749 162 B1

Figure 11.22

PSG

Gate Contact

Nitride

Oxide

NMOS

n++ layer

BARRIER

PMOS

Highly (Ga P2) p type Doped layer

Wafer Bulk (undoped)

Figure 11.23

Figure 11.24

Figure 11.25

Figure 11.26

Figure 11.27

Figure 11.28

Figure 11.29

EP 0 749 162 B1

Figure 11.30

Figure 11.31

METALLIZATION & PASSIVATION

PSG

Nitride

Oxide

NMOS

n+ layer

BARRIER

Wafer Bulk (undoped)

Figure 11.32

Figure 11.33

METALLIZATION & PASSIVATION

Figure 12.1

EP 0 749 162 B1

Figure. 12.2

0.3 μm

2.1 μm

0.3 μm

Nitride
Oxide
NMOS
n++ layer
BARRIER
PMOS
Wafer Bulk (undoped or n-type doped)

Figure 12.3

Figure 12.4

2.1 µm

0.3 µm

0.3 µm

Nitride

Oxide

NMOS

n++ layer

BARRIER

PMOS

Wafer Bulk (undoped or n-type doped)

Figure 12.5

Figure 12.6

Figure 12.7

Nitride

Oxide

NMOS

n++ layer

BARRIER

Wafer Bulk (undoped or n-type doped)

Figure 12.8

Nitride
Oxide
NMOS
n++ layer
BARRIER
PMOS
PDMOS

Wafer Bulk (undoped or n-type doped)

EP 0 749 162 B1

Figure 12.9

Nitride
Oxide
NMOS
n++ layer
BARRIER
PMOS
p++ layer
Wafer Bulk (undoped or n-type doped)

EP 0 749 162 B1

Figure 12.10

Nitride

Oxide

NMOS

n++ layer

BARRIER

P++ layer

PMOS

Intrinsic layer

Wafer Bulk (undoped or n-type doped)

Figure 12.11

EP 0 749 162 B1

Figure 12.12

Figure 12.13

Nitride

Oxide

NMOS

n++ layer

BARRIER

PMOS

Gate Electrode

Wafer Bulk (undoped or n-type doped)

Figure 12.14

Figure 12.15

Nitride

Oxide

NMOS

n++ layer

BARRIER

Gate layer

PMOS

Oxide

Gate electrode

Wafer Bulk (undoped or n-type doped)

Figure 12.16

Figure 12.17

EP 0 749 162 B1

PSG

Nitride

Oxide

NMOS

n++ layer

BARRIER

PMOS

Gate-Electrode

Oxide

Wafer Bulk (undoped or n-type doped)

Figure 12.18

Figure 12.19

EP 0 749 162 B1

Figure 12.20

Figure 12.21

Figure 12.22

EP 0 749 162 B1

Figure 12.23

PSG

Nitrido
Oxido
NMOS
n++ layer
BARRIER
PMOS

Gate Contact

gate electrode

Gate Contact

gate electrode

Wafer Bulk (undoped or n-type doped)

Figure 12.24

PSG

Nitride

Oxide

NMOS

n++ layer

BARRIER

P++ layer

PMOS

gate contact

gate contact

Wafer Bulk (undoped or n-type doped)

Figure 12.25

Figure 12.26

Figure 12.27

Figure 12.28

Figure 12.28

EP 0 749 162 B1

Figure 12.29

Figure 12.30

EP 0 749 162 B1

Figure 12.31

PSG

Nitride
Oxide
NMOS
n++ layer
BARRIER
PMOS
RMOS
Poly layer

Wafer Bulk (undoped or n-type doped)

Figure 12.32

Figure 12.33

Figure 12.34

Figure 12.35

Figure 12.36

Figure 13.1

Figure 13.2

Figure 13.3

1.5 µm

0.3 µm

0.3 µm

Nitride

Oxide

PMOS

P+ layer

BARRIER

NMOS

n++ layer

BARRIER

P+ layer

PMOS

Highly p-type Doped Layer

Undoped

Figure 13.4

Figure 13:5

Nitride
Oxide
PMOS
R+N Well
BARRIER
NMOS
n++ layer
BARRIER
N++ N Well
PMOS
Highly p-type Doped Layer

Figure 13.6

Figure 13.7

Figure 13.8

Nitride
Oxide
PMOS
P++ Layer
BARRIER
NMOS
n++ layer
BARRIER
P++ layer
PMOS
Highly p-type Doped Layer
Undoped

**Figure 13.9**

Nitride
Oxide
PMOS
BARRIER
NMOS
n++ layer
BARRIER
p++ layer
PMOS
Highly p-type Doped Layer
Undoped wafer

Figure 13.10

Figure 13.11

EP 0 749 162 B1

Nitride

Oxide

PMOS

BARRIER

NMOS

n++ layer

BARRIER

p++ layer

PMOS

Highly p-type Doped Layer

Undoped Wafer

Figure 13.12

Gate Dielectric

Nitride

Oxide

PMOS

Rest Layer

BARRIER

NMOS

n++ layer

BARRIER

p++ layer

PMOS

Highly p-type Doped Layer

Undoped wafer

EP 0 749 162 B1

Figure 13.13

Nitride

Oxide

PMOS

P++ layer

BARRIER

NMOS

n++ layer

BARRIER

P++ layer

PMOS

Highly p-type Doped Layer

Undoped Wafer

Figure 13.14

Nitride
Oxide
1 PMOS
BARRIER
NMOS
n++ layer
BARRIER
PMOS
Highly p-type Doped Layer

Gate Electrode

Figure 13.15

Nitride
Oxide
PMOS
p++ layer
BARRIER
NMOS
n++ layer
BARRIER
p++ layer
PMOS
Highly p-type Doped Layer
Silicon Wafer

EP 0 749 162 B1

Figure 13.16

Figure 13.17

EP 0 749 162 B1

Figure 13.18

Figure 13.19

Figure 13.20

PSG

Nitride
Oxide
KPMOS
BARRIER
NMOS
n++ layer
BARRIER
PMOS
Highly p-type Doped Layer

Figure 13.21

Figure 13.22

PSG

Nitride

Oxide

PMOS

BARRIER

NMOS

n++ layer

BARRIER

PMOS

Highly p-type Doped Layer

Gate Electrode

Figure 13.23

Figure 13.24

Figure 13.25

Figure 13.26

Figure 13.27

Figure 13.28

EP 0 749 162 B1

PSG

Nitride

Oxide

PMOS

P++ Layer

BARRIER

NMOS

n++ layer

BARRIER

P++ layer

PMOS

Highly p-type Doped Layer

Gate Contact

Gate Electrode

Oxide

Figure 13.29

Figure 13.30

EP 0 749 162 B1

PSG

Nitride

Oxide

PMOS

BARRIER

NMOS

n++ layer

BARRIER

p+ layer

PMOS

Highly p-type Doped Layer

Gate Electrode

Gate Contact

Figure 13.31

EP 0 749 162 B1

# 1-Transistor Cell
# RAM Process Flow

| Epitaxy of Cell Transistor Layers |
| Deposition of Insulator(s) |
| Formation of 1st Trenches |
| Formation of 2nd Trenches (perpendicular to 1st ones) |
| Formation of Surrounding Gate Insulator |
| Deposition & Etchback of Gate Electrode |
| Oxidation of Gate Electrode below the top Epi Layer |

| Removal of Si3N4 & SiO2 from the Epi MESAS |
| Formation of Poly-Plug on the Epi-MESAS |
| Removal of Oxidised Poly from Gate Electrode |
| Formation of SiO2 Spacers around Poly-Plug |
| Patterning of Gate Electrode |
| Planarization |
| Formation of Capacitor Insulator & Electrode |

Figure 14

181

# 2-Transistor Cell
# RAM Process Flow

Formation of Complementary
Transistor Stack with Capacitor
inbetween Drains

↓

Deposition of Insulator(s)

↓

Formation of 1st Trenches

↓

Formation of 2nd Trenches
(perpendicular to 1st ones)

↓

Formation of Surrounding
Gate Insulator

↓

Deposition & Etch Back
of Gate Electrode

↓

Oxidation of Gate Electrode
below the top Epi-Layer

Removal of Si3N4 & SiO2
from the Epi-MESAS

↓

Formation of Poly-Plug on
the Epi-MESAS

↓

Removal of Oxidised Poly
from Gate Electrode

↓

Formation of SiO2-Spacers
around Poly-Plugs

↓

Patterning of Gate Electrode

↓

Planarization + Deposition of
Top Electrode

↓

Patterning of Top Electrode

Figure 15

# 2- Transistor Cell

**Top Bitline**

NMOS

**Wordline**

Capacitor

PMOS

**Bottom Bitline**

Figure 16

Figure 17.1

EP 0 749 162 B1

Figure 17.2

Figure 17.3

Figure 17.4

Figure 17.5

Resist

n++ layer

p-type substrate

Figure 17.6

Figure 17.7

Resist

Figure 17.8

Gate Oxide

Figure 17.9

POLY
(in-situ doped)

Gate Oxide

Figure 17.10

OXIDE (oxidized poly)

POLY (in-situ doped)

Gate Oxide

Figure 17.11

Figure 17.12

Figure 17.13

POLY
(in-situ doped)

Gate Oxide

Poly Plug

EP 0 749 162 B1

Figure 17.14

Oxide Spacers

POLY
(in-situ doped)

Gate Oxide

Poly Plug

EP 0 749 162 B1

Figure 17.15

Figure 17.16

Oxide Spacers

Salicide

Gate Oxide

Poly Plug

EP 0 749 162 B1

199

Oxide Spacers

Salicide

Gate Oxide

Oxide (Planarization)

Poly Plug

Figure 17.17

Figure 17.18

Cell Plate (TiN)

Storage Capacitor
Dielectric / Metal   (BST/ TiN)

Oxide
(Planarization)

Oxide Spacers

Cell Area = 2L x 2L

2L

2L

2L

Salicide

Gate Oxide

Poly Plug

WORDLINE  (Gate Electrode)

BITLINE (Source)

Figure 18.1

Nitride

Oxide

n++ layer

NMOS Layers

n++ layer

p-type substrate

EP 0 749 162 B1

Figure 18.2

Figure 18.3

n++ layer

NMOS Layers

n++ layer

p-type substrate

EP 0 749 162 B1

Figure 18.4

n++ layer

p-type substrate

Figure 18.5

Figure 18.6

Figure 18.7

Resist

n++ layer

p-type substrate

EP 0 749 162 B1

Figure 18.8

Figure 18.9

Gate Oxide

Figure 18.10

Figure 18.11

OXIDE
(oxidized poly)

POLY
(in-situ doped)

Gate Oxide

OXIDE
(oxidized poly)

POLY
(in-situ doped)

Gate Oxide

Figure 18.12

Figure 18.13

OXIDE
(oxidized poly)

POLY
(in-situ doped)

Gate Oxide

Poly Plug

EP 0 749 162 B1

214

Figure 18.14

**POLY**
**(in-situ doped)**

Gate Oxide

Poly Plug

EP 0 749 162 B1

Oxide Spacers

POLY
(in-situ doped)

Gate Oxide

Poly Plug

Figure 18.15

Figure 18.16

Figure 18.17

Figure 18.18

Oxide Spacers

Salicide

Gate Oxide

Oxide (Planarization)

Poly Plug

Figure 18.19

Cell Plate (TiN)

Storage Capacitor
Dielectric / Metal (BST/ TiN)

Cell Area = 2L x 2L

2L

Salicide

Gate Oxide

Poly Plug

WORDLINE (Gate Electrode)

BITLINE (Source)

EP 0 749 162 B1

220

EP 0 749 162 B1

Figure 19.1

Capacitor's Top Electrode

Capacitor's Dielectric

Capacitor's Bottom Electrode

n++ layer

**NMOS Layers**

n++ layer

**p-type substrate**

Figure 19.2

n++ layer

NMOS Layers

n++ layer

p type substrate

EP 0 749 162 B1

Figure 19.3

EP 0 749 162 B1

Figure 19.4

Resist

n++ layer

p-type substrate

Figure 19.5

Figure 19.6

Figure 19.7

Gate Oxide

EP 0 749 162 B1

Figure 19.8

Figure 19.9

Gate Electrode

Gate Oxide

Figure 19.10

Figure 19.11

Oxide Spacers

Gate Oxide

RESIST

EP 0 749 162 B1

Figure 19-12

232

Figure 19.13

Oxide Spacers

Oxide (Planarization)

Gate Oxide

Figure 19.14

Figure 20.1

Nitride

Channel Layer

Capacitor

Channel Layer

n-type substrate

Figure 20.2

Nitride

Oxide

Channel Layer

Capacitor

Channel Layer

n-type substrate

EP 0 749 162 B1

EP 0 749 162 B1

Figure 20.3

Nitride

Channel Layer

Capacitor

Channel Layer

n-type substrate

EP 0 749 162 B1

## Figure 20.4

Nitride

Channel Layer

Capacitor

Channel Layer

n-type substrate

Figure 20.5

Figure 20.6

Nitride

Nitride

Oxide

RESIST

n-type substrate

Figure 20.7

Figure 20.8

Nitride

Nitride

RESIST

n-type substrate

Figure 20.9

Nitride

Gate Oxide

Gate Oxide

n-type substrate

EP 0 749 162 B1

Figure 20.10

POLY
(in-situ doped)

Nitride

Gate Oxide

n-type substrate

Figure 20.11

Figure 20.12

Figure 20.13

Silicide
(optional)

OXIDE
(oxidation of poly)

POLY
(in-situ doped)

Poly
Plug

Poly
Plug

n-type substrate                    Gate Oxide

EP 0 749 162 B1

Figure 20.14

Poly plug

Poly plug

Silicide (optional)

POLY (in-situ doped)

Gate Oxide

n-type substrate

Figure 20.15

Silicide (optional)

Poly Plug

POLY
(in-situ doped)

n-type substrate

Gate Oxide

EP 0 749 162 B1

Figure 20.16

Figure 20.17

Figure 20.18

Planarization (Oxide)

Silicide (optional)

Oxide Spacers

Oxide Spacers

Poly Plug

Poly Plug

Poly Plug

Planarization (Oxide)

n-type substrate

Gate Oxide

EP 0 749 162 B1

Figure 20.19

Poly Plug

Poly Plug

Top Electrode (TiN for example)

Planarization (Oxide)

Gate Oxide

n-type substrate

Figure 20.20

Figure 21.1

Nitride

Channel layer

Capacitor

Channel layer

n-type substrate

Figure 21.2

Figure 21.3

Figure 21.4

Figure 21.5

Nitride

Oxide

Channel layer

Capacitor

Channel layer

n-type substrate

Figure 21.6

Nitride

Nitride

RESIST

Nitride
Oxide
Channel layer
Capacitor
Channel layer
n-type substrate

Figure 21.7

Figure 21.8

Figure 21.9

Figure 21.10

Figure 21.11

Figure 21.12

Figure 21.13

Poly Plug

Poly Plug

Poly Plug

Nitride

OXIDE
(oxidation of poly)

Channel layer

POLY
(in-situ doped)

Capacitor

Channel layer

n-type substrate

Gate Oxide

Figure 21.14

Nitride

Channel layer

Capacitor

Channel layer

POLY
(in-situ doped)

Poly Plug

Poly Plug

Poly Plug

Figure 21.15

Figure 21.16

Poly Plug

Poly Plug

RESIST

Nitride

Channel layer

Capacitor

Channel layer

Gate Oxide

n-type substrate

EP 0 749 162 B1

Figure 21.17

Poly Plug

Poly Plug

Poly Plug

Nitride

Channel layer

Capacitor

Channel layer

n-type substrate

Gate Oxide

Figure 21.18

Planarization
(Oxide)

Poly Plug

Poly
Plug

Poly Plug

Oxide Spacers

Oxide Spacers

Poly
Plug

Nitride

Channel layer

Capacitor

Channel layer

Planarization
(Oxide)

n-type substrate

Gate Oxide

EP 0 749 162 B1

Figure 21.19

EP 0 749 162 B1

Figure 21.20

Poly plus

Poly plus

Planarization (Oxide)

Gate Oxide

n-type substrate

Figure 21.21

Poly Plug

Poly Plug

Planarization (Oxide)

Gate Oxide

n-type substrate

Figure 21.22

Thin Oxide

Nitride Spacers

Poly Plug

Poly Plug

Planarization
(Oxide)

n-type substrate

Gate Oxide

EP 0 749 162 B1

Figure 21.23

Nitride Spacers

Planarization
(Oxide)

Poly
Plug

Poly
Plug

n-type substrate

Gate Oxide

EP 0 749 162 B1

Figure 21.24

EP 0 749 162 B1

Figure 21.25

EP 0 749 162 B1

Poly
Plug

Poly
Plug

Nitride Spacers

Metal
Plug

Planarization
(Oxide)

n-type substrate

Gate Oxide

Figure 21.26

Figure 21.27

Figure 21.28

Figure 21.29

Figure 21.30

Poly Plug

Poly Plug

Planarization (Oxide)

Nitride Spacers

Gate Oxide

Metal Plug

Nitride Spacers

n-type substrate

Metal Plug

Figure 21.31

Figure 21.32

Cell Area = 2L x 2L

2L

Planarization (Oxide)

To PMOS Source

Nitride Spacers

Oxide Spacers

Oxide Spacers

Top Bitline

Poly Plug

Common Drain Contact

Metal Plug

Poly Plug

Wordline

Metal Plug

Nitride Spacers

Metal Plug

NMOS Drain

Wordline

Gate Electrode

PMOS Drain

Gate Electrode

Planarization (Oxide)

Bottom Bitline

n-type substrate

Gate Oxide

EP 0 749 162 B1